# EUROPEAN PATENT APPLICATION

(11) **EP 4 411 478 A1**
(43) Date of publication of application: **07.08.2024**
(21) Application number: 22875983.3
(22) Date of filing: 21.09.2022
(51) Int. Cl.: G03F 7/027, C08F 290/00, G03F 7/004, G03F 7/031, G03F 7/037, G03F 7/075

(54) **PHOTOSENSITIVE COMPOSITION, CURED PRODUCT, DISPLAY DEVICE, ELECTRONIC COMPONENT, AND METHOD FOR PRODUCING CURED PRODUCT**

(30) Priority: 29.09.2021 JP 2021158861
(71) Applicant: Toray Industries, Inc., Tokyo 103-8666 (JP)
(72) Inventor: TANIGAKI, Yugo, Otsu-shi, Shiga 520-8558 (JP); SAEKI, Akinori, Otsu-shi, Shiga 520-8558 (JP); HIBINO, Chika, Otsu-shi, Shiga 520-8558 (JP); KOYAMA, Yutaro, Otsu-shi, Shiga 520-8558 (JP)
(74) Representative: Kador & Partner Part mbB
(86) International application number: PCT/JP2022/035169
(87) International publication number: WO 2023/054116

(57) **Abstract**

An object of the present invention is to provide a photosensitive composition of having improved sensitivity at the time of exposure, suppressed narrow mask bias of an opening pattern dimension after development, and excellent halftone characteristics, and a cured film capable of improving reliability of a light-emitting element in a display device and improving migration resistance in an electronic component. In order to achieve the above object, the photosensitive composition of the present invention is a photosensitive composition satisfying a condition (α) or a condition (β) below, wherein a double bond equivalent in total solid content is 600 to 6,000 g/mol: the condition (α): containing a compound of (I) described below and/or a compound of (II) described below: (I) a compound having a specific weakly acidic group (WA) and a radical polymerizable group; and (II) a compound having a specific weakly acidic group (WA) and Compound having a radical polymerizable group; or the condition (β): containing an alkali-soluble resin (A), a radical polymerizable compound (B), and a photosensitive agent (C):

## Description

### TECHNICAL FIELD

The present relates to a photosensitive composition, a cured product, a display device, an electronic component, and a method for producing cured product.

### BACKGROUND ART

In recent years, many products that use organic electroluminescence (hereinafter, referred to as "EL") displays have been developed in display devices including thin displays, such as smartphones, tablet PCs, and televisions.

In order to improve light-emitting characteristics and reliability of an organic EL display, a photosensitive composition having high heat resistance is used for a pixel defining layer, a thin-film-transistor (hereinafter, referred to as "TFT") planarization layer, or a TFT protective layer of the organic EL display, or an interlayer insulation layer or a gate insulation layer in TFT array formation. For example, in a photosensitive composition for forming a pixel defining layer formed on a first electrode, it is necessary to expose the first electrode to be an anode (anode) by photolithography. Therefore, in order to reduce the process time and improve the productivity in the production of the organic EL display, the photosensitive composition is required to improve the sensitivity at the time of exposure. On the other hand, as the improvement of the light-emitting characteristics of the organic EL display, improvement of the reliability of the light-emitting element is also required. By improving the reliability of the light-emitting element, the durability of the organic EL display can be improved.

In addition, after the pixel defining layer is formed, it is common to form a film of a light-emitting material by vapor deposition through a vapor deposition mask, and then to form a film of a second electrode by vapor deposition. Note that it is also common to form a region having a thick film thickness (hereinafter, referred to as "thick film part") in a part of the pixel defining layer as a support base of a deposition mask when a film of the light-emitting material is formed by vapor deposition. Such a region having a thick film thickness in a part of the pixel defining layer can be formed by a two-layer film forming process in which after the pixel defining layer is formed, a photosensitive composition is formed again on the pixel defining layer to perform pattern processing. On the other hand, in such a two-layer film forming process, there is a concern about a decrease in productivity and a decrease in yield due to an increase in the number of processes. Therefore, when the pixel defining layer is formed by photolithography, a process of collectively forming the pixel defining layer and the thick film part as a step shape in the pixel defining layer by using a halftone photomask is applied.

Meanwhile, since the organic EL display has the self-light-emitting element, incident external light such as sunlight outdoors decreases the visibility and contrast due to external light reflection. Therefore, as a technique for blocking external light and reducing external light reflection, it is common to improve the light-shielding property by containing a colorant in a photosensitive composition for forming a pixel defining layer.

In addition, in recent years, electronic terminal devices have become more sophisticated, smaller, thinner, and lighter. These electronic terminal devices include a semiconductor device, and examples thereof include a processor and a memory. With expansion of uses and improvement in performance of semiconductors, efforts have been made to reduce costs and increase integration by improving the efficiency of production processes, and semiconductor devices that form multilayer metal rewiring are attracting attention. Due to wiring miniaturization associated with high integration of the semiconductor devices, a material used for an interlayer insulation layer in such multilayer metal rewiring is also required to have reliability related to electrical insulation property, and therefore is also required to have high migration resistance.

Examples of the photosensitive composition include a negative-type photosensitive composition containing a first resin such as polyimide and a second resin such as a cardo resin (refer to Patent Document 1), and a negative-type photosensitive composition containing an epoxy acrylate resin and a novolak resin (refer to Patent Document 2).

### PRIOR ART DOCUMENT

### PATENT DOCUMENTS

Patent Document 1: International Publication No. 2017/159876
Patent Document 2: Japanese Patent Laid-open Publication No. 2009-003442

### SUMMARY OF THE INVENTION

### PROBLEMS TO BE SOLVED BY THE INVENTION

Improving the sensitivity at the time of exposure in the photosensitive composition described above may become a problem if the content of the colorant is increased in order to improve the light-shielding property of the photosensitive composition. In particular, when a black pigment or the like having a high light-shielding property is contained, ultraviolet rays or the like at the time of pattern exposure are also blocked, which causes a decrease in the sensitivity at the time of exposure.

In addition, in the process of forming a thick film part on a part of the pixel defining layer described above, depending on the characteristics of the photosensitive composition, the characteristics of collectively forming the pixel defining layer and the thick film part by pattern exposure through the halftone photomask (hereinafter, referred to as "halftone characteristics") may be insufficient. Specifically, even if a halftone photomask is used, there may be a case where a film thickness difference between the pixel defining layer and the thick film part cannot be formed, or a case where a region of the pixel defining layer disappears at the time of development. This is considered to be a dominant factor of the sensitivity of the photosensitive composition to light having a relatively small exposure energy through a halftone portion of the halftone photomask. That is, in the case of a positive-type photosensitive composition, when the sensitivity to light through the halftone portion is excessive, the region of the pixel defining layer is likely to disappear at the time of development. On the other hand, in a case of a negative-type photosensitive composition, when the sensitivity to the light through the halftone portion is excessive, it is likely to be difficult to form the film thickness difference between the pixel defining layer and the thick film part. In particular, in the case of the negative-type photosensitive composition, insufficient photo-curing tends to occur in a region where the exposure energy is relatively small, and the region of the pixel defining layer often disappears at the time of development, so that stable pattern processing is difficult.

On the other hand, in the formation of an opening by photolithography using a photosensitive composition, when an opening dimensional error (hereinafter, referred to as "mask bias property") from a pattern dimension of a photomask is large, this leads to a design error of a light-emitting pixel region on an anode, which adversely affects light-emitting characteristics of an organic EL display. In order to suppress the mask bias property, a method for adjusting the pattern dimension of the photomask according to the characteristics of the photosensitive composition can be mentioned, but there is also another problem that design such as pattern arrangement and resolution of the photomask is limited. In addition, when the mask bias property is excessively large, it is difficult to improve the pattern dimension adjustment of the photomask. The mask bias property includes a characteristic that the opening dimension is narrower than the pattern dimension of the photomask (hereinafter, referred to as "narrow mask bias") and a characteristic that the opening dimension is wider than the pattern dimension of the photomask (hereinafter, referred to as "wide mask bias"). Such a mask bias property is considered to be due to the influence of diffracted light at the time of pattern exposure, but it also depends on material characteristics. In the case of a positive-type photosensitive composition, the mask bias property varies depending on how much the alkali solubility improvement of the exposed portion is affected by the diffracted light. In general, when the alkali solubility of the exposed portion is insufficiently improved, the narrow mask bias is likely to occur, and when the alkali solubility of the exposed portion is excessive, the wide mask bias is likely to occur. On the other hand, in the case of the negative-type photosensitive composition, the mask bias property varies depending on how much the alkali solubility reduction due to the photo-curing of the exposed portion is affected by the diffracted light. In particular, in the case of the negative-type photosensitive composition, the influence of photo-curing due to radicals generated by diffracted light tends to be dominant, and the narrow mask bias is often generated. In addition, in a case where photo-curing of the exposed portion is insufficient, a wide mask bias is likely to occur.

When a process of forming a pixel defining layer or a composition of the photosensitive composition is changed in order to suppress such a mask bias property, the patternability of the photosensitive composition may be adversely affected. Therefore, it is difficult to achieve compatibility with various characteristics such as sensitivity improvement at the time of exposure required from the viewpoint of process time reduction and productivity improvement, and excellent halftone characteristics required from the viewpoint of productivity improvement and yield improvement. Therefore, as the photosensitive composition, a material having improved sensitivity at the time of exposure, suppressed narrow mask bias of the opening pattern dimension after development, and excellent halftone characteristics is required. In addition, there is also a need for a material that can provide a cured film that can improve the reliability of light-emitting elements in display devices. In addition, the conventional compositions have had problems in providing cured products having migration resistance. However, both of the photosensitive compositions disclosed in Patent Documents 1 and 2 were insufficient in one of the above characteristics.

### SOLUTIONS TO THE PROBLEMS

In order to solve the problems as described above, the present invention has the constitution as described below. That is:
[1] A photosensitive composition satisfying a condition (α) or a condition (β) below, wherein a double bond equivalent in total solid content is 600 to 6,000 g/mol: the condition (α): containing a compound of (I) described below and/or a compound of (II) described below:
   (I) a compound having a weakly acidic group (WA) below and a radical polymerizable group;
   (II) a compound having a weakly acidic group (WA) below and Compound having a radical polymerizable group; or
   the condition (β): containing an alkali-soluble resin (A), a radical polymerizable compound (B), and a photosensitive agent (C):
   the weakly acidic group (WA): one or more groups selected from the group consisting of a phenolic hydroxyl group, a hydroxyimide group, a hydroxyamide group, a silanol group, a 1,1-bis(trifluoromethyl) methylol group, and a mercapto group.
[2] The photosensitive composition according to [1], wherein a weakly acidic group equivalent in total solid content is 400 to 6,000 g/mol.
[3] The photosensitive composition according to the above [1] or [2], further containing one or more selected from the group consisting of a cyclic amide compound represented by general formula (20), an amide compound represented by general formula (21), a cyclic urea compound represented by general formula (22), and a urea compound represented by general formula (23), and a condition (4) described below is satisfied:
   (4) a total content of the cyclic amide compound represented by the general formula (20), the amide compound represented by the general formula (21), the cyclic urea compound represented by the general formula (22), and the urea compound represented by the general formula (23) in the total solid content of the photosensitive composition is 0.010% to 5.0% by mass. 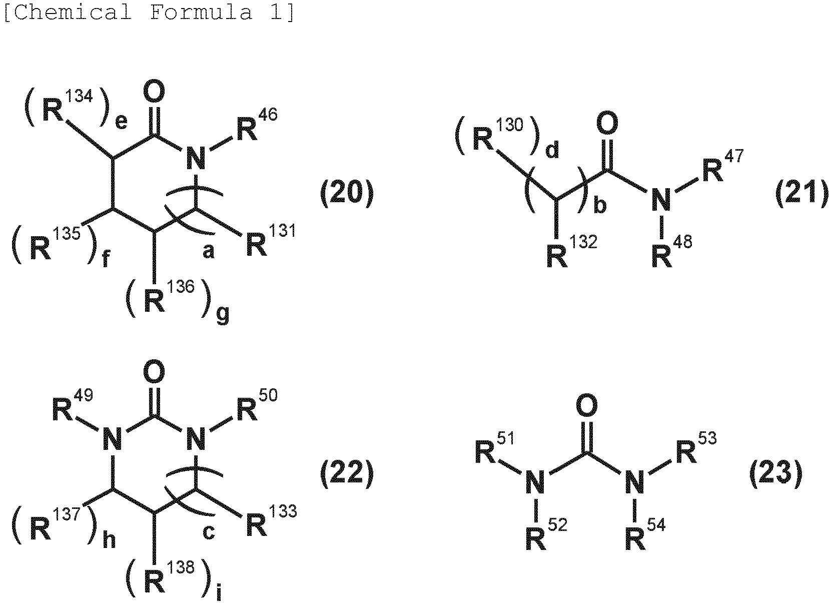
   (In the general formulae (20) to (23), R⁴⁶ to R⁵⁴ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms. R¹³⁰ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms. R¹³¹ to R¹³⁸ each independently represent an alkyl group having 1 to 6 carbon atoms, a, b, and c each independently represent an integer of 0 to 6. d represents 1 or 2. e, f, g, h, and i each independently represent an integer of 0 to 2. In a case where b is 0, d is 1.)
[4] The photosensitive composition according to [3], further containing one or more selected from the group consisting of a component containing a sodium element, a component containing a potassium element, a component containing a magnesium element, a component containing a calcium element, a component containing an iron element, a component containing a copper element, and a component containing a chromium element, and a condition (5) described below is satisfied:
   (5) a total content of the sodium element, the potassium element, the magnesium element, the calcium element, the iron element, the copper element, and the chromium element in the total solid content of the photosensitive composition is 0.010 to 500 ppm by mass.
[5] The photosensitive composition according to any one of [1] to [4], containing an alkali-soluble resin (A), wherein the alkali-soluble resin (A) has the weakly acidic group (WA), a phenol equivalent in a total solid content is 400 to 6,000 g/mol, and the alkali-soluble resin (A) has a phenolic hydroxyl group.
[6] The photosensitive composition according to [5], wherein the alkali-soluble resin (A) contains one or more selected from the group consisting of a resin (A3-1), a resin (A3-2), a resin (A3-3), and a resin (A3-4) described below:
   the resin (A3-1): a phenol resin;
   the resin (A3-2): polyhydroxystyrene;
   the resin (A3-3): a phenol group-containing epoxy resin; and
   the resin (A3-4): a phenol group-containing acrylic resin.
[7] The photosensitive composition according to [6], wherein the resin (A3-1), the resin (A3-2), the resin (A3-3), and the resin (A3-4) have one or more selected from the group consisting of a structural unit (3x), a structural unit (3y), and a structural unit (3z) below, an aromatic group in the structural unit (3y) is an aromatic group different from an aromatic ring to which a phenolic hydroxyl group is bonded, and a second aromatic group in the structural unit (3z) is an aromatic group excluding an aromatic ring to which a phenolic hydroxyl group is bonded:
   the structural unit (3x): a structural unit containing at least two phenolic hydroxyl groups;
   the structural unit (3y): a structural unit containing a phenolic hydroxyl group and an aromatic group; and
   the structural unit (3z): a structural unit containing a phenolic hydroxyl group and a structural unit containing a second aromatic group.
[8] The photosensitive composition according to any one of [2] to [7], containing an alkali-soluble resin (A); a radical polymerizable compound (B); and a photosensitive agent (C), wherein the alkali-soluble resin (A) contains a resin having a radical polymerizable group and a resin not having a radical polymerizable group, and the photosensitive agent (C) contains a photo-polymerization initiator (C1).
[9] The photosensitive composition according to any one of [1] to [8], wherein the weakly acidic group equivalent in total solid content is 400 to 1,500 g/mol, and the double bond equivalent is 750 to 6,000 g/mol.
[10] The photosensitive composition according to any one of [1] to [9], further containing inorganic particles (I), wherein the inorganic particles (I) contain silica particles (I1).
[11] The photosensitive composition according to any one of [1] to [10], further containing one or more selected from the group consisting of a halogen element-containing component, a sulfur element-containing component, and a phosphorus element-containing component, and satisfying one or more of conditions (1) to (3) below:
   (1) a content of the halogen elements in the photosensitive composition is 0.01 to 100 ppm by mass;
   (2) a content of the sulfur elements in the photosensitive composition is 0.01 to 100 ppm by mass; and
   (3) a content of the phosphorus elements in the photosensitive composition is 0.01 to 100 ppm by mass.
[12] The photosensitive composition according to any one of [1] to [11], containing an alkali-soluble resin (A), wherein the alkali-soluble resin (A) contains one or more selected from the group consisting of a resin (A1), a resin (A2), and a resin (A3) below:
   the resin (A1): a resin having the weakly acidic group (WA), further having a structural unit containing one or more selected from the group consisting of an imide structure, an amide structure, an oxazole structure, and a siloxane structure, and having no radical polymerizable group;
   the resin (A2): a resin having a radical polymerizable group; and
   the resin (A3): a resin having a phenolic hydroxyl group.
[13] The photosensitive composition according to [12], wherein the alkali-soluble resin (A) contains the resin (A1) and/or the resin (A3), and further contains the resin (A2) :
   the resin (A2): a resin having a radical polymerizable group.
[14] The photosensitive composition according to any one of [1] to [13], further containing an organic black pigment (D1a-1) and/or a coloring pigment mixture of two or more colors (D1a-3), wherein the organic black pigment (D1a-1) contains one or more selected from the group consisting of a benzofuranone-based black pigment (D1a-1a), a perylene-based black pigment (D1a-1b), and an azo-based black pigment (D1a-1c), and the coloring pigment mixture of two or more colors (D1a-3) contains two or more pigments selected from the group consisting of red, orange, yellow, green, blue, and violet pigments.
[15] The photosensitive composition according to any one of [1] to [14], further containing a radical polymerizable compound (B), and satisfying at least one of conditions (γ), (δ), and (ε) below:
   the condition (γ): a radical polymerizable compound (B) contains a fourth polymerizable compound (B4) and a fifth polymerizable compound (B5) below;
   the condition (δ): a radical polymerizable compound (B) contains a sixth polymerizable compound (B6) and a seventh polymerizable compound (B7) below; and
   the condition (ε): a radical polymerizable compound (B) contains the fourth polymerizable compound (B4) or the fifth polymerizable compound (B5) below, and further contains the sixth polymerizable compound (B6) or the seventh polymerizable compound (B7) below:
      the fourth polymerizable compound (B4): a compound having a structure (I-b4) below and further having at least two radical polymerizable groups:
      the structure (I-b4): a structure including an alicyclic structure and/or a structure including a heteroalicyclic structure,
      the fifth polymerizable compound (B5): a compound having a structure (I-b5) and a structure (II-b5) below and further having at least two radical polymerizable groups:
         the structure (I-b5): a structure including an aromatic structure; and
         the structure (II-b5): a structure including an aliphatic structure,
         the sixth polymerizable compound (B6): a compound having at least two (meth)acryloyl groups and further having a structure (I-b6) below:
            the structure (I-b6): a structure having at least two (meth)acryloyl groups linked with a minimum number of atoms of 4 to 10 and an aliphatic structure, and
            the seventh polymerizable compound (B7): a compound having at least two (meth)acryloyl groups and further having a structure (I-b7) below:
               the structure (I-b7): a structure having at least two (meth)acryloyl groups linked with a minimum number of atoms of 11 to 45 and an aliphatic structure.
[16] A cured product obtained by curing the photosensitive composition according to any one of [1] to [15].
[17] A display device including the cured product according to [16].
[18] An electronic component including the cured product according to [16].
[19] A method for producing a cured product, the method comprising: (1) forming a coating film of the photosensitive composition according to any one of [1] to [15] on a substrate; (2) irradiating a coating film of the photosensitive composition with active actinic rays through a photomask; (3) developing using an alkaline solution to form a pattern of the photosensitive composition; and (4) heating the pattern to obtain a cured pattern of the photosensitive composition, wherein the photomask is a halftone photomask including a light-transmitting portion, a light-shielding portion, and a partial light-transmitting portion between the light-transmitting portion and the light-shielding portion, the partial light-transmitting portion having a transmittance lower than a value of the light-transmitting portion and a transmittance higher than a value of the light-shielding portion.
[20] A display device comprising at least a substrate, a first electrode, a second electrode, and a pixel defining layer, and further comprising an organic EL layer including a light-emitting layer and/or a light extraction layer including a light-emitting layer, wherein the pixel defining layer is formed so as to overlap a part of the first electrode, the organic EL layer including the light-emitting layer and/or the light extraction layer including the light-emitting layer are formed on the first electrode and between the first electrode and the second electrode, the pixel defining layer includes a colorant (D-DL), and optical density of the pixel defining layer at a wavelength of visible light per 1 µm of film thickness is 0.5 to 5.0, the pixel defining layer contains a resin having a weakly acidic group (WA) below, a resin having a weakly acidic group (WA) contains one or more selected from the group consisting of a resin (XA3-1), a resin (XA3-2), a resin (XA3-3), and a resin (XA3-4) below, and the display device satisfies conditions (1x) and/or (2x) below:
   the weakly acidic group (WA): one or more groups selected from the group consisting of a phenolic hydroxyl group, a hydroxyimide group, a hydroxyamide group, a silanol group, a 1,1-bis(trifluoromethyl) methylol group, and a mercapto group.
   the resin (XA3-1): a phenol resin;
   the resin (XA3-2): polyhydroxystyrene;
   the resin (XA3-3): a phenol group-containing epoxy resin;
   the resin (XA3-4): a phenol group-containing acrylic resin; (1x) when a maximum value of a surface roughness of a surface of a thin film part in a step shape of the pixel defining layer is represented by (Ra_{HT/max}) and a maximum value of a surface roughness of a surface of a thick film part in a step shape of the pixel defining layer is represented by (Ra_{FT/max}), a difference |Δ (Ra_{HT/max} - Ra_{FT/max})| between (Ra_{HT/max}) and (Ra_{FT/max}) is 1.0 to 50.0 nm; and
   (2x) when (Ra_{DL/max}) is a maximum value of surface roughness on a surface of the pixel defining layer, and (Ra_{SP/max}) is a maximum value of surface roughness on a surface of a spacer layer on the pixel defining layer, a difference |Δ(Ra_{DL/max} - Ra_{SP/max})| between (Ra_{DL/max}) and (Ra_{SP/max}) is 1.0 to 50.0 nm.

### EFFECTS OF THE INVENTION

The photosensitive composition of the present invention has improved sensitivity at the time of exposure, suppressed narrow mask bias of the opening pattern dimension after development, and excellent halftone characteristics. In addition, according to the photosensitive composition of the present invention, it is possible to provide a cured film capable of improving the reliability of a light-emitting element in a display device. In addition, according to the photosensitive composition of the present invention, a cured film capable of improving migration resistance in an electronic component can be provided. Further, according to the display device of the present invention, the reliability of the light-emitting element can be improved. According to the electronic component of the present invention, the migration resistance of the element can be improved.

### BRIEF DESCRIPTION OF THE DRAWINGS

Fig. 1 is a sectional view illustrating a cross section example of a cured pattern with a step shape.
Fig. 2 is a schematic sectional view illustrating an enlarged section of an example of a pad portion of a semiconductor device having a bump.
Fig. 3 is a process diagram illustrating, in schematic cross-sectional views, a manufacturing process of Step 1 to Step 7 in an organic EL display that uses a cured product of a photosensitive composition of the present invention.
Fig. 4 is a schematic view illustrating the arrangement and dimensions of a light-transmitting portion, a light-shielding portion, and a partial light-transmitting portion in a halftone photomask for use in halftone characteristic evaluation.
Fig. 5 is a schematic view illustrating, in plan views, a producing process of Step 1 to Step 4 for a substrate of an organic EL display for use in the evaluation of light-emitting characteristics.

### EMBODIMENTS OF THE INVENTION

### <Photosensitive Composition>

Hereinafter, the photosensitive composition of the present invention will be described.

The photosensitive composition of the present invention is a photosensitive composition satisfying a condition (α) or a condition (β) below, wherein a double bond equivalent in total solid content is 600 to 6,000 g/mol.

Condition (α): Containing a compound of (I) described below and/or a compound of (II) described below:
(I) Compound having a weakly acidic group (WA) below and a radical polymerizable group
(II) Compound having a weakly acidic group (WA) below and Compound having a radical polymerizable group

### Condition (β): Containing an alkali-soluble resin (A), a radical polymerizable compound (B), and a photosensitive agent (C)

Weakly acidic group (WA): one or more groups selected from the group consisting of a phenolic hydroxyl group, a hydroxyimide group, a hydroxyamide group, a silanol group, a 1,1-bis(trifluoromethyl) methylol group, and a mercapto group.

In the present invention, a photosensitive composition that satisfies the above condition (α) and has a double bond equivalent in the total solid content within the above range may be referred to as a first aspect of the photosensitive composition of the present invention.

In addition, a photosensitive composition that satisfies the above condition (β) and has a double bond equivalent in the total solid content within the above range may be referred to as a second aspect of the photosensitive composition of the present invention.

In addition, "a compound (I) having a weakly acidic group (WA) and a radical polymerizable group" may be simply referred to as "compound (I)". In addition, the "compound having a weakly acidic group (WA)" in the above (II) may be simply referred to as a "compound (IIa)", and the "compound having a radical polymerizable group" in the above (II) may be simply referred to as a "compound (IIb)".

In the present invention, the radical polymerizable group refers to a group to which a methyl radical can be added at room temperature, and a group that generates another radical when the methyl radical is added. Examples of a method for generating a methyl radical at room temperature include a method in which a photo-polymerization initiator having an acetyloxime ester structure is irradiated with active actinic rays (radiation). Examples of a method for detecting another radical generated when a methyl radical is added include electron spin resonance analysis. Examples of a method for confirming that another radical is generated when a methyl radical is added include a method in which a composition obtained by dissolving a compound having a radical polymerizable group and a photo-polymerization initiator having an acetyloxime ester structure in a solvent is irradiated with active actinic rays, and the presence or absence of an increase in viscosity before and after irradiation with the active actinic rays, or a change in appearance such as gelation or film formation is confirmed. Examples of the active actinic rays include visible light, ultraviolet rays, electron beams, X-rays or the like. It is preferable that another radical generated when a methyl radical is added to a radical polymerizable group can be further added to another radical polymerizable group. In addition, it is preferable to generate still another radical in the same manner when a methyl radical is added to still another radical polymerizable group. As another radical generated when the methyl radical is added to the radical polymerizable group, a carbon radical, an oxygen radical, a nitrogen radical, or a sulfur radical is preferable, and a carbon radical is more preferable.

### <Double bond equivalent in total solid content of photosensitive composition>

The photosensitive composition of the present invention has a double bond equivalent in the total solid content of 600 to 6,000 g/mol. When the double bond equivalent in the total solid content of the photosensitive composition is 600 to 6,000 g/mol, the effect of improving the sensitivity at the time of exposure becomes remarkable. In addition, the effect of improving the reliability of the light-emitting element in the display device becomes remarkable.

As described above, in a case of a positive-type photosensitive composition, when the alkali solubility of the exposed portion is not sufficiently improved, the narrow mask bias is likely to occur. By setting the double bond equivalent in the total solid content of the photosensitive composition to a specific range, it is presumed that the alkali solubility in the exposed portion is improved by the interaction between a double bond group of the resin or the like in the photosensitive composition and an aromatic ring of the photosensitive agent (C) described later, whereby the narrow mask bias is suppressed. In addition, since alkali solubility improvement caused by the photosensitive agent (C) to be described later does not occur in the unexposed portion, n-bond stacking due to interaction between the double bond group of the resin or the like in the photosensitive composition and the aromatic ring of the photosensitive agent (C) to be described later becomes dominant, and it is presumed that halftone processability is improved since the halftone exposed portion has gradual development film loss.

On the other hand, in a case of a negative-type photosensitive composition, the narrow mask bias is likely to be generated due to the influence of photo-curing by radicals generated by diffracted light. It is presumed that by setting the double bond equivalent in the total solid content of the photosensitive composition within a specific range, the influence of the photo-curing due to radicals generated by the diffracted light at the time of pattern exposure can be minimized, and the narrow mask bias is suppressed. In addition, it is presumed that by controlling excessive photo-curing in the exposed portion with an appropriate amount of double bond groups, the gradient of the degree of photo-curing with respect to the exposure energy can be made gradual, so that halftone processability is improved.

In the photosensitive composition of the present invention, the double bond equivalent in the total solid content of the photosensitive composition is preferably 650 g/mol or more, more preferably 700 g/mol or more, still more preferably 750 g/mol or more, still more preferably 800 g/mol or more, and particularly preferably 850 g/mol or more, from the viewpoint of suppressing the narrow mask bias after development and improving the halftone characteristics. Furthermore, it is preferably 900 g/mol or more and more preferably 1,000 g/mol or more, from the viewpoint of suppressing the narrow mask bias after development and improving the halftone characteristics. On the other hand, the double bond equivalent in the total solid content of the photosensitive composition is preferably 3,000 g/mol or less, more preferably 2,500 g/mol or less, still more preferably 2,000 g/mol or less, still more preferably 1,700 g/mol or less, and particularly preferably 1,500 g/mol or less from the viewpoint of improving the sensitivity at the time of exposure and the reliability of the light-emitting element in the display device.

The double bond equivalent is calculated from the mass of the total solid content in the photosensitive composition and the iodine value of each component having a double bond group in the photosensitive composition. The iodine value refers to a value obtained by converting the amount of halogen that reacts with 100 g of the photosensitive composition into the mass of iodine and converting the mass of iodine into 100 g of the solid content of the photosensitive composition. The unit of iodine value is gI/100 g.

In the photosensitive composition of the present invention, it is preferable that only one or more selected from the group consisting of an alkali-soluble resin (A), a radical polymerizable compound (B), a photosensitive agent (C), a dispersant (E), a compound (F), and a cross-linking agent (G) have an ethylenically unsaturated double bond group, it is more preferable that only one or more selected from the group consisting of the alkali-soluble resin (A), the radical polymerizable compound (B), and the cross-linking agent (G) have an ethylenically unsaturated double bond group, and it is still more preferable that only the alkali-soluble resin (A) and/or the radical polymerizable compound (B) have an ethylenically unsaturated double bond group.

The photosensitive composition of the present invention contains a compound having a radical polymerizable group. The radical polymerizable group is preferably an ethylenically unsaturated double bond group. The radical polymerizable group is more preferably one or more selected from the group consisting of a photoreactive group, an alkenyl group having 2 to 5 carbon atoms, and an alkynyl group having 2 to 5 carbon atoms from the viewpoint of improving the sensitivity at the time of exposure, improving the reliability of the light-emitting element in the display device, and accelerating radical polymerization in heating at a low temperature. The photoreactive group is preferably a styryl group, a cinnamoyl group, a maleimide group, or a (meth)acryloyl group, and more preferably a (meth)acryloyl group. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and more preferably a vinyl group or an allyl group.

In the second aspect of the photosensitive composition of the present invention, from the viewpoint of improving the sensitivity at the time of exposure and improving the halftone characteristics, and from the viewpoint of improving the reliability of the light-emitting element in the display device, the alkali-soluble resin (A) preferably contains a resin (A2) described later.

### Resin (A2): A resin having a radical polymerizable group.

In the photosensitive composition of the present invention, it is preferable that one or more selected from the group consisting of an alkali-soluble resin (A), a radical polymerizable compound (B), a photosensitive agent (C), a dispersant (E), a compound (F), and a cross-linking agent (G) described later have a radical polymerizable group, and it is preferable that a colorant (D), and a dissolution accelerator (H) described later do not have a radical polymerizable group.

It is more preferable that one or more selected from the group consisting of the alkali-soluble resin (A), the radical polymerizable compound (B), and the cross-linking agent (G) have a radical polymerizable group, and the photosensitive agent (C), the colorant (D), the dispersant (E), the compound (F), and the dissolution accelerator (H) do not have a radical polymerizable group.

It is still more preferable that the alkali-soluble resin (A) and/or the radical polymerizable compound (B) have a radical polymerizable group, and the photosensitive agent (C), the colorant (D), the dispersant (E), the compound (F), the cross-linking agent (G), and the dissolution accelerator (H) do not have a radical polymerizable group.

In the first aspect of the photosensitive composition of the present invention, the compound (I) preferably contains one or more selected from the group consisting of the alkali-soluble resin (A), the radical polymerizable compound (B), and the cross-linking agent (G) described later, and more preferably contains the alkali-soluble resin (A) and/or the cross-linking agent (G).

A compound (IIa) preferably contains one or more selected from the group consisting of the alkali-soluble resin (A), the radical polymerizable compound (B), the cross-linking agent (G), and the dissolution accelerator (H) described later, and more preferably contains the alkali-soluble resin (A) and/or the cross-linking agent (G).

A compound (IIb) preferably contains one or more selected from the group consisting of the alkali-soluble resin (A), the radical polymerizable compound (B), the photosensitive agent (C), the dispersant (E), the compound (F), and the cross-linking agent (G) described later, and more preferably contains one or more selected from the group consisting of the alkali-soluble resin (A), the radical polymerizable compound (B), and the cross-linking agent (G).

### <Weakly acidic group equivalent in total solid content of photosensitive composition>

A first preferable aspect of the photosensitive composition of the present invention is a photosensitive composition satisfying the above condition (α), in which a weakly acidic group equivalent in the total solid content is 400 to 6,000 g/mol.

In addition, a second preferable aspect of the photosensitive composition of the present invention is a photosensitive composition satisfying the above condition (β), in which a weakly acidic group equivalent in the total solid content is 400 to 6,000 g/mol.

In the photosensitive composition of the present invention, when the weakly acidic group equivalent in the total solid content of the photosensitive composition is 400 to 6,000 g/mol, the effects of suppressing a narrow mask bias and improving the halftone characteristics after development are remarkable. The weakly acidic group in the weakly acidic group equivalent is the above-described weakly acidic group (WA).

As described above, in general, in a case of a positive-type photosensitive composition, when the alkali solubility of the exposed portion is not sufficiently improved, a narrow mask bias is likely to occur. On the other hand, in the present invention, it is presumed that by setting the weakly acidic group equivalent in the total solid content of the photosensitive composition within a specific range, residues in the exposed portion are suppressed by an appropriate amount of the weakly acidic group, and the alkali solubility is improved even with diffracted light at the time of pattern exposure, whereby the narrow mask bias is suppressed. In addition, in the unexposed portion, it is presumed that halftone processability is improved because the halftone exposed portion has gradual development film loss due to the mild acidity of the weakly acidic group.

In addition, in a case of a negative-type photosensitive composition, generally, a narrow mask bias is likely to be generated due to the influence of photo-curing by radicals generated by diffracted light. On the other hand, in the present invention, it is presumed that by setting the weakly acidic group equivalent in the total solid content of the photosensitive composition within a specific range, residues in the unexposed portion are suppressed by an appropriate amount of the weakly acidic group, and side etching in a deep portion of a film at the time of alkali development in the exposed portion is suppressed, whereby the narrow mask bias is suppressed. In addition, it is presumed that halftone processability is improved because the halftone exposed portion has gradual development film loss due to the mild acidity of the weakly acidic group. In addition, by setting the phenol equivalent in the total solid content of the photosensitive composition to a specific range in addition to setting the weakly acidic group equivalent in the total solid content of the photosensitive composition to a specific range, the phenolic hydroxyl group can stabilize radicals generated by diffracted light at the time of pattern exposure, and by controlling excessive photo-curing in the exposed portion by the phenolic hydroxyl group, the gradient of the degree of photo-curing with respect to the exposure energy can be made gradual, which is more preferable from the viewpoint of suppressing the narrow mask bias and improving the halftone characteristics.

In the photosensitive composition of the present invention, the weakly acidic group equivalent in total solid content of the photosensitive composition is preferably 450 g/mol or more, more preferably 500 g/mol or more, still more preferably 550 g/mol or more, still more preferably 600 g/mol or more, and particularly preferably 700 g/mol or more from the viewpoint of improving the sensitivity at the time of exposure and improving the reliability of the light-emitting element in the display device. Furthermore, it is preferably 750 g/mol or more and more preferably 800 g/mol or more, from the viewpoint of suppressing the narrow mask bias after development and improving the halftone characteristics. On the other hand, the weakly acidic group equivalent in the total solid content of the photosensitive composition is preferably 3,000 g/mol or less, more preferably 2,500 g/mol or less, still more preferably 2,000 g/mol or less, still more preferably 1,700 g/mol or less, and particularly preferably 1,500 g/mol or less from the viewpoint of suppressing residues after development, and suppressing the narrow mask bias after development and improving the halftone characteristics.

In the photosensitive composition of the present invention, from the viewpoint of suppressing the narrow mask bias after development and improving the halftone characteristics, in addition to the fact that the weakly acidic group equivalent is in any of the above-described ranges, the phenol equivalent, the hydroxyimide equivalent, the hydroxyamide equivalent, or the silanol equivalent in the total solid content of the photosensitive composition is preferably 400 to 6,000 g/mol, the phenol equivalent or the silanol equivalent is more preferably 400 to 6,000 g/mol, and the phenol equivalent is still more preferably 400 to 6,000 g/mol. A more preferable range of the phenol equivalent, the hydroxyimide equivalent, the hydroxyamide equivalent, or the silanol equivalent is the same as the preferable range of the weakly acidic group equivalent described above. In particular, by setting the phenol equivalent within the above range, the effects of suppressing the narrow mask bias and improving the halftone characteristics become more remarkable. Although the reason is not clear, it can be presumed as follows. That is, it is presumed that the phenolic hydroxyl group can stabilize radicals generated by diffracted light at the time of pattern exposure. In addition, it is presumed that the gradient of the degree of photo-curing with respect to the exposure energy can be made gradual by controlling excessive photo-curing in the exposed portion by the phenolic hydroxyl group. As a result, it is presumed that the effect of suppressing the narrow mask bias and improving the halftone characteristics becomes more remarkable.

The weakly acidic group equivalent can be obtained by measuring the following weakly acidic group value.

Weakly acidic group value: Total of phenol value, hydroxyimide value, hydroxyamide value, silanol value, 1,1-bis(trifluoromethyl) methylol value, and mercapto value.

In the photosensitive composition of the present invention, the weakly acidic group equivalent is a weakly acidic group equivalent determined from the weakly acidic group value in the total solid content of the photosensitive composition. That is, it is a weakly acidic group equivalent calculated from the mass of the total solid content in the photosensitive composition and the weakly acidic group value of each component having a weakly acidic group in the photosensitive composition. The weakly acidic group value refers to a value obtained by converting the mass of potassium hydroxide that reacts with 1 g of the photosensitive composition per 1 g of the solid content of the photosensitive composition. The unit of weakly acidic group value is mgKOH/g.

In the photosensitive composition of the present invention, it is preferable that only one or more selected from the group consisting of the alkali-soluble resin (A), the radical polymerizable compound (B), the cross-linking agent (G), and the dissolution accelerator (H) has a weakly acidic group (WA), it is more preferable that only the alkali-soluble resin (A) and/or the cross-linking agent (G) has a weakly acidic group (WA), and it is still more preferable that only the alkali-soluble resin (A) has a weakly acidic group (WA).

In the photosensitive composition of the present invention, the weakly acidic group equivalent in the total solid content of the photosensitive composition is preferably 400 to 1,500 g/mol, and the double bond equivalent in the total solid content of the photosensitive composition is preferably 750 to 6,000 g/mol from the viewpoint of improving the sensitivity at the time of exposure, suppressing the narrow mask bias after development, and improving the halftone characteristics, and improving the reliability of the light-emitting element in the display device.

When the photosensitive composition contains a plurality of resins such as a resin having a weakly acidic group (WA) and other resins having an acidic group, it is preferable to remove components in the composition that can be separated by a method such as centrifugation, liquid separation extraction, or column chromatography, and then separate the respective resins by GPC fractionation. Thereafter, it is preferable to measure the weakly acidic group equivalent and other acid equivalents of each resin. In addition, when the photosensitive composition contains a resin having a weakly acidic group (WA) and other acidic groups, and when the photosensitive composition contains a resin having two or more weakly acidic groups (WA), it is preferable to liberate one kind of acidic group by adding a protective group using a difference in reactivity between the acidic groups. Thereafter, it is preferable to measure the weakly acidic group equivalent or other acid equivalents. Next, it is preferable to appropriately repeat addition of a further protective group and deprotection of the protective group to release each acidic group. Thereafter, it is preferable to measure a weakly acidic group equivalent or another acid equivalent for each acidic group.

In the photosensitive composition of the present invention, the weakly acidic group (WA) preferably contains a phenolic hydroxyl group, a hydroxyimide group, a hydroxyamide group, or a silanol group, more preferably contains a phenolic hydroxyl group or a silanol group, and still more preferably contains a phenolic hydroxyl group.

In the photosensitive composition of the present invention, it is preferable that one or more selected from the group consisting of the alkali-soluble resin (A), the radical polymerizable compound (B), the cross-linking agent (G), and the dissolution accelerator (H) described later have a phenolic hydroxyl group, and it is more preferable that the alkali-soluble resin (A) and/or the cross-linking agent (G) have a phenolic hydroxyl group. In such a case, it is preferable that the photosensitive agent (C), the colorant (D), the dispersant (E), and the compound (F) described later do not have a phenolic hydroxyl group.

### <Alkali-soluble resin (A)>

The first aspect of the photosensitive composition of the present invention preferably contains an alkali-soluble resin (A). In the first aspect of the photosensitive composition of the present invention, the compound (I) and/or the compound (IIa) preferably contains the alkali-soluble resin (A), and the compound (IIa) more preferably contains the alkali-soluble resin (A). In addition, it is more preferable that the compound (I) and the compound (IIa) contain the alkali-soluble resin (A).

On the other hand, the second aspect of the photosensitive composition according to the present invention contains an alkali-soluble resin (A).

The photosensitive composition of the present invention contains the alkali-soluble resin (A), and the alkali-soluble resin (A) preferably has a weakly acidic group (WA) from the viewpoint of suppressing the narrow mask bias after development and improving the halftone characteristics. The weakly acidic group (WA) more preferably contains a phenolic hydroxyl group.

When the photosensitive composition of the present invention contains the alkali-soluble resin (A), and the alkali-soluble resin (A) has the weakly acidic group (WA), the photosensitive composition of the present invention preferably has a phenol equivalent in the total solid content of 400 to 6,000 g/mol, and the alkali-soluble resin (A) has a phenolic hydroxyl group, from the viewpoint of suppressing the narrow mask bias after development and improving the halftone characteristics.

When the alkali-soluble resin (A) has a phenolic hydroxyl group, it is preferable that the photosensitive agent (C), the colorant (D), the dispersant (E), and the compound (F) described later do not have a phenolic hydroxyl group, and it is more preferable that the radical polymerizable compound (B) and the dissolution accelerator (H) described later do not have a phenolic hydroxyl group.

The photosensitive composition of the present invention contains the alkali-soluble resin (A), and the alkali-soluble resin (A) preferably has a radical polymerizable group.

In the photosensitive composition of the present invention, the radical polymerizable group in the alkali-soluble resin (A) is preferably one or more selected from the group consisting of a photoreactive group, an alkenyl group having 2 to 5 carbon atoms, and an alkynyl group having 2 to 5 carbon atoms from the viewpoint of improving the sensitivity at the time of exposure, improving the reliability of the light-emitting element in the display device, and accelerating radical polymerization in heating at a low temperature. The photoreactive group is more preferably a (meth)acryloyl group. The alkenyl group having 2 to 5 carbon atoms or the alkynyl group having 2 to 5 carbon atoms is more preferably a vinyl group or an allyl group.

When the alkali-soluble resin (A) has a (meth)acryloyl group, a vinyl group, or an allyl group, it is preferable that the colorant (D) and the dissolution accelerator (H) described later do not have a (meth)acryloyl group, a vinyl group, or an allyl group, and it is more preferable that the photosensitive agent (C), the dispersant (E), and the compound (F) described later do not have a (meth)acryloyl group, a vinyl group, or an allyl group.

The photosensitive composition of the present invention preferably contains the alkali-soluble resin (A) and the radical polymerizable compound (B) to be described later, and the alkali-soluble resin (A) preferably contains a resin having a radical polymerizable group and a resin not having a radical polymerizable group, from the viewpoints of improving the sensitivity at the time of exposure, suppressing a narrow mask bias after development, improving the halftone characteristics, improving the reliability of a light-emitting element in a display device, improving mechanical properties in heating at a low temperature, and improving migration resistance.

With the above configuration, it is considered that the resin having no radical polymerizable group exhibits suppression of residues after development by an alkali-soluble group or an organic solvent-soluble structure, suppression of migration by the ability to trap metal impurities and ion impurities, and the like, and the resin having a radical polymerizable group exhibits improvement in sensitivity at the time of exposure, promotion of radical polymerization in heating at a low temperature, and the like. It is estimated that the effect of improving a plurality of characteristics becomes remarkable by such function separation in the resin.

In the photosensitive composition of the present invention, when the weakly acidic group equivalent in the total solid content of the photosensitive composition is 400 to 6,000 g/mol, it is preferable that the photosensitive composition of the present invention contains an alkali-soluble resin (A), a radical polymerizable compound (B) described later, and a photosensitive agent (C) described later, in which the alkali-soluble resin (A) contains a resin having a radical polymerizable group and a resin not having a radical polymerizable group, and the photosensitive agent (C) contains a photo-polymerization initiator (C1) described later.

The radical polymerizable group of the alkali-soluble resin (A) and the radical polymerizable compound (B) is preferably an ethylenically unsaturated double bond group.

In the photosensitive composition of the present invention, the radical polymerizable group in the alkali-soluble resin (A) and the radical polymerizable compound (B) described later is preferably one or more selected from the group consisting of a photoreactive group, an alkenyl group having 2 to 5 carbon atoms, and an alkynyl group having 2 to 5 carbon atoms. The photoreactive group is more preferably a (meth)acryloyl group. The alkenyl group having 2 to 5 carbon atoms or the alkynyl group having 2 to 5 carbon atoms is more preferably a vinyl group or an allyl group.

When the alkali-soluble resin (A) and the radical polymerizable compound (B) described later have a (meth)acryloyl group, a vinyl group, or an allyl group, it is preferable that the colorant (D) and the dissolution accelerator (H) described later do not have a (meth)acryloyl group, a vinyl group, or an allyl group, and it is more preferable that the photosensitive agent (C), the dispersant (E), and the compound (F) described later do not have a (meth)acryloyl group, a vinyl group, or an allyl group.

### <Alkali-soluble resin (A); Resin (A1), Resin (A2), and Resin (A3)>

The photosensitive composition of the present invention contains an alkali-soluble resin (A), from the viewpoint of suppressing a narrow mask bias and improving the halftone characteristics after development, and from the viewpoint of improving reliability of a light-emitting element in a display device, and the alkali-soluble resin (A) preferably contains one or more selected from the group consisting of the following resin (A1), resin (A2), and resin (A3), and more preferably contains the resin (A1) and/or resin (A3),. In addition, it is preferable to contain the resin (A1) from the viewpoint of improving mechanical properties in heating at a low temperature and improving migration resistance.
Resin (A1): A resin having the weakly acidic group (WA), further having a structural unit containing one or more selected from the group consisting of an imide structure, an amide structure, an oxazole structure, and a siloxane structure, and having no radical polymerizable group
Resin (A2): A resin having a radical polymerizable group
Resin (A3): A resin having a phenolic hydroxyl group.

The resin (A3) preferably contains a resin having a phenolic hydroxyl group and a radical polymerizable group.

The resin (A1) preferably has one or more selected from the group consisting of an imide structure, an amide structure, an oxazole structure, and a siloxane structure in a structural unit in a main chain of the resin. The resin (A1) preferably has a weakly acidic group (WA) on at least one of a main chain of the resin, a side chain of the resin, and an end of the resin. The resin (A3) preferably has a phenolic hydroxyl group in at least one of a main chain of the resin, a side chain of the resin, and an end of the resin, and more preferably has a phenolic hydroxyl group in a structural unit in the main chain of the resin. The resin (A1), the resin (A3), and the following resin (A2) are different from each other.

When each of the resin (A1), the resin (A2), and the resin (A3) has a structure or a group constituting another resin among these resins, the resins are classified into any of the following rules. When a certain resin can correspond to two or more of the resin (A1), the resin (A2), and the resin (A3), which resin corresponds to the resin is determined as follows. That is, when a resin having a structural unit (hereinafter, simply referred to as "a structural unit such as an imide structure") containing one or more selected from the group consisting of an imide structure, an amide structure, an oxazole structure, and a siloxane structure and having no radical polymerizable group has a phenolic hydroxyl group, the resin corresponds to the resin (A1). Further, when the resin having a structural unit such as an imide structure has a radical polymerizable group and does not have a phenolic hydroxyl group, the resin corresponds to the resin (A2). On the other hand, when the resin having no structural unit such as an imide structure and having a radical polymerizable group has a phenolic hydroxyl group, the resin corresponds to the resin (A3). Further, when the resin having a structural unit such as an imide structure has a radical polymerizable group and further has a phenolic hydroxyl group, the resin corresponds to the resin (A2).

As described above, in a case of a positive-type photosensitive composition, when the alkali solubility of the exposed portion is not sufficiently improved, the narrow mask bias is likely to occur. When the resin (A3) having a phenolic hydroxyl group is contained, it is considered that the residue of the exposed portion is suppressed by the alkali dissolution acceleration action of the phenolic hydroxyl group, and the alkali solubility is improved even with diffracted light at the time of pattern exposure, so that the narrow mask bias is suppressed. In addition, in the unexposed portion, it is estimated that halftone processability is improved because the halftone exposed portion has gradual development film loss due to the mild acidity of the phenolic hydroxyl group. Similarly, when the resin (A1) having a structural unit containing one or more selected from the group consisting of an imide structure, an amide structure, an oxazole structure, and a siloxane structure, which are rigid skeletons, is contained, it is considered that the alkali solubility of the exposed portion is less likely to be excessive due to alkali dissolution inhibition by the rigid skeleton, and the halftone exposed portion has a gradual development film loss, so that suppression of a narrow mask bias after development and improvement of halftone characteristics are improved. Therefore, it is preferable that the alkali-soluble resin (A) contains the resin (A1) and/or the resin (A3), and it is more preferable that the resin (A1) has a phenolic hydroxyl group.

On the other hand, in a case of a negative-type photosensitive composition, the narrow mask bias is likely to be generated due to the influence of photo-curing by radicals generated by diffracted light. When the resin (A3) having a phenolic hydroxyl group is contained, it is considered that the residue of the unexposed portion is suppressed by the alkali dissolution acceleration action of the phenolic hydroxyl group, and the phenolic hydroxyl group is stabilized by the radical generated by the diffracted light at the time of pattern exposure, so that the narrow mask bias is suppressed. In addition, it is considered that the gradient of the degree of photo-curing with respect to the exposure energy can be made gradual by controlling excessive photo-curing in the exposed portion by the phenolic hydroxyl group. In addition, it is estimated that halftone processability is improved because the halftone exposed portion has gradual development film loss due to the mild acidity of the phenolic hydroxyl group. Similarly, when the resin (A1) having a structural unit containing one or more selected from the group consisting of an imide structure, an amide structure, an oxazole structure, and a siloxane structure, which are rigid skeletons, is contained, excessive photo-curing in the exposed portion is controlled by steric hindrance and molecular motion inhibition by the rigid skeleton. Furthermore, the alkali dissolution inhibition by the rigid skeleton suppresses side etching in a deep portion of a film at the time of alkali development in the exposed portion, and effects such as gradual development film loss in the halftone exposed portion are remarkable. Therefore, it is considered that the narrow mask bias is suppressed and the halftone characteristics are improved after development. Therefore, it is preferable that the alkali-soluble resin (A) contains the resin (A1) and/or the resin (A3), and it is more preferable that the resin (A1) has a phenolic hydroxyl group.

When the photosensitive composition of the present invention contains the alkali-soluble resin (A), and the alkali-soluble resin (A) contains the resin (A1) and/or the resin (A3), in the photosensitive composition of the present invention, it is preferable that the alkali-soluble resin (A) contains the resin (A1), and the resin (A1) contains one or more selected from the group consisting of a resin (A1-1), a resin (A1-2), a resin (A1-3), a resin (A1-4), a resin (A1-5), a resin (A1-6), and a resin (A1-7) described later, from the viewpoints of suppressing a narrow mask bias after development, improving the halftone characteristics, improving reliability of a light-emitting element in a display device, improving mechanical properties in heating at a low temperature, and improving migration resistance. The resin (A1) more preferably contains one or more selected from the group consisting of the following resin (A1-1), resin (A1-2), resin (A1-3), resin (A1-4), resin (A1-5), and resin (A1-6), and further preferably contains the resin (A1-1) and/or resin (A1-5). The resin (A1) may be a single resin or a copolymer thereof.
Resin (A1-1): Polyimide
Resin (A1-2): Polyimide precursor
Resin (A1-3): Polybenzoxazole
Resin (A1-4): Polybenzoxazole precursor
Resin (A1-5): Polyamideimide
Resin (A1-6): Polyamideimide precursor
Resin (A1-7): Polysiloxane.

The resin (A1) as described above has a structural unit containing an imide structure, an amide structure, an oxazole structure, or a siloxane structure, thereby obtaining an effect of improving the mechanical properties. In addition, since these structures trap metal impurities, ion impurities, and the like that adversely affect electrical insulation property, it is estimated that ion migration and electromigration are suppressed, and the migration resistance is improved.

In the photosensitive composition of the present invention, when the phenol equivalent in the total solid content is 400 to 6,000 g/mol and the alkali-soluble resin (A) has a phenolic hydroxyl group, in the photosensitive composition of the present invention, the alkali-soluble resin (A) preferably contains the resin (A1) and/or the resin (A3), more preferably contains the resin (A1), and still more preferably contains the resin (A1) and the resin (A3) .

In the photosensitive composition of the present invention, when the phenol equivalent in the total solid content is 400 to 6,000 g/mol and the alkali-soluble resin (A) has a phenolic hydroxyl group, in the photosensitive composition of the present invention, the alkali-soluble resin (A) preferably contains the resin (A3), and the resin (A3) preferably contains one or more selected from the group consisting of a resin (A3-1), a resin (A3-2), a resin (A3-3), and a resin (A3-4) described later, from the viewpoints of suppressing a narrow mask bias after development, improving the halftone characteristics, improving the reliability of a light-emitting element in a display device, improving mechanical properties in heating at a low temperature, and improving migration resistance. The resin (A3) more preferably contains the resin (A3-1) and/or the resin (A3-3), and still more preferably contains the resin (A3-1). The resin (A3) may be a single resin or a copolymer thereof.
Resin (A3-1): Phenol resin
Resin (A3-2): Polyhydroxystyrene
Resin (A3-3): Phenol group-containing epoxy resin
Resin (A3-4): Phenol group-containing acrylic resin.

The photosensitive composition of the present invention preferably contains the alkali-soluble resin (A), and the alkali-soluble resin (A) preferably contains the resin (A2), from the viewpoint of improving the sensitivity at the time of exposure and improving the halftone characteristics, and from the viewpoint of improving the reliability of the light-emitting element in the display device.

When the photosensitive composition of the present invention contains the alkali-soluble resin (A), and the alkali-soluble resin (A) contains the resin (A1) and/or the resin (A3), in the photosensitive composition of the present invention, the alkali-soluble resin (A) preferably further contains the resin (A2), from the viewpoints of improving the sensitivity at the time of exposure, suppressing a narrow mask bias after development, improving the halftone characteristics, improving the reliability of a light-emitting element in a display device, improving mechanical properties in heating at a low temperature, and improving migration resistance. The alkali-soluble resin (A) more preferably contains the resin (A1) and the resin (A2), and still more preferably contains the resin (A1), the resin (A3), and the resin (A2).

The radical polymerizable group of the resin (A2) is preferably one or more selected from the group consisting of a photoreactive group, an alkenyl group having 2 to 5 carbon atoms, and an alkynyl group having 2 to 5 carbon atoms from the viewpoint of improving the sensitivity at the time of exposure. The photoreactive group is preferably a styryl group, a cinnamoyl group, a maleimide group, or a (meth)acryloyl group, and more preferably a (meth)acryloyl group. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and more preferably a vinyl group or an allyl group.

The resin (A2) preferably contains one or more selected from the group consisting of a resin (A2-a), a resin (A2-b), a resin (A2-c), a resin (A2-d), a resin (A2-e), a resin (A2-f), a resin (A2-g), a resin (A2-1), a resin (A2-2), and a resin (A2-3) described later, from the viewpoint of suppressing a narrow mask bias and improving the halftone characteristics after development, and from the viewpoint of improving reliability of a light-emitting element in a display device. The resin (A2) more preferably contains one or more selected from the group consisting of the resin (A2-a), the resin (A2-b), the resin (A2-c), the resin (A2-d), the resin (A2-e), the resin (A2-f), and the resin (A2-g), further preferably contains one or more selected from the group consisting of the resin (A2-a), the resin (A2-b), the resin (A2-c), the resin (A2-d), the resin (A2-e), and the resin (A2-f), and particularly preferably contains the resin (A2-a) and/or the resin (A2-e).

On the other hand, from the viewpoint of improving the sensitivity at the time of exposure and improving the halftone characteristics, the resin (A2) more preferably contains one or more selected from the group consisting of the resin (A2-1), the resin (A2-2), and the resin (A2-3), and still more preferably contains the resin (A2-1) and/or the resin (A2-2).

In addition, the resin (A2) preferably contains one or more selected from the group consisting of the resin (A2-a), the resin (A2-b), the resin (A2-c), the resin (A2-d), the resin (A2-e), the resin (A2-f), and the resin (A2-g), and further contains one or more selected from the group consisting of the resin (A2-1), the resin (A2-2), and the resin (A2-3), from the viewpoints of improving the sensitivity at the time of exposure, suppressing a narrow mask bias, and improving the halftone characteristics after development, and from the viewpoint of improving reliability of a light-emitting element in a display device. The resin (A2) may be a single resin or a copolymer thereof.
Resin (A2-a): Unsaturated group-containing polyimide
Resin (A2-b): Unsaturated group-containing polyimide precursor
Resin (A2-c): Unsaturated group-containing polybenzoxazole
Resin (A2-d): Unsaturated group-containing polybenzoxazole precursor
Resin (A2-e): Unsaturated group-containing polyamideimide
Resin (A2-f): Unsaturated group-containing polyamideimide precursor
Resin (A2-g): Unsaturated group-containing polysiloxane
Resin (A2-1): Polycyclic side chain-containing resin
Resin (A2-2): Acid-modified epoxy resin
Resin (A2-3): Acrylic resin.

### <Alkali-soluble resin (A); Resin (A3a) and Resin (A3b) >

In the photosensitive composition of the present invention, the alkali-soluble resin (A) preferably contains a resin (A3b) described later from the viewpoint of improving the sensitivity at the time of exposure and improving the halftone characteristics.

Resin (A3b): A resin having a phenolic hydroxyl group and a radical polymerizable group, among the resins (A3).

The resin (A3b) preferably has a phenolic hydroxyl group on at least one of a main chain of the resin, a side chain of the resin, and an end of the resin, and has a radical polymerizable group on at least one of a side chain of the resin and an end of the resin. The resin (A3b) is a resin different from the resins (A1) and (A2).

The radical polymerizable group of the resin (A3b) is preferably one or more selected from the group consisting of a photoreactive group, an alkenyl group having 2 to 5 carbon atoms, and an alkynyl group having 2 to 5 carbon atoms from the viewpoint of improving the sensitivity at the time of exposure. The photoreactive group is preferably a styryl group, a cinnamoyl group, a maleimide group, or a (meth)acryloyl group, and more preferably a (meth)acryloyl group. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and more preferably a vinyl group or an allyl group.

The double bond equivalent of the resin (A3b) is preferably 500 g/mol or more, more preferably 700 g/mol or more, and still more preferably 1,000 g/mol or more from the viewpoint of suppressing the narrow mask bias after development and improving the halftone characteristics. On the other hand, the double bond equivalent is preferably 3,000 g/mol or less, more preferably 2,000 g/mol or less, and still more preferably 1,500 g/mol or less, from the viewpoint of improving the sensitivity at the time of exposure and improving the reliability of the light-emitting element in the display device.

In the photosensitive composition of the present invention, it is also preferable that the alkali-soluble resin (A) contains the following resin (A3a) from the viewpoint of suppressing the narrow mask bias after development and improving the halftone characteristics.

Resin (A3a): A resin having a phenolic hydroxyl group and having no radical polymerizable group, among the resins (A3) .

The resin (A3a) preferably has a phenolic hydroxyl group on at least one of a main chain of the resin, a side chain of the resin, and an end of the resin. The resin (A3a) is a resin different from the resins (A1) and (A2).

In the photosensitive composition of the present invention, the alkali-soluble resin (A) preferably contains the resin (A3b), and the alkali-soluble resin (A) further preferably contains the resin (A3a), from the viewpoint of improving the sensitivity at the time of exposure, suppressing a narrow mask bias after development, and improving the halftone characteristics, and from the viewpoint of improving the reliability of the light-emitting element in the display device.

### <Alkali-soluble group>

The resin (A1) and the resin (A2) have an acidic group as an alkali-soluble group on at least one of a main chain of the resin, a side chain of the resin, and an end of the resin. The resin (A1) has a weakly acidic group (WA) as an acidic group. Among the resins (A2), the resin (A2) having the structural unit such as an imide structure preferably has a weakly acidic group (WA) as an acidic group from the viewpoint of suppressing the narrow mask bias after development and improving the halftone characteristics.

On the other hand, the resin (A1) and the resin (A2) preferably have a carboxy group, a carboxylic anhydride group, or a sulfonic acid group as an acidic group, and more preferably have a carboxy group or a carboxylic anhydride group from the viewpoint of suppressing residues after development. The resin (A1) and the resin (A2) have a weakly acidic group (WA) as an acidic group, and further preferably have a carboxy group, a carboxylic anhydride group, or a sulfonic acid group. The resin (A1) and the resin (A2) are also preferably alkali-soluble resins and organic solvent-soluble resins. The alkali-soluble resin refers to a resin having solubility in an alkaline developer. The organic solvent-soluble resin refers to a resin having solubility of an organic solvent in a developer.

The acid equivalent of the resin (A1) is preferably 200 g/mol or more, more preferably 250 g/mol or more, still more preferably 300 g/mol or more, from the viewpoint of improving the sensitivity at the time of exposure and improving the reliability of the light-emitting element in the display device. On the other hand, the acid equivalent is preferably 600 g/mol or less, more preferably 500 g/mol or less, still more preferably 450 g/mol or less, from the viewpoint of suppressing residues after development, suppressing the narrow mask bias after development, and improving the halftone characteristics. In addition, the weakly acidic group equivalent of the resin (A1) is preferably in a specific range, the phenol equivalent, the hydroxyimide equivalent, the hydroxyamide equivalent, or the silanol equivalent of the resin (A1) is more preferably in a specific range, the phenol equivalent or the silanol equivalent of the resin (A1) is still more preferably in a specific range, and the phenol equivalent of the resin (A1) is particularly preferably in a specific range. The specific range of the weakly acidic group equivalent, the phenol equivalent, the hydroxyimide equivalent, the hydroxyamide equivalent, or the silanol equivalent is the same as the preferable range of the acid equivalent described above.

The acid equivalent of the resin (A2) is preferably 300 g/mol or more, more preferably 350 g/mol or more, still more preferably 400 g/mol or more, from the viewpoint of improving the sensitivity at the time of exposure and improving the reliability of the light-emitting element in the display device. On the other hand, the acid equivalent is preferably 700 g/mol or less, more preferably 600 g/mol or less, still more preferably 550 g/mol or less, from the viewpoint of suppressing residues after development, suppressing the narrow mask bias after development, and improving the halftone characteristics. In addition, the weakly acidic group equivalent of the resin (A2) is preferably in a specific range, the phenol equivalent, the hydroxyimide equivalent, the hydroxyamide equivalent, or the silanol equivalent of the resin (A2) is more preferably in a specific range, the phenol equivalent or the silanol equivalent of the resin (A2) is still more preferably in a specific range, and the phenol equivalent of the resin (A2) is particularly preferably in a specific range. The specific range of the weakly acidic group equivalent, the phenol equivalent, the hydroxyimide equivalent, the hydroxyamide equivalent, or the silanol equivalent is the same as the preferable range of the acid equivalent described above.

The resin (A3) has a phenolic hydroxyl group. The resin (A3) preferably has at least one of a structural unit having a phenolic hydroxyl group and an end structure having a phenolic hydroxyl group. In addition, the resin (A3) preferably further has a hydroxyimide group, a hydroxyamide group, a silanol group, a 1,1-bis(trifluoromethyl) methylol group, or a mercapto group, from the viewpoint of suppressing the narrow mask bias after development and improving the halftone characteristics. On the other hand, the resin (A3) preferably has a carboxy group, a carboxylic anhydride group, or a sulfonic acid group, and more preferably have a carboxy group or a carboxylic anhydride group from the viewpoint of suppressing residues after development.

The acid equivalent (A3) of the resin is preferably 70 g/mol or more, more preferably 80 g/mol or more, and still more preferably 90 g/mol or more, from the viewpoint of improving the sensitivity at the time of exposure and improving the reliability of the light-emitting element in the display device. On the other hand, the acid equivalent is preferably 450 g/mol or less, more preferably 350 g/mol or less, still more preferably 300 g/mol or less, from the viewpoint of suppressing residues after development, suppressing the narrow mask bias after development, and improving the halftone characteristics. In addition, the weakly acidic group equivalent of the resin (A3) is preferably within a specific range, and the phenol equivalent of the resin (A2) is more preferably within a specific range. The preferable specific range of the weakly acidic group equivalent or the phenol equivalent is the same as the preferable range of the acid equivalent described above.

### <Alkali-soluble resin (A); polyimide and polyimide precursor>

Hereinafter, the resin (A1-1) and the resin (A2-a) which are polyimides will be collectively described. Similarly, the resin (A1-2) and the resin (A2-b), which are polyimide precursors, will be collectively described. Examples of the polyimide precursor include a resin obtained by reacting a tetracarboxylic acid or a corresponding tetracarboxylic dianhydride with a diamine or a diisocyanate compound. Other examples of the polyimide precursor include a polyamide acid, a polyamide acid ester, a polyamide acid amide, and a polyisoimide. Examples of the polyimide include a resin obtained by dehydrating and cyclizing a polyimide precursor by heating or a reaction using a catalyst. The polyimide and the polyimide precursor may be a resin which is a copolymer with polyamide and is obtained by further using a dicarboxylic acid or a corresponding dicarboxylic acid active diester in a reaction for synthesizing a resin.

The polyimide preferably has a structural unit represented by the general formula (1) from the viewpoint of suppressing the narrow mask bias after development and improving the halftone characteristics. The content ratio of the structural unit represented by the general formula (1) to all structural units in the polyimide is preferably 50 to 100 mol%, more preferably 60 to 100 mol%, and still more preferably 70 to 100 mol%.

The polyimide precursor preferably has a structural unit represented by the general formula (3) from the viewpoint of suppressing the narrow mask bias after development and improving the halftone characteristics. The content ratio of the structural unit represented by the general formula (3) to all structural units in the polyimide precursor is preferably 50 to 100 mol%, more preferably 60 to 100 mol%, and still more preferably 70 to 100 mol%.

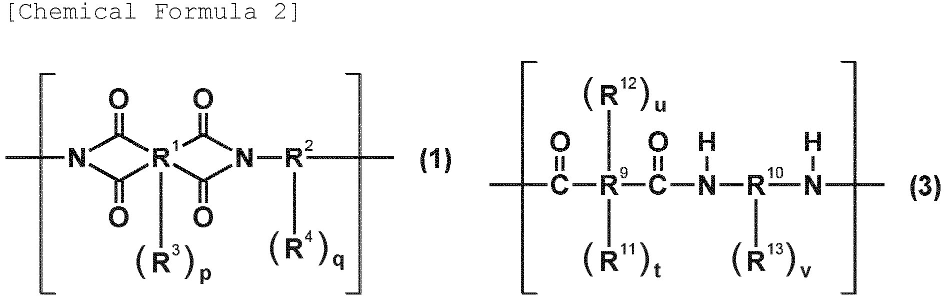

In the general formulae (1) and (3), R¹ and R⁹ each independently represent a 4 to 10 valent organic group. R² and R¹⁰ each independently represent a 2 to 10 valent organic group. R³, R⁴, and R¹³ each independently represent a phenolic hydroxyl group, a sulfonic acid group, a mercapto group, or a substituent represented by the general formula (7) or the general formula (8). R¹¹ represents a substituent represented by general formula (7) or general formula (8). R¹² represents a phenolic hydroxyl group, a sulfonic acid group, or a mercapto group. p represents an integer of 0 to 6. q represents an integer of 0 to 8. t represents an integer of 2 to 8, u represents an integer of 0 to 6, and 2 ≤ t + u ≤ 8 is satisfied. v represents an integer of 0 to 8. However, when R³ or R⁴ represents a phenolic hydroxyl group, the structure in R¹ bonded to the phenolic hydroxyl group or the structure in R² represents an aromatic structure. When R¹² or R¹³ represents a phenolic hydroxyl group, the structure in R⁹ bonded to the phenolic hydroxyl group or the structure in R¹⁰ represents an aromatic structure.

In the general formulae (1) and (3), it is preferable that R¹, R⁹, R², and R¹⁰ each independently have an aliphatic structure having 2 to 20 carbon atoms, an alicyclic structure having 4 to 20 carbon atoms, or an aromatic structure having 6 to 30 carbon atoms. q is preferably an integer of 1 to 8. v is preferably an integer of 1 to 8. R¹ and R⁹ each independently represent an acid monomer residue. R² and R¹⁰ each independently represent an amine monomer residue. The above-described aliphatic structure, alicyclic structure, and aromatic structure may have a hetero atom, and may be either unsubstituted or substituted.

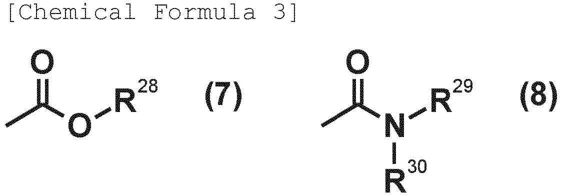

In the general formulae (7) and (8), R²⁸ to R³⁰ each independently represent a hydrogen atom, an alkyl group having 1 to 10 carbon atoms, an acyl group having 2 to 6 carbon atoms, or an aryl group having 6 to 15 carbon atoms. In the general formulae (7) and (8), R²⁸ to R³⁰ each independently preferably represent a hydrogen atom, an alkyl group having 1 to 6 carbon atoms, an acyl group having 2 to 4 carbon atoms, or an aryl group having 6 to 10 carbon atoms. The above-described alkyl group, acyl group, and aryl group may have a hetero atom, and may be either unsubstituted or substituted.

As the polyimide precursor, in a case where R¹¹ in the structural unit represented by general formula (3) represents a substituent represented by general formula (7), the structural unit where R²⁸ represents hydrogen atom is referred to as an amide acid structural unit. In a case where R¹¹ in the structural unit represented by general formula (3) represents a substituent represented by general formula (7), the structural unit where R²⁸ represents an alkyl group having 1 to 10 carbon atoms, an acyl group having 2 to 6 carbon atoms, or an aryl group having 6 to 15 carbon atoms is referred to as an amide acid ester structural unit. In a case where R¹¹ in the structural unit represented by general formula (3) represents a substituent represented by general formula (8), the structural unit is referred to as an amide acid amide structural unit. The polyimide precursor preferably has an amide acid ester structural unit and/or an amide acid amide structural unit from the viewpoint of suppressing the narrow mask bias after development and improving the halftone characteristics. Examples of the polyimide precursor having an amide acid ester structural unit and/or an amide acid amide structural unit include a resin obtained by esterifying and/or amidizing a part of a carboxy group which is a tetracarboxylic acid residue and/or a tetracarboxylic acid derivative residue. The polyimide precursor may have an amide acid structural unit, an amide acid ester structural unit, or an imide ring-closed structural unit in which a part of the amide acid amide structural unit is imide ring-closed. The total content ratio of the amide acid ester structural unit and the amide acid amide structural unit to the total content ratio of the amide acid structural unit, the amide acid ester structural unit, the amide acid amide structural unit, and the imide ring-closed structural unit is preferably 10 mol% or more, more preferably 30 mol% or more, and still more preferably 50 mol% or more, from the viewpoint of suppressing the narrow mask bias and improving the halftone characteristics after development. On the other hand, the total content ratio of the amide acid ester structural unit and the amide acid amide structural unit is preferably 100 mol% or less, more preferably 90 mol% or more, and still more preferably 80 mol% or more, from the viewpoint of suppressing residues after development.

### <Alkali-soluble resin (A); Polybenzoxazole precursor and polybenzoxazole>

Hereinafter, the resin (A1-3) and the resin (A2-c) which are polybenzoxazoles will be collectively described. Similarly, the resin (A1-4) and the resin (A2-d) which are polybenzoxazole precursors are collectively described. Examples of the polybenzoxazole precursor include a resin obtained by reacting a dicarboxylic acid or a corresponding dicarboxylic acid active diester or the like with a bisaminophenol compound or the like as a diamine. In addition, examples of the polybenzoxazole precursor include polyhydroxy amide. Examples of the polybenzoxazole include a resin obtained by dehydrating and cyclizing a polybenzoxazole precursor by heating or a reaction using a catalyst. The polybenzoxazole and the polybenzoxazole precursors may be resins which are obtained by further using a diamine, a diisocyanate compound or the like in a reaction for synthesizing a resin and is a copolymer with polyamide.

The polybenzoxazole preferably has a structural unit represented by the general formula (2) from the viewpoint of suppressing the narrow mask bias after development and improving the halftone characteristics. The content ratio of the structural unit represented by the general formula (2) to all structural units in the polybenzoxazole is preferably 50 to 100 mol%, more preferably 60 to 100 mol%, and still more preferably 70 to 100 mol%.

The polybenzoxazole precursor preferably has a structural unit represented by the general formula (4) from the viewpoint of suppressing the narrow mask bias after development and improving the halftone characteristics. The content ratio of the structural unit represented by the general formula (4) to all structural units in the polybenzoxazole precursor is preferably 50 to 100 mol%, more preferably 60 to 100 mol%, and still more preferably 70 to 100 mol%.

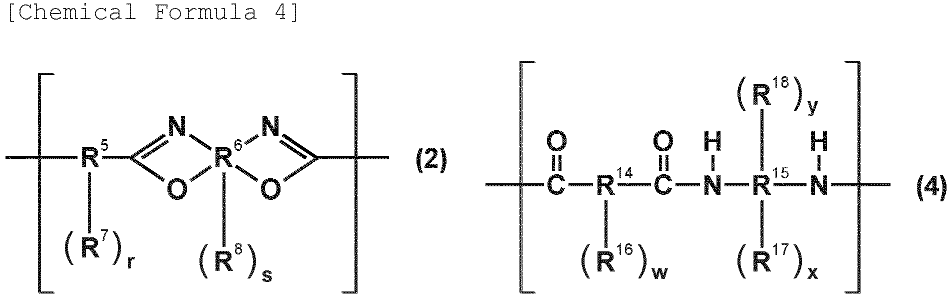

In the general formulae (2) and (4), R⁵ and R¹⁴ each independently represent a 2 to 10 valent organic group. R⁶ and R¹⁵ each independently represent a 4 to 10 valent organic group having an aromatic structure. R⁷, R⁸, and R¹⁶ each independently represent a phenolic hydroxyl group, a sulfonic acid group, a mercapto group, or a substituent represented by the general formula (7) or general formula (8) described above. R¹⁷ represents a phenolic hydroxyl group. R¹⁸ represents a sulfonic acid group, a mercapto group, or a substituent represented by the general formula (7) or the general formula (8) described above. r represents an integer of 0 to 8. s represents an integer of 0 to 6. w represents an integer of 0 to 8. x represents an integer of 2 to 8, y represents an integer of 0 to 6, and 2 ≤ x + y ≤ 8 is satisfied. However, when R⁷ or R⁸ represents a phenolic hydroxyl group, the structure in R⁵ bonded to the phenolic hydroxyl group or the structure in R⁶ represents an aromatic structure. When R¹⁶ represents a phenolic hydroxyl group, the structure in R¹⁴ bonded to the phenolic hydroxyl group represents an aromatic structure. In addition, the structure in R¹⁵ bonded to R¹⁷ represents an aromatic structure.

In the general formulae (2) and (4), it is preferable that R⁵, R¹⁴, R⁶, and R¹⁵ each independently have an aliphatic structure having 2 to 20 carbon atoms, an alicyclic structure having 4 to 20 carbon atoms, or an aromatic structure having 6 to 30 carbon atoms. s is preferably an integer of 1 to 6. R⁵ and R¹⁴ each independently represent an acid monomer residue. R⁶ and R¹⁵ each independently represent an amine monomer residue. The above-described aliphatic structure, alicyclic structure, and aromatic structure may have a hetero atom, and may be either unsubstituted or substituted.

### <Alkali-soluble resin (A); Polyamideimide and Polyamideimide precursor>

Hereinafter, the resin (A1-5), the resin (A1-6), the resin (A2-e), and the resin (A2-f) which are polyamideimide or polyamideimide precursors will be collectively described. Examples of the polyamideimide precursor include a resin obtained by reacting a tricarboxylic acid or a corresponding tricarboxylic anhydride with a diamine or a diisocyanate compound. Examples of the polyamideimide include a resin obtained by dehydrating and cyclizing a polyamideimide precursor by heating or a reaction using a catalyst. The polyamideimide and the polyamideimide precursor may be a resin which is a copolymer with polyamide and is obtained by further using a dicarboxylic acid or a corresponding dicarboxylic acid active diester in a reaction for synthesizing a resin.

The polyamideimide preferably has a structural unit represented by the general formula (5) from the viewpoint of suppressing the narrow mask bias after development and improving the halftone characteristics. The content ratio of the structural unit represented by the general formula (5) to all structural units in the polyamideimide is preferably 50 to 100 mol%, more preferably 60 to 100 mol%, and still more preferably 70 to 100 mol%.

The polyamideimide precursor preferably has a structural unit represented by the general formula (6) from the viewpoint of suppressing the narrow mask bias after development and improving the halftone characteristics. The content ratio of the structural unit represented by the general formula (6) to all structural units in the polyamideimide precursor is preferably 50 to 100 mol%, more preferably 60 to 100 mol%, and still more preferably 70 to 100 mol%.

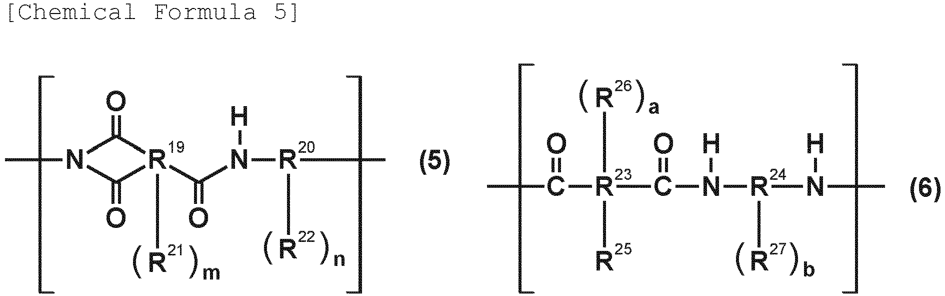

In the general formulae (5) and (6), R¹⁹ and R²³ each independently represent a 3 to 10 valent organic group. R²⁰ and R²⁴ each independently represent a 2 to 10 valent organic group. R²¹, R²², and R²⁷ each independently represent a phenolic hydroxyl group, a sulfonic acid group, a mercapto group, or a substituent represented by the general formula (7) or general formula (8) described above. R²⁵ represents a substituent represented by general formula (7) or general formula (8). R²⁶ represents a phenolic hydroxyl group, a sulfonic acid group, or a mercapto group. m represents an integer 0 to 7. n represents an integer of 0 to 8. a represents an integer of 0 to 7. b represents an integer of 0 to 8. However, when R²¹ or R²² represents a phenolic hydroxyl group, the structure in R¹⁹ or R²⁰ bonded to the phenolic hydroxyl group represents an aromatic structure. When R²⁶ or R²⁷ represents a phenolic hydroxyl group, the structure in R²³ or R²⁴ bonded to the phenolic hydroxyl group represents an aromatic structure.

In the general formulae (5) and (6), it is preferable that R¹⁹, R²³, R²⁰, and R²⁴ each independently have an aliphatic structure having 2 to 20 carbon atoms, an alicyclic structure having 4 to 20 carbon atoms, or an aromatic structure having 6 to 30 carbon atoms. n is preferably an integer of 1 to 8. b is preferably an integer of 1 to 8. R¹⁹ and R²³ each independently represent an acid monomer residue. R²⁰ and R²⁴ each independently represent an amine monomer residue. The above-described aliphatic structure, alicyclic structure, and aromatic structure may have a hetero atom, and may be either unsubstituted or substituted.

### <Structural Unit Having Fluorine Atom>

The polyimide, the polyimide precursor, the polybenzoxazole, the polybenzoxazole precursor, the polyamideimide, and the polyamideimide precursor (hereinafter, referred to as "polyimide-based resin") preferably have a structural unit having a fluorine atom from the viewpoint of improving the sensitivity at the time of exposure, suppressing the narrow mask bias after development, and improving the halftone characteristics. The exposure herein refers to irradiation with active actinic rays (radiation), and examples thereof include irradiation with visible light, ultraviolet rays, electron beams, X-rays or the like. Hereinafter, exposure refers to irradiation with active actinic rays (radiant rays).

In the polyimide-based resin, when a structural unit derived from a carboxylic acid or a structural unit derived from a carboxylic acid derivative has a fluorine atom, and a structural unit derived from an amine or a structural unit derived from an amine derivative has a fluorine atom, among all structural units of each resin, the total content ratio of the structural unit having a fluorine atom to all structural units of each resin is preferably 10 to 100 mol%, more preferably 30 to 100 mol%, and still more preferably 50 to 100 mol%. The structural unit derived from a carboxylic acid or a structural unit derived from a carboxylic acid derivative includes a structural unit derived from a tetracarboxylic acid or a corresponding tetracarboxylic dianhydride, a structural unit derived from a dicarboxylic acid or a corresponding dicarboxylic acid active diester, or a structural unit derived from a tricarboxylic acid or a corresponding tricarboxylic anhydride. In addition, the structural unit derived from an amine or the structural unit derived from an amine derivative includes a structural unit derived from a diamine, a structural unit derived from a diisocyanate compound, a structural unit derived from a bisaminophenol compound, or the like.

When only the structural unit derived from a carboxylic acid or the structural unit derived from a carboxylic acid derivative has a fluorine atom among all the structural units of each resin, the total content ratio of the structural unit having a fluorine atom to the total of the structural units derived from all the carboxylic acids and the structural units derived from all the carboxylic acid derivatives is preferably 10 to 100 mol%, more preferably 30 to 100 mol%, and still more preferably 50 to 100 mol%.

On the other hand, when only the structural unit derived from an amine or the structural unit derived from an amine derivative has a fluorine atom among all the structural units of each resin, the total content ratio of the structural unit having a fluorine atom to the total of the structural units derived from all the amines and the structural units derived from all the amine derivatives is preferably 10 to 100 mol%, more preferably 30 to 100 mol%, and still more preferably 50 to 100 mol%.

### <Alkali-soluble group>

The polyimide-based resin has an acidic group as an alkali-soluble group on at least one of a main chain of the resin, a side chain of the resin, and an end of the resin. These resins preferably have a structural unit having an acidic group such as a structural unit derived from a carboxylic acid having an acidic group or a structural unit derived from a diamine having an acidic group, or an end structure having an acidic group. In addition, a resin obtained by reacting a part of hydroxy groups or the like of each resin with a polyfunctional carboxylic dianhydride is also preferable, and a resin obtained by introducing an acidic group into at least one of the main chain of each resin, the side chain of the resin, and the end of the resin by a reaction using a catalyst is also preferable.

### <Radical polymerizable group>

The resin (A2-a), the resin (A2-b), the resin (A2-c), the resin (A2-d), the resin (A2-e), and the resin (A2-f) (hereinafter, referred to as a "polyimide-based resin (A2)"), which are the resins (A2), have a radical polymerizable group. These resins (A2) are preferably resins obtained by reacting some acidic groups and the like of the respective resins with a compound having a radical polymerizable group in the resin (A1-1), the resin (A1-2), the resin (A1-3), the resin (A1-4), the resin (A1-5), and the resin (A1-6) (hereinafter, referred to as a "polyimide-based resin (A1)"). In addition, a resin in which a radical polymerizable group is introduced into at least one of the side chain of each resin and the end of the resin by a reaction using a catalyst is also preferable. The compound having a radical polymerizable group is preferably an electrophilic compound having a radical polymerizable group. From the viewpoint of reactivity and compound availability, the compound having a radical polymerizable group is preferably an isocyanate compound, an epoxy compound, an aldehyde compound, a ketone compound, an acetate compound, a carboxylic acid compound, a carboxylic acid derivative, an alkyl halide compound, an alkyl azide compound, a sulfonate alkyl compound, an alkyl cyanide compound, or an alcohol compound. It is also preferable that these compounds have a urea bond or a urethane bond.

Examples of the alcohol compound having a radical polymerizable group include 2-hydroxyethyl (meth)acrylate, 4-hydroxybutyl (meth)acrylate, 4-hydroxyhexyl (meth)acrylate, glycerol di(meth)acrylate, trimethylolpropane di(meth)acrylate, ditrimethylolpropane tri(meth)acrylate, pentaerythritol tri(meth)acrylate, dipentaerythritol penta(meth)acrylate, and trispentaerythritol hepta(meth)acrylate.

In the polyimide-based resin (A2), the radical polymerizable group is preferably one or more selected from the group consisting of groups represented by any of the general formulae (51), (52), (53), (54), and (55).

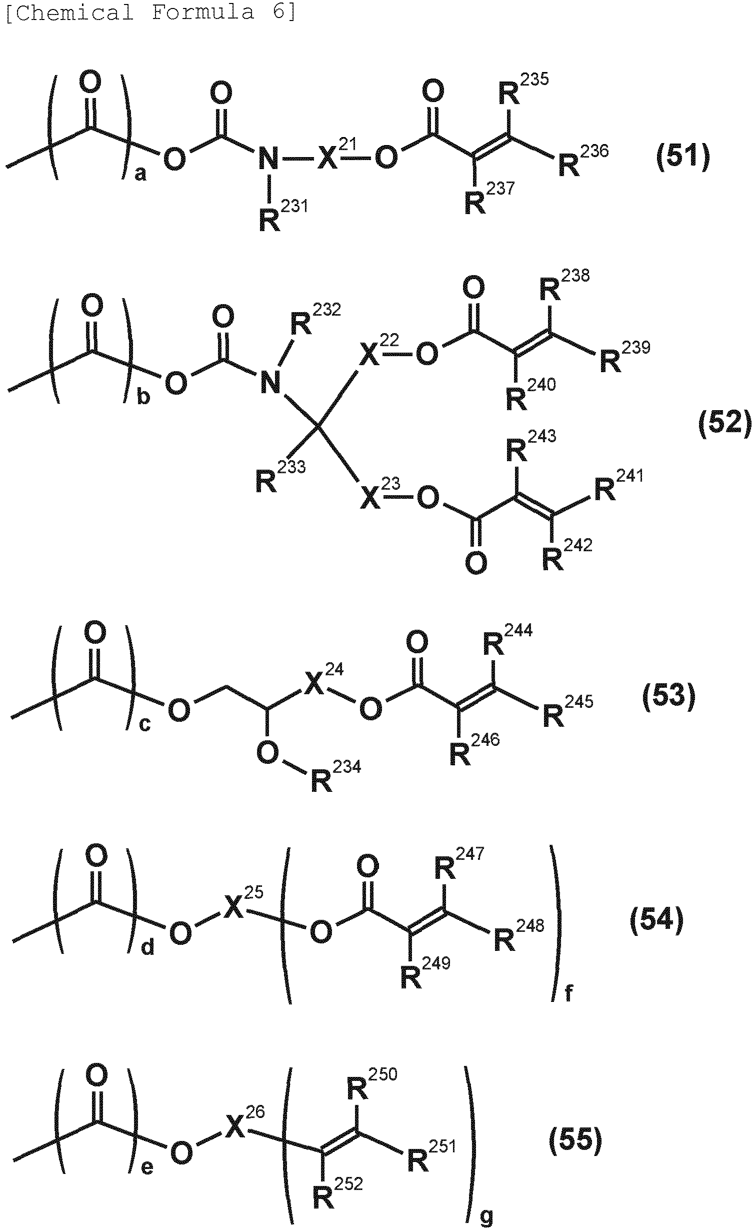

In the general formulae (51) to (55), X²¹ to X²⁴ each independently represent an alkylene group having 1 to 10 carbon atoms, a cycloalkylene group having 4 to 10 carbon atoms, or an arylene group having 6 to 15 carbon atoms. X²⁵ represents a 2 to 6 valent organic group. X²⁶ represents a direct bond or a 2 to 6 valent organic group. R²³¹ to R²⁵² each independently represent a hydrogen atom, an alkyl group having 1 to 10 carbon atoms, or an aryl group having 6 to 15 carbon atoms, a, b, c, d, and e each independently represent 0 or 1. f and g each independently represent an integer of 1 to 5.

In the general formulae (51) to (55), X²⁵ is preferably a 2 to 6 valent aliphatic group, and more preferably a 2 to 6 valent alkylene group having 1 to 10 carbon atoms. X²⁶ is preferably a direct bond or a 2 to 6 valent aliphatic group, and more preferably a 2 to 6 valent alkylene group having 1 to 10 carbon atoms. The alkyl group, aryl group, alkylene group, cycloalkylene group, and arylene group described above may have a hetero atom, and may be either unsubstituted or substituted.

The double bond equivalent of the polyimide-based resin (A2) described above is preferably 200 g/mol or more, more preferably 400 g/mol or more, still more preferably 500 g/mol or more, still more preferably 700 g/mol or more, and particularly preferably 1,000 g/mol or more, from the viewpoint of suppressing the narrow mask bias after development and improving the halftone characteristics. On the other hand, the double bond equivalent is preferably 3,000 g/mol or less, more preferably 2,000 g/mol or less, and still more preferably 1,500 g/mol or less, from the viewpoint of improving the sensitivity at the time of exposure and improving the reliability of the light-emitting element in the display device.

### <Other structural units, end-capping agent, and molecular weight>

The structural unit of the polyimide-based resin is also preferably a structural unit having an aromatic group such as a structural unit derived from an aromatic carboxylic acid or a structural unit derived from an aromatic diamine from the viewpoint of improving the reliability of the light-emitting element in the display device. In addition, from the viewpoint of reducing the taper of the pattern shape, a structural unit having an oxyalkylene skeleton such as a structural unit having a silyl group or a siloxane bond, such as a structural unit derived from a silicone diamine, or a structural unit derived from an oxyalkylene diamine is also preferable. In addition, it is also preferable to have a structure in which the end of the resin is capped with an end-capping agent such as a monoamine or a dicarboxylic anhydride.

From the viewpoint of improving the reliability of the light-emitting element in the display device, the weight average molecular weight (hereinafter, referred to as "Mw") of the polyimide-based resin is preferably 1,000 or more, more preferably 3,000 or more, and still more preferably 5,000 or more in terms of polystyrene measured by gel permeation chromatography (hereinafter, referred to as "GPC"). On the other hand, Mw is preferably 100,000 or less, more preferably 50,000 or less, still more preferably 30,000 or less, and particularly preferably 20,000 or less from the viewpoint of suppressing residues after development and reducing the taper of the pattern shape. The polyimide-based resin can be synthesized by a known method. Examples of the tetracarboxylic acid, tricarboxylic acid, dicarboxylic acid, and derivatives thereof and diamines, bisaminophenol compounds, monoamines, and derivatives thereof used for synthesis of the respective resins include the compounds disclosed in International Publication No. 2017/057281 or International Publication No. 2017/159876.

### <Alkali-soluble resin (A); Polysiloxane>

Hereinafter, the resin (A1-7) and the resin (A2-g) which are polysiloxanes will be collectively described. Examples of the polysiloxane include a resin obtained by hydrolysis and dehydration condensation of one or more selected from the group consisting of trifunctional organosilane, a tetrafunctional organosilane, a bifunctional organosilane, and a monofunctional organosilane.

The polysiloxane preferably has a trifunctional organosilane unit represented by the general formula (9) and/or a tetrafunctional organosilane unit represented by the general formula (10) from the viewpoint of suppressing the narrow mask bias after development and improving the halftone characteristics, and from the viewpoint of improving the reliability of the light-emitting element in the display device.

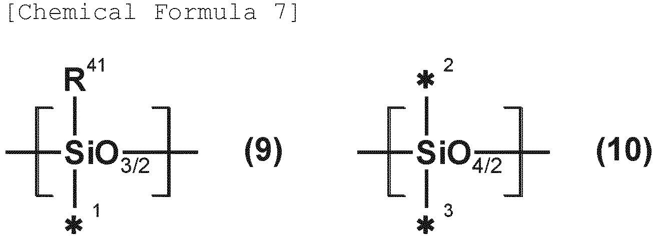

In general formula (9), R⁴¹ represents a hydrogen atom or a monovalent organic group. In the general formulae (9) and (10), *¹ to *³ each independently represent a bonding point in the resin. In the general formula (9), R⁴¹ is preferably a hydrogen atom, an alkyl group having 1 to 10 carbon atoms, a cycloalkyl group having 4 to 10 carbon atoms, an aryl group having 6 to 15 carbon atoms, a halogenated alkyl group having 1 to 10 carbon atoms, a halogenated cycloalkyl group having 4 to 10 carbon atoms, or a halogenated aryl group having 6 to 15 carbon atoms. The alkyl group, cycloalkyl group, aryl group, halogenated alkyl group, halogenated cycloalkyl group, and halogenated aryl group described above may have a hetero atom, and may be either unsubstituted or substituted.

The content ratio of the trifunctional organosilane unit represented by general formula (9) to the polysiloxane is preferably 50 to 100 mol%, more preferably 60 to 100 mol%, and still more preferably 70 to 100 mol% in terms of Si atom mol ratio. The trifunctional organosilane unit is preferably an organosilane unit having an epoxy group from the viewpoint of suppressing residues after development.

The content ratio of the tetrafunctional organosilane unit represented by the general formula (10) in the polysiloxane is preferably 1 mol% or more, more preferably 5 mol% or more, and still more preferably 10 mol% or more in terms of Si atom mol ratio from the viewpoint of suppressing residues after development. On the other hand, the content ratio of the tetrafunctional organosilane unit represented by the general formula (10) is preferably 40 mol% or less, more preferably 30 mol% or less, and still more preferably 20 mol% or less in terms of Si atom mol ratio from the viewpoint of reducing the taper of the pattern shape.

### <Alkali-soluble group>

The polysiloxane has an acidic group as an alkali-soluble group on at least one of a main chain of the resin, a side chain of the resin, and an end of the resin. The polysiloxane is preferably a resin having an organosilane unit having an acidic group. In addition, a resin obtained by reacting a part of hydroxy groups or the like of the resin with a polyfunctional carboxylic dianhydride is also preferable, and a resin obtained by introducing an acidic group into at least one of the main chain of the resin, the side chain of the resin, and the end of the resin by a reaction using a catalyst is also preferable.

### <Radical polymerizable group>

The resin (A2-g) as a resin (A2) has a radical polymerizable group. The resin (A2-g) is preferably a resin having an organosilane unit having a radical polymerizable group. In addition, a resin obtained by reacting some acidic groups or the like of the resin with a compound having a radical polymerizable group is also preferable, and a resin obtained by introducing a radical polymerizable group into at least one of a side chain of the resin and an end of the resin by a reaction using a catalyst is also preferable. The double bond equivalent of the resin (A2-g) is preferably 500 g/mol or more, more preferably 700 g/mol or more, and still more preferably 1,000 g/mol or more from the viewpoint of suppressing the narrow mask bias after development and improving the halftone characteristics. On the other hand, the double bond equivalent is preferably 3,000 g/mol or less, more preferably 2,000 g/mol or less, and still more preferably 1,500 g/mol or less, from the viewpoint of improving the sensitivity at the time of exposure and improving the reliability of the light-emitting element in the display device.

### <Other structural units and molecular weight>

The structural unit of the polysiloxane is also preferably a bifunctional organosilane unit or a monofunctional organosilane unit from the viewpoint of reducing the taper of the pattern shape. From the viewpoint of improving the reliability of the light-emitting element in the display device, an organosilane unit having an aromatic group is also preferable. Each organosilane unit may be arranged regularly or irregularly. Examples of the regular arrangement include alternating copolymerization, periodic copolymerization, block copolymerization, or graft copolymerization. As the irregular sequence, for example, random copolymerization and the like can be cited. The organosilane units may be arranged two-dimensionally or three-dimensionally. As the two-dimensional sequence, for example, a straight chain type can be cited. Examples of the three-dimensional arrangement include a ladder shape, a basket shape, and a mesh shape.

From the viewpoint of improving the reliability of the light-emitting element in the display device, the Mw of the polysiloxane is preferably 500 or more and more preferably 1,000 or more in terms of polystyrene measured by GPC. On the other hand, Mw is preferably 50,000 or less and more preferably 10,000 or less, from the viewpoint of suppressing residues after development and reducing the taper of the pattern shape. The polysiloxane can be synthesized by known methods. Examples of the organosilane include the compounds disclosed in International Publication No. 2017/057281 or International Publication No. 2017/159876.

### <Alkali-soluble resin (A); Polycyclic side chain-containing resin>

Hereinafter, the resin (A2-1) which is a polycyclic side chain-containing resin will be described. Examples of the polycyclic side chain-containing resin include resins obtained in the following (1-a2-1) to (6-a2-1). If necessary, the polyfunctional alcohol compound may be further reacted in any reaction stage.

(1-a2-1) A resin obtained by reacting an epoxy compound with the compound obtained by reacting a polyfunctional phenol compound and a polyfunctional carboxylic dianhydride.

(2-a2-1) A resin obtained by reacting a polyfunctional carboxylic dianhydride with the compound obtained by reacting a polyfunctional phenol compound and an epoxy compound.

(3-a2-1) A resin obtained by reacting an epoxy compound with the compound obtained by reacting a cyclic skeleton-containing polyfunctional alcohol compound and a polyfunctional carboxylic dianhydride.

(4-a2-1) A resin obtained by reacting a polyfunctional carboxylic dianhydride with the compound obtained by reacting a cyclic skeleton-containing polyfunctional alcohol compound and an epoxy compound.

(5-a2-1) A resin obtained by reacting an epoxy compound with the compound obtained by reacting a polyfunctional epoxy compound with a polyfunctional carboxylic acid compound.

(6-a2-1) A resin obtained by reacting a polyfunctional carboxylic dianhydride with the compound obtained by reacting a polyfunctional epoxy compound with a carboxylic acid compound.

The polycyclic side chain-containing resin has a structure in which a main chain and a bulky side chain having a cyclic skeleton are connected by one atom in a structural unit of the resin. In addition, the polycyclic side chain-containing resin preferably has a structural unit represented by the general formula (41) from the viewpoint of suppressing the narrow mask bias after development and improving the halftone characteristics.

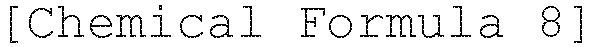

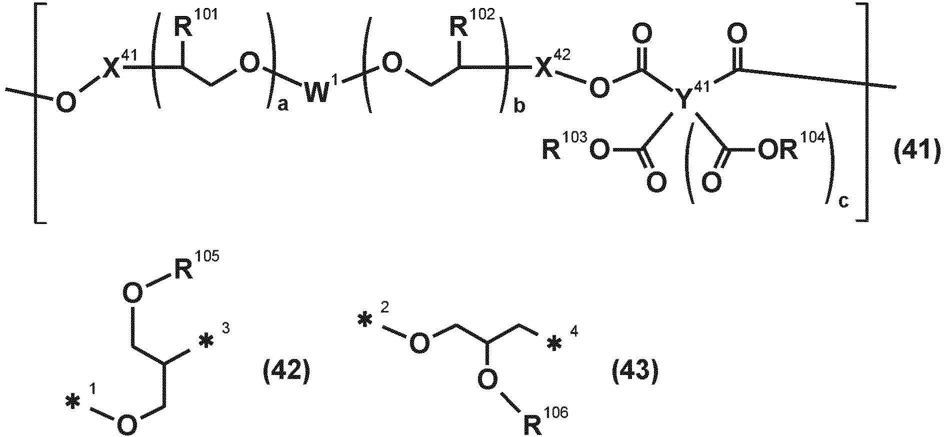

In the general formula (41), X⁴¹ and X⁴² each independently represent a direct bond, or a substituent represented by the general formula (42) or the general formula (43). Y⁴¹ represents a 3 to 4 valent organic group which is a carboxylic acid residue or a carboxylic acid derivative residue. W¹ represents an organic group having at least two aromatic groups. R¹⁰¹ and R¹⁰² each independently represent a hydrogen atom or an alkyl group having 1 to 6 carbon atoms, and R¹⁰³ and R¹⁰⁴ each independently represent a hydrogen atom, an alkyl group having 1 to 10 carbon atoms, or an organic group having a radical polymerizable group. a and b each independently represent an integer of 0 to 10. c represents 0 or 1. In the general formulae (42) and (43), R¹⁰⁵ and R¹⁰⁶ each independently represent a hydrogen atom, an alkyl group having 1 to 10 carbon atoms, or an organic group having a radical polymerizable group. *¹ and *² each independently represent a bonding point to W¹ or a bonding point to a carbon atom in the general formula (41). *³ and *⁴ each independently represent a bonding point with an oxygen atom in the general formula (41).

In the general formula (41), Y⁴¹ preferably represents a 3 to 4 valent organic group having an aliphatic structure having 2 to 20 carbon atoms, an alicyclic structure having 4 to 20 carbon atoms, and an aromatic structure having 6 to 30 carbon atoms. From the viewpoint of suppressing the narrow mask bias after development and improving the halftone characteristics, and from the viewpoint of improving the reliability of the light-emitting element in the display device, W¹ is preferably a substituent represented by any of the general formulae (44) to (49). R¹⁰³ and R¹⁰⁴ each independently preferably represent a hydrogen atom or an organic group having a radical polymerizable group. In the general formulae (41) to (43), the organic group having a radical polymerizable group in R¹⁰³ to R¹⁰⁶ is preferably a (meth)acryloyl group or a substituent represented by the general formula (50). The above-described alkyl group, aliphatic structure, alicyclic structure, and aromatic structure may have a hetero atom, and may be either unsubstituted or substituted.

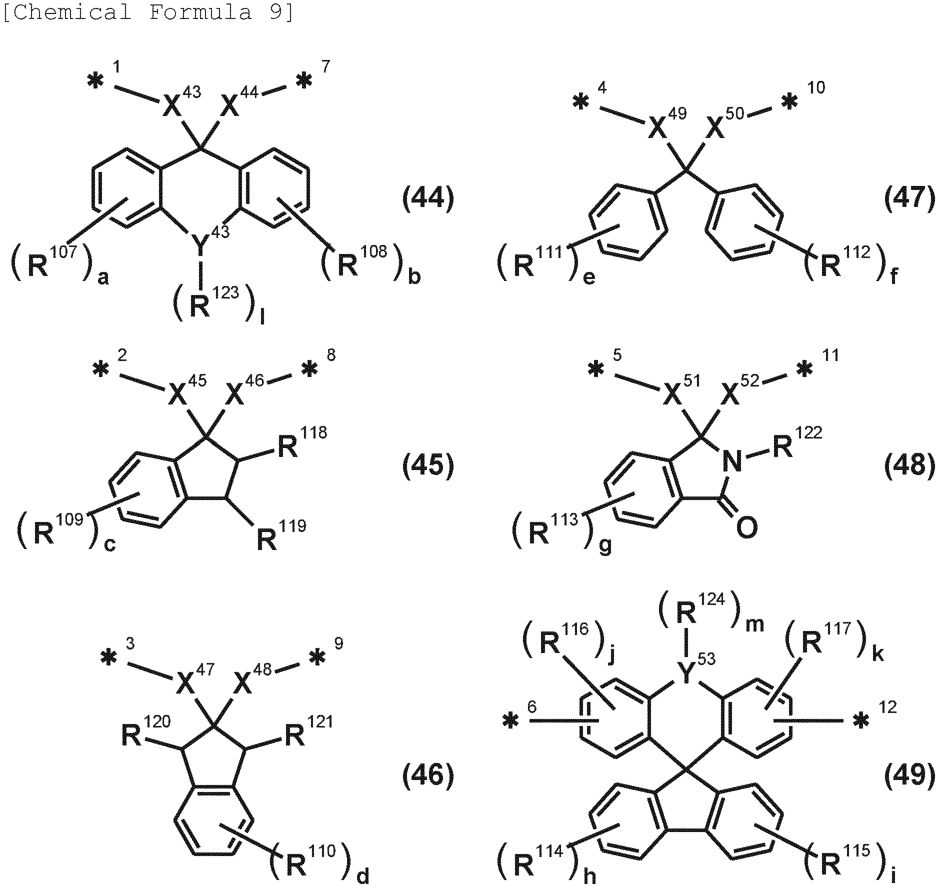

In general formulae (44) to (49), X⁴³ to X⁵² each independently represent a monocyclic or condensed polycyclic hydrocarbon ring. Y⁴³ and Y⁵³ each independently represent a direct bond, a carbon atom, a nitrogen atom, an oxygen atom, or a sulfur atom. R¹⁰⁷ to R¹¹⁷ each independently represent a halogen atom or an alkyl group having 1 to 10 carbon atoms. R¹¹⁸ to R¹²⁴ each independently represent a hydrogen atom, a halogen atom, an alkyl group having 1 to 10 carbon atoms, a cycloalkyl group having 4 to 10 carbon atoms, or an aryl group having 6 to 15 carbon atoms, a, b, c, and d each independently represent an integer of 0 to 4. e and f each independently represent an integer of 0 to 5. g, h, and i each independently represent an integer of 0 to 4. j and k each independently represent an integer of 0 to 3. When Y⁴³ is a direct bond, an oxygen atom, or a sulfur atom, l is 0. When Y⁴³ is a nitrogen atom, l is 1. When Y⁴³ is a carbon atom, l is 2. When Y⁵³ is a direct bond, an oxygen atom, or a sulfur atom, m is 0. When Y⁵³ is a nitrogen atom, m is 1. When Y⁵³ is a carbon atom, m is 2. *¹ to *⁶ each independently represent a bonding point to X⁴¹ or a bonding point to an oxygen atom in the general formula (47) described above. *⁷ to *¹² each independently represent a bonding point to X⁴² or a bonding point to an oxygen atom in the general formula (47) described above.

In general formulae (44) to (49), X⁴³ to X⁵² each independently preferably represent a monocyclic or condensed polycyclic hydrocarbon ring having 6 to 15 carbon atoms. Y⁴³ to Y⁵³ each independently preferably represent a direct bond or an oxygen atom. The alkyl group, cycloalkyl group, aryl group, and monocyclic or condensed polycyclic aromatic hydrocarbon ring described above may have a hetero atom, and may be either unsubstituted or substituted.

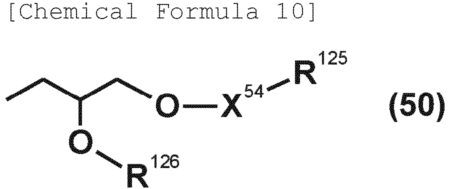

In the general formula (50), X⁵⁴ represents a direct bond, an alkylene group having 1 to 10 carbon atoms, a cycloalkylene group having 4 to 10 carbon atoms, or an arylene group having 6 to 15 carbon atoms. R¹²⁵ represents a vinyl group, an allyl group, a crotonyl group, a styryl group, a cinnamoyl group, a maleimide group, or a (meth)acryloyl group. R¹²⁶ represents a carboxylic acid derivative residue having a hydrogen atom, an alkyl group having 1 to 10 carbon atoms, or a carboxy group. The alkylene group, cycloalkylene group, and arylene group described above may have a hetero atom, and may be either unsubstituted or substituted.

The polycyclic side chain-containing resin preferably has a structural unit having a condensed polycyclic structure or a structural unit having a condensed polycyclic heterocyclic structure from the viewpoint of suppressing the narrow mask bias after development and improving the halftone characteristics, and from the viewpoint of improving the reliability of the light-emitting element in the display device. The condensed polycyclic structure or the condensed polycyclic heterocyclic structure is preferably a fluorene skeleton, a xanthene skeleton, or an isoindolinone skeleton. In the general formula (41) described above, when W¹ is represented by the general formula (44) or the general formula (49) and Y⁴³ is a direct bond or an oxygen atom, the resin has a structural unit having a fluorene skeleton or a structural unit having a xanthene skeleton. In the general formula (41) described above, when W¹ is represented by the general formula (48), the resin has a structural unit having an isoindolinone skeleton.

### <Alkali-soluble group>

The polycyclic side chain-containing resin has an acidic group as an alkali-soluble group on at least one of a main chain of the resin, a side chain of the resin, and an end of the resin. The polycyclic side chain-containing resin preferably has at least one of a structural unit derived from a polyfunctional carboxylic acid compound, a structural unit derived from a polyfunctional carboxylic dianhydride, and an end structure having an acidic group. In addition, a resin obtained by reacting a part of hydroxy groups or the like of the resin with a polyfunctional carboxylic dianhydride is also preferable, and a resin obtained by introducing an acidic group into at least one of the main chain of the resin, the side chain of the resin, and the end of the resin by a reaction using a catalyst is also preferable.

### <Radical polymerizable group>

The resin (A2-1) which is the resin (A2) has a radical polymerizable group. The resin (A2-1) preferably has at least one of a structural unit derived from an epoxy compound having a radical polymerizable group, a structural unit derived from a carboxylic acid compound having a radical polymerizable group, and an end structure having a radical polymerizable group. In addition, a resin obtained by reacting some acidic groups or the like of the resin with a compound having a radical polymerizable group is also preferable, and a resin obtained by introducing a radical polymerizable group into at least one of a side chain of the resin and an end of the resin by a reaction using a catalyst is also preferable. The double bond equivalent of the resin (A2-1) is preferably 300 g/mol or more, more preferably 400 g/mol or more, and still more preferably 500 g/mol or more from the viewpoint of suppressing the narrow mask bias after development and improving the halftone characteristics. On the other hand, the double bond equivalent is preferably 1,500 g/mol or less, more preferably 1,000 g/mol or less, and still more preferably 700 g/mol or less, from the viewpoint of improving the sensitivity at the time of exposure and improving the reliability of the light-emitting element in the display device.

### <Other structural units, end-capping agent, and molecular weight>

The structural unit of the polycyclic side chain-containing resin is also preferably a structural unit having an aromatic group such as a structural unit derived from an aromatic polyfunctional carboxylic acid compound or a structural unit derived from an aromatic polyfunctional carboxylic dianhydride, from the viewpoint of improving the reliability of the light-emitting element in the display device. In addition, it is also preferable to have a structure in which the end of the resin is capped with an end-capping agent such as a monocarboxylic acid, a dicarboxylic anhydride, or a tricarboxylic anhydride.

From the viewpoint of improving the reliability of the light-emitting element in the display device, Mw of the polycyclic side chain-containing resin is preferably 500 or more and more preferably 1,000 or more in terms of polystyrene measured by GPC. On the other hand, Mw is preferably 50,000 or less and more preferably 10,000 or less, from the viewpoint of suppressing residues after development and reducing the taper of the pattern shape. The polycyclic side chain-containing resin can be synthesized by a known method. It is to be noted that examples of the phenol compound, alcohol compound, epoxy compound, carboxylic anhydride, and carboxylic acid compound include the compounds disclosed in International Publication Nos. 2017/057281 and 2017/159876.

Examples of the polycyclic side chain-containing resin include "ADEKA ARKLS" (registered trademark) WR-101 or WR-301 (all of the above are manufactured by ADEKA CORPORATION.), and "OGSOL" (registered trademark) CR-1030 (manufactured by Osaka Gas Chemicals Co., Ltd.).

### <Alkali-soluble resin (A); Acid-modified epoxy resin>

Hereinafter, the resin (A2-2) which is an acid-modified epoxy resin will be described. Examples of the acid-modified epoxy resin include resins obtained in the following (1-a2-2) to (2-a2-2). If necessary, the polyfunctional alcohol compound may be further reacted in any reaction stage.

(1-a2-2) A resin obtained by reacting an epoxy compound with the compound obtained by reacting a polyfunctional epoxy compound with a polyfunctional carboxylic acid compound.

(2-a2-2) A resin obtained by reacting a polyfunctional carboxylic dianhydride with the compound obtained by reacting a polyfunctional epoxy compound with a carboxylic acid compound.

The acid-modified epoxy resin has a cyclic skeleton in the structural unit of the resin. In addition, from the viewpoint of suppressing the narrow mask bias after development and improving the halftone characteristics, it is preferable to have one or more selected from the group consisting of structural units represented by any of the general formulae (61), (62), and (63).

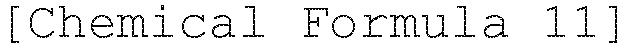

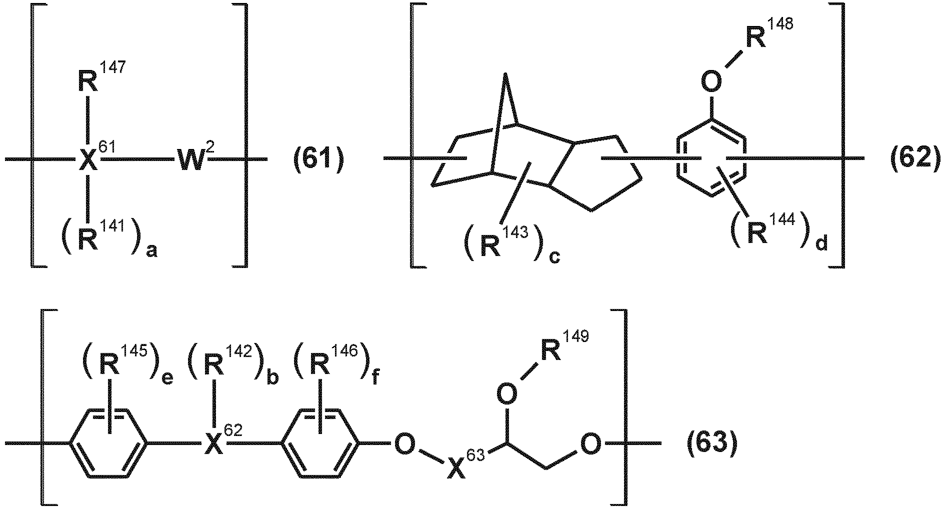

In the general formulae (61) to (63), X⁶¹ to X⁶² each independently represent an aliphatic structure having 1 to 6 carbon atoms. X⁶³ represents an alkylene group having 1 to 6 carbon atoms. W² represents an organic group having at least one aromatic groups. R¹⁴¹ to R¹⁴² each independently represent a halogen atom, an alkyl group having 1 to 10 carbon atoms, a cycloalkyl group having 4 to 10 carbon atoms, or an aryl group having 6 to 15 carbon atoms. R¹⁴³ represents a halogen atom or an alkyl group having 1 to 10 carbon atoms. R¹⁴⁴ to R¹⁴⁶ each independently represent a halogen atom, an alkyl group having 1 to 10 carbon atoms, a cycloalkyl group having 4 to 10 carbon atoms, an aryl group having 6 to 15 carbon atoms, or a substituent represented by the general formula (69). R¹⁴⁷ represents a hydrogen atom or a substituent represented by general formula (70) . R¹⁴⁸ and R¹⁴⁹ each independently represent an organic group having a radical polymerizable group. a and b each independently represent an integer of 0 to 10. c represents an integer of 0 to 14. d represents an integer of 0 to 3. e and f each independently represent an integer of 0 to 4.

In general formula (61), from the viewpoint of suppressing the narrow mask bias after development and improving the halftone characteristics, and from the viewpoint of improving the reliability of the light-emitting element in the display device, W² is preferably a substituent represented by any of the general formulae (64) to (68). In the general formulae (61) to (63), the organic group having a radical polymerizable group in R¹⁴⁸ to R¹⁴⁹ is preferably a (meth)acryloyl group or a substituent represented by the general formula (72) or (73). The above-described aliphatic structure, alkylene group, alkyl group, cycloalkyl group, and aryl group may have a hetero atom, and may be either unsubstituted or substituted.

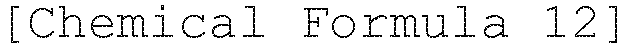

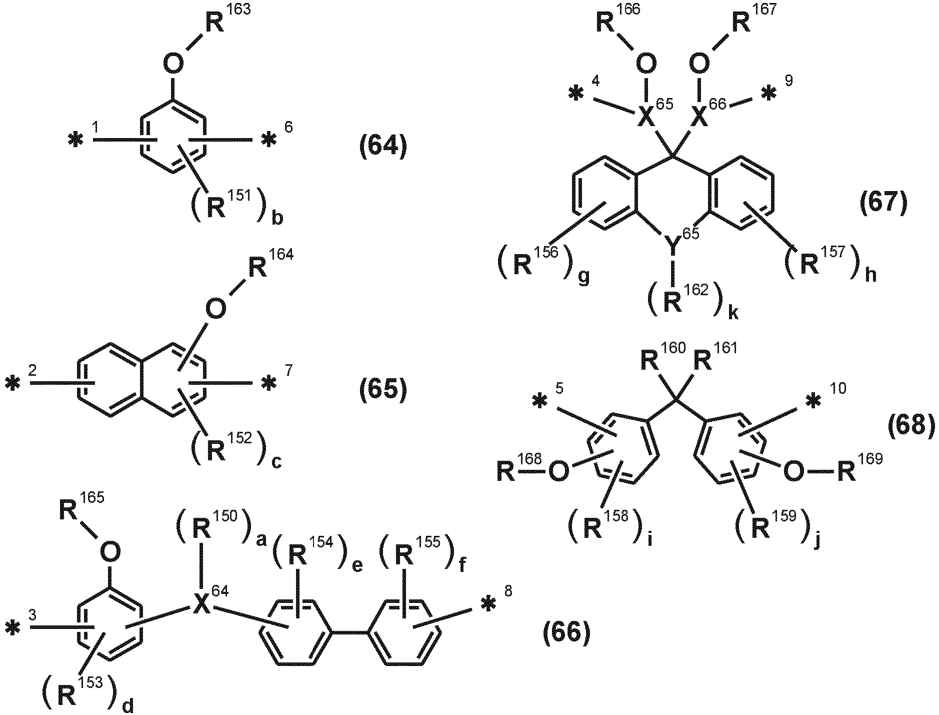

In the general formulae (64) to (68), X⁶⁴ represents an aliphatic structure having 1 to 6 carbon atoms. X⁶⁵ and X⁶⁶ each independently represent a monocyclic or condensed polycyclic hydrocarbon ring. Y⁶⁵ represents a direct bond, a carbon atom, a nitrogen atom, an oxygen atom, or a sulfur atom. R¹⁵⁰ represents a halogen atom, an alkyl group having 1 to 10 carbon atoms, a cycloalkyl group having 4 to 10 carbon atoms, or an aryl group having 6 to 15 carbon atoms. R¹⁵¹ to R¹⁵⁹ each independently represent a halogen atom, an alkyl group having 1 to 10 carbon atoms, a cycloalkyl group having 4 to 10 carbon atoms, an aryl group having 6 to 15 carbon atoms, or a substituent represented by the general formula (69). R¹⁶⁰ to R¹⁶² each independently represent a halogen atom, a hydrogen atom, an alkyl group having 1 to 10 carbon atoms, a cycloalkyl group having 4 to 10 carbon atoms, or an aryl group having 6 to 15 carbon atoms. R¹⁶³ and R¹⁶⁹ each independently represent an organic group having a radical polymerizable group. a represents an integer of 0 to 10. b represents an integer of 0 to 3. c represents an integer of 0 to 5. d represents an integer of 0 to 3. e, f, g, and h each independently represent an integer of 0 to 4. i and j each independently represent an integer of 0 to 3. When Y⁶⁵ is a direct bond, an oxygen atom, or a sulfur atom, k is 0. When Y⁶⁵ is a nitrogen atom, k is 1. When Y⁶⁵ is a carbon atom, k is 2. *¹ to *⁵ each independently represent a bonding point with X⁶¹ in the general formula (61) described above. *⁶ to *¹⁰ each independently represent a bonding point in the general formula (61) described above.

In the general formulae (64) to (68), X⁶⁵ to X⁶⁶ each independently preferably represent a monocyclic or condensed polycyclic hydrocarbon ring having 6 to 15 carbon atoms. Y⁶⁵ is preferably a direct bond or an oxygen atom. The organic group having a radical polymerizable group in R¹⁶³ to R¹⁶⁹ is preferably a (meth) acryloyl group or a substituent represented by general formula (72) or (73). The aliphatic structure, alkyl group, cycloalkyl group, aryl group, and monocyclic or condensed polycyclic aromatic hydrocarbon ring described above may have a hetero atom, and may be either unsubstituted or substituted.

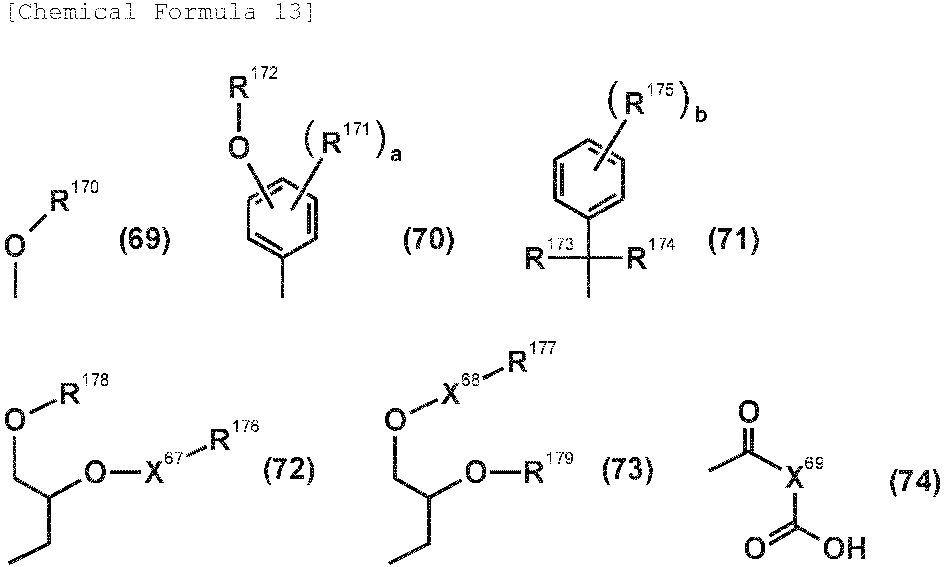

In the general formulae (69) and (70), R¹⁷⁰ and R¹⁷² each independently represent a substituent represented by the general formula (72) or the general formula (73). R¹⁷¹ represents a halogen atom, an alkyl group having 1 to 10 carbon atoms, a cycloalkyl group having 4 to 10 carbon atoms, an aryl group having 6 to 15 carbon atoms, or a substituent represented by the general formula (69) or general formula (71). a represents an integer of 0 to 4. In the general formula (71), R¹⁷³ and R¹⁷⁴ each independently represent a hydrogen atom, a halogen atom, or an alkyl group having 1 to 10 carbon atoms. R¹⁷⁵ represents a halogen atom, an alkyl group having 1 to 10 carbon atoms, or a substituent represented by general formula (69). b represents an integer of 0 to 5. In the general formulae (72) and (73), X⁶⁷ and X⁶⁸ each independently represent a direct bond, an alkylene group having 1 to 10 carbon atoms, a cycloalkylene group having 4 to 10 carbon atoms, or an arylene group having 6 to 15 carbon atoms. R¹⁷⁶ and R¹⁷⁷ each independently represent a vinyl group, an allyl group, a crotonyl group, a styryl group, a cinnamoyl group, a maleimide group, or a (meth) acryloyl group. R¹⁷⁸ and R¹⁷⁹ each independently represent a hydrogen atom, an alkyl group having 1 to 10 carbon atoms, or a substituent represented by the general formula (74). In the general formula (74), X⁶⁹ represents an alkylene group having 1 to 6 carbon atoms, an alkenylene group having 2 to 6 carbon atoms, a cycloalkylene group having 4 to 10 carbon atoms, a cycloalkenylene group having 4 to 10 carbon atoms, or an arylene group having 6 to 15 carbon atoms. X⁶⁹ is preferably a carboxylic acid anhydride residue. The alkyl group, cycloalkyl group, aryl group, alkylene group, alkenylene group, cycloalkylene group, cycloalkenylene group, and arylene group described above may have a hetero atom, and may be either unsubstituted or substituted.

The acid-modified epoxy resin preferably has a structural unit having a condensed polycyclic structure, a structural unit having a condensed polycyclic heterocyclic structure, a structural unit having a structure in which an aromatic ring skeleton and an alicyclic skeleton are directly linked, or a structural unit having a structure in which at least two aromatic ring skeletons are directly linked, from the viewpoint of suppressing the narrow mask bias and improving the halftone characteristics after development and improving the reliability of the light-emitting element in the display device. The condensed polycyclic structure or the condensed polycyclic heterocyclic structure is preferably a naphthalene skeleton, a fluorene skeleton, or a xanthene skeleton. The alicyclic skeleton is preferably a tricyclo [5.2.1.0^{2,6}] decane skeleton. The structure in which at least two aromatic ring skeletons are directly linked is preferably a biphenyl skeleton. In the general formula (61) described above, when W² is a substituent represented by any of the general formulae (65) to (67) and Y⁶⁵ is a direct bond or an oxygen atom, a structural unit having a naphthalene skeleton, a structural unit having a biphenyl skeleton, a structural unit having a fluorene skeleton, or a structural unit having a xanthene skeleton is contained. In addition, in the general formula (62), a structural unit having a structure in which an aromatic ring skeleton and a tricyclo [5.2.1.0^{2,6}] decane skeleton are directly linked is contained.

### <Alkali-soluble group>

The acid-modified epoxy resin has an acidic group as an alkali-soluble group on at least one of a main chain of the resin, a side chain of the resin, and an end of the resin. The acid-modified epoxy resin preferably has at least one of a structural unit derived from a polyfunctional carboxylic acid compound, a structural unit derived from a polyfunctional carboxylic dianhydride, and an end structure having an acidic group. Examples of a method for producing the acid-modified epoxy resin include a method for obtaining a resin having a carboxy group in the resin by a reaction between a polyfunctional epoxy compound and a polyfunctional carboxylic acid compound, and a method for reacting a polyfunctional epoxy compound with a carboxylic acid compound, and then reacting some hydroxy groups in the resin with a polyfunctional carboxylic dianhydride. Another method for producing the acid-modified epoxy resin is, for example, a method for introducing an acidic group into a resin having no acidic group. More specific examples thereof include a method in which some hydroxy groups and the like of the resin are reacted with a polyfunctional carboxylic dianhydride, and a method in which an acidic group is introduced into at least one of the main chain of the resin having no carboxy group, the side chain of the resin, and the end of the resin by a reaction using a catalyst.

### <Radical polymerizable group>

The resin (A2-2) which is the resin (A2) has a radical polymerizable group. The resin (A2-2) preferably has at least one of a structural unit derived from an epoxy compound having a radical polymerizable group, a structural unit derived from a carboxylic acid compound having a radical polymerizable group, and an end structure having a radical polymerizable group. In addition, a resin obtained by reacting some acidic groups or the like of the resin with a compound having a radical polymerizable group is also preferable, and a resin obtained by introducing a radical polymerizable group into at least one of a side chain of the resin and an end of the resin by a reaction using a catalyst is also preferable. The double bond equivalent of the resin (A2-2) is preferably 300 g/mol or more, more preferably 400 g/mol or more, and still more preferably 500 g/mol or more from the viewpoint of suppressing the narrow mask bias after development and improving the halftone characteristics. On the other hand, the double bond equivalent is preferably 1,500 g/mol or less, more preferably 1,000 g/mol or less, and still more preferably 700 g/mol or less, from the viewpoint of improving the sensitivity at the time of exposure and improving the reliability of the light-emitting element in the display device.

### <Other structural units, end-capping agent, and molecular weight>

The structural unit of the acid-modified epoxy resin is also preferably a structural unit having an aromatic group such as a structural unit derived from an aromatic polyfunctional carboxylic acid compound or a structural unit derived from an aromatic polyfunctional carboxylic dianhydride, from the viewpoint of improving the reliability of the light-emitting element in the display device. In addition, it is also preferable to have a structure in which the end of the resin is capped with an end-capping agent such as a monocarboxylic acid, a dicarboxylic anhydride, or a tricarboxylic anhydride.

From the viewpoint of improving the reliability of the light-emitting element in the display device, Mw of the acid-modified epoxy resin is preferably 500 or more and more preferably 1,000 or more in terms of polystyrene measured by GPC. On the other hand, Mw is preferably 50,000 or less and more preferably 20,000 or less, from the viewpoint of suppressing residues after development and reducing the taper of the pattern shape. The acid-modified epoxy resin can be synthesized by a known method. Examples of the epoxy compound, carboxylic anhydride, and carboxylic acid compound include the compounds disclosed in International Publication Nos. 2017/057281 and 2017/159876.

Examples of the acid-modified epoxy resin "KAYARAD" (registered trademark) PCR-1222H, CCR-1171H, TCR-1348H, ZAR-1494H, ZFR-1401H, ZCR-1798H, ZXR-1807H, ZCR-6002H, or ZCR-8001H (all manufactured by Nippon Kayaku Co., Ltd.).

### <Alkali-soluble resin (A); Acrylic resin>

Hereinafter, the resin (A2-3) which is an acrylic resin will be described. Examples of the acrylic resin include resins obtained by radical copolymerization of one or more selected from the group consisting of (meth)acrylic acid derivatives, (meth)acrylic acid ester derivatives, styrene derivatives, and other copolymerization components. The acrylic resin preferably has a structural unit represented by the general formula (81) and/or a structural unit represented by the general formula (82) from the viewpoint of suppressing the narrow mask bias after development and improving the halftone characteristics.

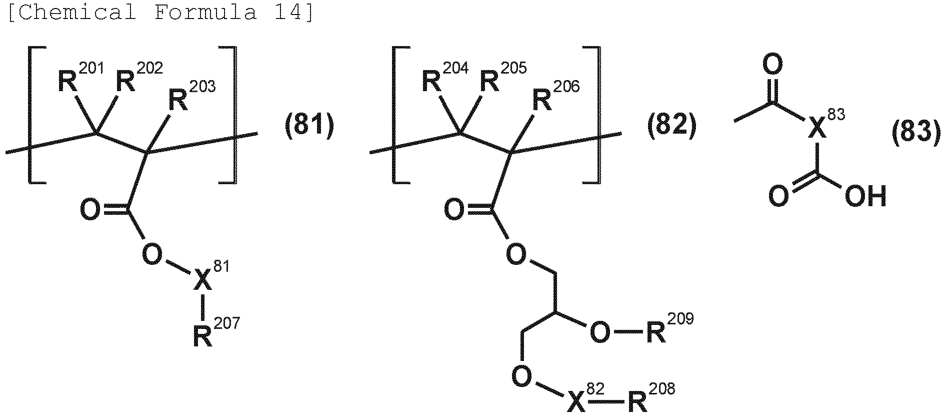

In the general formulae (81) and (82), X⁸¹ represents a direct bond or an alkylene group having 1 to 10 carbon atoms. X⁸² represents a direct bond, an alkylene group having 1 to 10 carbon atoms, a cycloalkylene group having 4 to 10 carbon atoms, or an arylene group having 6 to 15 carbon atoms. R²⁰¹ to R²⁰⁶ each independently represent a hydrogen atom or an alkyl group having 1 to 6 carbon atoms. R²⁰⁷ represents a hydrogen atom, an alkyl group having 1 to 10 carbon atoms, a cycloalkyl group having 4 to 10 carbon atoms, an aryl group having 6 to 15 carbon atoms, a halogenated alkyl group having 1 to 10 carbon atoms, a halogenated cycloalkyl group having 4 to 10 carbon atoms, or a halogenated aryl group having 6 to 15 carbon atoms. R²⁰⁸ represents a vinyl group, an allyl group, a crotonyl group, a styryl group, a cinnamoyl group, a maleimide group, or a (meth)acryloyl group. R²⁰⁹ represents a hydrogen atom, an alkyl group having 1 to 10 carbon atoms, or a substituent represented by general formula (83). In the general formula (83), X⁸³ represents an alkylene group having 1 to 6 carbon atoms, an alkenylene group having 2 to 6 carbon atoms, a cycloalkylene group having 4 to 10 carbon atoms, a cycloalkenylene group having 4 to 10 carbon atoms, or an arylene group having 6 to 15 carbon atoms. X⁸³ is preferably a carboxylic acid anhydride residue. In the general formula (81), it is preferable that X⁸¹ is a direct bond and R²⁰⁷ is a hydrogen atom. The alkyl group, cycloalkyl group, aryl group, halogenated alkyl group, halogenated cycloalkyl group, halogenated aryl group, alkylene group, alkenylene group, cycloalkylene group, cycloalkenylene group, and arylene group described above may have a hetero atom, and may be either unsubstituted or substituted.

### <Alkali-soluble group>

The acrylic resin has an acidic group as an alkali-soluble group on at least one of a main chain of the resin, a side chain of the resin, and an end of the resin. The acrylic resin preferably has a structural unit derived from a (meth)acrylic acid derivative or an end structure having an acidic group. In addition, a resin obtained by reacting a part of hydroxy groups or the like of the resin with a polyfunctional carboxylic dianhydride is also preferable, and a resin obtained by introducing an acidic group into at least one of the main chain of the resin, the side chain of the resin, and the end of the resin by a reaction using a catalyst is also preferable.

### <Radical polymerizable group>

The resin (A2-3) which is the resin (A2) has a radical polymerizable group. The resin (A2-3) is preferably a resin obtained by reacting some acidic groups or the like of the resin with an epoxy compound having a radical polymerizable group or the like. In addition, a resin obtained by reacting an epoxy group or the like of the resin with a carboxylic acid compound having a radical polymerizable group or the like is also preferable. In addition, a resin in which a radical polymerizable group is introduced into at least one of the side chain of the resin and the end of the resin by a reaction using a catalyst is also preferable. The double bond equivalent of the resin (A2-3) is preferably 500 g/mol or more, more preferably 700 g/mol or more, and still more preferably 1,000 g/mol or more from the viewpoint of suppressing the narrow mask bias after development and improving the halftone characteristics. On the other hand, the double bond equivalent is preferably 4,000 g/mol or less, more preferably 3,000 g/mol or less, still more preferably 2,000 g/mol or less, and particularly preferably 1,500 g/mol or less, from the viewpoint of improving the sensitivity at the time of exposure and improving the reliability of the light-emitting element in the display device.

### <Other structural units and molecular weight>

The structural unit of the acrylic resin is preferably a structural unit having an aromatic group such as a structural unit derived from an aromatic (meth)acrylic acid ester derivative or a structural unit derived from a styrene derivative, and is also preferably a structural unit having an alicyclic group such as a structural unit derived from an alicyclic (meth)acrylic acid ester derivative, from the viewpoint of improving the reliability of the light-emitting element in the display device.

From the viewpoint of improving the reliability of the light-emitting element in the display device, Mw of the acrylic resin is preferably 1,000 or more and more preferably 3,000 or more in terms of polystyrene measured by GPC. On the other hand, Mw is preferably 50,000 or less and more preferably 20,000 or less, from the viewpoint of suppressing residues after development and reducing the taper of the pattern shape. The acrylic resin can be synthesized by known methods. Examples of the (meth)acrylic acid derivative, the (meth)acrylic acid ester derivative, the styrene derivative, and other copolymerization components include the compounds disclosed in International Publication No. 2017/057281 or International Publication No. 2017/159876.

### <Alkali-soluble resin (A); resin (A3x), resin (A3y), and resin (A3z)>

In the photosensitive composition of the present invention, when the phenol equivalent in the total solid content is 400 to 6,000 g/mol and the alkali-soluble resin (A) has a phenolic hydroxyl group, in the photosensitive composition of the present invention, the alkali-soluble resin (A) preferably contains the resin (A3), and the resin (A3) preferably contains one or more selected from the group consisting of a resin (A3-1), a resin (A3-2), a resin (A3-3), and a resin (A3-4), from the viewpoints of suppressing the narrow mask bias after development, improving the halftone characteristics, and improving the reliability of the light-emitting element in the display device,
the resin (A3-1), the resin (A3-2), the resin (A3-3), and the resin (A3-4) have one or more selected from the group consisting of the following structural unit (3x), structural unit (3y), and structural unit (3z),
an aromatic group in the structural unit (3y) is an aromatic group different from an aromatic ring to which a phenolic hydroxyl group is bonded, and
the second aromatic group in the structural unit (3z) is preferably an aromatic group excluding an aromatic ring to which a phenolic hydroxyl group is bonded.
Structural unit (3x): A structural unit containing at least two phenolic hydroxyl groups;
Structural unit (3y): A structural unit containing a phenolic hydroxyl group and an aromatic group; and
Structural unit (3z): A structural unit containing a phenolic hydroxyl group and a structural unit containing a second aromatic group.

Here, the aromatic group in the structural unit (3y) is an aromatic group different from the aromatic ring to which the phenolic hydroxyl group is bonded. The second aromatic group in the structural unit (3z) is an aromatic group excluding an aromatic ring to which a phenolic hydroxyl group is bonded. The second aromatic group is a name for distinguishing it from an aromatic group (referring to an aromatic group different from an aromatic ring to which a phenolic hydroxyl group is bonded) in the structural unit (3y).

In the photosensitive composition of the present invention, it is preferable that one or more selected from the group consisting of the resin (A3-1), the resin (A3-2), the resin (A3-3), and the resin (A3-4) have one or more selected from the group consisting of the structural unit (3x), the structural unit (3y), and the structural unit (3z), and it is more preferable that all of the resin (A3-1), the resin (A3-2), the resin (A3-3), and the resin (A3-4) have one or more selected from the group consisting of the structural unit (3x), the structural unit (3y), and the structural unit (3z).

The resin (A3) preferably contains one or more selected from the group consisting of the following resin (A3x), resin (A3y), and resin (A3z). The resin (A3) more preferably contains the resin (A3x) and/or the resin (A3y), and still more preferably contains the resin (A3x). The resin (A3) contains the resin (A3x), and further preferably contains the resin (A3y) and/or the resin (A3z). The resin (A3) may be a single resin or a copolymer thereof.
Resin (A3x): A resin having a structural unit (3x)
Resin (A3y): A resin having a structural unit (3y)
Resin (A3z): A resin having a structural unit (3z).

The resin (A3x) is a resin containing at least two phenolic hydroxyl groups in one structural unit of the resin.

The resin (A3y) is a resin containing a phenolic hydroxyl group and an aromatic group in one structural unit of the resin. Here, the aromatic group is an aromatic group different from the aromatic ring to which the phenolic hydroxyl group is bonded.

The resin (A3z) is a resin containing a phenolic hydroxyl group in one structural unit of the resin and further containing a second aromatic group in another structural unit of the resin. Here, the second aromatic group is an aromatic group excluding an aromatic ring to which a phenolic hydroxyl group is bonded.

The resin having the structural unit (3x) and having the structural unit (3y) and/or the structural unit (3z) is contained in the resin (A3x). Further, the resin having the structural unit (3y) and the structural unit (3z) is contained in the resin (A3y).

The at least two phenolic hydroxyl groups in the structural unit (3x) are preferably at least two phenolic hydroxyl groups bonded to the same aromatic ring or at least two phenolic hydroxyl groups bonded to different aromatic rings, and more preferably at least two phenolic hydroxyl groups bonded to different aromatic rings.

The aromatic group in the structural unit (3y) and the second aromatic group in the structural unit (3z) are preferably a benzene skeleton, an isocyanuric acid skeleton, a triazine skeleton, a skeleton derived from bisphenol A, a skeleton derived from bisphenol F, or a skeleton derived from bisphenol F.

In addition, the aromatic group in the structural unit (3y) and the second aromatic group in the structural unit (3z) preferably have a condensed polycyclic structure, a condensed polycyclic heterocyclic structure, a structure in which an aromatic ring skeleton and an alicyclic skeleton are directly linked, or a structure in which at least two aromatic ring skeletons are directly linked, and more preferably have a condensed polycyclic structure or a condensed polycyclic heterocyclic structure.

The condensed polycyclic structure is preferably a naphthalene skeleton, an anthracene skeleton, an indane skeleton, an indene skeleton, a fluorene skeleton, a benzoindane skeleton, a benzoindene skeleton, a benzofluorene skeleton, a dibenzofluorene skeleton, a dihydronaphthalene skeleton, a tetrahydronaphthalene skeleton, a dihydroanthracene skeleton, or a dihydrophenanthrene skeleton, and more preferably a naphthalene skeleton, an anthracene skeleton, a fluorene skeleton, a benzofluorene skeleton, or a dihydroanthracene skeleton.

The condensed polycyclic heterocyclic structure is preferably a carbazole skeleton, a dibenzofuran skeleton, a dibenzothiophene skeleton, a benzocarbazole skeleton, a naphthobenzofuran skeleton, a naphthobenzothiophene skeleton, an indole skeleton, a benzofuran skeleton, a benzothiophene skeleton, an indoline skeleton, an indolinone skeleton, an isoindolinone skeleton, an acridine skeleton, a xanthene skeleton, or a thioxanthene skeleton, and more preferably a carbazole skeleton, a dibenzofuran skeleton, a benzocarbazole skeleton, an indolinone skeleton, an isoindolinone skeleton, an acridine skeleton, or a xanthene skeleton.

The aromatic ring skeleton in the structure in which the aromatic ring skeleton and the alicyclic skeleton are directly linked is preferably the aromatic group or the condensed polycyclic structure described above.

The alicyclic skeleton in the structure in which an aromatic ring skeleton and an alicyclic skeleton are directly linked is preferably a cyclopentane skeleton, a cyclohexane skeleton, a cycloheptane skeleton, a bicyclo [4.3.0] nonane skeleton, a bicyclo [5.4.0] undecane skeleton, a bicyclo [2.2.2] octane skeleton, a tricyclo [5.2.1.0^{2,6}] decane skeleton, a pentacyclopentadecane skeleton, or an adamantane skeleton.

The structure in which at least two aromatic ring skeletons are directly linked is preferably a biphenyl skeleton, a terphenyl skeleton, or a structure in which the aromatic group or the condensed polycyclic structure is directly linked.

In the photosensitive composition of the present invention, the resin (A3x), the resin (A3y), and the resin (A3z) are also preferably one or more selected from the group consisting of the resin (A3-1), the resin (A3-2), the resin (A3-3), and the resin (A3-4) described above.

### <Alkali-soluble resin (A); Phenol resin>

Hereinafter, the resin (A3-1) which is a phenol resin will be described. Examples of the phenol resin include a resin obtained by reacting a phenol compound or the like with one or more selected from the group consisting of an aldehyde compound, a ketone compound, an alkoxymethyl compound, and a methylol compound. The phenol resin preferably contains a novolac resin and/or a resol resin. The novolac resin refers to a resin obtained by a reaction under an acid catalyst. The resol resin refers to a resin obtained by a reaction under a base catalyst.

The structural unit in the phenol resin refers to a repeating unit including (I) a structure derived from a phenol compound and (II) a structure derived from an aldehyde compound, a ketone compound, an alkoxymethyl compound, or a methylol compound. The structural unit in the phenol resin may further have (III) a structure derived from another compound.

The phenol resin preferably contains one or more selected from the group consisting of resins having a structural unit represented by any of the general formulae (31), (32), (33), (34), (35), (38), (39), and (40) from the viewpoint of suppressing the narrow mask bias and improving the halftone characteristics after development and improving the reliability of the light-emitting element in the display device.

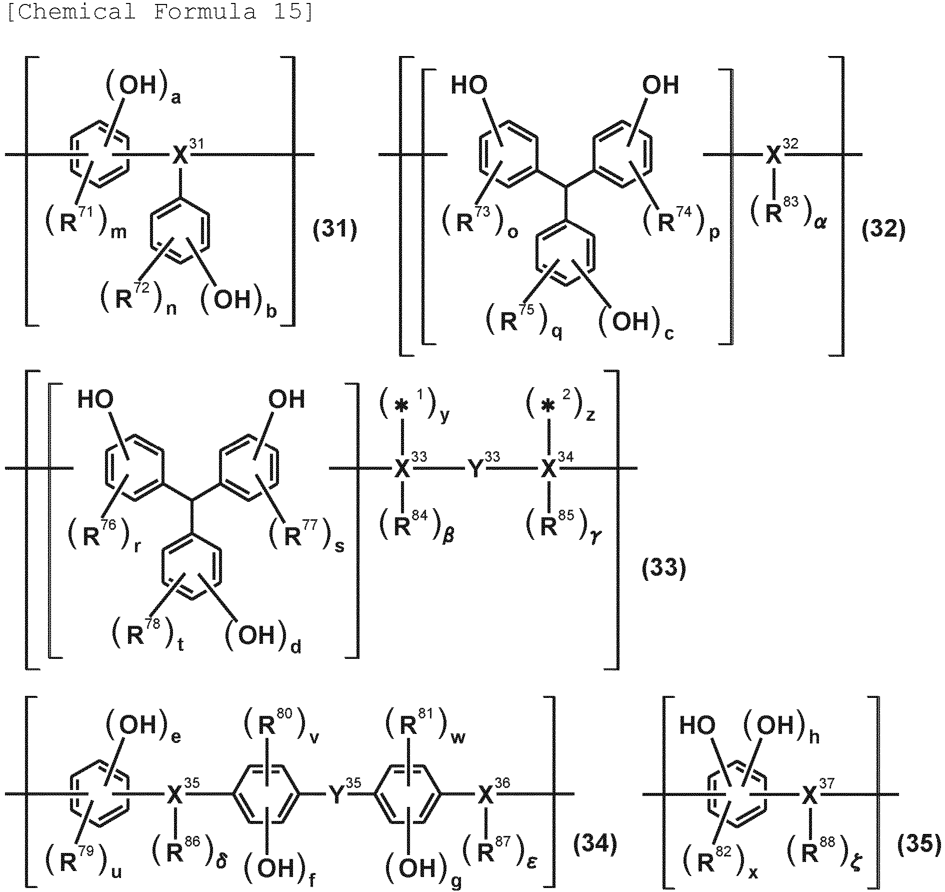

In the general formulae (31) to (35), X³¹ to X³⁷ each independently represent an aliphatic structure having 1 to 2 carbon atoms. Y³³ represents an alkylene group having 1 to 10 carbon atoms. Y³⁵ represents a direct bond, an alkylene group having 1 to 6 carbon atoms, an alkylidene group having 1 to 6 carbon atoms, a halogenated alkylene group having 1 to 6 carbon atoms, a halogenated alkylidene group having 1 to 6 carbon atoms, an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked. R⁷¹ to R⁸² each independently represent a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring linked by a group forming the ring represents a monocyclic or condensed polycyclic hydrocarbon ring. R⁸³ to R⁸⁸ each independently represent an alkyl group having 1 to 10 carbon atoms, a cycloalkyl group having 4 to 10 carbon atoms, an aryl group having 6 to 15 carbon atoms, or a hydroxy group. a represents an integer of 1 to 4. b represents an integer of 1 to 5. m represents an integer 0 to 3. n represents an integer of 0 to 4. c represents an integer of 1 to 4. o and p each independently represent an integer of 0 to 3. q represents an integer of 0 to 4. d represents an integer of 1 to 4. r and s each independently represent an integer of 0 to 3. t represents an integer of 0 to 4. e represents an integer of 1 to 4. f, g, v, and w each independently represent an integer of 0 to 4. u represents an integer of 0 to 3. h represents an integer of 1 to 3. x represents an integer of 0 to 2. y and z each independently represent 0 or 1. α, β, γ, δ, ε, and ζ each independently represent an integer of 0 to 4. *¹ and *² each independently represent a bonding point in the resin.

In the general formulae (31) to (35), Y³⁵ preferably has an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked, and more preferably has a condensed polycyclic structure or a condensed polycyclic heterocyclic structure. In addition, in the structural unit (3x), the structural unit (3y), and the structural unit (3z) described above, a structure in which an aromatic group, a condensed polycyclic structure, a condensed polycyclic heterocyclic structure, an aromatic ring skeleton and an alicyclic skeleton are directly linked, or a structure in which at least two aromatic ring skeletons are directly linked, which exemplify preferable structures, is preferable. The aliphatic structure, the alkyl group, the cycloalkyl group, the aryl group, the alkenyl group, the alkoxy group, the alkenyloxy group, the acyl group, the ring-forming group, the alkylene group, the alkylidene group, the aromatic group, the condensed polycyclic structure, the condensed polycyclic heterocyclic structure, the aromatic ring skeleton, and the alicyclic skeleton described above may have a hetero atom, and may be either unsubstituted or substituted. The condensed polycyclic hydrocarbon ring formed by the group forming the ring is preferably a naphthalene ring, an anthracene ring, a pyrene ring, an indane ring, an indene ring, a tetrahydronaphthalene ring, a fluorene ring, a xanthene ring, or an isoindolinone ring.

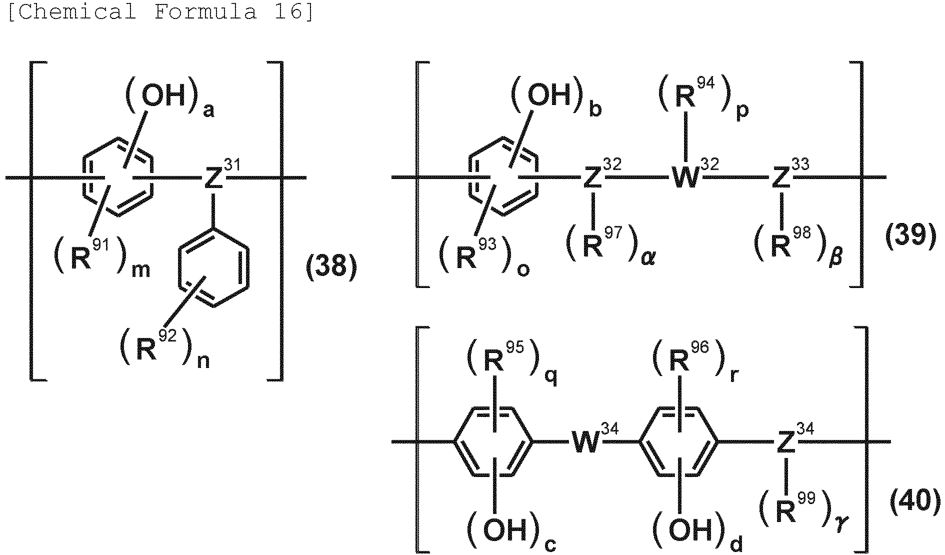

In the general formulae (38) to (40), Z³¹ to Z³⁴ each independently represent an aliphatic structure having 1 to 2 carbon atoms. W³² represents an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked. W³⁴ represents a direct bond, an alkylene group having 1 to 6 carbon atoms, an alkylidene group having 1 to 6 carbon atoms, a halogenated alkylene group having 1 to 6 carbon atoms, a halogenated alkylidene group having 1 to 6 carbon atoms, an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked. R⁹¹ to R⁹⁶ each independently represent a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring linked by a group forming the ring represents a monocyclic or condensed polycyclic hydrocarbon ring. R⁹⁷ to R⁹⁹ each independently represent an alkyl group having 1 to 10 carbon atoms, a cycloalkyl group having 4 to 10 carbon atoms, an aryl group having 6 to 15 carbon atoms, or a hydroxy group. a represents an integer of 1 to 4. m represents an integer 0 to 3. n represents an integer of 0 to 5. b represents an integer of 1 to 4. o represents an integer 0 to 3. p represents an integer of 0 to 10. However, when the valence of W³² is X, 0 ≤ p ≤ (X-2) is satisfied. c and d each independently represent an integer of 1 to 4. q and r each independently represent an integer of 0 to 3. α, β, and γ each independently represent an integer of 0 to 4. In the general formulae (38) to (40), W³² preferably has a condensed polycyclic structure or a condensed polycyclic heterocyclic structure. W³⁴ preferably has an aromatic group, a condensed polycyclic structure, a condensed polycyclic heterocyclic structure, a structure in which an aromatic ring skeleton and an alicyclic skeleton are directly linked, or a structure in which at least two aromatic ring skeletons are directly linked, and more preferably has a condensed polycyclic structure or a condensed polycyclic heterocyclic structure. In addition, in the structural unit (3x), the structural unit (3y), and the structural unit (3z) described above, W³² and W³⁴ are each independently preferably a structure in which an aromatic group, a condensed polycyclic structure, a condensed polycyclic heterocyclic structure, an aromatic ring skeleton and an alicyclic skeleton are directly linked, or a structure in which at least two aromatic ring skeletons are directly linked, which exemplify preferable structures, is preferable. The aliphatic structure, the alkyl group, the cycloalkyl group, the aryl group, the alkenyl group, the alkoxy group, the alkenyloxy group, the acyl group, the ring-forming group, the alkylene group, the alkylidene group, the aromatic group, the condensed polycyclic structure, the condensed polycyclic heterocyclic structure, the aromatic ring skeleton, and the alicyclic skeleton described above may have a hetero atom, and may be either unsubstituted or substituted. The condensed polycyclic hydrocarbon ring formed by the group forming the ring is preferably a naphthalene ring, an anthracene ring, a pyrene ring, an indane ring, an indene ring, a tetrahydronaphthalene ring, a fluorene ring, a xanthene ring, or an isoindolinone ring.

When the phenol resin has one or more selected from the group consisting of structural units represented by any of the general formulae (31), (32), (33), (35), and (40), the phenol resin is contained in the resin (A3x).

When the phenol resin has a structural unit represented by the general formula (34) and f and g in the general formula (34) independently represent an integer of 1 to 4, the phenol resin is contained in the resin (A3x). Further, when the phenol resin has a structural unit represented by the general formula (34) and f and g in the general formula (34) are 0, the phenol resin is contained in the (A3y) resin.

When the phenol resin has a structural unit represented by the general formula (38) and/or a structural unit represented by the general formula (39), the phenol resin is contained in the resin (A3y).

The content ratio of the structural unit represented by the general formula (31) to all structural units of the phenol resin is preferably 50 mol% or more, more preferably 60 mol% or more, and still more preferably 70 mol% or more. On the other hand, the content ratio of the structural unit represented by the general formula (31) is preferably 100 mol% or less and more preferably 90 mol% or less.

The content ratio of the structural unit represented by the general formula (32) to all structural units of the phenol resin is preferably 50 to 100 mol%, more preferably 60 to 100 mol% or more, and still more preferably 70 to 100 mol%.

The content ratio of the structural unit represented by the general formula (33) to all structural units of the phenol resin is preferably 5 mol% or more, more preferably 10 mol% or more, still more preferably 15 mol% or more, and particularly preferably 20 mol% or more. On the other hand, the content ratio of the structural unit represented by the general formula (33) is preferably 60 mol% or less and more preferably 45 mol% or less.

The content ratio of the structural unit represented by the general formula (34) to all structural units of the phenol resin is preferably 50 mol% or more, more preferably 60 mol% or more, and still more preferably 70 mol% or more. On the other hand, the content ratio of the structural unit represented by the general formula (34) is preferably 100 mol% or less and more preferably 90 mol% or less.

The content ratio of the structural unit represented by the general formula (35) to all structural units of the phenol resin is preferably 50 to 100 mol%, more preferably 60 to 100 mol% or more, and still more preferably 70 to 100 mol%.

The content ratio of the structural unit represented by the general formula (38) to all structural units of the phenol resin is preferably 50 mol% or more, more preferably 60 mol% or more, and still more preferably 70 mol% or more. On the other hand, the content ratio of the structural unit represented by the general formula (38) is preferably 100 mol% or less and more preferably 90 mol% or less.

The content ratio of the structural unit represented by the general formula (39) to all structural units of the phenol resin is preferably 5 mol% or more, more preferably 10 mol% or more, still more preferably 15 mol% or more, and particularly preferably 20 mol% or more. On the other hand, the content ratio of the structural unit represented by the general formula (39) is preferably 70 mol% or less, more preferably 60 mol% or less, and still more preferably 50 mol% or less.

The content ratio of the structural unit represented by the general formula (40) to all structural units of the phenol resin is preferably 5 mol% or more, more preferably 10 mol% or more, still more preferably 15 mol% or more, and particularly preferably 20 mol% or more. On the other hand, the content ratio of the structural unit represented by the general formula (40) is preferably 70 mol% or less, more preferably 60 mol% or less, and still more preferably 50 mol% or less.

The phenol resin preferably has a structural unit represented by the general formula (36) from the viewpoint of suppressing the narrow mask bias after development and improving the halftone characteristics. The content ratio of the structural unit represented by the general formula (36) to all structural units in the phenol resin is preferably 50 to 100 mol%, more preferably 60 to 100 mol%, and still more preferably 70 to 100 mol%.

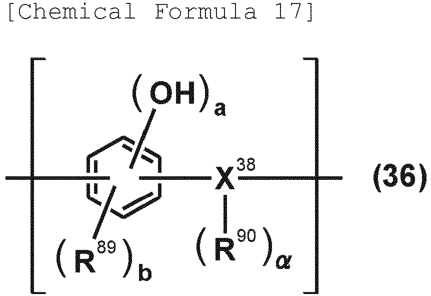

In the general formula (36), X³⁸ represents an aliphatic structure having 1 to 6 carbon atoms. R⁸⁹ represents a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring linked by a group forming the ring represents a monocyclic or condensed polycyclic hydrocarbon ring. R⁹⁰ represents an alkyl group having 1 to 10 carbon atoms, a cycloalkyl group having 4 to 10 carbon atoms, or an aryl group having 6 to 15 carbon atoms, a represents an integer of 1 to 4. b represents an integer of 0 to 3. α represents an integer of 0 to 4. The aliphatic structure, the alkyl group, the aryl group, the alkenyl group, the alkoxy group, the acyl group, the group forming a ring, and the alkylene group described above may have a hetero atom, and may be either unsubstituted or substituted. The condensed polycyclic hydrocarbon ring formed by the group forming the ring is preferably a naphthalene ring, an anthracene ring, a pyrene ring, an indane ring, an indene ring, a tetrahydronaphthalene ring, a fluorene ring, a xanthene ring, or an isoindolinone ring.

### <Alkali-soluble group>

The phenol resin has a phenolic hydroxyl group as an alkali-soluble group on at least one of a main chain of the resin, a side chain of the resin, and an end of the resin. The phenol resin includes a resin obtained by reacting a phenol compound with one or more selected from the group consisting of an aldehyde compound, an alkoxymethyl compound, and a methylol compound. In addition, a resin in which a phenolic hydroxyl group is introduced into at least one of the main chain of the resin, the side chain of the resin, and the end of the resin by a reaction using a catalyst is also preferable. It may have a carboxy group and/or a carboxylic anhydride group. Examples thereof include a resin obtained by reacting a phenolic hydroxyl group of a resin with a carboxylic anhydride, and a resin obtained by reacting a phenol compound having a carboxy group and/or a carboxylic anhydride group as a phenol compound.

### <Radical polymerizable group>

The phenol resin preferably contains the following resin (A3b-1). The resin (A3b-1) is a resin (A3b) having at least one radical polymerizable group.

Resin (A3b-1): An unsaturated group-containing phenol resin.

The resin (A3b-1) is preferably a resin obtained by reacting some acidic groups or the like of the resin with an epoxy compound having a radical polymerizable group or the like. In addition, a resin in which a radical polymerizable group is introduced into at least one of the side chain of the resin and the end of the resin by a reaction using a catalyst is also preferable. When the alkali-soluble resin (A) preferably contains the resin (A3b-1), the alkali-soluble resin (A) preferably further contains the following resin (A3a-1). The unsaturated group is preferably an ethylenically unsaturated double bond group. The resin (A3a-1) is a resin (A3a) having no radical polymerizable group.

Resin (A3a-1): A phenol resin having no unsaturated group.

### <Other structural units and molecular weight>

The structural unit of the phenol resin is also preferably a structural unit having an aromatic group, such as a structural unit derived from an aromatic aldehyde compound or a structural unit derived from an aromatic ketone compound, and is also preferably a structural unit having an alicyclic group, such as a structural unit derived from an alicyclic aldehyde compound, a structural unit derived from an alicyclic ketone compound, a structural unit derived from an alicyclic alkoxymethyl compound, or a structural unit derived from an alicyclic methylol compound, from the viewpoint of improving the reliability of the light-emitting element in the display device.

From the viewpoint of improving the reliability of the light-emitting element in the display device, Mw of the phenol resin is preferably 500 or more and more preferably 1,000 or more in terms of polystyrene measured by GPC. On the other hand, Mw is preferably 50,000 or less, more preferably 30,000 or less, still more preferably 10,000 or less, even more preferably 5,000 or less, and particularly preferably 3,000 or less from the viewpoint of suppressing residues after development and reducing the taper of the pattern shape. The phenol resin can be synthesized by a known method. Examples of the phenol compound, the aldehyde compound, the ketone compound, the alkoxymethyl compound, and the methylol compound include compounds disclosed in International Publication No. 2017/159876.

### <Alkali-soluble resin (A); Polyhydroxystyrene>

Hereinafter, the resin (A3-2) which is polyhydroxystyrene will be described. Examples of the polyhydroxystyrene include a resin obtained by radically copolymerizing a hydroxystyrene derivative or the like with a styrene derivative and/or other copolymerization components. Examples of other copolymerization components include (meth)acrylic acid derivatives and (meth)acrylic acid ester derivatives. The polyhydroxystyrene preferably has a structural unit represented by the general formula (91) and/or a structural unit represented by the general formula (92) from the viewpoint of suppressing the narrow mask bias after development and improving the halftone characteristics. The content ratio of the structural unit represented by the general formula (91) and the structural unit represented by the general formula (92) to the entire structural units of the polyhydroxystyrene is preferably 50 to 100 mol%, more preferably 60 to 100 mol%, and still more preferably 70 to 100 mol%.

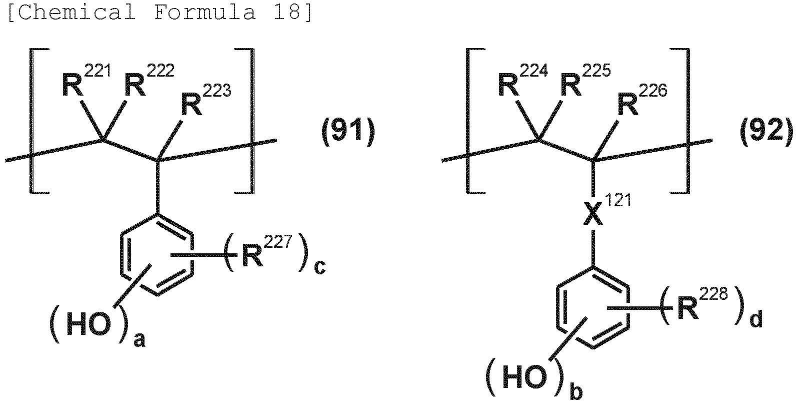

In the general formulae (91) and (92), X¹²¹ represents an alkylene group having 1 to 10 carbon atoms, a cycloalkylene group having 4 to 10 carbon atoms, or an arylene group having 6 to 15 carbon atoms. R²²¹ to R²²⁶ each independently represent a hydrogen atom or an alkyl group having 1 to 6 carbon atoms. R²²⁷ to R²²⁸ each independently represent a halogen atom, an alkyl group having 1 to 10 carbon atoms, an aryl group having 6 to 15 carbon atoms, an alkenyl group having 2 to 10 carbon atoms, an alkoxy group having 1 to 10 carbon atoms, an alkenyloxy group having 2 to 10 carbon atoms, an acyl group having 1 to 10 carbon atoms, a carboxy group, an amino group, or a group forming a ring. The ring linked by a group forming the ring represents a monocyclic or condensed polycyclic hydrocarbon ring. a and b each independently represent an integer of 1 to 5. c and d each independently represent an integer of 0 to 4. The alkyl group, the aryl group, the alkenyl group, the alkoxy group, the acyl group, the group forming a ring, alkylene group, cycloalkylene group, and arylene group described above may have a hetero atom, and may be either unsubstituted or substituted. The condensed polycyclic hydrocarbon ring formed by the group forming the ring is preferably a naphthalene ring, an anthracene ring, a pyrene ring, an indane ring, an indene ring, a tetrahydronaphthalene ring, a fluorene ring, a xanthene ring, or an isoindolinone ring.

### <Alkali-soluble group>

The polyhydroxystyrene has a phenolic hydroxyl group as an alkali-soluble group on at least one of a main chain of the resin, a side chain of the resin, and an end of the resin. The polyhydroxystyrene is preferably a resin obtained by radically copolymerizing a copolymerization component containing at least a hydroxystyrene derivative. In addition, in the resin obtained by radically copolymerizing a copolymerization component containing a (meth)acrylic acid ester having a reactive group such as an epoxy group, a resin obtained by reacting an epoxy group or the like of the resin with a phenol compound having a carboxy group or the like is also preferable, and a resin obtained by introducing a phenolic hydroxyl group into at least one of the main chain of the resin, the side chain of the resin, and the end of the resin by a reaction using a catalyst is also preferable. It may have a carboxy group and/or a carboxylic anhydride group. Examples thereof include a resin obtained by reacting a phenolic hydroxyl group of a resin with a carboxylic anhydride, and a resin obtained by reacting a copolymerization component having a carboxy group and/or a carboxylic anhydride group as other copolymerization components.

### <Radical polymerizable group>

The polyhydroxystyrene preferably contains the following resin (A3b-2). The resin (A3b-2) is the resin (A3b) having at least one radical polymerizable group.

Resin (A3b-2): Unsaturated group-containing polyhydroxystyrene.

The resin (A3b-2) is preferably a resin obtained by reacting some acidic groups or the like of the resin with an epoxy compound having a radical polymerizable group or the like. In addition, a resin obtained by reacting an epoxy group or the like of the resin with a carboxylic acid compound having a radical polymerizable group or the like is also preferable. When the alkali-soluble resin (A) preferably contains the resin (A3b-2), the alkali-soluble resin (A) preferably further contains the following resin (A3a-2). The unsaturated group is preferably an ethylenically unsaturated double bond group. The resin (A3a-2) is a resin (A3a) having no radical polymerizable group.

Resin (A3a-2): Polyhydroxystyrene having no unsaturated group.

### <Other structural units and molecular weight>

The structural unit of the polyhydroxystyrene is preferably a structural unit having an aromatic group such as a structural unit derived from an aromatic (meth)acrylic acid ester derivative, and is also preferably a structural unit having an alicyclic group such as a structural unit derived from an alicyclic (meth)acrylic acid ester derivative, from the viewpoint of improving the reliability of the light-emitting element in the display device.

From the viewpoint of improving the reliability of the light-emitting element in the display device, the Mw of the polyhydroxystyrene is preferably 500 or more and more preferably 1,000 or more in terms of polystyrene measured by GPC. On the other hand, Mw is preferably 50,000 or less and more preferably 20,000 or less, from the viewpoint of suppressing residues after development and reducing the taper of the pattern shape. The polyhydroxystyrene can be synthesized by known methods. Examples of the hydroxystyrene derivative, the styrene derivative, and other copolymerization components include the compounds disclosed in International Publication No. 2017/159876.

### <Alkali-soluble resin (A); Phenol group-containing epoxy resin>

Hereinafter, the resin (A3-3) which is a phenol group-containing epoxy resin will be described. Examples of the phenol group-containing epoxy resin include resins obtained by the following (1-a3-3) to (2-a3-3). If necessary, the polyfunctional alcohol compound may be further reacted in any reaction stage. The phenol group-containing epoxy resin has a cyclic skeleton in the structural unit of the resin.

(1-a3-3) A resin obtained by reacting a polyfunctional epoxy compound with a phenol compound having an epoxy-reactive group.

(2-a3-3) A resin obtained by further reacting a polyfunctional carboxylic dianhydride or a polyfunctional carboxylic acid compound with the resin (1-a3-3) described above.

### <Alkali-soluble group>

The phenol group-containing epoxy resin has a phenolic hydroxyl group as an alkali-soluble group on at least one of a main chain of the resin, a side chain of the resin, and an end of the resin. The phenol group-containing epoxy resin is preferably a resin obtained by reacting a polyfunctional epoxy compound or the like with a phenol compound having a carboxy group. In addition, a resin in which a phenolic hydroxyl group is introduced into at least one of the main chain of the resin, the side chain of the resin, and the end of the resin by a reaction using a catalyst is also preferable. It may have a carboxy group and/or a carboxylic anhydride group. Examples thereof include a resin obtained by reacting a hydroxy group of a resin with a carboxylic anhydride.

### <Radical polymerizable group>

The phenol group-containing epoxy resin preferably contains the following resin (A3b-3). The resin (A3b-3) is the resin (A3b) having at least one radical polymerizable group.

Resin (A3b-3): An unsaturated group-containing phenol group-containing epoxy resin.

The resin (A3b-3) is preferably a resin obtained by reacting some acidic groups or the like of the resin with an epoxy compound having a radical polymerizable group or the like. In addition, a resin obtained by reacting an epoxy group or the like of the resin with a carboxylic acid compound having a radical polymerizable group or the like is also preferable. When the alkali-soluble resin (A) preferably contains the resin (A3b-3), the alkali-soluble resin (A) preferably further contains the following resin (A3a-3). The unsaturated group is preferably an ethylenically unsaturated double bond group. The resin (A3a-3) is a resin (A3a) having no radical polymerizable group.

Resin (A3a-3): A phenol group-containing epoxy resin having no unsaturated group.

### <Other structural units and molecular weight>

The structural unit of the phenol group-containing epoxy resin is also preferably a structural unit having an aromatic group such as a structural unit derived from an aromatic polyfunctional carboxylic acid compound or a structural unit derived from an aromatic polyfunctional carboxylic dianhydride, from the viewpoint of improving the reliability of the light-emitting element in the display device.

From the viewpoint of improving the reliability of the light-emitting element in the display device, Mw of the phenol group-containing epoxy resin is preferably 500 or more and more preferably 1,000 or more in terms of polystyrene measured by GPC. On the other hand, Mw is preferably 50,000 or less and more preferably 20,000 or less, from the viewpoint of suppressing residues after development and reducing the taper of the pattern shape. The phenol group-containing epoxy resin can be synthesized by a known method.

### <Alkali-soluble resin (A); Phenol group-containing acrylic resin>

Hereinafter, the resin (A3-4) which is a phenol group-containing acrylic resin will be described. Examples of the phenol group-containing acrylic resin include resins obtained by the following (1-a3-4) to (5-a3-4).

(1-a3-4) A resin obtained by further reacting a phenol compound having an addition reactive group with a resin obtained by radical copolymerization of one or more selected from the group consisting of (meth)acrylic acid derivatives, (meth)acrylic acid ester derivatives, styrene derivatives, and other copolymerization components.

(2-a3-4) A resin obtained by further reacting a polyfunctional carboxylic dianhydride or a polyfunctional carboxylic acid compound with the resin (1-a3-4) described above.

(3-a3-4) A resin obtained by radical copolymerization of one or more selected from the group consisting of a copolymerization component having a phenolic hydroxyl group and (meth)acrylic acid derivatives, (meth)acrylic acid ester derivatives, styrene derivatives, and other copolymerization components. Here, the copolymerization component having a phenolic hydroxyl group is a copolymerization component different from the hydroxystyrene derivative.

(4-a3-4) A resin obtained by further reacting a phenol compound having an addition reactive group with the resin (3-a3-4) described above.

(5-a3-4) A resin obtained by further reacting a polyfunctional carboxylic dianhydride or a polyfunctional carboxylic acid compound with the resin (4-a3-4) described above.

### <Alkali-soluble group>

The phenol group-containing acrylic resin has a phenolic hydroxyl group as an alkali-soluble group on at least one of a main chain of the resin, a side chain of the resin, and an end of the resin. The phenol group-containing acrylic resin is preferably a resin obtained by reacting an epoxy group or the like of the resin with a phenol compound having a carboxy group in a resin obtained by radically copolymerizing a copolymerization component containing a (meth)acrylic acid ester having a reactive group such as an epoxy group. In addition, a resin in which a phenolic hydroxyl group is introduced into at least one of the main chain of the resin, the side chain of the resin, and the end of the resin by a reaction using a catalyst is also preferable. It may have a carboxy group and/or a carboxylic anhydride group. Examples thereof include a resin obtained by reacting a hydroxy group of a resin with a carboxylic anhydride.

### <Radical polymerizable group>

The phenol group-containing acrylic resin preferably contains the following resin (A3b-4). The resin (A3b-4) is the resin (A3b) having at least one radical polymerizable group.

Resin (A3b-4): An unsaturated group-containing phenol group-containing acrylic resin.

The resin (A3b-4) is preferably a resin obtained by reacting some acidic groups or the like of the resin with an epoxy compound having a radical polymerizable group or the like. In addition, a resin obtained by reacting an epoxy group or the like of the resin with a carboxylic acid compound having a radical polymerizable group or the like is also preferable. When the alkali-soluble resin (A) preferably contains the resin (A3b-4), the alkali-soluble resin (A) preferably further contains the following resin (A3a-4). The unsaturated group is preferably an ethylenically unsaturated double bond group. The resin (A3a-4) is a resin (A3a) having no radical polymerizable group.

Resin (A3a-4): A phenol group-containing acrylic resin having no unsaturated group.

### <Other structural units and molecular weight>

The structural unit of the phenol group-containing acrylic resin is preferably a structural unit having an aromatic group such as a structural unit derived from an aromatic (meth)acrylic acid ester derivative or a structural unit derived from a styrene derivative, and is also preferably a structural unit having an alicyclic group such as a structural unit derived from an alicyclic (meth)acrylic acid ester derivative, from the viewpoint of improving the reliability of the light-emitting element in the display device.

From the viewpoint of improving the reliability of the light-emitting element in the display device, Mw of the phenol group-containing acrylic resin is preferably 1,000 or more and more preferably 3,000 or more in terms of polystyrene measured by GPC. On the other hand, Mw is preferably 50,000 or less and more preferably 20,000 or less, from the viewpoint of suppressing residues after development and reducing the taper of the pattern shape. The phenol group-containing acrylic resin can be synthesized by a known method.

### <Content ratio of alkali-soluble resin (A)>

In the photosensitive composition of the present invention, the total content ratio of the resin (A1) to the total 100% by mass of the alkali-soluble resin (A) is preferably 5% by mass or more, more preferably 10% by mass or more, still more preferably 20% by mass or more, even more preferably 30% by mass or more, and particularly preferably 35% by mass or more, from the viewpoint of suppressing the narrow mask bias after development, improving the halftone characteristics, improving the reliability of the light-emitting element in the display device, improving the mechanical properties in heating at a low temperature, and improving the migration resistance. On the other hand, the content ratio of the resin (A1) is preferably 100% by mass or less, more preferably 90% by mass or lower, still more preferably 80% by mass or lower, even more preferably 75% by mass or lower, and particularly preferably 70% by mass or lower, from the viewpoint of reducing the taper of the pattern shape.

In the photosensitive composition of the present invention, the total content ratio of the resin (A2) to the total 100% by mass of the alkali-soluble resin (A) is preferably 5% by mass or more, more preferably 10% by mass or more, still more preferably 15% by mass or more, even more preferably 20% by mass or more, and particularly preferably 25% by mass or more, from the viewpoint of improving the sensitivity at the time of exposure, improving the halftone characteristics, and improving the mechanical properties in heating at a low temperature. On the other hand, the total content ratio of the resin (A2) is preferably 95% by mass or less, more preferably 85% by mass or less, still more preferably 75% by mass or less, even more preferably 70% by mass or less, and particularly preferably 65% by mass or less, from the viewpoint of suppressing the narrow mask bias after development, improving the halftone characteristics, and reducing the taper of the pattern shape.

In the photosensitive composition of the present invention, the total content ratio of the resin (A3) to the total 100% by mass of the alkali-soluble resin (A) is preferably 5% by mass or more, more preferably 7% by mass or more, still more preferably 10% by mass or more, even more preferably 15% by mass or more, and particularly preferably 20% by mass or more, from the viewpoint of suppressing the narrow mask bias after development, improving the halftone characteristics, and improving the mechanical properties in heating at a low temperature. On the other hand, the total content ratio of the resin (A3) is preferably 90% by mass or less, more preferably 80% by mass or less, still more preferably 70% by mass or less, even more preferably 65% by mass or less, and particularly preferably 60% by mass or less, from the viewpoint of suppressing residues after development, improving the sensitivity at the time of exposure, suppressing the narrow mask bias after development, and improving the halftone characteristics.

The content ratio of the alkali-soluble resin (A) in the total solid content of the photosensitive composition of the present invention excluding the solvent is preferably 10% by mass or more, more preferably 20% by mass or more, and still more preferably 25% by mass or more, from the viewpoint of suppressing the narrow mask bias after development, improving the halftone characteristics, improving the reliability of the light-emitting element in the display device, improving the mechanical properties in heating at a low temperature, and improving the migration resistance. On the other hand, the content ratio of the alkali-soluble resin (A) is preferably 75% by mass or less, more preferably 65% by mass or less, and still more preferably 55% by mass or less, from the viewpoint of improving the sensitivity at the time of exposure and suppressing residues after development. When the photosensitive composition of the present invention contains the alkali-soluble resin (A) and the radical polymerizable compound (B), the content of the alkali-soluble resin (A) in the photosensitive composition of the present invention is preferably 25 parts by mass or more, more preferably 35 parts by mass or more, and still more preferably 45 parts by mass or more, relative to the total of 100 parts by mass, of the alkali-soluble resin (A) and the radical polymerizable compound (B). On the other hand, it is preferable that the content of the alkali-soluble resin (A) is 85 parts by mass or less, and it is more preferable that the content thereof is 80 parts by mass or less, and it is still more preferable that the content thereof is 75 parts by mass or less.

### <Radical polymerizable compound (B)>

The first aspect of the photosensitive composition of the present invention preferably contains a radical polymerizable compound (B) (hereinafter, referred to as "compound (B)"). It is preferable that the compound (I) and/or the compound (IIb) contain the compound (B), and it is more preferable that the compound (IIb) contain the compound (B). On the other hand, the second aspect of the photosensitive composition of the present invention contains the compound (B).

The compound (B) refers to a compound having at least two radical polymerizable groups. When the photosensitive composition of the present invention has negative-type photosensitivity, at the time of pattern exposure, radical polymerization of the compound (B) proceeds due to radicals generated from the photo-polymerization initiator (C1) described later, and the exposed portion of the film of the composition is insoluble in an alkaline developer, so that a negative pattern can be formed. In addition, photo-curing at the time of exposure is accelerated, and the effect of improving the sensitivity at the time of exposure becomes remarkable. On the other hand, when the photosensitive composition of the present invention has positive-type photosensitivity, radical polymerization of the compound (B) proceeds at the time of exposure after development or thermal curing in an unexposed portion at the time of pattern exposure, and the degree of cross-linking of the film of the composition is improved, so that the effect of pattern shape control after thermal curing becomes remarkable. The radical polymerizable group of the compound (B) preferably has a (meth)acryloyl group from the viewpoint that radical polymerization easily proceeds.

The compound (B) preferably contains one or more selected from the group consisting of a hydrophobic skeleton-containing radical polymerizable compound (B1), a flexible skeleton-containing radical polymerizable compound (B2), and a cyclic skeleton-containing radical polymerizable compound (B3), which will be described later. In addition, it is more preferable that the compound (B) contains the hydrophobic skeleton-containing radical polymerizable compound (B1) and/or the cyclic skeleton-containing radical polymerizable compound (B3), and further contains the flexible skeleton-containing radical polymerizable compound (B2).

The compound (B) preferably has a phenolic hydroxyl group from the viewpoint of suppressing the narrow mask bias after development and improving the halftone characteristics. On the other hand, when the alkali-soluble resin (A) described above has a phenolic hydroxyl group, the compound (B) preferably does not have a phenolic hydroxyl group.

The compound (B) preferably has a (meth)acryloyl group, a vinyl group, or an allyl group from the viewpoint of improving the sensitivity at the time of exposure and improving the reliability of the light-emitting element in the display device. The alkali-soluble resin (A) and the compound (B) described above more preferably have a (meth)acryloyl group, a vinyl group, or an allyl group. When the compound (B) has a (meth)acryloyl group, a vinyl group, or an allyl group, it is also preferable that the alkali-soluble resin (A) does not have a (meth)acryloyl group, a vinyl group, or an allyl group.

The double bond equivalent of the compound (B) is preferably 80 g/mol or more and more preferably 90 g/mol or more, from the viewpoint of suppressing the narrow mask bias after development and improving the halftone characteristics. On the other hand, the double bond equivalent is preferably 800 g/mol or less and more preferably 600 g/mol or less, from the viewpoint of improving the sensitivity at the time of exposure.

When the photosensitive composition of the present invention contains the alkali-soluble resin (A) and the compound (B), the content of the compound (B) in the photosensitive composition of the present invention is, in a case where the total of the alkali-soluble resin (A) and the compound (B) is 100 parts by mass, preferably 15 parts by mass or more, more preferably 20 parts by mass or more, and still more preferably 25 parts by mass or more, from the viewpoint of improving the sensitivity at the time of exposure and suppressing residues after development. On the other hand, the content of the compound (B) is preferably 75 parts by mass or less, more preferably 65 parts by mass or less, and still more preferably 55 parts by mass or less from the viewpoint of suppressing the narrow mask bias after development and improving the halftone characteristics, and from the viewpoint of improving the reliability of the light-emitting element in the display device.

### <Radical polymerizable compound (B); Compound (B1)>

It is preferable that the photosensitive composition of the present invention contains the compound (B), the compound (B) contains the hydrophobic skeleton-containing radical polymerizable compound (B1) (hereinafter, referred to as "compound (B1)"), and the compound (B1) has the following structure (I-b1) and structure (II-b1) and has at least two structures (II-b1).
Structure (I-b1): A structure containing one or more selected from the group consisting of a fluorene structure, an indane structure, a condensed polycyclic alicyclic structure, an indolinone structure, and an isoindolinone structure
Structure (II-b1): An organic group having a radical polymerizable group.

The radical polymerizable group preferably has a (meth)acryloyl group. By containing the compound (B1), effects of suppressing the narrow mask bias and improving the halftone characteristics after development are remarkable.

In the compound (B1), from the viewpoint of suppressing the narrow mask bias after development and improving the halftone characteristics, the structure (I-b1) described above is preferably a structure represented by any of the general formulae (141) to (147).

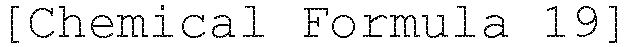

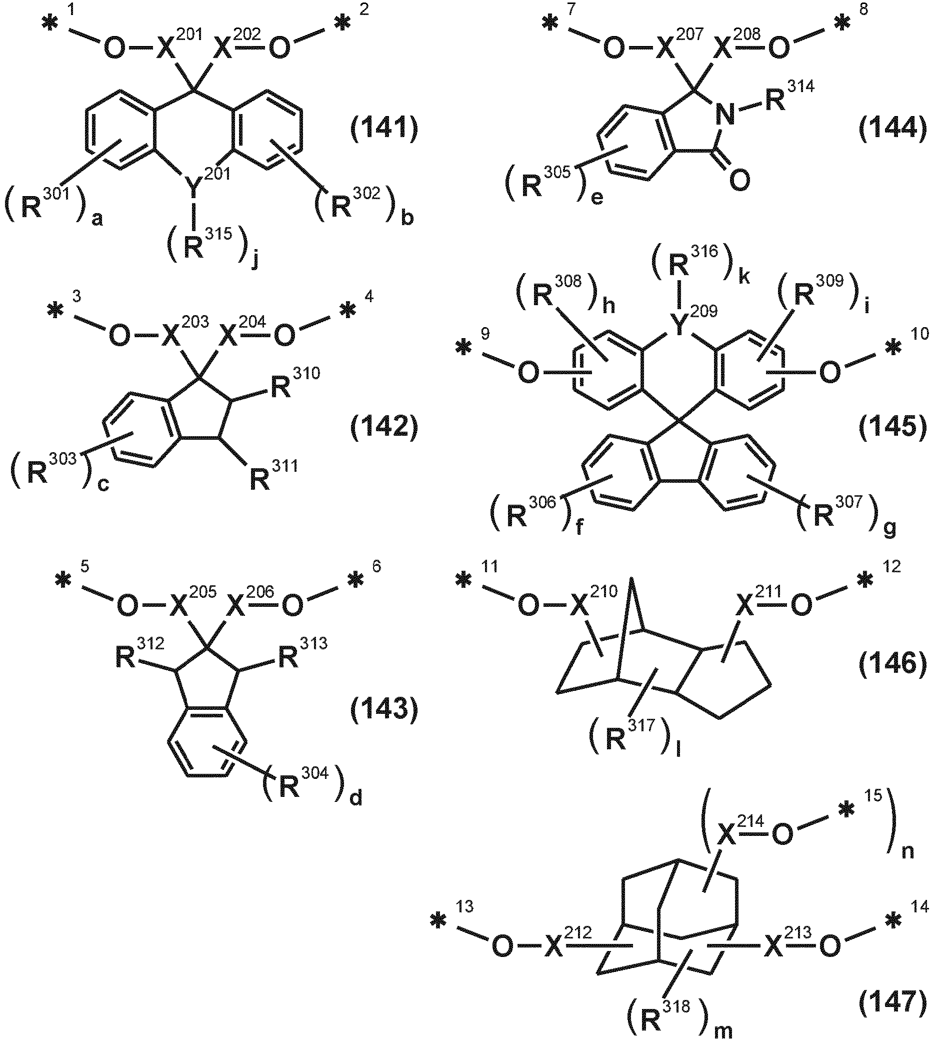

In general formulae (141) to (147), X²⁰¹ to X²⁰⁸ each independently represent a monocyclic or condensed polycyclic hydrocarbon ring. X²¹⁰ to X²¹⁴ each independently represent an aliphatic structure having 1 to 6 carbon atoms. Y²⁰¹ and Y²⁰⁹ each independently represent a direct bond, a carbon atom, a nitrogen atom, an oxygen atom, or a sulfur atom. R³⁰¹ to R³⁰⁹ each independently represent a halogen atom or an alkyl group having 1 to 10 carbon atoms. R³¹⁰ to R³¹⁶ each independently represent a hydrogen atom, a halogen atom, an alkyl group having 1 to 10 carbon atoms, a cycloalkyl group having 4 to 10 carbon atoms, or an aryl group having 6 to 15 carbon atoms. R³¹⁷ to R³¹⁸ each independently represent a halogen atom or an alkyl group having 1 to 10 carbon atoms, a, b, c, d, e, f, and g each independently represent an integer of 0 to 4. h and i each independently represent an integer of 0 to 3. When Y²⁰¹ is a direct bond, an oxygen atom, or a sulfur atom, j is 0. When Y²⁰¹ is a nitrogen atom, j is 1. When Y²⁰¹ is a carbon atom, j is 2. When Y²⁰⁹ is a direct bond, an oxygen atom, or a sulfur atom, k is 0. When Y²⁰⁹ is a nitrogen atom, k is 1. When Y²⁰⁹ is a carbon atom, k is 2. l and m each independently represent an integer of 0 to 14. n represents an integer of 0 to 2. *¹ to *¹⁵ each independently represent a bonding point in the above-described structure (II-b1).

In the general formulae (141) to (147), X²⁰¹ to X²⁰⁸ each independently preferably represent a monocyclic or condensed polycyclic hydrocarbon ring having 6 to 15 carbon atoms. Y²⁰¹ to Y²⁰⁹ each independently preferably represent a direct bond or an oxygen atom. The aliphatic structure, alkyl group, cycloalkyl group, aryl group, and monocyclic or condensed polycyclic aromatic hydrocarbon ring described above may have a hetero atom, and may be either unsubstituted or substituted.

The compound (B1) more preferably has the structure (I-b1), the structure (II-b1), and the following structure (III-b1) or structure (IV-bl) from the viewpoint of improving the sensitivity at the time of exposure, suppressing the narrow mask bias after development, and improving the halftone characteristics.

Structure (III-b1): An alkylenecarbonyl group, an oxyalkylenecarbonyl group, or an aminoalkylenecarbonyl group.

Structure (IV-b1): An alkylene group containing a hydroxy group or an oxyalkylene group containing a hydroxy group.

The total number of the structures (III-b1) or structures (IV-bl) of the compound (B1) is preferably 2 or more, more preferably 3 or more, and still more preferably 4 or more. On the other hand, the total number of the structures (III-b1) or structures (IV-bl) is preferably 10 or less, more preferably 8 or less, and still more preferably 6 or less. The compound (B1) preferably has a structure (III-b1). The structure (III-b1) is preferably a structure derived from a lactone compound or a structure derived from a lactam compound. When the compound (B1) has a structure (III-b1) or a structure (IV-b1), in the general formulae (141) to (147) described above, *¹ to *¹⁵ each independently represent a bonding point to the structure (II-b1) described above, a bonding point to the structure (III-b1) described above, or a bonding point to the structure (IV-bl) described above.

When the compound (B1) has a structure represented by general formula (157) described later, the compound has the above-described structure (III-b1). Further, when the compound (B1) has a structure represented by the general formula (156) described later and X²³¹ represents an alkylene group having 1 to 10 carbon atoms including a hydroxy group, the compound (B1) has the structure (IV-bl) described above. In general formulae (156) and (157), *¹ and *² each independently represent a bonding point with the above-described structure (I-b1). *³ and *⁴ each independently represent a bonding point in the above-described structure (II-b1). In the general formula (157), it is preferable that *¹ and *² are each independently a bonding point with an oxygen atom in the general formulae (141) to (147) described above.

The double bond equivalent of the compound (B1) is preferably 150 g/mol or more and more preferably 190 g/mol or more, from the viewpoint of suppressing the narrow mask bias after development and improving the halftone characteristics. On the other hand, the double bond equivalent is preferably 600 g/mol or less, and more preferably 400 g/mol or less, from the viewpoint of suppressing residues after development.

When the photosensitive composition of the present invention contains the alkali-soluble resin (A) and the compound (B), the content of the compound (B1) in the photosensitive composition of the present invention is, in a case where the total of the alkali-soluble resin (A) and the compound (B) is 100 parts by mass, preferably 5 parts by mass or more, and more preferably 10 parts by mass or more, from the viewpoint of suppressing the narrow mask bias after development and improving the halftone characteristics. On the other hand, the content of the compound (B1) is preferably 25 parts by mass or less, and more preferably 20 parts by mass or less from the viewpoint of suppressing residues after development.

### <Radical polymerizable compound (B); Compound (B2)>

It is preferable that the photosensitive composition of the present invention contains the compound (B), the compound (B) contains the flexible skeleton-containing radical polymerizable compound (B2) (hereinafter, referred to as "compound (B2)"), and the compound (B2) has the following structure (I-b2), structure (II-b2), and structure (III-b2) and has at least two structures (II-b2).
Structure (I-b2): A structure derived from a compound having at least two hydroxy groups
Structure (II-b2): An organic group having a radical polymerizable group
Structure (III-b2): An alkylene group, an oxyalkylene group, an alkylene group including a hydroxy group, an oxyalkylene group including a hydroxy group, an alkylene carbonyl group, an oxyalkylene carbonyl group, or an aminoalkylene carbonyl group.

The radical polymerizable group preferably has a (meth)acryloyl group. By containing the compound (B2), the effects of improving the sensitivity at the time of exposure, suppressing residues after development, and improving the halftone characteristics become remarkable.

In the compound (B2), the structure (I-b2) is more preferably the following structure (I-b2x) from the viewpoint of improving the sensitivity at the time of exposure, suppressing residues after development, and improving the halftone characteristics.

Structure (I-b2x): A structure containing one or more selected from the group consisting of a structure derived from an aliphatic polyfunctional alcohol, an alicyclic structure, and a heteroalicyclic structure.

In the compound (B2), from the viewpoint of improving the sensitivity at the time of exposure, suppressing residues after development, and improving the halftone characteristics, the structure (I-b2x) described above is preferably a structure represented by any of the general formulae (151) to (154).

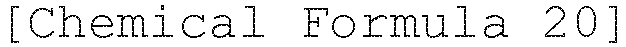

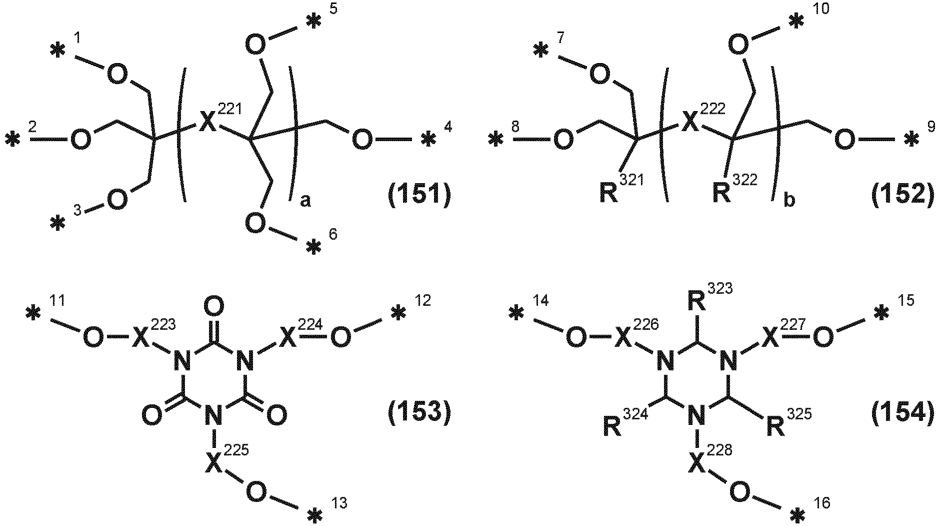

In the general formulae (151) to (154), X²²¹ to X²²⁸ each independently represent an aliphatic structure having 1 to 6 carbon atoms. R³²¹ to R³²⁵ each independently represent a hydrogen atom, a halogen atom, an alkyl group having 1 to 10 carbon atoms, or a cycloalkyl group having 4 to 10 carbon atoms, a and b each independently represent an integer of 0 to 5. *¹ to *¹⁶ each independently represent a bonding point to the structure (II-b2) described above or a bonding point to the structure (III-b2) described above. The above-described aliphatic structure, alkyl group, and cycloalkyl group may have a hetero atom, and may be either unsubstituted or substituted.

When the compound (B2) contains the compound having the structure (I-b2x) described above, the compound (B2) preferably further contains a compound having a structure represented by the general formula (155) as the structure (I-b2) described above, from the viewpoints of suppressing the narrow mask bias after development, improving the halftone characteristics, and reducing the taper of the pattern shape.

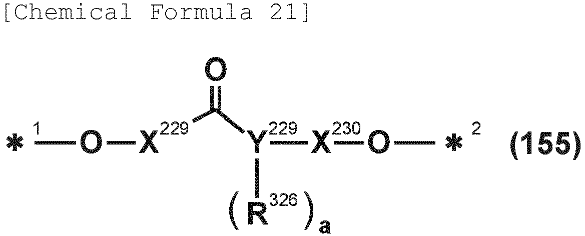

In the general formula (155), X²²⁹ to X²³⁰ each independently represent an aliphatic structure having 1 to 6 carbon atoms. Y²²⁹ represents a direct bond, a nitrogen atom, or an oxygen atom. R³²⁶ represents a hydrogen atom, a halogen atom, an alkyl group having 1 to 10 carbon atoms, or a cycloalkyl group having 4 to 10 carbon atoms. When Y²²⁹ is a direct bond or an oxygen atom, a is 0. When Y²²⁹ is a nitrogen atom, a is 1. *² and *² each independently represent a bonding point to the structure (III-b2) described above. The above-described aliphatic structure may have a hetero atom, and may be either unsubstituted or substituted.

The compound (B2) more preferably has the following structure (III-b2x) from the viewpoint of improving the sensitivity at the time of exposure, suppressing residues after development, suppressing the narrow mask bias after development, and improving the halftone characteristics.

Structure (III-b2x): An alkylenecarbonyl group, an oxyalkylenecarbonyl group, or an aminoalkylenecarbonyl group.

The total number of structures (III-b2) and structures (III-b2x) of the compound (B2) is preferably 2 or more, more preferably 3 or more, and still more preferably 4 or more. On the other hand, the total number of structures (III-b2) and structures (III-b2x) is preferably 12 or less, more preferably 10 or less, and still more preferably 8 or less. The alkylene group, the oxyalkylene group, the alkylene group containing a hydroxy group, and the oxyalkylene group containing a hydroxy group are preferably a structure derived from an epoxy compound or a structure derived from an alkylene glycol. The compound (B2) preferably has a structure (III-b2x). The structure (III-b2x) is preferably a structure derived from a lactone compound or a structure derived from a lactam compound.

From the viewpoint of improving the sensitivity at the time of exposure, suppressing residues after development, and improving the halftone characteristics, the compound (B2) preferably has one or more structures (III-b2) selected from the group consisting of structures represented by any of general formula (156) and (157).

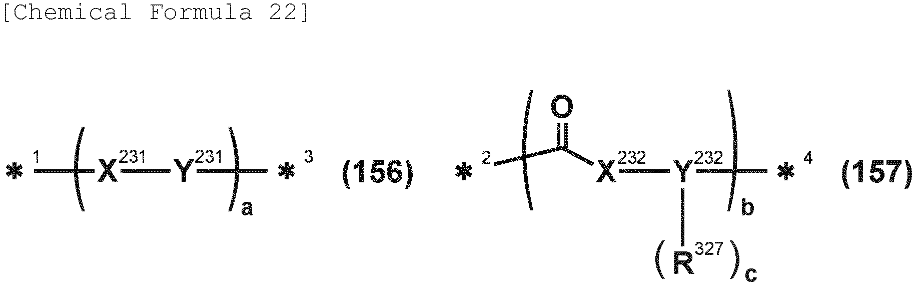

In the general formulae (156) and (157), X²³¹ and X²³² each independently represent an alkylene group having 1 to 10 carbon atoms or an alkylene group having 1 to 10 carbon atoms including a hydroxy group. Y²³¹ to Y²³² each independently represent a direct bond, a nitrogen atom, or an oxygen atom. R³²⁷ represents a hydrogen atom, a halogen atom, an alkyl group having 1 to 10 carbon atoms, or a cycloalkyl group having 4 to 10 carbon atoms, a and b each independently represent an integer of 1 to 4. When Y²³² is a direct bond or an oxygen atom, c is 0. When Y²³² is a nitrogen atom, c is 1. *² and *² each independently represent a bonding point in the above-described structure (I-b2). *³ to *⁴ each independently represent a bonding point in the above-described structure (II-b2). In the general formulae (156) and (157), it is preferable that *¹ and *² are each independently a bonding point with an oxygen atom in the general formulae (151) to (154). The above-described alkylene group, alkyl group, and cycloalkyl group may have a hetero atom, and may be either unsubstituted or substituted. When the compound (B2) has a structure represented by general formula (157) described later, the compound has the above-described structure (III-b2x) .

The number of radical polymerizable groups in the compound (B2) is preferably 2 or more, more preferably 3 or more, and still more preferably 4 or more, from the viewpoint of improving the sensitivity at the time of exposure, suppressing residues after development, and improving the halftone characteristics. On the other hand, the number of radical polymerizable groups is preferably 12 or less, more preferably 10 or less, and still more preferably 8 or less, from the viewpoint of improving the halftone characteristics and reducing the taper of the pattern shape. In addition, the double bond equivalent of the compound (B2) is preferably 100 g/mol or more and more preferably 120 g/mol or more, from the viewpoint of improving the halftone characteristics and reducing the taper of the pattern shape. On the other hand, the double bond equivalent is preferably 600 g/mol or less and more preferably 400 g/mol or less, from the viewpoint of improving the sensitivity at the time of exposure, suppressing residues after development, and improving the halftone characteristics. The compound (B2) more preferably contains a compound having at least three structures (II-b2) and a compound having two structures (II-b2) from the viewpoint of improving the sensitivity at the time of exposure, suppressing residues after development, suppressing the narrow mask bias after development, and improving the halftone characteristics.

When the photosensitive composition of the present invention contains the alkali-soluble resin (A) and the compound (B), the content of the compound (B2) in the photosensitive composition of the present invention is, in a case where the total of the alkali-soluble resin (A) and the compound (B) is 100 parts by mass, preferably 10 parts by mass or more, and more preferably 20 parts by mass or more, from the viewpoint of improving the sensitivity at the time of exposure, suppressing residues after development and improving the halftone characteristics. On the other hand, the content of the compound (B2) is preferably 40 parts by mass or less and more preferably 35 parts by mass or less, from the viewpoint of improving the halftone characteristics and reducing the taper of the pattern shape.

### <Radical polymerizable compound (B); Compound (B3)>

It is preferable that the photosensitive composition of the present invention contains the compound (B), the compound (B) contains the cyclic skeleton-containing radical polymerizable compound (B3) (hereinafter, referred to as "compound (B3)"), and the compound (B3) has the following structure (I-b3) and structure (II-b3) and has at least two structures (II-b3).
Structure (I-b3): A structure containing an alicyclic structure and/or a heteroalicyclic structure
Structure (II-b3): An organic group having a radical polymerizable group.

The compound (B3) is a compound different from the compound (B1) and the compound (B2). Compounds corresponding to both the compound (B1) and the compound (B2) are included in the compound (B1). The radical polymerizable group preferably has a (meth)acryloyl group. By containing the compound (B3), effects of suppressing the narrow mask bias and improving the halftone characteristics after development are remarkable.

In the compound (B3), from the viewpoint of suppressing residues after development, suppressing the narrow mask bias after development, and improving the halftone characteristics, the compound preferably has a structure in which the above-described structure (I-b3) includes a cyclic structure having at least two nitrogen atoms. The cyclic structure having at least two nitrogen atoms is preferably an isocyanuric acid structure and/or a triazine structure.

The double bond equivalent of the compound (B3) is preferably 150 g/mol or more and more preferably 190 g/mol or more, from the viewpoint of suppressing the narrow mask bias after development and improving the halftone characteristics. On the other hand, the double bond equivalent is preferably 600 g/mol or less, and more preferably 400 g/mol or less, from the viewpoint of suppressing residues after development.

When the photosensitive composition of the present invention contains the alkali-soluble resin (A) and the compound (B), the content of the compound (B3) in the photosensitive composition of the present invention is, in a case where the total of the alkali-soluble resin (A) and the compound (B) is 100 parts by mass, preferably 5 parts by mass or more, and more preferably 10 parts by mass or more, from the viewpoint of suppressing the narrow mask bias after development and improving the halftone characteristics. On the other hand, the content of the compound (B3) is preferably 25 parts by mass or less, and more preferably 20 parts by mass or less from the viewpoint of suppressing residues after development.

The total content of the compound (B1), the compound (B2), and the compound (B3) is preferably 15 parts by mass or more, more preferably 20 parts by mass or more, and still more preferably 25 parts by mass or more. On the other hand, the total content of the compound (B1), the compound (B2), and the compound (B3) is preferably 75 parts by mass or less, more preferably 65 parts by mass or less, and still more preferably 55 parts by mass or less.

### <Radical polymerizable compound (B); Compounds (B4) to (B8)>

The photosensitive composition of the present invention contains the compound (B) from the viewpoint of improving the sensitivity at the time of exposure and improving the mechanical properties in heating at a low temperature. Furthermore, it is preferable to satisfy at least one of conditions (γ), (δ), and (ε) described below.
Condition (γ): The compound (B) contains the following fourth polymerizable compound (B4) (hereinafter, referred to as "compound (B4)") and fifth polymerizable compound (B5) (hereinafter, referred to as "compound (B5)")
Condition (δ): The radical polymerizable compound (B) contains a sixth polymerizable compound (B6) (hereinafter, referred to as "compound (B6)") and a seventh polymerizable compound (B7) (hereinafter, referred to as "compound (B7)") described below
Condition (ε): The radical polymerizable compound (B) contains the following compound (B4) or compound (B5), and further contains the following compound (B6) or compound (B7)
Compound (B4): A compound having structure (I-b4) below and further having at least two radical polymerizable groups
Structure (I-b4): A structure including an alicyclic structure and/or a structure including a heteroalicyclic structure
Compound (B5): A compound having a structure (I-b5) and a structure (II-b5) below and further having at least two radical polymerizable groups
Structure (I-b5): A structure including an aromatic structure; and
Structure (II-b5): A structure including an aliphatic structure,
Compound (B6): A compound having at least two (meth)acryloyl groups and further having a structure (I-b6) below
Structure (I-b6): A structure having at least two (meth)acryloyl groups linked with a minimum number of atoms of 4 to 10 and an aliphatic structure, and
Compound (B7): A compound having at least two (meth)acryloyl groups and further having a structure (I-b7) below
Structure (I-b7): A structure having at least two (meth)acryloyl groups linked with a minimum number of atoms of 11 to 45 and an aliphatic structure.

When the compound (B) contains the compound (B4), the compound (B5), the compound (B6), or the compound (B7), the compound (B) does not contain the compound (B1), the compound (B2), and the compound (B3).

The alicyclic structure in the structure (I-b4) in the compound (B4) is preferably a condensed polycyclic alicyclic structure, and more preferably a tricyclo [5.2.1.0^{2,6}] decane structure, from the viewpoint of improving the mechanical properties in heating at a low temperature. From the same viewpoint, the heteroalicyclic structure in the (I-b4) structure is preferably a nitrogen-containing cyclic structure, more preferably a cyclic structure having at least two nitrogen atoms, and still more preferably an isocyanuric acid structure and/or a triazine structure. The number of nitrogen atoms of the heteroalicyclic structure in the structure (I-b4) in the compound (B4) is preferably 1 or more, more preferably 2 or more, and still more preferably 3 or more. On the other hand, the number of nitrogen atoms is preferably 6 or less, and more preferably 4 or less.

The compound (B4) preferably further has the following structure (II-b4).

### Structure (II-b4): A structure including aliphatic structure

The aliphatic structure in the structure (II-b4) in the compound (B1) is preferably an alkylene group, an oxyalkylene group, and an alkylene group including a hydroxy group, an oxyalkylene group including a hydroxy group, an alkylene carbonyl group, an oxyalkylene carbonyl group, or an aminoalkylene carbonyl group from the viewpoint of improving the sensitivity at the time of exposure and improving the migration resistance.

The aromatic structure in the structure (I-b5) in the compound (B5) is preferably a benzene structure or a biphenyl structure from the viewpoint of improving the mechanical properties in heating at a low temperature. From the same viewpoint, the aromatic structure in the above structure (I-b5) is preferably a condensed polycyclic structure, and more preferably a fluorene structure, an indane structure, or a naphthalene structure. From the same viewpoint, the aromatic structure in the above structure (I-b5) is preferably a condensed polycyclic heterocyclic structure, and more preferably a xanthene structure, an indolinone structure, or an isoindolinone structure.

The aliphatic structure in the structure (II-b5) in the compound (B5) is preferably an alkylene group, an oxyalkylene group, and an alkylene group including a hydroxy group, an oxyalkylene group including a hydroxy group, an alkylene carbonyl group, an oxyalkylene carbonyl group, or an aminoalkylene carbonyl group from the viewpoint of improving the sensitivity at the time of exposure and improving the migration resistance.

When the compound (B6) or the compound (B7) has two (meth)acryloyl groups, the minimum number of atoms in the structure (I-b6) or the structure (I-b7) refers to the minimum number of atoms including a carbon atom and a heteroatom between carbonyl carbons of the two (meth)acryloyl groups. The carbon atom between the carbonyl carbons and the atom bonded to the heteroatom are not included in the calculation of the minimum number of atoms. For example, when an oxygen atom, a propylene group, and an oxygen atom exist between carbonyl carbons, the minimum number of atoms is 5. When the compound (B6) or the compound (B7) has three or more (meth)acryloyl groups, the minimum number of atoms refers to the minimum number of atoms including a carbon atom linking the carbonyl carbons of all (meth)acryloyl groups and a heteroatom. Similarly, the carbon atom linking the carbonyl carbon and the atom linked to the heteroatom are not included in the calculation of the minimum number of atoms.

In the compound (B6), when the minimum number of atoms in the structure (I-b6) is in a specific range, the low molecular weight derived from the compound (B) in the cured product can be further reduced, and the effect of improving the migration resistance becomes remarkable. The minimum number of atoms in the structure (I-b6) is preferably 5 or more, and more preferably 6 or more. On the other hand, the minimum number of atoms in the structure (I-b6) is preferably 9 or less, and more preferably 8 or less. On the other hand, in the compound (B7), when the minimum number of atoms in the structure (I-b7) is in a specific range, the collision probability between (meth)acryloyl groups or between a (meth)acryloyl group and another radical polymerizable group is improved by improving the molecular mobility, and the effect of improving the sensitivity at the time of exposure becomes remarkable. The minimum number of atoms in the structure (I-b7) is preferably 13 or more, more preferably 15 or more, still more preferably 17 or more, and particularly preferably 20 or more. On the other hand, the minimum number of atoms in the structure (I-b7) is preferably 40 or less, more preferably 35 or less, still more preferably 30 or less, and particularly preferably 25 or less.

The aliphatic structure in the structure (I-b6) and the structure (I-b7) in the compound (B6) and the compound (B7) is preferably an alkylene group, an oxyalkylene group, and an alkylene group including a hydroxy group, an oxyalkylene group including a hydroxy group, an alkylene carbonyl group, an oxyalkylene carbonyl group, or an aminoalkylene carbonyl group from the viewpoint of improving the sensitivity at the time of exposure and improving the migration resistance. The aliphatic structure in the structure (I-b6) and the structure (I-b7) is preferably a structure derived from an aliphatic polyfunctional alcohol. The compound (B6) and the compound (B7) are compounds different from the compound (B4) and the compound (B5), and do not have a structure including an alicyclic structure, a structure including a heteroalicyclic structure, and a structure including an aromatic structure.

In the compound (B) as described above, the effect of improving the degree of cross-linking of the cured product is obtained by radical generation at the time of exposure and radical generation in heating at a low temperature, and in addition, the effect of improving the degree of cross-linking by reaction with the radical polymerizable group on the side chain or the end of the resin is obtained, and therefore it is presumed that the mechanical properties in heating at a low temperature are improved. In addition, it is presumed that the compound (B) having an aliphatic structure in the structure (II-b4), the structure (II-b5), the structure (I-b6), or the structure (I-b7) suppresses ion migration and electromigration due to the reduction of a low molecular weight component derived from the compound (B) in the cured product, and the migration resistance is improved.

It is also preferable that the compound (B) further contains the following compound (B8) from the viewpoint of improving the mechanical properties in heating at a low temperature. The compound (B8) is a compound different from the compound (B5), and does not have the structure (II-b5) .

Compound (B8): A compound having a structure including a condensed polycyclic structure and/or a structure including a condensed polycyclic heterocyclic structure, and further having at least two radical polymerizable groups

In the compound (B8), the condensed polycyclic structure is preferably a fluorene structure, an indane structure, or a naphthalene structure. In the compound (B8), the condensed polycyclic heterocyclic structure is preferably a xanthene structure, an indolinone structure, or an isoindolinone structure.

The compound (B) also preferably contains one or more selected from the group consisting of the compound (B4), the compound (B5), the compound (B6), the compound (B7), and the compound (B8). The compound (B) preferably contains two or more selected from the group consisting of the compound (B4), the compound (B5), the compound (B6), and the compound (B7), and more preferably further contains the compound (B8).

When the photosensitive composition of the present invention contains the alkali-soluble resin (A) and the compound (B), the content of the compound (B4) is, in a case where the total of the alkali-soluble resin (A) and the compound (B) is 100 parts by mass, preferably 5 parts by mass or more, more preferably 10 parts by mass or more, still more preferably 15 parts by mass or more, and particularly preferably 20 parts by mass or more, from the viewpoint of improving the sensitivity at the time of exposure and improving the mechanical properties in heating at a low temperature. On the other hand, the content of the compound (B4) is preferably 50 parts by mass or less, more preferably 45 parts by mass or less, still more preferably 40 parts by mass or less, still more preferably 35 parts by mass or less, particularly preferably 30 parts by mass or less, and most preferably 25 parts by mass or less, from the viewpoint of improving the mechanical properties and the migration resistance in heating at a low temperature. The preferable contents of the compound (B5), the compound (B6), the compound (B7), and the compound (B8) are also the same as those described above.

The total content of the compound (B4), the compound (B5), the compound (B6), the compound (B7), and the compound (B8) is preferably 15 parts by mass or more, more preferably 20 parts by mass or more, and still more preferably 25 parts by mass or more. On the other hand, the total content of the compound (B4), the compound (B5), the compound (B6), the compound (B7), and the compound (B8) is preferably 75 parts by mass or less, more preferably 65 parts by mass or less, and still more preferably 55 parts by mass or less.

### <(C) Photosensitive agent>

The first aspect of the photosensitive composition of the present invention preferably further contains a photosensitive agent (C). The second aspect of the photosensitive composition of the present invention contains a photosensitive agent (C).

The photosensitive agent (C) refers to a compound that gives positive-type or negative-type photosensitivity to a composition by bond cleavage, reaction, or structural change by exposure to generate another compound. The photosensitive agent (C) preferably contains one or more selected from the group consisting of a photo-polymerization initiator (C1) (hereinafter, referred to as "compound (C1)"), a photo-acid generator (C2), and a naphthoquinonediazide compound (C3) (hereinafter, referred to as "compound (C3)"). In a case of imparting negative-type photosensitivity to the composition, it is preferable to contain the compound (C1), and it is more preferable to further contain the photo-acid generator (C2) and/or the compound (C3). When the positive-type photosensitivity is imparted to the composition, it is preferable to contain the compound (C3), and it is more preferable to further contain the compound (C1) and/or the photo-acid generator (C2) .

The photosensitive agent (C) preferably has a (meth)acryloyl group, a vinyl group, or an allyl group from the viewpoint of improving the sensitivity at the time of exposure and improving the reliability of the light-emitting element in the display device. Here, when the alkali-soluble resin (A) described above has a (meth)acryloyl group, a vinyl group, or an allyl group, the photosensitive agent (C) preferably does not have a (meth)acryloyl group, a vinyl group, or an allyl group.

The content ratio of the photosensitive agent (C) to the total solid content of the photosensitive composition of the present invention, excluding the solvent, is preferably 0.3% by mass or more, more preferably 1.0% by mass or more, and still more preferably 2.0% by mass or more, from the viewpoint of improving the sensitivity at the time of exposure. On the other hand, the content ratio of the photosensitive agent (C) is preferably 25% by mass or less, more preferably 20% by mass or less, and still more preferably 15% by mass or less, from the viewpoint of suppressing residues after development.

### <Photosensitive agent (C); Compound (C1)>

The photosensitive composition of the present invention preferably contains the photosensitive agent (C), and the photosensitive agent (C) preferably contains the photo-polymerization initiator (C1).

In the photosensitive composition of the present invention, when the weakly acidic group equivalent in the total solid content of the photosensitive composition is 400 to 6,000 g/mol, the photosensitive composition of the present invention preferably contains the photosensitive agent (C), and the photosensitive agent (C) preferably contains the photo-polymerization initiator (C1).

The compound (C1) refers to a compound that undergoes bond cleavage and/or reaction upon exposure to light to generate a radical. Containing the compound (C1) is suitable for negative-type pattern formation. At the time of exposure, even when the amount of radicals generated from the compound (C1) is small, radical polymerization of the compound (B) and the like described above proceeds in a chain manner, and thus, it is suitable for negative-type pattern formation with low exposure energy light, and the effect of improving the sensitivity at the time of exposure becomes remarkable.

The compound (C1) is preferably a benzyl ketal-based compound, an α-hydroxyketone-based compound, an α-aminoketone-based compound, an acylphosphine oxide-based compound, a biimidazole-based compound, an oxime ester-based compound, an acridine-based compound, a titanocene-based compound, a benzophenone-based compound, an acetophenone-based compound, an aromatic ketoester-based compound, or a benzoic acid ester-based compound. From the viewpoint of improving the sensitivity at the time of exposure, an α-hydroxyketone-based compound, an α-aminoketone-based compound, an acylphosphine oxide-based compound, a biimidazole-based compound, or an oxime ester-based compound is more preferable, and from the viewpoint of improving the sensitivity at the time of exposure, improving the halftone characteristics, and suppressing residues after development, an oxime ester-based compound is still more preferable.

The content ratio of the compound (C1) to the total solid content of the photosensitive composition of the present invention, excluding the solvent, is preferably 0.3% by mass or more, more preferably 1.0% by mass or more, and still more preferably 2.0% by mass or more, from the viewpoint of improving the sensitivity at the time of exposure. On the other hand, the content ratio of the compound (C1) is preferably 25% by mass or less, more preferably 20% by mass or less, and still more preferably 15% by mass or less, from the viewpoint of suppressing residues after development. In addition, when the photosensitive composition of the present invention contains the alkali-soluble resin (A) and the compound (B), the content of the compound (C1) in the photosensitive composition of the present invention is, in a case where the total of the alkali-soluble resin (A) and the compound (B) is 100 parts by mass, preferably 1 part by mass or more, more preferably 3 parts by mass or more, and still more preferably 5 parts by mass or more. On the other hand, the content of the compound (C1) is preferably 30 parts by mass or less, more preferably 25 parts by mass or less, and still more preferably 20 parts by mass or less.

### <Photosensitive agent (C); Compound (C1-1)>

In the photosensitive composition of the present invention, the compound (C1) preferably contains an oxime ester-based compound (C1-1) (hereinafter, referred to as "compound (C1-1)").

The compound (C1-1) refers to a compound having an oxime ester structure as a skeleton that undergoes bond cleavage and/or reaction upon exposure to light to generate a radical. By containing the compound (C1-1), the effects of improving the sensitivity at the time of exposure, improving the halftone characteristics, and the suppressing residues after development become remarkable.

In the photosensitive composition of the present invention, it is preferable that the compound (C1) contains the compound (C1-1) and further contains the compound (B) described above from the viewpoint of improving the sensitivity at the time of exposure, improving the halftone characteristics, and suppressing residues after development. Since the compound (C1-1) has high absorbance with respect to light at the time of exposure, it is suitable for highly efficient radical generation, and the reaction rate of radical polymerization of the compound (B) is remarkably improved.

The compound (C1-1) preferably has a condensed polycyclic structure, a condensed polycyclic heterocyclic structure, or a diphenyl sulfide structure. The compound (C1-1) preferably has a structure (a-oxime structure) in which at least one oxime ester structure is bonded to a condensed polycyclic structure, a condensed polycyclic heterocyclic structure, or a diphenyl sulfide structure, or a structure in which at least one oxime ester carbonyl structure is bonded to a condensed polycyclic structure, a condensed polycyclic heterocyclic structure, or a diphenyl sulfide structure (that is, a structure in which an oxime ester structure is bonded via a carbonyl structure; β-oxime structure), and more preferably has a structure in which at least one oxime ester structure is bonded to a condensed polycyclic structure, a condensed polycyclic heterocyclic structure, or a diphenyl sulfide structure. The condensed polycyclic structure is preferably a fluorene structure, a benzofluorene structure, a dibenzofluorene structure, an indene structure, an indane structure, a benzoindene structure, or a benzoindane structure, and more preferably a fluorene structure, a benzofluorene structure, or a dibenzofluorene structure. The condensed polycyclic heterocyclic structure is preferably a carbazole structure, a dibenzofuran structure, a dibenzothiophene structure, a benzocarbazole structure, an indole structure, an indoline structure, a benzoindole structure, a benzoindoline structure, a phenothiazine structure, or a phenothiazine oxide structure, and more preferably a carbazole structure, a benzocarbazole structure, an indole structure, or a benzoindole structure. From the viewpoint of improving the sensitivity at the time of exposure, suppressing the narrow mask bias after development, and improving the halftone characteristics, the compound (C1-1) preferably has a fluorene structure, a benzofluorene structure, a dibenzofluorene structure, a benzocarbazole structure, an indole structure, a benzindole structure, a phenothiazine structure, or a phenothiazine oxide structure.

The photosensitive composition of the present invention preferably contains a photosensitive agent (C), the photosensitive agent (C) contains a compound (C1), the compound (C1) contains a compound (C1-1), and the compound (C1-1) has one or more selected from the group consisting of a nitro group, a naphthylcarbonyl structure, a trimethylbenzoyl structure, a thiophenylcarbonyl structure, a furylcarbonyl structure, at least two oxime ester structures, and at least two oxime ester carbonyl structures.

When the compound (C1-1) has one or more selected from the group consisting of a nitro group, a naphthylcarbonyl structure, a trimethylbenzoyl structure, a thiophenylcarbonyl structure, a furylcarbonyl structure, at least two oxime ester structures, and at least two oxime ester carbonyl structures, the effects of improving the sensitivity at the time of exposure, suppressing the narrow mask bias after development, and improving the halftone characteristics are remarkable. Among them, it is preferable to have a structure in which these structures are bonded to a condensed polycyclic structure, a condensed polycyclic heterocyclic structure, or a diphenyl sulfide structure.

In the photosensitive composition of the present invention, when the compound (C1-1) has one or more selected from the group consisting of a nitro group, a naphthylcarbonyl structure, a trimethylbenzoyl structure, a thiophenylcarbonyl structure, a furylcarbonyl structure, at least two oxime ester structures, and at least two oxime ester carbonyl structures, the compound (C1-1) preferably further has one or more selected from the group consisting of a fluorene skeleton, a benzofluorene skeleton, and a dibenzofluorene skeleton.

When the compound (C1-1) has one or more selected from the group consisting of a fluorene skeleton, a benzofluorene skeleton, and a dibenzofluorene skeleton, the compound (C1-1) has a photobleaching property, so that effects of improving sensitivity at the time of exposure, suppressing the narrow mask bias after development, and improving the halftone characteristics are remarkable. The photobleaching property refers to reduction in absorbance at a wavelength in an ultraviolet region (for example, 400 nm or less) and/or absorbance at a wavelength of visible light (380 to 780 nm) due to bond cleavage and/or reaction by exposure. Similarly, from the viewpoint of having the photobleaching property, the compound (C1-1) also preferably has a diphenyl sulfide structure, an indole structure, a benzoindole structure, a phenothiazine structure, or a phenothiazine oxide structure, and also preferably has a structure in which at least one oxime ester carbonyl structure is bonded to a condensed polycyclic structure or a condensed polycyclic heterocyclic structure.

The compound (C1-1) preferably has a group substituted with a halogen atom, and more preferably has a group substituted with a fluorine atom, from the viewpoint of improving the sensitivity at the time of exposure, suppressing the narrow mask bias after development, and improving the halftone characteristics. It is presumed that when the alkali-soluble resin (A) described above has a structural unit having a halogen atom, the improvement in compatibility between the resin and the photo-polymerization initiator promotes photo-curing from the film surface to the deep portion of the film. The polyimide-based resin described above preferably has the structural unit having a fluorine atom described above. The group substituted with a halogen atom is preferably a trifluoromethyl group, a trifluoropropyl group, a trichloropropyl group, a tetrafluoropropyl group, a fluorocyclopentyl group, a fluorophenyl group, a pentafluorophenyl group, a trifluoropropoxy group, a tetrafluoropropoxy group, or a pentafluorophenoxy group.

The compound (C1-1) preferably has a radical polymerizable group, and more preferably has one or more selected from the group consisting of a photoreactive group, an alkenyl group having 2 to 5 carbon atoms, and an alkynyl group having 2 to 5 carbon atoms, from the viewpoint of improving the sensitivity at the time of exposure, suppressing the narrow mask bias after development, and improving the halftone characteristics. Among them, it is preferable to have a structure in which at least one alkenyl group having 2 to 5 carbon atoms is bonded to a condensed polycyclic structure, a condensed polycyclic heterocyclic structure, or a diphenyl sulfide structure. The photoreactive group is preferably a styryl group, a cinnamoyl group, a maleimide group, or a (meth)acryloyl group, and more preferably a (meth)acryloyl group. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and more preferably a vinyl group or an allyl group.

The compound (C1-1) having a condensed polycyclic structure, a condensed polycyclic heterocyclic structure, or a diphenyl sulfide structure preferably contains one or more selected from the group consisting of compounds represented by any of general formulae (17), (18), and (19), and more preferably contains a compound represented by general formula (18), from the viewpoints of improving the sensitivity at the time of exposure, improving the halftone characteristics, and suppressing residues after development. In the case of having a condensed polycyclic structure, in the general formula (17) and the general formula (18), Y¹ and Y² are each independently a carbon atom. In the case of having a condensed polycyclic heterocyclic structure, Y¹ and Y² each independently represent a nitrogen atom, an oxygen atom, or a sulfur atom in general formulae (17) and (18) .

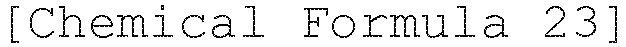

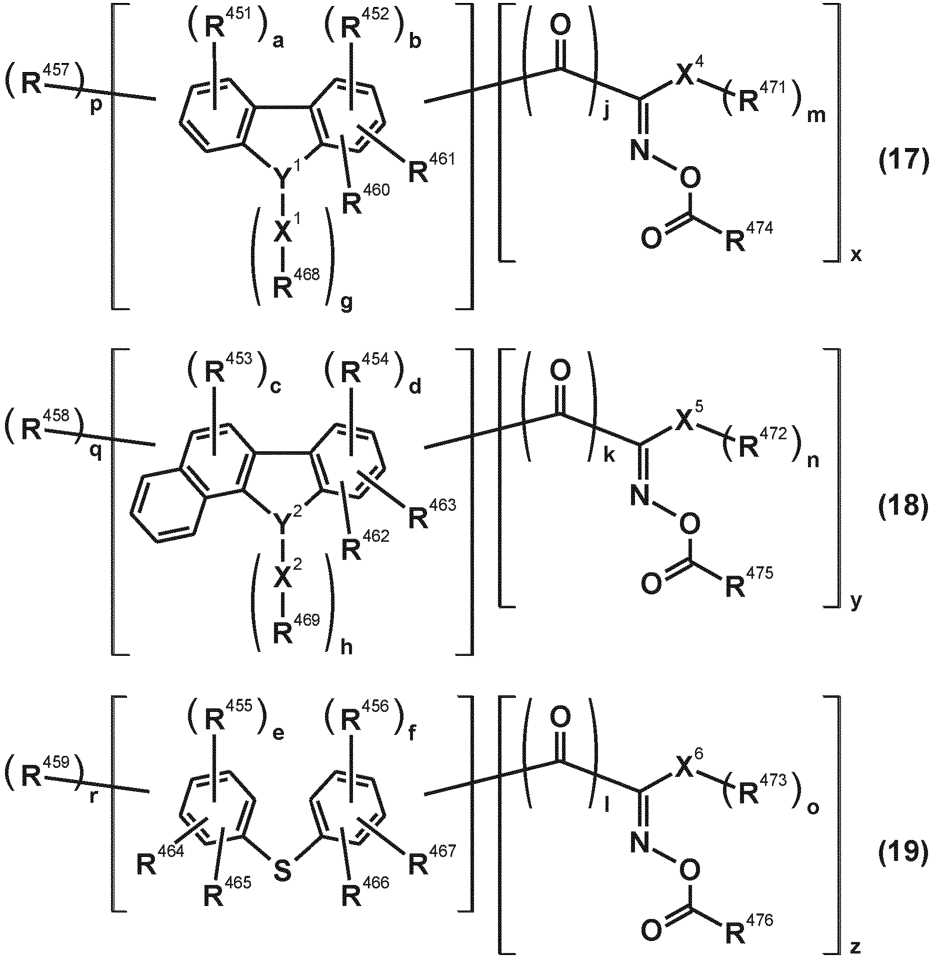

In the general formulae (17) to (19), X¹, X², X⁴, X⁵, and X⁶ each independently represent a direct bond, an alkylene group having 1 to 10 carbon atoms, a cycloalkylene group having 4 to 10 carbon atoms, or an arylene group having 6 to 15 carbon atoms. Y¹ and Y² each independently represent a carbon atom, a nitrogen atom, an oxygen atom, or a sulfur atom. R⁴⁵¹ to R⁴⁵⁶ each independently represent an alkyl group having 1 to 10 carbon atoms, a cycloalkyl group having 4 to 10 carbon atoms, an aryl group having 6 to 15 carbon atoms, an alkoxy group having 1 to 10 carbon atoms, or a hydroxyalkyl group having 1 to 10 carbon atoms. R⁴⁵⁷ to R⁴⁵⁹ each independently represent a substituent represented by any of the general formulae (57) to (60) or a nitro group. R⁴⁶⁰ to R⁴⁶⁷ each independently represent a hydrogen atom, an alkyl group having 1 to 10 carbon atoms, a cycloalkyl group having 4 to 10 carbon atoms, an aryl group having 6 to 15 carbon atoms, or a group that forms a ring having 4 to 10 carbon atoms. R⁴⁶⁸ to R⁴⁶⁹ each independently represent a hydrogen atom, an alkyl group having 1 to 10 carbon atoms, a cycloalkyl group having 4 to 10 carbon atoms, an aryl group having 6 to 15 carbon atoms, an alkenyl group having 2 to 10 carbon atoms, an alkoxy group having 1 to 10 carbon atoms, a haloalkyl group having 1 to 10 carbon atoms, a haloalkoxy group having 1 to 10 carbon atoms, or an acyl group having 2 to 15 carbon atoms. R⁴⁷¹ to R⁴⁷³ each independently represent a hydrogen atom, an alkyl group having 1 to 10 carbon atoms, a cycloalkyl group having 4 to 10 carbon atoms, an aryl group having 6 to 15 carbon atoms, an alkenyl group having 2 to 10 carbon atoms, an alkoxy group having 1 to 10 carbon atoms, a haloalkyl group having 1 to 10 carbon atoms, a haloalkoxy group having 1 to 10 carbon atoms, a heterocyclic group having 4 to 10 carbon atoms, a heterocyclic oxy group having 4 to 10 carbon atoms, an acyl group having 2 to 10 carbon atoms, or a nitro group. R⁴⁷⁴ to R⁴⁷⁶ each independently represent a hydrogen atom, an alkyl group having 1 to 10 carbon atoms, a cycloalkyl group having 4 to 10 carbon atoms, or an aryl group having 6 to 15 carbon atoms, a represents an integer of 0 to 3. c represents an integer of 0 to 5. b and d each independently represent 0 or 1. e and f each independently represent an integer of 0 to 2. When Y¹ and Y² are each independently a carbon atom, g and h are each independently 2. When Y¹ and Y² are each independently a nitrogen atom, g and h are each independently 1. When Y¹ and Y² are each independently an oxygen atom or a sulfur atom, g and h are each independently 0. j, k, and l each independently represent 0 or 1. m, n, and o each independently represent an integer of 1 to 10. p, q, and r each independently represent an integer of 1 to 4. x, y, and z each independently represent an integer of 1 to 4.

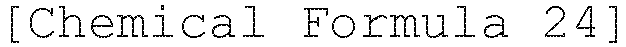

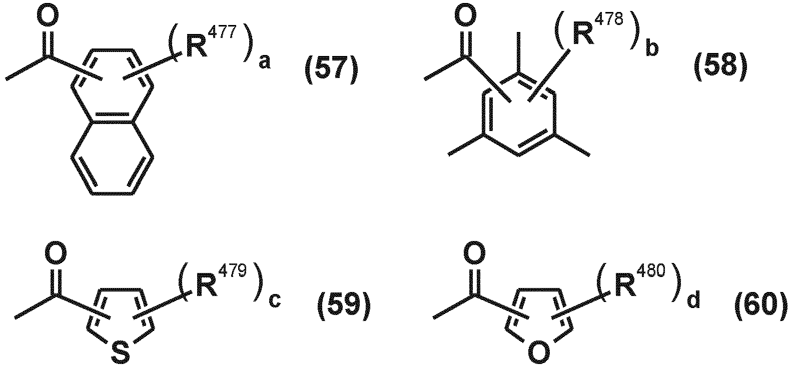

In the general formulae (57) to (60), R⁴⁷⁷ to R⁴⁸⁰ each independently represent an alkyl group having 1 to 10 carbon atoms, a cycloalkyl group having 4 to 10 carbon atoms, an aryl group having 6 to 15 carbon atoms, an alkoxy group having 1 to 10 carbon atoms, a hydroxyalkyl group having 1 to 10 carbon atoms, or a group that forms a ring. Examples of the ring formed for the plurality of R⁴⁷⁷ to R⁴⁸⁰ include a benzene ring, a naphthalene ring, an anthracene ring, a cyclopentane ring, and a cyclohexane ring. a represents an integer of 0 to 7. b represents an integer of 0 to 2. c and d each independently represent an integer of 0 to 3. The ring formed for the plurality of R⁴⁷⁷ to R⁴⁸⁰ is preferably a benzene ring or a naphthalene ring.

The content ratio of the compound (C1-1) to the total solid content of the photosensitive composition of the present invention, excluding the solvent, is preferably 0.3% by mass or more, more preferably 1.0° by mass or more, and still more preferably 2.0% by mass or more, from the viewpoint of improving the sensitivity at the time of exposure and improving the halftone characteristics. On the other hand, the content ratio of the compound (C1-1) is preferably 25% by mass or less, more preferably 20% by mass or less, and still more preferably 15% by mass or less, from the viewpoint of suppressing residues after development. In addition, when the photosensitive composition of the present invention contains the alkali-soluble resin (A) and the compound (B), the content of the compound (C1-1) in the photosensitive composition of the present invention is, in a case where the total of the alkali-soluble resin (A) and the compound (B) is 100 parts by mass, preferably 1 part by mass or more, more preferably 3 parts by mass or more, and still more preferably 5 parts by mass or more. On the other hand, the content of the compound (C1-1) is preferably 30 parts by mass or less, more preferably 25 parts by mass or less, and still more preferably 20 parts by mass or less.

### <Photosensitive agent (C); Compound (C2)>

The photosensitive composition of the present invention preferably contains the photosensitive agent (C), and the photosensitive agent (C) preferably contains the photo-acid generator (C2).

The photo-acid generator (C2) refers to a compound that undergoes bond cleavage and/or reaction upon exposure to light to generate an acid. At the time of exposure, even when the amount of the acid generated from the photo-acid generator (C2) is small, cationic polymerization of a cationic polymerizable compound and/or cross-linking of a cross-linking agent (G) and the like to be described later with a resin proceed in a chain manner, and thus, it is suitable for negative-type pattern formation at a low exposure energy, and the effects of improving the sensitivity at the time of exposure, suppressing the narrow mask bias after development, and improving the halftone characteristics are remarkable. It is also preferable that the photosensitive agent (C) contains the compound (C1) and the photo-acid generator (C2) described above. On the other hand, when the photosensitive agent (C) contains the compound (C3) and the photo-acid generator (C2) described later, an acid can be generated from the photo-acid generator (C2) at the time of exposure after alkali development and before thermal curing. The generated acid can promote cross-linking between the resin and the cross-linking agent (C) and the like described later during subsequent thermal curing, so that the effects of improving the heat resistance of the cured film and improving the chemical resistance of the cured film are remarkable.

Examples of the photo-acid generator (C2) include an ionic compound and a non-ionic compound. The ionic compound is preferably a triorganosulfonium salt-based compound. Preferable examples of the non-ionic compound include halogen-containing compounds, diazomethane compounds, sulfone compounds, sulfonate ester compounds, carboxylic acid ester compounds, sulfonimide compounds, phosphate ester compounds, and sulfone benzotriazoles compounds.

### <Photosensitive agent (C); Compound (C3)>

The photosensitive composition of the present invention contains a photosensitive agent (C), and the photosensitive agent (C) preferably contains a naphthoquinonediazide compound (C3).

The compound (C3) refers to a compound whose structure is changed by exposure to generate indene carboxylic acid and/or sulfoindene carboxylic acid. At the time of exposure, the exposed portion of the film of the composition is solubilized in an alkaline developer by the acidic compound in which the compound (C3) is structurally changed, whereby a positive-type pattern can be formed. In addition, the solubility of the exposed portion in an alkaline developer is selectively improved, and the effect of improving the resolution after development is remarkable. On the other hand, when the photosensitive composition of the present invention has negative-type photosensitivity, the photosensitive agent (C) contains the compound (C1) and the compound (C3) described above, so that effects of suppressing the narrow mask bias after development, improving the halftone characteristics, suppressing a change in pattern shape during development, and reducing the taper of the pattern shape are remarkable.

The compound (C3) is preferably a 5-naphthoquinone diazide sulfonic acid ester form or a 4-naphthoquinone diazide sulfonic acid ester form of a compound having a phenolic hydroxyl group. Examples of the method for producing the compound (C3) include a method in which a compound having a phenolic hydroxyl group is subjected to an esterification reaction with a naphthoquinone diazide sulfonic acid, and a method in which a compound having a phenolic hydroxyl group is subjected to an esterification reaction with a naphthoquinone diazide sulfonic acid chloride. The naphthoquinone diazide sulfonic acid chloride is preferably 5-naphthoquinone diazide sulfonic acid chloride or 4-naphthoquinone diazide sulfonic acid chloride.

### <Colorant (D); Compound (Da) and Compound (Db)>

It is preferable that the photosensitive composition of the present invention further contain a (D) colorant. In the photosensitive composition of the present invention, the colorant (D) preferably contains a black colorant (Da).

The colorant (D) refers to a compound that is colored by absorbing light having a wavelength of visible light (380 to 780 nm). By containing the colorant (D), light transmitted through the film of the composition or light reflected from the film of the composition can be colored to a desired color. In addition, a light-shielding property can be imparted to the film of the composition. The colorant (D) is preferably a pigment (D1) or a dye (D2). In particular, in a case where a light-shielding property against visible light is required, the black colorant (Da) is preferable. The black colorant (Da) refers to a compound that is blackened by absorbing light having a wavelength of visible light. By containing the black colorant (Da), the effects of improving the light-shielding property of the film of the composition and improving the reliability of the light-emitting element in the display device become remarkable. The film of the composition containing the black colorant (Da) is suitable for applications requiring high contrast due to suppression of external light reflection, prevention of light leakage from adjacent pixels, prevention of malfunction of TFTs, and the like, and is particularly preferable as a pixel defining layer, a TFT planarization layer, a TFT protective layer, an interlayer insulation layer, or a gate insulation layer of an organic EL display. A black matrix or a black column spacer is also preferable.

The photosensitive composition of the present invention contains the black colorant (Da), the weakly acidic group equivalent in the total solid content of the photosensitive composition is 400 to 6,000 g/mol, and the double bond equivalent in the total solid content of the photosensitive composition is 600 to 6,000 g/mol, whereby the effects of improving the sensitivity at the time of exposure, suppressing the narrow mask bias after development, and improving the halftone characteristics are remarkable. In addition, the effect of improving the reliability of the light-emitting element in the display device becomes remarkable. This is presumed to be because when the black colorant (Da) is contained, ultraviolet rays and the like at the time of pattern exposure are also blocked, which causes a decrease in sensitivity at the time of exposure, and the like, but by setting the weakly acidic group equivalent and the double bond equivalent in the total solid content of the photosensitive composition within specific ranges, it is possible to achieve both alkali solubility control in the exposed portion and the unexposed portion at a high level.

In addition, the black colorant (Da) may be contained, and a non-black colorant (Db) may be further contained. By containing the non-black colorant (Db), the film of the composition can be toned to desired color coordinates.

The dye (D2) refers to a compound that colors the surface structure of an object by chemical adsorption or the like, and is generally soluble in a solvent or the like. Examples of the (D2) dye include anthraquinone-based dyes, azo-based dyes, azine-based dyes, phthalocyanine-based dyes, methine-based dyes, oxazine-based dyes, quinoline-based dyes, indigo-based dyes, indigoid-based dyes, carbonium-based dyes, selenium-based dyes, perinone-based dyes, perylene-based dyes, triarylmethane-based dyes, and xanthene-based dyes.

The black color in the colorant (D) refers to a color with Colour Index Generic Name (hereinafter, referred to as a "C.I. number") including "BLACK" therein. When containing the color assigned with no C.I. number, it refers to a black color in the case of the composition as a cured film. The black color in the case of the composition a cured film means that in the transmission spectrum of the cured film of the composition containing the colorant (D), based on the Lambert Beer formula, the transmittance per 1.0 µm of the film thickness at a wavelength of 550 nm is converted with the film thickness within the range of 0.1 to 1.5 µm such that the transmittance at a wavelength of 550 nm is 10%, the transmittance at a wavelength of 450 to 650 nm in the converted transmission spectrum is 25% or less. The transmission spectrum of the cured film can be determined on the basis of the method disclosed in paragraph [0285] of International Publication No. 2019/087985.

The average primary particle size of the pigment is preferably 20 to 150 nm. The average primary particle size of the pigment is preferably 20 nm or more, more preferably 30 nm or more, still more preferably 40 nm or more, even more preferably 50 nm or more, and particularly preferably 60 nm or more, from the viewpoint of improving the reliability of the light-emitting element. On the other hand, the average primary particle size of the pigment is preferably 150 nm or less, more preferably 120 nm or less, still more preferably 100 nm or less, even more preferably 90 nm or less, and particularly preferably 80 nm or less, from the viewpoint of improving the light-shielding property and improving the reliability of the light-emitting element. The primary particle size of the pigment refers to a major axis size of primary particle of the pigment. The preferable range of the average primary particle size of the pigment in the pigment dispersion liquid is the same as the preferable range of the average primary particle size of the pigment described above.

The primary particle size of the pigment can be obtained by observing, with a transmission electron microscope (hereinafter, referred to as "TEM"), an image of a cross section obtained by thinly cleaving a cured film as a measurement sample and polishing the cross section by an ion milling treatment to improve smoothness, at a magnification of 50,000 times, at a position located in a range of 0.2 to 0.8 um in a depth direction from a surface of the cured film using image-analytical particle size distribution measuring software (Mac-View; (manufactured by MOUNTECH). The average primary particle size of the pigment can be calculated as an average value obtained by imaging and analyzing a cross section of the measurement sample and measuring 30 primary particles of the pigment. Furthermore, elements constituting the particles can be discriminated by observation with transmission electron microscope-energy dispersive X-ray spectroscopy (hereinafter, referred to as "TEM-EDX"). The average primary particle size of the pigment in the pigment dispersion liquid can be obtained by measuring a particle size distribution by a dynamic light scattering method.

Furthermore, the content ratio of the colorant (D) to the total solid content of the photosensitive composition of the present invention, excluding the solvent, is preferably 5°. by mass or more, more preferably 20% by mass or more, and still more preferably 30% by mass or more, from the viewpoint of improving the light-shielding property, and improving the reliability of the light-emitting element in the display device. On the other hand, the content ratio of the colorant (D) is preferably 70% by mass or less and more preferably 50% by mass or less, from the viewpoint of improving the sensitivity at the time of exposure and improving the reliability of the light-emitting element in the display device. In the photosensitive composition of the present invention, the preferable content ratio of the black colorant (Da) is the same as the preferable content ratio of the colorant (D) described above.

### <Colorant (D); Compounds (D1a) and (D1b)>

In the photosensitive composition of the present invention, the black colorant (Da) preferably contains a black pigment (D1a). The black pigment (D1a) refers to a pigment that is blackened by absorbing light having a wavelength of visible light. The pigment refers to a compound that colors the surface of an object by physical adsorption, interaction, or the like, and is generally insoluble in a solvent or the like. By containing the black pigment (D1a), the effects of improving the light-shielding property of the film of the composition and improving the reliability of the light-emitting element in the display device become remarkable. When the black pigment (D1a) is an organic black pigment (D1a-1) and/or an inorganic black pigment (D1a-2) described later, a non-black pigment (D1b) may be further contained. By containing the non-black pigment (D1b), the film of the composition can be toned to desired color coordinates. The non-black pigment (D1b) is preferably one or more selected from the group consisting of a blue pigment, a red pigment, a yellow pigment, a violet pigment, an orange pigment, and a green pigment described later. In the photosensitive composition of the present invention, the preferable content ratio of the black pigment (D1a) is the same as the preferable content ratio of the colorant (D) described above.

### <Colorant (D); Compounds (D1a-1), (D1a-2), and (D1a-3)>

In the photosensitive composition of the present invention, the black pigment (D1a) is preferably one or more selected from the group consisting of the organic black pigment (D1a-1) (hereinafter, referred to as "compound (D1a-1)"), an inorganic black pigment (D1a-2) (hereinafter, referred to as "compound (D1a-2)"), and a coloring pigment mixture of two or more colors (D1a-3) (hereinafter, referred to as "compound (D1a-3)"). From the viewpoint of improving the reliability of the light-emitting element in the display device, the compound (D1a-1) and/or the compound (D1a-3) is more preferable, and the compound (D1a-1) is still more preferable.

Examples of the compound (D1a-1) include a benzofuranone-based black pigment (D1a-1a), a perylene-based black pigment (D1a-1b), an azo-based black pigment (D1a-1c), an anthraquinone-based black pigment, an aniline-based black pigment, and carbon black. Examples of the compound (D1a-2) include graphite, or fine particles, oxides, composite oxides, sulfides, sulfates, nitrates, carbonates, nitrides, carbides, or oxynitrides of metals such as titanium, copper, iron, manganese, cobalt, chromium, nickel, zinc, calcium, or silver. The compound (D1a-3) refers to a pigment mixture that is pseudo-blackened by combining two or more pigments. Since two or more pigments are mixed, the film of the composition can be toned to desired color coordinates.

The photosensitive composition of the present invention further contains a compound (D1a-1) and/or a compound (D1a-3), the compound (D1a-1) contains one or more selected from the group consisting of a benzofuranone-based black pigment (D1a-1a), a perylene-based black pigment (D1a-1b), and an azo-based black pigment (D1a-1c), and the compound (D1a-3) preferably contains two or more pigments selected from the group consisting of red, orange, yellow, green, blue, and violet pigments.

Even when the photosensitive composition of the present invention contains these pigments having a high light-shielding property as the black pigment (D1a), it is more preferable that the weakly acidic group equivalent in the total solid content of the photosensitive composition is 400 to 6,000 g/mol, and the double bond equivalent in the total solid content of the photosensitive composition is 600 to 6,000 g/mol. Similarly, this is presumed that by setting the weakly acidic group equivalent and the double bond equivalent in the total solid content of the photosensitive composition within specific ranges, it is possible to achieve both alkali solubility control in the exposed portion and the unexposed portion at a high level.

The compound (D1a-3) preferably contains two or more pigments selected from the group consisting of red, orange, yellow, green, blue, and violet pigments. The compound (D1a-3) is preferably a coloring pigment mixture containing a blue pigment (I-d1), a red pigment, and a yellow pigment, a coloring pigment mixture containing a blue pigment (II-d1), a red pigment, and an orange pigment, a coloring pigment mixture containing a blue pigment (III-d1), a violet pigment, and an orange pigment, or a coloring pigment mixture containing a violet pigment (IV-d1) and a yellow pigment, from the viewpoint of improving the sensitivity at the time of exposure, suppressing the narrow mask bias after development, and improving the reliability of the light-emitting element in the display device. In the coloring pigment mixture of two or more colors (D1a-3), the blue pigment is preferably C.I. Pigment Blue 15:4, C.I. Pigment Blue 15:6, or C.I. Pigment Blue 60, the red pigment is preferably C.I. Pigment Red 123, C.I. Pigment Red 149, C.I. Pigment Red 177, C.I. Pigment Red 179, or C.I. Pigment Red 190, and the yellow pigment is preferably C.I. Pigment Yellow 120, C.I. Pigment Yellow 151, C.I. Pigment Yellow 175, C.I. Pigment Yellow 180, C.I. Pigment Yellow 181, C.I. Pigment Yellow 192, or C.I. Pigment Yellow 194, and the violet pigment is preferably C.I. Pigment Violet 19, C.I. Pigment Violet 29, or C.I. Pigment Violet 37, and the orange pigment is preferably C.I. Pigment Orange 43, C.I. Pigment Orange 64, or C.I. Pigment Orange 72 (all numerical values are C.I. numbers). In the photosensitive composition of the present invention, the total content ratio of the compound (D1a-1), the compound (D1a-2), and the compound (D1a-3) is as the preferable content ratio of the colorant (D) described above.

### <Colorant (D); Compounds (D1a-1a), (D1a-1b), and (D1a-1c)>

In the photosensitive composition of the present invention, the compound (D1a-1) preferably contains one or more (hereinafter, referred to as "a specific organic black pigment (D1a-1)") selected from the group consisting of the benzofuranone-based black pigment (D1a-1a), the perylene-based black pigment (D1a-1b), and the azo-based black pigment (D1a-1c), and more preferably contains the benzofuranone-based black pigment (D1a-1a). The specific organic black pigment (D1a-1) has an excellent light-shielding property per unit content ratio of the pigment in the composition as compared with a general organic pigment, and has a high transmittance for a wavelength in the ultraviolet region (for example, 400 nm or less), and thus the effects of improving the sensitivity at the time of exposure, suppressing residues after development, suppressing the narrow mask bias after development, and improving the halftone characteristics are remarkable. In addition, since insulating properties and low dielectric properties are excellent as compared with general organic pigments and inorganic pigments, the effect of improving the reliability of the light-emitting element in the display device becomes remarkable.

In the photosensitive composition of the present invention, the compound (D1a-1) suitable for combination with setting the weakly acidic group equivalent and the double bond equivalent in the total solid content of the photosensitive composition to specific ranges is particularly preferably the benzofuranone-based black pigment (D1a-1a) from the viewpoints of high light-shielding property of the pigment at a wavelength of visible light and high transmittance of the pigment at a wavelength in an ultraviolet region.

The photosensitive composition of the present invention contains the compound (D1a-1), and the compound (D1a-1) preferably contains the benzofuranone-based black pigment (D1a-1a).

The benzofuranone-based black pigment (D1a-1a) preferably has at least two benzofuran-2(3H)-one structures or at least two benzofuran-3(2H)-one structures, and more preferably a compound represented by either general formula (161) or general formula (162), a geometric isomer thereof, a salt thereof, or a salt of a geometric isomer thereof.

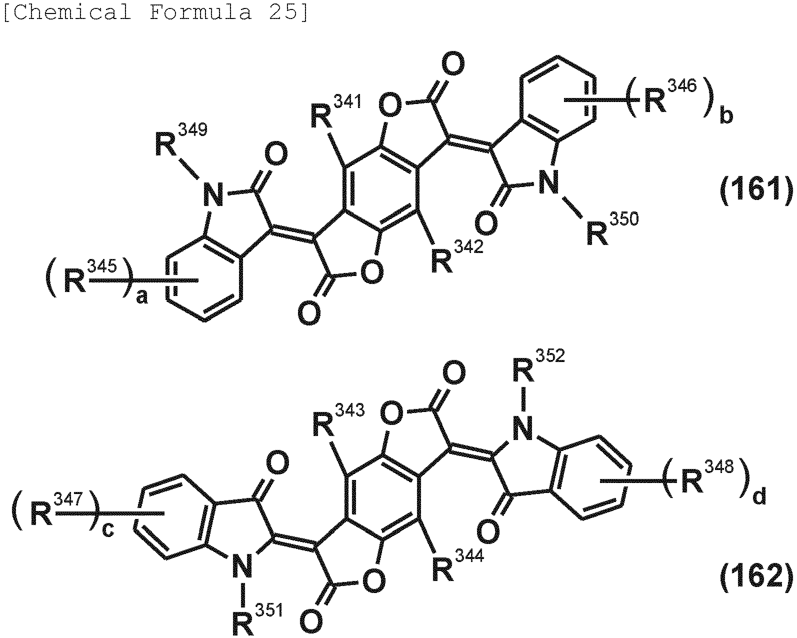

In the general formulae (161) and (162), R³⁴¹ to R³⁴⁴ each independently represent a hydrogen atom, a halogen atom, or an alkyl group having 1 to 10 carbon atoms. R³⁴⁵ to R³⁴⁸ each independently represent a halogen atom, R³⁵³, COOH, COOR³⁵³, COO⁻, CONH₂, CONHR³⁵³, CONR³⁵³R³⁵⁴, CN, OH, OR³⁵³, OCOR³⁵³, OCONH₂, OCONHR³⁵³, OCONR³⁵³R³⁵⁴, NO₂, NH₂, NHR³⁵³, NR³⁵³R³⁵⁴, NHCOR³⁵³, NR³⁵³COR³⁵⁴, N=CH₂, N=CHR³⁵³, N=CR³⁵³R³⁵⁴, SH, SR³⁵³, SOR³⁵³, SO₂R³⁵³, SO₃R³⁵³, SO₃H, SO₃⁻, SO₂NH₂, SO₂NHR³⁵³, or SO₂NR³⁵³R³⁵⁴. R³⁵³ and R³⁵⁴ each independently represent an alkyl group having 1 to 10 carbon atoms, a cycloalkyl group having 4 to 10 carbon atoms, an alkenyl group having 2 to 10 carbon atoms, a cycloalkenyl group having 4 to 10 carbon atoms, or an alkynyl group having 2 to 10 carbon atoms. The plurality of R³⁴⁵ to R³⁴⁸ may form a ring with a direct bond, or an oxygen atom bridge, a sulfur atom bridge, an NH bridge, or an NR³⁵³ bridge. R³⁴⁹ to R³⁵² each independently represent a hydrogen atom, an alkyl group having 1 to 10 carbon atoms, or an aryl group having 6 to 15 carbon atoms. a, b, c, and d each independently represent an integer of 0 to 4. The alkyl group, cycloalkyl group, alkenyl group, cycloalkenyl group, alkynyl group, and aryl group described above may have a hetero atom, and may be either unsubstituted or substituted.

The perylene-based black pigment (D1a-1b) preferably has a perylene structure, more preferably a compound represented by any of the general formulae (164) to (166) or a salt thereof, and still more preferably a compound having a 3,4,9,10-perylene tetracarboxylic acid bisbenzimidazole structure, a geometric isomer thereof, a salt thereof, or a salt of a geometric isomer thereof.

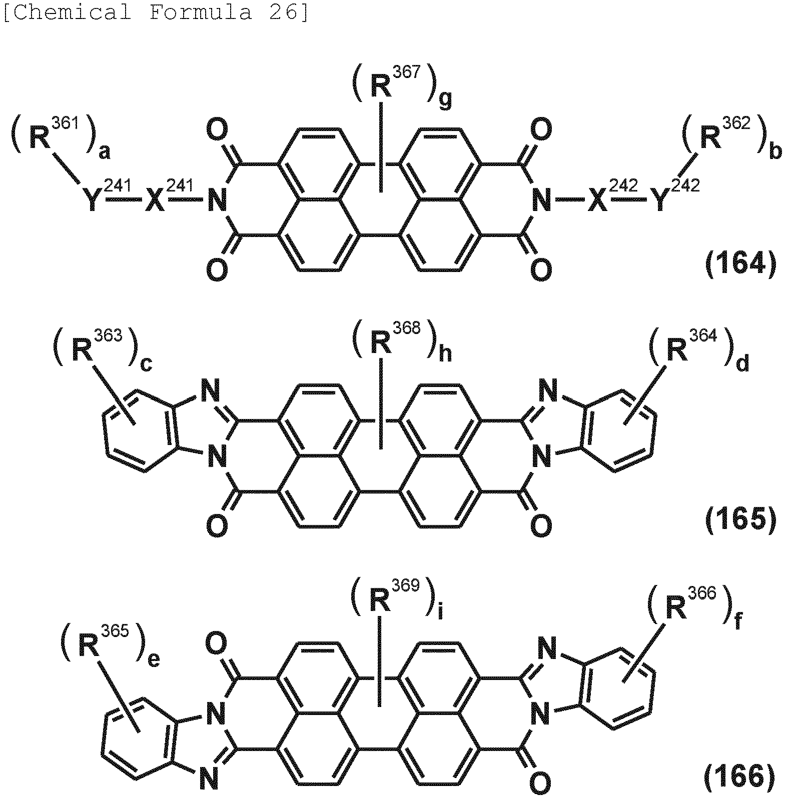

In general formulae (164) to (166), X²⁴¹ and X²⁴² each independently represent a direct bond or an alkylene group having 1 to 10 carbon atoms. Y²⁴¹ and Y²⁴² each independently represent a direct bond or an arylene group having 6 to 15 carbon atoms. R³⁶¹ and R³⁶² each independently represent a hydrogen atom, a hydroxy group, an alkyl group having 1 to 10 carbon atoms, an alkoxy group having 1 to 6 carbon atoms, or an acyl group having 2 to 6 carbon atoms. R³⁶³ to R³⁶⁹ each independently represent a hydroxy group, an alkyl group having 1 to 10 carbon atoms, an alkoxy group having 1 to 6 carbon atoms, an acyl group having 2 to 6 carbon atoms, a halogen atom, R³⁷⁰, COOH, COOR³⁷⁰, COO⁻, CONH₂, CONHR³⁷⁰, CONR³⁷⁰R³⁷¹, CN, OH, OR³⁷⁰, OCOR³⁷⁰, OCONH₂, OCONHR³⁷⁰, OCONR³⁷⁰R³⁷¹, NO₂, NH₂, NHR³⁷⁰, NR³⁷⁰R³⁷¹, NHCOR³⁷⁰, NR³⁷⁰COR³⁷¹, N=CH₂, N=CHR³⁷⁰, N=CR³⁷⁰R³⁷¹, SH, SR³⁷⁰, SOR³⁷⁰, SO₂R³⁷⁰, SO₃R³⁷⁰, SO₃H, SO₃⁻, SO₂NH₂, SO₂NHR³⁷⁰, or SO₂NR³⁷⁰R³⁷¹. R³⁷⁰ and R³⁷¹ each independently represent an alkyl group having 1 to 10 carbon atoms, a cycloalkyl group having 4 to 10 carbon atoms, an alkenyl group having 2 to 10 carbon atoms, a cycloalkenyl group having 4 to 10 carbon atoms, or an alkynyl group having 2 to 10 carbon atoms. The plurality of R³⁶⁷ to R³⁶⁹ may form a ring with a direct bond, or an oxygen atom bridge, a sulfur atom bridge, an NH bridge, or an NR³⁷⁰ bridge, a and b each independently represent an integer of 0 to 5. c, d, e, and f each independently represent an integer of 0 to 4. g, h, and i each independently represent an integer of 0 to 8. When X²⁴¹ and X²⁴² are a direct bond and Y²⁴¹ and Y²⁴² are a direct bond, R³⁶¹ and R³⁶² are each independently preferably a hydrogen atom or an alkyl group having 1 to 10 carbon atoms, and a and b are 1. When X²⁴¹ and X²⁴² are an alkylene group having 1 to 10 carbon atoms and Y²⁴¹ and Y²⁴² are a direct bond, R³⁶¹ and R³⁶² are preferably a hydroxy group, and a and b are 1. When X²⁴¹ and X²⁴² are an alkylene group having 1 to 10 carbon atoms and Y²⁴¹ and Y²⁴² are an arylene group having 6 to 15 carbon atoms, R³⁶¹ and R³⁶² each independently preferably represent a hydroxy group, an alkoxy group having 1 to 6 carbon atoms, or an acyl group having 2 to 6 carbon atoms, and a and b each independently represent an integer of 0 to 5. The alkylene group, arylene group, alkyl group, alkoxy group, and acyl group described above may have a hetero atom, and may be either unsubstituted or substituted.

The azo-based black pigment (D1a-1c) preferably has an azo group in the molecule, more preferably contains a compound having an azomethine structure and a carbazole structure or a salt thereof, and still more preferably contains a compound represented by the general formula (168) or a salt thereof.

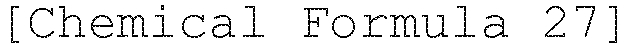

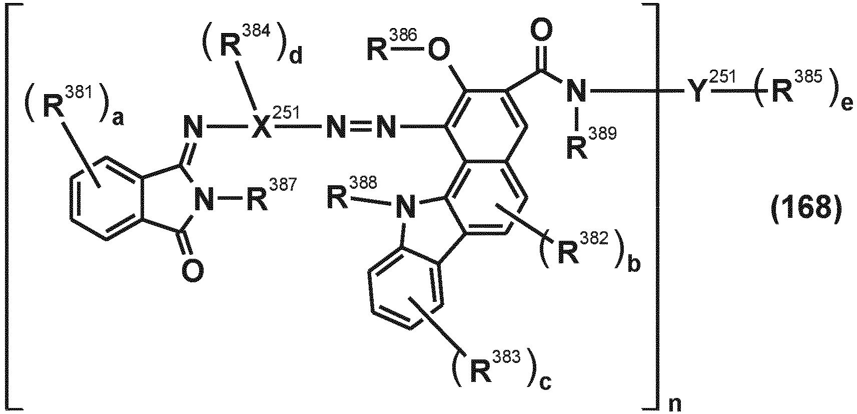

In the general formula (168), X²⁵¹ represents an arylene group having 6 to 15 carbon atoms. Y²⁵¹ represents an arylene group having 6 to 15 carbon atoms. R³⁸¹ to R³⁸³ each independently represent a halogen atom, R³⁹⁰, COOH, COOR³⁹⁰, COO⁻, CONH₂, CONHR³⁹⁰, CONR³⁹⁰R³⁹¹, CN, OH, OR³⁹⁰, OCOR³⁹⁰, OCONH₂, OCONHR³⁹⁰, OCONR³⁹⁰R³⁹¹, NO₂, NH₂, NHR³⁹⁰, NR³⁹⁰R³⁹¹, NHCOR³⁹⁰, NR³⁹⁰COR³⁹¹, N=CH₂, N=CHR³⁹⁰, N=CR³⁹⁰R³⁹¹, SH, SR³⁹⁰, SOR³⁹⁰, SO₂R³⁹⁰, SO₃R³⁹⁰, SO₃H, SO₃⁻, SO₂NH₂, SO₂NHR³⁹⁰, or SO₂NR³⁹⁰R³⁹¹. R³⁹⁰ and R³⁹¹ each independently represent an alkyl group having 1 to 10 carbon atoms, a cycloalkyl group having 4 to 10 carbon atoms, an alkenyl group having 2 to 10 carbon atoms, a cycloalkenyl group having 4 to 10 carbon atoms, or an alkynyl group having 2 to 10 carbon atoms. The plurality of R³⁸¹ to R³⁸³ may form a ring with a direct bond, or an oxygen atom bridge, a sulfur atom bridge, an NH bridge, or an NR³⁹⁰ bridge. R³⁸⁴ represents a halogen atom, an alkyl group having 1 to 10 carbon atoms, an alkoxy group having 1 to 6 carbon atoms, or a nitro group. R³⁸⁵ represents a halogen atom, an alkyl group having 1 to 10 carbon atoms, an alkoxy group having 1 to 6 carbon atoms, an acylamino group having 2 to 10 carbon atoms, or a nitro group. R³⁸⁶ to R³⁸⁹ each independently represent a hydrogen atom or an alkyl group having 1 to 10 carbon atoms, a represents an integer of 0 to 4. b represents an integer of 0 to 2. c represents an integer of 0 to 4. d and e each independently represent an integer of 0 to 8. n represents an integer of 1 to 4. The above-mentioned arylene group, alkyl group, alkoxy group, and acylamino group may have a hetero atom, and may be either unsubstituted or substituted.

Examples of the benzofuranone-based black pigment (D1a-1a) include "IRGAPHOR" (registered trademark) BLACK S0100CF (manufactured by BASF), the black pigment disclosed in International Publication No. 2010/081624, or the black pigment disclosed in International Publication No. 2010/081756. In addition, examples of the perylene-based black pigment (D1a-1b) include C.I. Pigment Black 31 and C.I. Pigment Black 32 (all numerical values are C.I. numbers). The examples include, besides the pigments described above, "PALIOGEN" (registered trademark) BLACK S0084, K0084, L0086, K0086, K0087, K0088, EH0788, FK4280, or FK4281 (all manufactured by BASF). Further, examples of the (D1a-1c) azo-based black pigment include "CHROMOFINE" (registered trademark) BLACK A1103 (manufactured by Dainichiseika Color & Chemicals Mfg. Co., Ltd.), the black pigment disclosed in Japanese Patent Laid-open Publication No. 01-170601, or the black pigment disclosed in Japanese Patent Laid-open Publication No. 02-034664. In the photosensitive composition of the present invention, the total content ratio of the specific organic black pigment (D1a-1) is as the preferable content ratio of the colorant (D) described above.

### <Covering layer (DC)>

In the photosensitive composition of the present invention, the compound (D1a-1) preferably further has a covering layer (DC). The covering layer (DC) refers to a layer covering a pigment surface, which is formed by a treatment such as a surface treatment with a silane coupling agent, a surface treatment with a silicate, a surface treatment with a metal alkoxide, or a covering treatment with a resin, for example. By having the covering layer (DC), the acid resistance, alkali resistance, solvent resistance, dispersion stability, or heat resistance of the compound (D1a-1) can be improved, and the effect of suppressing residues after development, improving the halftone characteristics, and improving the reliability of the light-emitting element in the display device becomes remarkable. In particular, when the compound (D1a-1) described above contains the benzofuranone-based black pigment (D1a-1a), the effect of suppressing residues after development caused by the pigment, suppressing the narrow mask bias after development, and improving the halftone characteristics becomes remarkable by having the covering layer (DC). In addition, the effect of improving the reliability of the light-emitting element in the display device becomes remarkable. The average coverage of the covering layer (DC) with respect to the compound (D1a-1) is preferably 50 to 100%, more preferably 70 to 100%, and still more preferably 90 to 100%, from the viewpoint of suppressing residues after development and improving the reliability of the light-emitting element in the display device. The average coverage of the covering layer (DC) with respect to the compound (D1a-1) can be determined on the basis of the method described in paragraph [0349] of International Publication No. 2019/087985.

### <Covering layer (DC); Covering layer (DC-1), Covering layer (DC-2), and Covering layer (DC-3)>

From the viewpoint of suppressing residues after development and improving the reliability of the light-emitting element in the display device, the covering layer (DC) preferably contains one selected from the group consisting of a silica covering layer (DC-1) (hereinafter, referred to as "covering layer (DC-1)"), a metal oxide covering layer (DC-2) (hereinafter, referred to as "covering layer (DC-2)"), and a metal hydroxide covering layer (DC-3) (hereinafter, referred to as "covering layer (DC-3)"), and the covering layer (DC-1) is more preferable. Examples of the silica in the covering layer (DC-1) include silicon dioxide and a hydrous material thereof. The metal oxide in the covering layer (DC-2) includes not only the metal oxide itself but also, for example, a hydrate of the metal oxide. Examples of the metal oxide include alumina (Al₂O₃) and alumina hydrate (Al₂O₃ · nH₂O). Examples of the metal hydroxide in the covering layer (DC-3) include aluminum hydroxide (Al(OH)₃).

In the photosensitive composition of the present invention, in a case where the compound (D1a-1) is 100 parts by mass, the content of the covering layer (DC-1) is preferably 1 part by mass or more, and more preferably 5 parts by mass or more, from the viewpoint of suppressing residues after development and from the viewpoint of improving the reliability of the light-emitting element in the display device. On the other hand, the content of the covering layer (DC-1) is preferably 20 parts by mass or less, and more preferably 10 parts by mass or less from the viewpoint of suppressing residues after development. In addition, in the photosensitive composition of the present invention, in a case where the compound (D1a-1) is 100 parts by mass, the total content of the covering layer (DC-2) and the covering layer (DC-3) is preferably 0.1 parts by mass or more, and more preferably 0.5 parts by mass or more, from the viewpoint of suppressing residues after development and from the viewpoint of improving the reliability of the light-emitting element in the display device. On the other hand, the total content of the covering layer (DC-2) and the covering layer (DC-3) is preferably 20 parts by mass or less, and more preferably 10 parts by mass or less from the viewpoint of suppressing residues after development.

### <Dispersant (E)>

It is preferable that the photosensitive composition of the present invention further contain a dispersant (E). The dispersant (E) refers to a compound having a surface affinity group that interacts with a surface, such as the pigment (D1) described above, and a dispersion stabilizing structure that improves dispersion stability. Examples of the dispersion stabilizing structure include an ionic substituent and a polar substituent that are dispersed and stabilized by electrostatic repulsion, and a polymer chain that is dispersed and stabilized by steric hindrance. When the number average particle size of the pigment (D1) is 500 nm or less, the dispersion stability is deteriorated due to an increase in a surface area, and aggregation of particles is likely to occur. By containing the dispersant (E), the effects of suppressing residues after development and improving the resolution after development are remarkable.

The dispersant (E) preferably has a (meth)acryloyl group, a vinyl group, or an allyl group from the viewpoint of improving the sensitivity at the time of exposure and improving the reliability of the light-emitting element in the display device. When the alkali-soluble resin (A) described above has a (meth)acryloyl group, a vinyl group, or an allyl group, the dispersant (E) more preferably does not have a (meth)acryloyl group, a vinyl group, or an allyl group.

From the viewpoint of suppressing residues after development, the dispersant (E) preferably has one or more selected from the group consisting of a basic group, an acidic group, a salt structure of a basic group, and a salt structure of an acidic group, and more preferably has a basic group and/or a salt structure of the basic group. From the viewpoint of suppressing residues after development, the dispersant (E) is preferably a dispersant having only a basic group, a dispersant having a basic group and an acidic group, a dispersant having a structure in which a basic group forms a salt with an acid, or a dispersant having a structure in which an acidic group forms a salt with a base, and more preferably a dispersant having only a basic group, or a dispersant having a basic group and an acidic group. A dispersant having only an acidic group or a dispersant having neither a basic group nor an acidic group may be contained.

The basic group of the dispersant (E) is preferably a tertiary amino group or a nitrogen-containing ring skeleton such as a pyrrolidine skeleton, a pyrrole skeleton, an imidazole skeleton, or a piperidine skeleton. The acidic group of the dispersant (E) is preferably a carboxy group, a sulfonic acid group, a phosphonate group, or a phenolic hydroxyl group. The structure in which the basic group of the dispersant (E) forms a salt with an acid is preferably a quaternary ammonium salt structure or a structure in which the above-described nitrogen-containing ring skeleton forms a salt. The counter anion in the salt structure of the basic group is preferably a carboxylate anion, a sulfonate anion, a phenoxy anion, a sulfate anion, a nitrate anion, a phosphate anion, or a halogen anion, and more preferably a carboxylate anion. Examples of the dispersant (E) having a polymer chain, an acrylic resin-based dispersant, a polyoxyalkylene ether-based dispersant, a polyester-based dispersant, a polyurethane-based dispersant, a polyol-based dispersant, a polyalkyleneamine-based dispersant, a polyethyleneimine-based dispersant, and a polyallylamine-based dispersant.

### <Dispersant (E); Compound (E1)>

The dispersant (E) preferably contains a pigment dispersant (E1) having a basic group (hereinafter, referred to as "compound (E1)"), and the compound (E1) more preferably has one or more structures selected from the group consisting of structures represented by any of the general formulae (26), (27), (28), and (29) and a polyoxyalkylene structure. The compound (E1) more preferably has a structure represented by general formula (26) and a polyoxyalkylene structure from the viewpoint of suppressing an increase in viscosity during storage of the pigment dispersion liquid, improving the flatness of the cured film, and suppressing residues after development. In addition, the pigment dispersant having a basic group (E1) more preferably has a structure represented by the general formula (29) and a polyoxyalkylene structure from the viewpoint of improving the dispersibility of the pigment and suppressing pigment aggregates during frozen storage of the pigment dispersion liquid.

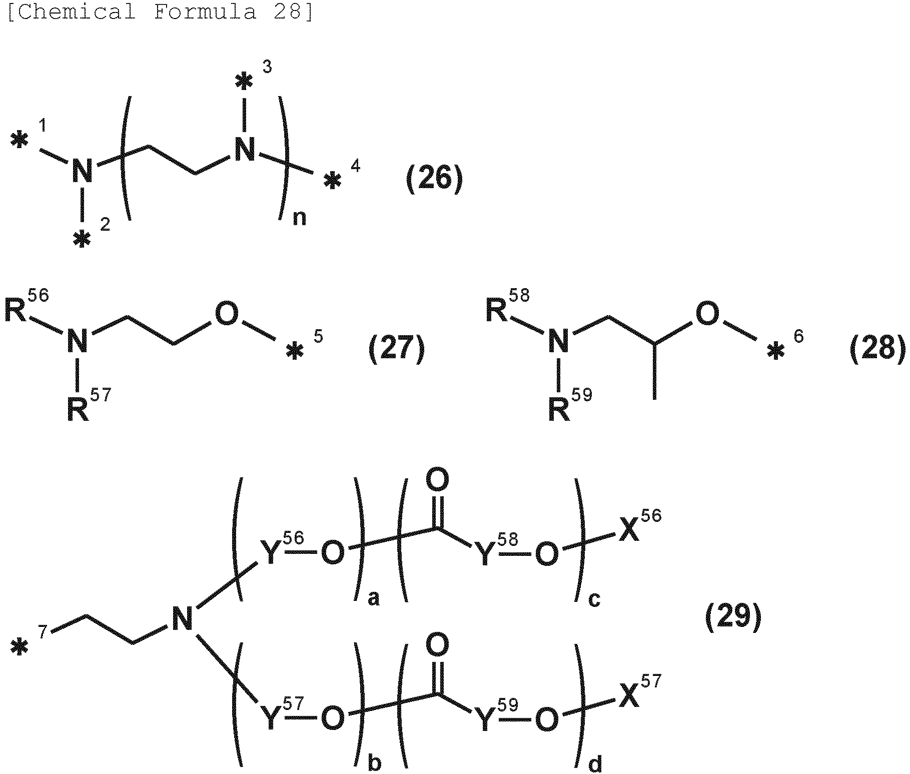

In general formulae (26) to (28), R⁵⁶ to R⁵⁹ each independently represent an alkyl group having 1 to 6 carbon atoms. n represents an integer of 1 to 9. *¹ to *⁶ each independently represent a bonding point to a polyoxyalkylene structure. In general formula (29), X⁵⁶ and X⁵⁷ each independently represent a hydrogen atom or an alkyl group having 1 to 6 carbon atoms. Y⁵⁶ to Y⁵⁹ each independently represent an alkylene group having 1 to 6 carbon atoms, a and b each independently represent an integer of 1 to 100. c and d each independently represent an integer of 0 to 100. *7 represents a bonding point with a carbon atom or a nitrogen atom. a and b are each independently preferably an integer of 5 to 60, and more preferably an integer of 10 to 40. c and d are each independently preferably an integer of 0 to 20, and more preferably an integer of 0 to 10.

The amine value of the dispersant (E) (including the compound (E1)) is preferably 5 mgKOH/g or more, and more preferably 10 mgKOH/g or more from the viewpoint of suppressing residues after development. On the other hand, the amine value is preferably 100 mgKOH/g or less, and more preferably 70 mgKOH/g or less, from the viewpoint of suppressing residues after development. The amine value mentioned herein refers to a mass of potassium hydroxide equivalent to that of an acid that reacts with 1 g of the dispersant (E) or 1 g of the compound (E1), and the unit of the amine value is mgKOH/g.

The acid value of the dispersant (E) and the compound (E1) is preferably 10 mgKOH/g or more, and more preferably 20 mgKOH/g or more, from the viewpoint of suppressing residues after development. On the other hand, the acid value is preferably 100 mgKOH/g or less, and more preferably 70 mgKOH/g or less from the viewpoint of suppressing residues after development. The acid value mentioned herein refers to a mass of potassium hydroxide that reacts with 1 g of the dispersant (E), and 1 g of the compound (E1), and the unit of the acid value is mgKOH/g.

When the photosensitive composition of the present invention contains the pigment (D1), the total content of the dispersant (E) and the compound (E1) in the photosensitive composition of the present invention is preferably 5 parts by mass or more, and more preferably 15 parts by mass or more from the viewpoint of suppressing residues after development when the pigment (D1) is regarded as 100 parts by mass. On the other hand, the total content of the dispersant (E) and the compound (E1) is preferably 50 parts by mass or less, and more preferably 40 parts by mass or less from the viewpoint of suppressing residues after development.

### <Compound (F); Compound (F0) and Compound (FB)>

The photosensitive composition of the present invention preferably further contains a compound (F0) and/or a compound (FB) below.

Compound (F0): A compound having an acidic group containing a phosphorus atom and/or a salt of an acidic group containing a phosphorus atom (hereinafter, referred to as "compound (F0)").

Compound (FB): A compound having a betaine structure containing a phosphorus atom (hereinafter, referred to as "compound (FB)").

Hereinafter, the compound (F0), the compound (FB), a compound (FC1) to be described later, and a compound (FT) to be described later may be collectively referred to as "compound (F)".

The compound (F) preferably has a (meth)acryloyl group, a vinyl group, or an allyl group from the viewpoint of improving the sensitivity at the time of exposure and improving the reliability of the light-emitting element in the display device. When the alkali-soluble resin (A) described above has a (meth)acryloyl group, a vinyl group, or an allyl group, the compound (F) more preferably does not have a (meth)acryloyl group, a vinyl group, or an allyl group.

In the photosensitive composition of the present invention, the compound (F0) preferably has the following structure (I-f0).

Structure (I-f0): One or more groups selected from the group consisting of a mono- or divalent aliphatic group having 4 to 30 carbon atoms, an alkylaryl group having 10 to 30 carbon atoms, and an oxyalkylene group to which an aryl group having 6 to 15 carbon atoms is bonded.

In the photosensitive composition of the present invention, the compound (FB) preferably has the following structure (I-fb).

Structure (I-fb): A mono- or divalent aliphatic group having an ammonium cation structure and 1 to 6 carbon atoms.

By containing the compound (F0) and/or the compound (FB), the effects of suppressing residues after development, and improving the halftone characteristics become remarkable. In addition, the effect of improving the reliability of the light-emitting element in the display device becomes remarkable. The compound (F0) and/or the compound (FB) preferably contain two or more kinds of compounds, and more preferably contain two or more kinds of compounds (F0) and two or more kinds of compounds (FB). It is particularly preferable to contain the compound (F0) and the compound (FB).

### <Compound (F); Compound (F1) and Compound (FB1)>

It is preferable that the photosensitive composition of the present invention contains the compound (F0) and/or the compound (FB), the compound (F0) contains the following compound (F1), and the compound (FB) contains the following compound (FB1).

Compound (F1): One or more (hereinafter, referred to as "compound (F1)") selected from the group consisting of a phosphoric acid compound, a phosphonic acid compound, a phosphinic acid compound, and salts thereof.

Compound (FB1): One or more selected from the group consisting of a betaine phosphate compound, a betaine phosphonate compound, and a betaine phosphinate compound (hereinafter, referred to as "compound (FB1)").

In the photosensitive composition of the present invention, the compound (F1) preferably has the following structure (I-f1) and/or structure (II-f1).

Structure (I-f1): One or more groups selected from the group consisting of a monovalent aliphatic group having 4 to 30 carbon atoms, a divalent aliphatic group having 6 to 30 carbon atoms, and an alkylaryl group having 10 to 30 carbon atoms.

Structure (II-f1): One or more groups selected from the group consisting of an oxyalkylene group to which a monovalent aliphatic group having 4 to 30 carbon atoms is bonded, an oxyalkylene group to which an alkylaryl group having 10 to 30 carbon atoms is bonded, and an oxyalkylene group having 4 to 15 carbon atoms to which an aryl group having 6 to 15 carbon atoms is bonded.

In the photosensitive composition of the present invention, the compound (FB1) preferably has the following structure (I-fb1).

Structure (I-fb1): A mono- or divalent aliphatic group having an ammonium cation structure and 1 to 6 carbon atoms.

By containing the compound (F1) and/or the compound (FB1), the effects of suppressing residues after development, and improving the halftone characteristics become remarkable. In addition, the effect of improving the reliability of the light-emitting element in the display device becomes remarkable. The compound (F1) and/or the compound (FB1) preferably contain two or more kinds of compounds, and more preferably contain two or more kinds of compounds (F1) and two or more kinds of compounds (FB1). It is particularly preferable to contain the compound (F1) and the compound (FB1).

It is preferable that the compound (F1) has a substituent bonded to a phosphorus atom and/or a substituent bonded to an oxygen atom on a P-O bond, and the substituent has a structure (I-f1) and/or a structure (II-f1) .

The structure (I-f1) is preferably the following structure (I-f1x).

Structure (I-f1x): One or more groups selected from the group consisting of a monovalent aliphatic group having 6 to 12 carbon atoms, a divalent aliphatic group having 6 to 12 carbon atoms, and an alkylaryl group having 14 to 26 carbon atoms.

The monovalent aliphatic group is preferably an alkyl group, an alkenyl group, or an alkynyl group. The divalent aliphatic group is preferably an alkylene group, an alkenylene group, or an alkynylene group. The structure (I-f1) is also preferably a linear structure and/or a branched structure.

The structure (II-f1) is preferably the following structure (II-f1x).

Structure (II-f1x): One or more groups selected from the group consisting of an oxyalkylene group to which a monovalent aliphatic group having 6 to 12 carbon atoms is bonded, an oxyalkylene group to which an alkylaryl group having 14 to 26 carbon atoms is bonded, and an oxyalkylene group having 6 to 12 carbon atoms to which an aryl group having 6 to 10 carbon atoms is bonded.

The monovalent aliphatic group is preferably an alkyl group, an alkenyl group, or an alkynyl group. The structure (II-f1) is also preferably a linear structure and/or a branched structure.

Examples of the salt of an acidic group containing a phosphorus atom in the compound (F0) include salts of an acidic group containing a phosphorus atom and a compound having a cationic structure. Similarly, examples of the salt of the phosphoric acid compound, the salt of the phosphonic acid compound, or the salt of the phosphinic acid compound in the compound (F1) include salts of a phosphoric acid compound, a phosphonic acid compound, a phosphinic acid compound, and a compound having a cationic structure. Examples of the compound having a cationic structure include compounds having one or more selected from the group consisting of a cation of a metal atom, an ammonium cation, a phosphonium cation, and a sulfonium cation, and a compound having an ammonium cation is preferable. The ammonium cation is preferably a primary ammonium cation, a secondary ammonium cation, a tertiary ammonium cation, or a quaternary ammonium cation, and more preferably a quaternary ammonium cation. The ammonium cation preferably has at least one aliphatic group having 1 to 30 carbon atoms, more preferably has an aliphatic group having 1 to 15 carbon atoms, further preferably has an aliphatic group having 1 to 10 carbon atoms, and particularly preferably has an aliphatic group having 1 to 6 carbon atoms. As the aliphatic group, a mono- or divalent aliphatic group having a linear structure and/or a branched structure is preferable, a group selected from the group consisting of an alkyl group, an alkenyl group, and an alkynyl group having a linear structure is preferable, and an alkyl group having a linear structure is more preferable.

The compound (F1) preferably contains one or more selected from the group consisting of compounds represented by any of the general formulae (11), (12), and (13) and salts thereof. It is also preferable to contain two or more compounds selected from the group consisting of compounds represented by any of the general formulae (11), (12), and (13) and salts thereof. From the viewpoint of suppressing residues after development and improving the halftone characteristics, and from the viewpoint of improving the reliability of the light-emitting element in the display device, the compound (F1) particularly preferably contains at least a compound represented by general formula (12) and/or a salt thereof.

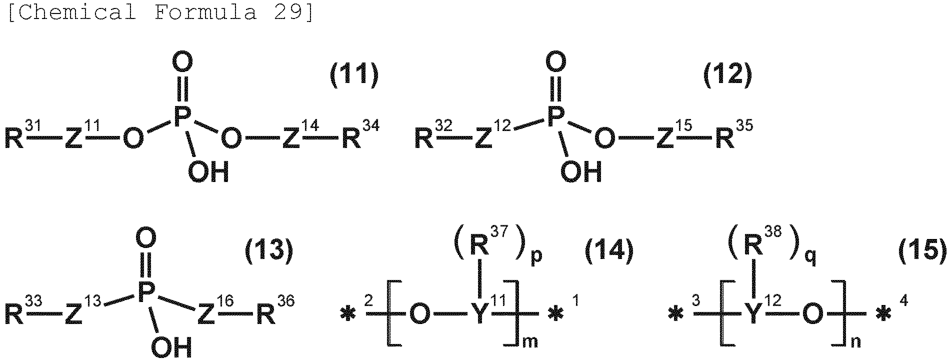

In the general formulae (11) to (13), Z¹¹ to Z¹³ each independently represent a direct bond, a divalent aliphatic group having 6 to 30 carbon atoms, or a group represented by the general formula (14). Z¹⁴ to Z¹⁶ each independently represent a direct bond, a divalent aliphatic group having 6 to 30 carbon atoms, or a group represented by the general formula (15). When Z¹¹ in the general formula (11) is a direct bond, the corresponding R³¹ represents a monovalent aliphatic group having 4 to 30 carbon atoms or an alkylaryl group having 10 to 30 carbon atoms. Z¹² and the corresponding R³² and Z¹³ and the corresponding R³³ in general formula (12) and general formula (13) are also similar to the relationship between Z¹¹ and the corresponding R³¹ in general formula (11). When Z¹⁴ in the general formula (11) is a direct bond, the corresponding R³⁴ represents a hydrogen atom, a monovalent aliphatic group having 4 to 30 carbon atoms, an alkylaryl group having 10 to 30 carbon atoms, a photoreactive group, an alkenyl group having 2 to 5 carbon atoms, an alkynyl group having 2 to 5 carbon atoms, or a thermally reactive group. Z¹⁵ and the corresponding R³⁵ and Z¹⁶ and the corresponding R³⁶ in general formula (12) and general formula (13) are also similar to the relationship between Z¹⁴ and the corresponding R³⁴ in general formula (11). When at least one of Z¹¹ and Z¹⁴ in the general formula (11) is a divalent aliphatic group having 6 to 30 carbon atoms, the corresponding R³¹ and/or R³⁴ each independently represent a hydrogen atom, a hydroxy group, or a monovalent organic group having 1 to 15 carbon atoms. Z¹² and Z¹⁵ and the corresponding R³² and R³⁵, and Z¹³ and Z¹⁶ and the corresponding R³³ and R³⁶ in general formula (12) and general formula (13) are also similar to the relationship between Z¹¹ and Z¹⁴ and the corresponding R³¹ and R³⁴ in general formula (11). When Z¹¹ in the general formula (11) is a group represented by the general formula (14), the corresponding R³¹ represents a monovalent aliphatic group having 4 to 30 carbon atoms, an alkylaryl group having 10 to 30 carbon atoms, or an aryl group having 6 to 15 carbon atoms. Z¹² and the corresponding R³² and Z¹³ and the corresponding R³³ in general formula (12) and general formula (13) are also similar to the relationship between Z¹¹ and the corresponding R³¹ in general formula (11). When Z¹⁴ in the general formula (11) is a group represented by general formula (15), the corresponding R³⁴ represents a hydrogen atom, a monovalent aliphatic group having 4 to 30 carbon atoms, an alkylaryl group having 10 to 30 carbon atoms, an aryl group having 6 to 15 carbon atoms, a photoreactive group, an alkenyl group having 2 to 5 carbon atoms, an alkynyl group having 2 to 5 carbon atoms, or a thermally reactive group. Z¹⁵ and the corresponding R³⁵ and Z¹⁶ and the corresponding R³⁶ in general formula (12) and general formula (13) are also similar to the relationship between Z¹⁴ and the corresponding R³⁴ in general formula (11). The photoreactive group, the alkenyl group having 2 to 5 carbon atoms, and the alkynyl group having 2 to 5 carbon atoms are preferably radical polymerizable groups. The thermally reactive group is preferably an alkoxymethyl group, a methylol group, an epoxy group, an oxetanyl group, or a blocked isocyanate group.

In general formulae (14) and (15), Y¹¹ and Y¹² each independently represent an alkylene group having 1 to 15 carbon atoms. R³⁷ to R³⁸ each independently represent an alkyl group having 1 to 6 carbon atoms. m and n each independently represent an integer of 1 to 15. p and q each independently represent an integer of 0 to 4. *¹ represents a bonding point to an oxygen atom in the general formula (11), a bonding point to a phosphorus atom in the general formula (12), or a bonding point to a phosphorus atom in the general formula (13). *² represents a bonding point with R³¹ in the general formula (11), a bonding point with R³² in the general formula (12), or a bonding point with R³³ in the general formula (13). *³ represents a bonding point to an oxygen atom in the general formula (11), a bonding point to an oxygen atom in the general formula (12), or a bonding point to a phosphorus atom in the general formula (13). *⁴ represents a bonding point with R³⁴ in the general formula (11), a bonding point with R³⁵ in the general formula (12), or a bonding point with R³⁶ in the general formula (13).

It is preferable that the photosensitive composition of the present invention contains propylene glycol monoalkyl ether acetate as a solvent having an acetate bond to be described later, and in the compound (F1), in the general formulae (11) to (13) described above, when Z¹¹ to Z¹³ are a direct bond or a group represented by the general formula (14), monovalent aliphatic groups having 4 to 30 carbon atoms in R³¹ to R³³ are each independently a monovalent aliphatic group having 6 to 12 carbon atoms, and in the general formulae (11) to (13) described above, when Z¹⁴ to Z¹⁶ are a direct bond, R³⁴ to R³⁶ are a hydrogen atom.

Such a compound (F1) is hereinafter referred to as a "specific compound (F1)". When the compound (F1) has a monovalent aliphatic group having 6 to 12 carbon atoms as the above-described structure (I-f1) and/or an oxyalkylene group to which a monovalent aliphatic group having 6 to 12 carbon atoms is bonded as the above-described structure (II-f1), such a compound is similarly referred to as a "specific compound (F1)" hereinafter.

When the compound (F1) contains a specific compound (F1), the solubility of the compound (F1) in propylene glycol monoalkyl ether acetate can be remarkably improved. Accordingly, the effect of suppressing residues after development and improving the halftone characteristics becomes remarkable. In addition, the effect of improving the reliability of the light-emitting element in the display device becomes remarkable. Propylene glycol monoalkyl ether acetate is preferably propylene glycol monomethyl ether acetate or propylene glycol monoethyl ether acetate, and more preferably propylene glycol monomethyl ether acetate.

The compound (F1) also preferably has the following structure (III-f1) from the viewpoint of improving the halftone characteristics.

Structure (III-f1): One or more selected from the group consisting of a photoreactive group, an alkenyl group having 2 to 5 carbon atoms, and an alkynyl group having 2 to 5 carbon atoms.

The compound (F1) has a substituent bonded to a phosphorus atom and/or two or more kinds of substituents bonded to an oxygen atom on a P-O bond, and the substituent is preferably a structure (I-f1) and/or a structure (II-f1) and a structure (III-f1).

In the structure (III-f1), the photoreactive group is preferably a radical polymerizable group, more preferably a styryl group, a cinnamoyl group, a maleimide group, or a (meth)acryloyl group, and still more preferably a (meth)acryloyl group. On the other hand, the alkenyl group having 2 to 5 carbon atoms or the alkynyl group having 2 to 5 carbon atoms is preferably a radical polymerizable group, a vinyl group, an allyl group, a 2-methyl-2-propenyl group, a crotonyl group, a 2-methyl-2-butenyl group, a 3-methyl-2-butenyl group, a 2,3-dimethyl-2-butenyl group, or an ethynyl group, more preferably a 2-propargyl group, and still more preferably a vinyl group or an allyl group.

It is also preferable that the photosensitive composition of the present invention contains the compound (F1) and/or the compound (FB1) described above, and contains one or more selected from the group consisting of a phosphoric acid compound, a phosphonic acid compound, and a phosphinic acid compound, having one or more selected from the group consisting of a photoreactive group, an alkenyl group having 2 to 5 carbon atoms, and an alkynyl group having 2 to 5 carbon atoms, which are different from the compound (F1).

It is preferable that the compound (FB1) has a substituent bonded to a phosphorus atom and/or a substituent bonded to an oxygen atom on a P-O bond, and the substituent is a structure (I-fb1).

In the structure (I-fb1), the mono- or divalent aliphatic group having 1 to 6 carbon atoms is preferably a divalent aliphatic group having 1 to 4 carbon atoms. The monovalent aliphatic group is preferably an alkyl group, an alkenyl group, or an alkynyl group. The divalent aliphatic group is preferably an alkylene group, an alkenylene group, or an alkynylene group. The mono- or divalent aliphatic group having 1 to 6 carbon atoms also preferably has a linear structure and/or a branched structure. The mono- or divalent aliphatic group having 1 to 6 carbon atoms may have, as a substituent, an alkyl group having 1 to 6 carbon atoms, an alkoxy group having 1 to 6 carbon atoms, a carboxy group, or a hydroxy group.

In the structure (I-fb1), the ammonium cation structure is preferably an ammonium cation, a monoalkylammonium cation, a dialkylammonium cation, or a trialkyl quaternary ammonium cation, and more preferably a trialkyl quaternary ammonium cation.

The structure (I-fb1) is more preferably a structure derived from a nitrogen-containing aliphatic alcohol compound having 1 to 6 carbon atoms and having at least one hydroxy group and at least one ammonium group or amino group. Such a compound is preferably ethanolamine, propanolamine, butanolamine, pentanolamine, serine, threonine, thiocin, or choline, and more preferably ethanolamine, serine, or choline.

When the photosensitive composition of the present invention contains at least propylene glycol monoalkyl ether acetate as a solvent having an acetate bond to be described later, and further contains diethylene glycol dialkyl ether as a solvent having at least three ether bonds to be described later, and/or one or more selected from the group consisting of propylene glycol monoalkyl ether, alkyl lactate, alkyl hydroxyacetate, and hydroxyalkyl acetate as a solvent having an alcoholic hydroxyl group to be described later (hereinafter, referred to as "the case of containing a specific solvent"), the compound (FB1) preferably has a trialkyl quaternary ammonium cation structure in the structure (I-fb1) described above.

The trialkyl quaternary ammonium cation structure preferably has three alkyl groups having 1 to 6 carbon atoms, and more preferably has three alkyl groups having 1 to 4 carbon atoms. Such a compound (FB1) is hereinafter referred to as a "specific compound (FB1)".

In a case of containing a specific solvent, when the compound (FB1) contains a specific compound (FB1), the solubility of the compound (FB1) in the solvent can be specifically remarkably improved. Accordingly, the effect of suppressing residues after development and improving the halftone characteristics becomes remarkable. In addition, the effect of improving the reliability of the light-emitting element in the display device becomes remarkable.

Propylene glycol monoalkyl ether acetate is preferably propylene glycol monomethyl ether acetate or propylene glycol monoethyl ether acetate, and more preferably propylene glycol monomethyl ether acetate.

The diethylene glycol dialkyl ether is preferably diethylene glycol dimethyl ether, diethylene glycol diethyl ether, and diethylene glycol ethyl methyl ether, more preferably diethylene glycol ethyl methyl ether.

Further, propylene glycol monoalkyl ether, alkyl lactate, alkyl hydroxyacetate, or hydroxyalkyl acetate is preferably propylene glycol monomethyl ether, propylene glycol monoethyl ether, methyl lactate, ethyl lactate, methyl hydroxyacetate, ethyl hydroxyacetate, 2-hydroxymethyl acetate, or 2-hydroxyethyl acetate, and more preferably propylene glycol monomethyl ether, ethyl lactate, ethyl hydroxyacetate, or 2-hydroxyethyl acetate.

The compound (FB1) preferably further has the following structure (II-fb1) from the viewpoint of suppressing residues after development and improving the halftone characteristics, and from the viewpoint of improving the reliability of the light-emitting element in the display device.

Structure (II-fb1): A fatty acid ester structure derived from a fatty acid compound having 6 to 30 carbon atoms and/or an aliphatic ether structure derived from an aliphatic alcohol having 6 to 30 carbon atoms.

It is preferable that the compound (FB1) has a substituent bonded to a phosphorus atom and/or two or more kinds of substituents bonded to an oxygen atom on a P-O bond, and the substituent has a structure (I-fb1) and a structure (II-fb1).

The structure (II-fb1) preferably has a mono- or divalent aliphatic group having 6 to 30 carbon atoms, and more preferably has a mono- or divalent aliphatic group having 10 to 20 carbon atoms. The monovalent aliphatic group is preferably an alkyl group, an alkenyl group, or an alkynyl group. The divalent aliphatic group is preferably an alkylene group, an alkenylene group, or an alkynylene group. The mono- or divalent aliphatic group having 6 to 30 carbon atoms also preferably has a linear structure and/or a branched structure. When the compound (FB1) has the structure (II-fb1) in the case of containing the specific solvent described above, the solubility of the compound (FB1) in the solvent can be more specifically improved.

The compound (FB1) preferably has a structure (I-fb1) and further contains a compound (hereinafter, referred to as "a betaine-type phospholipid compound (FB1)") having the following structure (IV-fb1) or structure (V-fb1) from the viewpoint of suppressing residues after development and improving the halftone characteristics, and from the viewpoint of improving the reliability of the light-emitting element in the display device.

Structure (IV-fb1): An ester structure derived from an aliphatic polyfunctional alcohol compound having 2 to 6 carbon atoms and having at least 3 hydroxy groups.

Structure (V-fb1): An ester structure derived from a nitrogen-containing aliphatic alcohol compound having 15 to 20 carbon atoms and having at least two hydroxy groups and at least one amino group or at least one alkylamide group.

When the compound (FB1) contains the compound (FB1) of betaine-type phospholipid in the case of containing the specific solvent described above, the solubility of the compound (FB1) in the solvent can be more specifically improved.

It is particularly preferable that the compound (FB1) contains glycerophospholipid and/or sphingophospholipid as the compound (FB1) of betaine-type phospholipid. The compound (FB1) of the betaine-type phospholipid particularly preferably contains one or more selected from the group consisting of phosphatidylcholine, phosphatidylethanolamine, phosphatidylserine, sphingomyelin, hydrogenated phosphatidylcholine, hydrogenated phosphatidylethanolamine, hydrogenated phosphatidylserine, hydrogenated sphingomyelin, lysophosphatidylcholine, lysophosphatidylethanolamine, lysophosphatidylserine, lysosphingomyelin, lecithin, hydrogenated lecithin, lysolecithin, cephalin, hydrogenated cephalin, lysocepin, plasmalogen, a platelet activator, and ceramide (trimethylammonio) ethylphosphonate.

The compound (FB1) also preferably has the following structure (III-fb1) from the viewpoint of improving the halftone characteristics.

Structure (III-fb1): One or more selected from the group consisting of a photoreactive group, an alkenyl group having 2 to 5 carbon atoms, and an alkynyl group having 2 to 5 carbon atoms.

It is preferable that the compound (FB1) has a substituent bonded to a phosphorus atom and/or two or more kinds of substituents bonded to an oxygen atom on a P-O bond, and the substituent has a structure (I-fb1) and a structure (III-fb1).

In addition, it is also preferable that the compound (FB1) contains two or more kinds of compounds (FB1), contains a compound having one or more kinds selected from the group consisting of the structure (II-fb1) described above, the (IV-fb1) structure described above, and the structure (V-fb1) described above, and further contains a compound having a structure (III-fb1).

In the structure (III-fb1), the photoreactive group is preferably a radical polymerizable group, more preferably a styryl group, a cinnamoyl group, a maleimide group, or a (meth)acryloyl group, and still more preferably a (meth)acryloyl group. On the other hand, the alkenyl group having 2 to 5 carbon atoms or the alkynyl group having 2 to 5 carbon atoms is preferably a radical polymerizable group, a vinyl group, an allyl group, a 2-methyl-2-propenyl group, a crotonyl group, a 2-methyl-2-butenyl group, a 3-methyl-2-butenyl group, a 2,3-dimethyl-2-butenyl group, or an ethynyl group, more preferably a 2-propargyl group, and still more preferably a vinyl group or an allyl group.

The total content ratio of the compound (F1) and the compound (FB1) in the total solid content of the photosensitive composition of the present invention excluding the solvent is preferably 0.02% by mass or more, more preferably 0.05% by mass or more, still more preferably 0.15% by mass or more, and particularly preferably 0.25% by mass or more, from the viewpoint of suppressing residues after development and improving the reliability of the light-emitting element in the display device. On the other hand, the total content ratio of the compound (F1) and the compound (FB1) is preferably 1.8% by mass or less, more preferably 1.5% by mass or less, still more preferably 1.3% by mass or less, and particularly preferably 1.0% by mass or less, from the viewpoint of suppressing residues after development and improving the reliability of the light-emitting element in the display device. In addition, when the photosensitive composition of the present invention contains the alkali-soluble resin (A) and the compound (B), the total content of the compound (F1) and the compound (FB1) in the photosensitive composition of the present invention is, in a case where the total of the alkali-soluble resin (A) and the compound (B) is 100 parts by mass, preferably 0.05 parts by mass or more, more preferably 0.10 parts by mass or more, still more preferably 0.30 parts by mass or more, and particularly preferably 0.50 parts by mass or more. On the other hand, the total content of the compound (F1) and the compound (FB1) is preferably 3.0 parts by mass or less, more preferably 2.5 parts by mass or less, still more preferably 2.0 parts by mass or less, and particularly preferably 1.5 parts by mass or less.

### <Compound (F); Compound (FC1)>

The photosensitive composition of the present invention preferably further contains a non-betaine-type phospholipid (FC1) (hereinafter, referred to as "compound (FC1)"). By containing the compound (FC1), the effects of suppressing residues after development, and improving the halftone characteristics become remarkable. In addition, the effect of improving the reliability of the light-emitting element in the display device becomes remarkable. The compound (FC1) preferably contain two or more kinds of compounds, more preferably contain the compound (F1) and the compound (FB1), and still more preferably contain the compound (FC1).

The compound (FC1) has at least the following structure (I-fc1) and structure (II-fc1).

Structure (I-fc1): One or more selected from the group consisting of an acidic group containing a phosphorus atom, an anionic structure containing a phosphorus atom, and a salt of an acidic group containing a phosphorus atom.

Structure (II-fc1): A fatty acid ester structure derived from a fatty acid compound having 6 to 30 carbon atoms and/or an aliphatic ether structure derived from an aliphatic alcohol having 6 to 30 carbon atoms.

When the structure (I-fc1) is an acidic group containing a phosphorus atom and/or an anionic structure containing a phosphorus atom, the compound (FC1) preferably does not have an ammonium cation structure. The above-described anion structure containing a phosphorus atom is preferably an anion structure derived from an acidic group containing a phosphorus atom. It is preferable that the compound (FC1) has a substituent bonded to a phosphorus atom and/or two or more kinds of substituents bonded to an oxygen atom on a P-O bond, and the substituent has a structure (I-fc1) and a structure (II-fc1).

The structure (I-fc1) is preferably a phosphate group, a phosphonate group, or a phosphinate group, and/or a phosphate anion, a phosphonate anion, or a phosphinate anion.

The structure (II-fc1) preferably has a mono- or divalent aliphatic group having 6 to 30 carbon atoms, and more preferably has a mono- or divalent aliphatic group having 10 to 20 carbon atoms. The monovalent aliphatic group is preferably an alkyl group, an alkenyl group, or an alkynyl group. The divalent aliphatic group is preferably an alkylene group, an alkenylene group, or an alkynylene group. The mono- or divalent aliphatic group having 6 to 30 carbon atoms also preferably has a linear structure and/or a branched structure.

It is particularly preferable that the compound (FC1) contains one or more selected from the group consisting of phosphatidic acid, phosphatidylglycerol, lysophosphatidic acid, lysophosphatidylglycerol, phosphatidylinositol, lysophosphatidylinositol, diphosphatidylglycerol, cardiolipin, sphingosine-1-phosphate, and phosphatidylcytidine monophosphate.

In the photosensitive composition of the present invention, the total content ratio of the compound (F1), the compound (FB1), and the compound (FC1) is as the preferable content ratio of the compound (F1) and the compound (FB1) described above. When the photosensitive composition of the present invention contains the alkali-soluble resin (A) and the compound (B), the total content of the compound (F1), the compound (FB1), and the compound (FC1) is as the preferable content of the compound (F1) and the compound (FB1) described above.

### <Compound (F); Compound (FT)>

The photosensitive composition of the present invention preferably further contains an ester compound (hereinafter, referred to as "compound (FT)") having a reactive group (FT) and having an acidic group containing a phosphorus atom. By containing the compound (FT), effects of improving the halftone characteristics and suppressing pattern peeling after development are remarkable. The compound (FT) preferably contain two or more kinds of compounds, more preferably contain the compound (F1) and the compound (FB1), and still more preferably contain the compound (FT).

The compound (FT) preferably has a radical polymerizable group, and more preferably has one or more selected from the group consisting of a photoreactive group, an alkenyl group having 2 to 5 carbon atoms, and an alkynyl group having 2 to 5 carbon atoms. When the number of one or more selected from the group consisting of a photoreactive group, an alkenyl group having 2 to 5 carbon atoms, and an alkynyl group having 2 to 5 carbon atoms of the compound (FT) is denoted by (X), and the number of one or more selected from the group consisting of a mono- or divalent aliphatic group, a mono- or divalent alicyclic group, a mono- or divalent aromatic group, and an oxyalkylene group to which a substituent is bonded of the compound (FT) is denoted by (Y), it is preferable that (X) and (Y) satisfy the formulae (FT-α) to (FT-γ). $X + Y = 3 \left(FT-α\right)$ $1 \leq X \leq 3 \left(FT-β\right)$ $0 \leq Y \leq 2 \left(FT-γ\right) .$

In the formulae (FT-α) to (FT-γ), X is preferably an integer of 1 to 3, more preferably 2 or 3, and still more preferably 3. Y is preferably an integer of 0 to 2, and more preferably 0 or 1.

The compound (FT) has a substituent bonded to a phosphorus atom and/or a substituent bonded to an oxygen atom on a P-O bond, and the substituent preferably has a radical polymerizable group, and more preferably has one or more selected from the group consisting of a photoreactive group, an alkenyl group having 2 to 5 carbon atoms, and an alkynyl group having 2 to 5 carbon atoms.

It is also preferable that the substituent has one or more selected from the group consisting of a mono- or divalent aliphatic group, a mono- or divalent alicyclic group, a mono- or divalent aromatic group, and an oxyalkylene group to which a substituent is bonded.

The photosensitive composition of the present invention preferably further contains one or more selected from the group consisting of the following compound (FT1), a compound having the structure (III-fb1) described above as the compound (F1), and a compound having the structure (III-fb1) described above as the compound (FB1).

Compound (FT1): An ester compound of an acidic group containing a phosphorus atom, having at least three of one or more selected from the group consisting of a photoreactive group, an alkenyl group having 2 to 5 carbon atoms, and an alkynyl group having 2 to 5 carbon atoms.

In the compound (FT), the photoreactive group is preferably a radical polymerizable group, more preferably a styryl group, a cinnamoyl group, a maleimide group, or a (meth)acryloyl group, and still more preferably a (meth)acryloyl group. On the other hand, the alkenyl group having 2 to 5 carbon atoms or the alkynyl group having 2 to 5 carbon atoms is preferably a radical polymerizable group, a vinyl group, an allyl group, a 2-methyl-2-propenyl group, a crotonyl group, a 2-methyl-2-butenyl group, a 3-methyl-2-butenyl group, a 2,3-dimethyl-2-butenyl group, or an ethynyl group, more preferably a 2-propargyl group, and still more preferably a vinyl group or an allyl group.

The compound (FT) preferably contains one or more selected from the group consisting of a phosphoric acid triester compound, a phosphorous acid triester compound, a phosphonic acid diester compound, a hypophosphorous acid diester compound, and a phosphinic acid monoester compound having one or more selected from the group consisting of the photoreactive group, the alkenyl group having 2 to 5 carbon atoms, and the alkynyl group having 2 to 5 carbon atoms described above.

In the photosensitive composition of the present invention, the total content ratio of the compound (F1), the compound (FB1), and the compound (FT) is as the preferable content ratio of the compound (F1) and the compound (FB1) described above. When the photosensitive composition of the present invention contains the alkali-soluble resin (A) and the compound (B), the total content of the compound (F1), the compound (FB1), and the compound (FT) is as the preferable content of the compound (F1) and the compound (FB1) described above.

### <Cross-linking agent (G)>

It is preferable that the photosensitive composition of the present invention further contain a cross-linking agent (G). The cross-linking agent (G) refers to a compound having a cross-linking group capable of bonding to a resin or the like or a compound having a cationically polymerizable group. In general, a cross-linking reaction with a resin or the like by a cross-linking group and cationic polymerization by a cationically polymerizable group can be promoted by acid and/or heat, and are suitable for improving the heat resistance of a cured film and improving the chemical resistance of a cured film. The cross-linking agent (G) is preferably a compound having at least two groups of one or more selected from the group consisting of an alkoxyalkyl group, a hydroxyalkyl group, an epoxy group, an oxetanyl group, a vinyl group, and an allyl group (here, the compound (B) described above is excluded). The alkoxyalkyl group is preferably an alkoxymethyl group, and more preferably a methoxymethyl group. The hydroxyalkyl group is preferably a methylol group.

The cross-linking agent (G) preferably has a phenolic hydroxyl group from the viewpoint of suppressing the narrow mask bias after development and improving the halftone characteristics. The alkali-soluble resin (A) and the cross-linking agent (G) described above more preferably have a phenolic hydroxyl group.

The cross-linking agent (G) preferably has a (meth)acryloyl group, a vinyl group, or an allyl group from the viewpoint of improving the sensitivity at the time of exposure and improving the reliability of the light-emitting element in the display device. The alkali-soluble resin (A) and the cross-linking agent (G) described above more preferably have a (meth)acryloyl group, a vinyl group, or an allyl group, and the alkali-soluble resin (A), the compound (B), and the cross-linking agent (G) more preferably have a (meth)acryloyl group, a vinyl group, or an allyl group. When the compound (B) and/or the cross-linking agent (G) has a (meth)acryloyl group, a vinyl group, or an allyl group, it is also preferable that the alkali-soluble resin (A) does not have a (meth)acryloyl group, a vinyl group, or an allyl group.

### <Cross-linking agent (G); Compound (G1)>

The photosensitive composition of the present invention preferably further contains a hydrophobic skeleton-containing epoxy cross-linking agent (G1) (hereinafter, referred to as "compound (G1)"). The compound (G1) refers to a compound having the following structure (I-g1) and structure (II-g1) and having at least two structures (II-g1).

Structure (I-g1): A structure containing one or more selected from the group consisting of a condensed polycyclic structure, a condensed polycyclic heterocyclic structure, a structure in which an aromatic ring skeleton and an alicyclic skeleton are directly linked, and a structure in which at least two aromatic ring skeletons are directly linked.

Structure (II-g1): An organic group having an epoxy group.

By containing the compound (G1), the effects of improving the halftone characteristics and suppressing variations in the opening pattern dimension after development are remarkable.

From the viewpoint of suppressing the narrow mask bias after development and improving the halftone characteristics, the structure (I-g1) of the compound (G1) is preferably a structure containing one or more selected from the group consisting of a fluorene structure, an indane structure, an indolinone structure, an isoindolinone structure, a xanthene structure, a tricyclo [5.2.1.0^{2,6}] decane structure, and a binaphthyl structure.

The epoxy group equivalent of the compound (G1) is preferably 150 g/mol or more, more preferably 170 g/mol or more, and still more preferably 190 g/mol or more, from the viewpoint of suppressing residues after development. On the other hand, the epoxy group equivalent is preferably 800 g/mol or less, more preferably 600 g/mol or less, and still more preferably 500 g/mol or less, from the viewpoint of suppressing the narrow mask bias after development and improving the halftone characteristics.

The content ratio of the compound (G1) to the total solid content of the photosensitive composition of the present invention, excluding the solvent, is preferably 0.3% by mass or more, more preferably 1.0% by mass or more, and still more preferably 2.0% by mass or more, from the viewpoint of suppressing the narrow mask bias after development and improving the halftone characteristics. On the other hand, the content ratio of the compound (G1) is preferably 25% by mass or less, more preferably 20% by mass or less, and still more preferably 15% by mass or less, from the viewpoint of suppressing residues after development. In addition, when the photosensitive composition of the present invention contains the alkali-soluble resin (A) and the compound (B), the content of the compound (G1) in the photosensitive composition of the present invention is, in a case where the total of the alkali-soluble resin (A) and the compound (B) is 100 parts by mass, preferably 1 part by mass or more, more preferably 3 parts by mass or more, and still more preferably 5 parts by mass or more. On the other hand, the content of the compound (G1) is preferably 30 parts by mass or less, more preferably 25 parts by mass or less, and still more preferably 20 parts by mass or less.

### <Cross-linking agent (G); Compounds (G2) and (G3)>

The photosensitive composition of the present invention further contains the following compound (G2) and/or compound (G3), and the cross-linking group preferably contains one or more selected from the group consisting of an alkoxyalkyl group, a hydroxyalkyl group, an epoxy group, an oxetanyl group, a vinyl group, and an allyl group. The alkoxyalkyl group is preferably an alkoxymethyl group, and more preferably a methoxymethyl group. The hydroxyalkyl group is preferably a methylol group.

Compound (G2): A compound having at least two phenolic hydroxyl groups and at least two cross-linking groups.

Compound (G3): A compound having a cyclic structure having at least two nitrogen atoms and at least two cross-linking groups.

By containing the compound (G2) and/or the compound (G3), the effects of suppressing residues after development, suppressing the narrow mask bias after development, and improving the halftone characteristics become remarkable. The number of cross-linking groups in the compound (G2) or compound (G3) is preferably 2 or more, more preferably 3 or more, and still more preferably 4 or more. On the other hand, the number of cross-linking groups is preferably 8 or less, more preferably 7 or less, and still more preferably 6 or less.

The compound (G2) preferably has at least two of the following structures (I-g2). In addition, the compound (G2) more preferably has at least two of the following structures (I-g2x).

Structure (I-g2): A structure in which a phenolic hydroxyl group and a cross-linking group are bonded to one aromatic structure.

Structure (I-g2x): A structure in which a phenolic hydroxyl group and at least two cross-linking groups are bonded to one aromatic structure.

The total number of structures (I-g2) and structures (I-g2x) of the compound (G2) is preferably 2 or more, more preferably 3 or more, and still more preferably 4 or more. On the other hand, the total number of structures (I-g2) and structures (I-g2x) is preferably 8 or less, more preferably 7 or less, and still more preferably 6 or less. The compound (G2) preferably has a hydrophobic skeleton such as an aromatic structure. The hydrophobic skeleton preferably has a structure containing one or more selected from the group consisting of a fluorene structure, an indane structure, a condensed polycyclic alicyclic structure, a structure in which at least two aromatic ring skeletons are linked by an aliphatic group, and a structure in which at least two aromatic ring skeletons are directly linked.

Regarding the compound (G2), from the viewpoint of suppressing residues after development, suppressing the narrow mask bias after development, and improving the halftone characteristics, the number of phenolic hydroxyl groups of the compound (G2) is preferably 2 or more, more preferably 3 or more, and still more preferably 4 or more. On the other hand, the number of phenolic hydroxyl groups is preferably 8 or less, more preferably 7 or less, and still more preferably 6 or less.

The compound (G3) preferably has the following structure (I-g3). In addition, the compound (G3) more preferably has the following structure (I-g3x).

Structure (I-g3): A structure in which a cross-linking group is bonded to a cyclic skeleton having at least two nitrogen atoms.

Structure (I-g3x): A structure in which at least two cross-linking groups are bonded to a cyclic skeleton having at least two nitrogen atoms.

The number of cross-linking groups in the structure (I-g3x) of the compound (G3) is preferably 2 or more, more preferably 3 or more, and still more preferably 4 or more. On the other hand, the number of cross-linking groups is preferably 8 or less, more preferably 7 or less, and still more preferably 6 or less.

Regarding the compound (G3), from the viewpoint of suppressing residues after development, suppressing the narrow mask bias after development, and improving the halftone characteristics, the cyclic skeleton of the compound (G3) having at least two nitrogen atoms is preferably one or more selected from the group consisting of an isocyanuric acid structure, a triazine structure, a glycoluril structure, an imidazolidone structure, a pyrazole structure, an imidazole structure, a triazole structure, a tetrazole structure, and a purine structure, more preferably one or more selected from the group consisting of an isocyanuric acid structure, a triazine structure, and a glycoluril structure, and still more preferably an isocyanuric acid structure and/or a triazine structure.

The compound (G2) preferably contains one or more selected from the group consisting of compounds represented by any of the general formulae (181), (182), (183), and (184) .

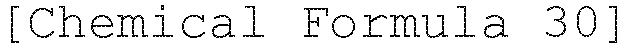

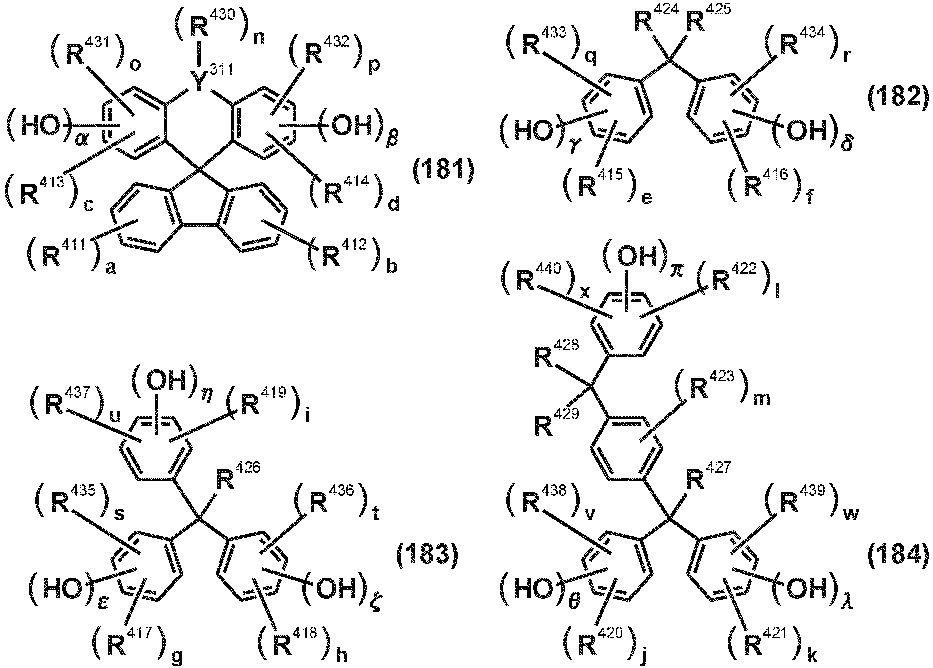

In the general formulae (181) to (184), Y³¹¹ represents a direct bond, a carbon atom, a nitrogen atom, an oxygen atom, or a sulfur atom. R⁴¹¹ to R⁴²³ each independently represent a halogen atom or an alkyl group having 1 to 10 carbon atoms. R⁴²⁴ to R⁴³⁰ each independently represent a hydrogen atom, a halogen atom, an alkyl group having 1 to 10 carbon atoms, a cycloalkyl group having 4 to 10 carbon atoms, or an aryl group having 6 to 15 carbon atoms. R⁴³¹ to R⁴⁴⁰ each independently represent an alkoxyalkyl group having 2 to 10 carbon atoms, a hydroxyalkyl group having 1 to 6 carbon atoms, an alkyl group having 1 to 6 carbon atoms having an epoxy group, an alkoxyalkyl group having 2 to 10 carbon atoms having an epoxy group, an alkyl group having 1 to 8 carbon atoms having an oxetanyl group, an alkoxyalkyl group having 2 to 12 carbon atoms having an oxetanyl group, a vinyl group, or an allyl group. a and b each independently represent an integer of 0 to 4. c and d each independently represent an integer of 0 to 2. a, b, c, d, e, f, g, h, i, j, k, and l each independently represent an integer of 0 to 3. m represents an integer 0 to 4. When Y³¹¹ is a direct bond, an oxygen atom, or a sulfur atom, n is 0. When Y³¹¹ is a nitrogen atom, n is 1. When Y³¹¹ is a carbon atom, n is 2. o, p, α, and β each independently represent an integer of 1 to 3, 2 ≤ o + α ≤ 4 and 2 ≤ p + β ≤ 4 are satisfied. q, r, γ, and δ each independently represent an integer of 1 to 4, 2 ≤ q + γ ≤ 5 and 2 ≤ r + δ ≤ 5 are satisfied. s, t, u, ε, ζ, and η each independently represent an integer of 1 to 4, 2 ≤ s + ε ≤ 5, 2 ≤ t + ζ ≤ 5, and 2 ≤ u + η ≤ 5 are satisfied. v, w, x, θ, λ, and π each independently represent an integer of 1 to 4, 2 ≤ v + θ ≤ 5, 2 ≤ w + λ ≤ 5, and 2 ≤ x + π ≤ 5 are satisfied. Y³¹¹ is preferably a direct bond or an oxygen atom. The alkyl group, cycloalkyl group, aryl group, alkoxyalkyl group, and hydroxyalkyl group described above may have a hetero atom, and may be either unsubstituted or substituted.

The compound (G3) preferably contains one or more selected from the group consisting of compounds represented by any of the general formulae (171), (172), and (173).

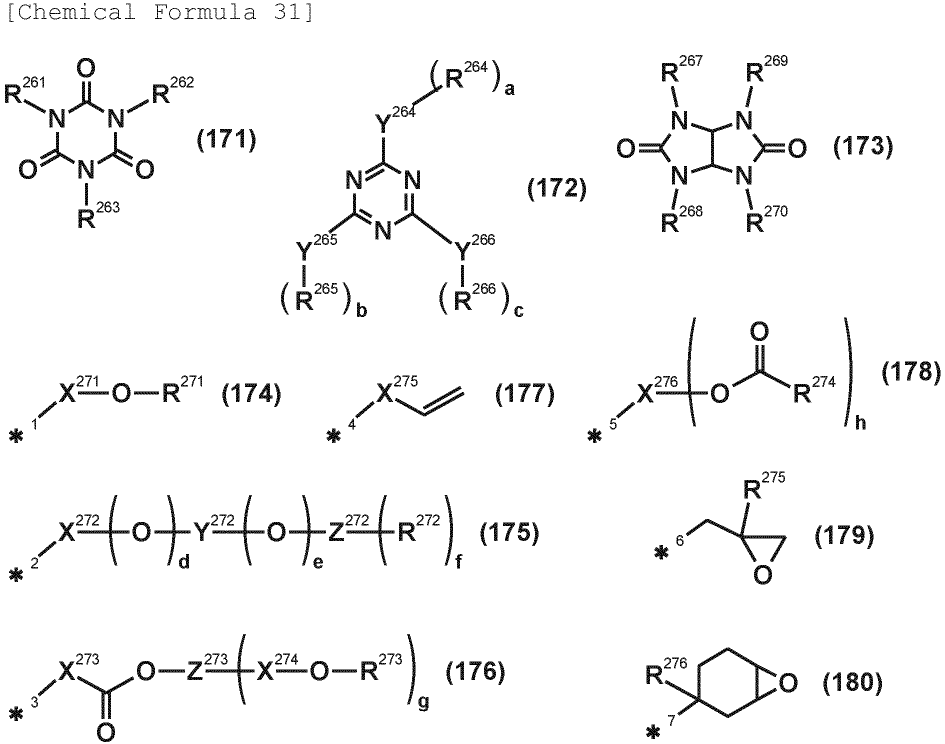

In the general formulae (171) to (173), Y²⁶⁴ to Y²⁶⁶ each independently represent a direct bond, an oxygen atom, or a nitrogen atom. R²⁶¹ to R²⁷⁰ each independently represent a group represented by any of the general formulae (174) to (178), a hydrogen atom, an alkyl group having 1 to 10 carbon atoms, a cycloalkyl group having 4 to 10 carbon atoms, an aryl group having 6 to 15 carbon atoms, or a hydroxy group. In the general formulae (174) to (178), X²⁷¹ represents an alkylene group having 1 to 6 carbon atoms. X²⁷², X²⁷⁴, and X²⁷⁶ each independently represent a direct bond or an alkylene group having 1 to 10 carbon atoms. X²⁷⁵ represents a direct bond, an alkylene group having 1 to 6 carbon atoms, or an arylene group having 6 to 15 carbon atoms. Y²⁷² represents a direct bond or an alkylene group having 1 to 10 carbon atoms. Z²⁷² and Z²⁷³ represents a direct bond, an alkylene group having 1 to 10 carbon atoms, a cycloalkylene group having 4 to 10 carbon atoms, or an arylene group having 6 to 15 carbon atoms. R²⁷¹ represents a hydrogen atom or an alkyl group having 1 to 6 carbon atoms. R²⁷² and R²⁷³ each independently represent a group represented by general formula (179) or general formula (180). R²⁷⁴ represents a hydrogen atom or an alkyl group having 1 to 10 carbon atoms. R²⁷⁵ and R²⁷⁶ each independently represent a hydrogen atom, an alkyl group having 1 to 10 carbon atoms, or a hydroxy group. When Y²⁶⁴ to Y²⁶⁶ are each independently a direct bond or an oxygen atom, a, b, and c are 1. When Y²⁶⁴ to Y²⁶⁶ are each independently a nitrogen atom, a, b, and c are 2. d represents 0 or 1. e represents 0 or 1. f represents an integer of 1 to 4. When e is 1, d is 1, and Y²⁷² represents an alkylene group having 1 to 10 carbon atoms. g represents an integer of 1 to 4. h represents an integer of 1 to 6. *¹ to *⁷ each independently represent a bonding point. The alkyl group, cycloalkyl group, aryl group, alkylene group, cycloalkylene group, and arylene group described above may have a hetero atom, and may be either unsubstituted or substituted.

The total content ratio of the compound (G2) and the compound (G3) in the total solid content of the photosensitive composition of the present invention excluding the solvent is preferably 0.3% by mass or more, more preferably 1.0% by mass or more, and still more preferably 2.0% by mass or more, from the viewpoint of suppressing residues after development, suppressing the narrow mask bias after development, and improving the halftone characteristics. On the other hand, the total content ratio of the compound (G2) and the compound (G3) is preferably 25% by mass or less, more preferably 20% by mass or less, and still more preferably 15% by mass or less, from the viewpoint of suppressing residues after development and improving the sensitivity at the time of exposure. In addition, when the photosensitive composition of the present invention contains the alkali-soluble resin (A) and the compound (B), the total content of the compound (G2) and the compound (G3) in the photosensitive composition of the present invention is, in a case where the total of the alkali-soluble resin (A) and the compound (B) is 100 parts by mass, preferably 1 part by mass or more, more preferably 3 parts by mass or more, and still more preferably 5 parts by mass or more. On the other hand, the total content of the compound (G2) and the compound (G3) is preferably 30 parts by mass or less, more preferably 25 parts by mass or less, and still more preferably 20 parts by mass or less.

### <Dissolution accelerator (H)>

The photosensitive composition of the present invention preferably further contains a dissolution accelerator (H) (hereinafter, referred to as "compound (H)"). The compound (H) refers to a compound having an acidic group and/or a hydrophilic group that can be dissolved in an alkaline developer. By containing the compound (H), the effect of suppressing residues after development is remarkable. The compound (H) preferably contains one or more selected from the group consisting of a polyfunctional carboxylic acid compound, a polyfunctional phenol compound, a hydroxyimide compound, and a compound having a hydroxy group and an oxyalkylene group.

The compound (H) preferably has a phenolic hydroxyl group from the viewpoint of suppressing the narrow mask bias after development and improving the halftone characteristics. On the other hand, when the alkali-soluble resin (A) described above has a phenolic hydroxyl group, the compound (H) preferably does not have a phenolic hydroxyl group.

The oxyalkylene group of the compound (H) is preferably bonded to a group selected from the group consisting of a mono- or divalent aliphatic group having 1 to 10 carbon atoms, an aryl group having 6 to 15 carbon atoms, an arylalkyl group having 7 to 25 carbon atoms, an alkylaryl group having 7 to 25 carbon atoms, and an aryl group having 6 to 15 carbon atoms to which at least two arylalkyl groups having 7 to 25 carbon atoms are bonded. The arylalkyl group having 7 to 25 carbon atoms is preferably an alkenyl group having 2 to 5 carbon atoms and having an aryl group having 6 to 15 carbon atoms. The oxyalkylene group of the compound (H) is preferably an oxyalkylene group having 1 to 6 carbon atoms, more preferably an oxyethylene group or an oxypropylene group, and still more preferably an oxyethylene group. The number of oxyalkylene groups in the compound (H) is preferably 2 or more, more preferably 3 or more, and still more preferably 4 or more. On the other hand, the number of oxyalkylene groups is preferably 20 or less, more preferably 15 or less, and still more preferably 10 or less.

The content ratio of the compound (H) to the total solid content of the photosensitive composition of the present invention, excluding the solvent, is preferably 0.2% by mass or more, more preferably 0.3% by mass or more, and still more preferably 1.0% by mass or more, from the viewpoint of suppressing residues after development. On the other hand, the content ratio of the compound (H) is preferably 20% by mass or less, more preferably 15% by mass or less, and still more preferably 10% by mass or less, from the viewpoint of suppressing pattern peeling after development. In addition, when the photosensitive composition of the present invention contains the alkali-soluble resin (A) and the compound (B), the content of the compound (H) in the photosensitive composition of the present invention is, in a case where the total of the alkali-soluble resin (A) and the compound (B) is 100 parts by mass, preferably 0.5% by mass or more, more preferably 1 part by mass or more, and still more preferably 3 parts by mass or more. On the other hand, the content of the compound (H) is preferably 25 parts by mass or less, more preferably 20 parts by mass or less, and still more preferably 15 parts by mass or less.

### <Inorganic particles (I)>

The photosensitive composition of the present invention preferably further contains inorganic particles (I) from the viewpoint of improving the halftone characteristics, improving the reliability of the light-emitting element, and improving the migration resistance. The inorganic particles (I) refer to particles containing an element selected from the group consisting of a metal element, a metalloid element, and a semiconductor element as a main component. Note that the main component refers to a component that is most contained in the constituent components on a mass basis. Examples of the inorganic particles (I) include halides, oxides, nitrides, hydroxides, carbonates, sulfates, nitrates, and metasilicates of the above elements.

When a cured film of the photosensitive composition contains the inorganic particles (I), a robust structure of the inorganic particles (I) is introduced, so that heat resistance is remarkably improved, and outgassing from a pixel defining layer or the like is suppressed. As a result, since deterioration of the light-emitting element is suppressed, the effect of improving the reliability of the light-emitting element becomes remarkable.

The inorganic particles (I) preferably have a hydroxy group and/or a silanol group on the particle surface. It is considered that the inorganic particles (I) trap metal impurities, ion impurities, and the like that adversely affect electrical insulation property due to the acidity and negative charge of the hydroxy group and/or silanol group on the particle surface. In addition, it is estimated that the migration resistance is improved because the robust structure of the particles keeps the trapped impurities even when a heat treatment or voltage application is performed.

In the case of a positive-type photosensitive composition, it is considered that the robust structure of the inorganic particles (I) hardly causes excessive alkali solubility in the exposed portion due to inhibition of alkali dissolution, and the halftone exposed portion has gradual development film loss, so that the effect of improving the halftone characteristics becomes remarkable. On the other hand, in the case of the negative-type photosensitive composition, steric hindrance and molecular movement inhibition due to the robust structure of the inorganic particles (I) control excessive photo-curing in the exposed portion. Furthermore, due to inhibition of alkali dissolution by the robust structure, side etching in a deep portion of a film at the time of alkali development in the exposed portion is suppressed, and effects such as gradual development film loss in the halftone exposed portion are remarkable. Therefore, it is considered that the effect of improving the halftone characteristics becomes remarkable.

The inorganic particles (I) are preferably silica particles, alumina particles, titania particles, vanadium oxide particles, chromium oxide particles, ferric oxide particles, cobalt oxide particles, zinc oxide particles, zirconium oxide particles, niobium oxide particles, tin oxide particles, or cerium oxide particles, and silica particles are preferable.

In the photosensitive composition of the present invention, the inorganic particles (I) preferably contain silica particles (I1) from the viewpoint of improving the halftone characteristics, improving the reliability of the light-emitting element, improving the migration resistance, and suppressing external light reflection. The silica particles unevenly distributed on the surface of the cured product reduce reflection and scattering of incident external light, so that the effect of suppressing external light reflection becomes remarkable.

The silica particles (I1) refer to inorganic particles containing silicon as a main component element. Examples of the silica particles (I1) include particles in which the pure content of silicon dioxide is 90% by mass or more in the mass excluding water, particles made of silicon dioxide (anhydrous silicic acid), particles made of silicon dioxide hydrate (hydrous silicic acid or white carbon), particles made of quartz glass, or particles made of orthosilicic acid, metasilicic acid, and metadisilicic acid. The structure of these particles is not particularly limited, and may have internal voids. However, silicon dioxide contained in the surface treatment agent or the covering layer in the organic pigment and the inorganic pigment is not contained in the silica particles (I1) regardless of the primary particle size and the aspect ratio thereof.

The silica particles (I1) preferably have a functional group on the surface from the viewpoint of improving the migration resistance. The functional group of the silica particles on the surface is preferably a radical polymerizable group, a thermally reactive group, a hydroxy group, a silanol group, an alkoxysilyl group, an alkylsilyl group, a dialkylsilyl group, a trialkylsilyl group, a phenylsilyl group, or a diphenylsilyl group. The radical polymerizable group or the thermally reactive group is also preferably a reaction residue of a surface-modifying group containing a radical polymerizable group or a reaction residue of a surface-modifying group containing a thermally reactive group. The silica particles (I1) more preferably have a radical polymerizable group and/or a thermally reactive group on the surface.

With such a configuration, the effect of improving the sensitivity at the time of exposure and improving the halftone characteristics becomes remarkable. In addition, the effects of improving the reliability of the light-emitting element and driving the light-emitting element at a low voltage are remarkable. It is presumed that by containing the silica particles (I1) having a radical polymerizable group and/or a thermally reactive group, the cross-linked structure of the radical polymerizable group or the thermally reactive group suppresses excessive alkali dissolution in the exposed portion in the case of the positive-type photosensitive composition, or suppresses side etching in the deep portion of the film during alkali development in the exposed portion in the case of the negative-type photosensitive composition, whereby the above effect becomes remarkable. In addition, since a cross-linked structure in which a radical polymerizable group such as a (meth)acryloyl group is radically polymerized is introduced, the cured film of the photosensitive composition has a remarkable effect of improving the heat resistance by improving the cross-linking density. As a result, since outgas from the pixel defining layer or the like is suppressed, it is estimated that the effect of improving the reliability of the light-emitting element becomes remarkable.

The radical polymerizable group is preferably an ethylenically unsaturated double bond group. The radical polymerizable group is more preferably one or more selected from the group consisting of a photoreactive group, an alkenyl group having 2 to 5 carbon atoms, and an alkynyl group having 2 to 5 carbon atoms. The photoreactive group is preferably a styryl group, a cinnamoyl group, a maleimide group, or a (meth)acryloyl group, and more preferably a (meth)acryloyl group. On the other hand, the alkenyl group having 2 to 5 carbon atoms or the alkynyl group having 2 to 5 carbon atoms is preferably a vinyl group, an allyl group, a 2-methyl-2-propenyl group, a crotonyl group, a 2-methyl-2-butenyl group, a 3-methyl-2-butenyl group, a 2,3-dimethyl-2-butenyl group, an ethynyl group, or a 2-propargyl group, and more preferably a vinyl group or an allyl group. The thermally reactive group is preferably an alkoxymethyl group, a methylol group, an epoxy group, an oxetanyl group, or a blocked isocyanate group.

The average primary particle size of the silica particles (I1) is preferably 5.0 nm or more, more preferably 7.0 nm or more, and still more preferably 10 nm or more, from the viewpoint of improving the halftone characteristics, improving the reliability of the light-emitting element, and improving the migration resistance. On the other hand, the average primary particle size of the silica particles (I1) is preferably 200 nm or less, more preferably 100 nm or less, and still more preferably 70 nm or less, from the viewpoint of suppressing residues after development, suppressing external light reflection, and improving the reliability of the light-emitting element. Furthermore, it is preferably 50 nm or less, more preferably 40 nm or less, still more preferably 30 nm or less, even more preferably 25 nm or less, particularly preferably 20 nm or less, and most preferably 15 nm or less.

The average primary particle size of the silica particles (I1) is preferably more than 0.20 um, more preferably 0.30 um or more, and still more preferably 0.50 um or more from the viewpoint of increasing the elastic modulus and decreasing the thermal expansion coefficient. On the other hand, the average primary particle size of the silica particles (I1) is preferably 100 µm or less, more preferably 50 µm or less, still more preferably 30 µm or less, even more preferably 10 µm or less, particularly preferably 5.0 µm or less, and most preferably 3.0 µm or less from the viewpoint of suppressing residues after development.

The primary particle size of the silica particles (I1) refers to the major axis size of the primary particles of the silica particles (I1). The average primary particle size of the silica particles in the film can be calculated as an average value obtained by imaging and analyzing a cross section of the film using TEM and measuring 30 primary particles of the silica particles. The average primary particle size of the silica particles in the silica particle dispersion liquid is obtained by measuring a particle size distribution by a dynamic light scattering method or a laser diffraction/scattering method. Examples of the measuring instrument include SZ-100 manufactured by HORIBA, Ltd. as a dynamic light scattering method, and SLD 3100 manufactured by Shimadzu Corporation, LA-920 manufactured by HORIBA, Ltd. or its equivalent as the laser diffraction/scattering method.

The silica particles (I1) preferably contain silica particles (I1) containing a sodium element from the viewpoint of improving the reliability and migration resistance of the light-emitting element. Examples of the existence form of the sodium element include an ion (Na⁺) or a salt with a silanol group (Si-ONa). The content of the sodium element in the silica particles (I1) is preferably 1.0 ppm by mass or more, more preferably 5.0 ppm by mass or more, still more preferably 10 ppm by mass or more, even more preferably 50 ppm by mass or more, and particularly preferably 100 ppm by mass or more. On the other hand, the content of the sodium element in the silica particles (I1) is preferably 10,000 ppm by mass or less, more preferably 5,000 ppm by mass or less, and still more preferably 1,000 ppm by mass or less. The sodium element (I1) contained in the silica particles can be detected by imaging and analyzing the cross section of the film using TEM-EDX. It is considered that the polarization structure and charge balance in the cured product are controlled by intentionally containing a small amount of sodium element in the silica particles (I1). As a result, metal impurities, ion impurities, and the like that adversely affect electrical insulation property are efficiently trapped, and therefore the migration resistance is estimated to be improved.

The content ratio of the inorganic particles (I) in the total solid content of the photosensitive composition of the present invention is preferably 5.0% by mass or more, more preferably 10% by mass or more, still more preferably 15% by mass or more, and particularly preferably 20% by mass or more, from the viewpoint of improving the halftone characteristics, improving the reliability of the light-emitting element, and improving the migration resistance. On the other hand, the content ratio of the inorganic particles (I) is preferably 90% by mass or less, more preferably 70% by mass or less, and still more preferably 50% by mass or less from the viewpoint of suppressing residues after development and improving the reliability of the light-emitting element.

### <Content of halogen element, sulfur element, and phosphorus element>

The photosensitive composition of the present invention preferably further contains one or more selected from the group consisting of a halogen element-containing component, a sulfur element-containing component, and a phosphorus element-containing component, more preferably contains a halogen element-containing component and/or a sulfur element-containing component, and still more preferably contains a sulfur element-containing component, from the viewpoint of improving the reliability of the light-emitting element in the display device and driving the light-emitting element at a low voltage. The photosensitive composition of the present invention preferably contains two or more selected from the group consisting of a halogen element-containing component, a sulfur element-containing component, and a phosphorus element-containing component, more preferably contains a halogen element-containing component and a sulfur element-containing component, and still more preferably contains a halogen element-containing component, a sulfur element-containing component, and a phosphorus element-containing component.

Examples of the halogen element include a chlorine element, a bromine element, an iodine element, and a fluorine element. The halogen element preferably contains one or more selected from the group consisting of a chlorine element, a bromine element, and an iodine element, more preferably contains a chlorine element and/or a bromine element, and still more preferably contains a chlorine element.

The content of the halogen element in the photosensitive composition is preferably 0.01 ppm by mass or more, more preferably 0.03 ppm by mass or more, still more preferably 0.05 ppm by mass or more, even more preferably 0.07 ppm by mass or more, and particularly preferably 0.1 ppm by mass or more. On the other hand, the content of the halogen element is preferably 700 ppm by mass or less, more preferably 500 ppm by mass or less, and still more preferably 300 ppm by mass or less. Furthermore, the content is preferably 100 ppm by mass or less, more preferably 70 ppm by mass or less, still more preferably 50 ppm by mass or less, even more preferably 30 ppm by mass or less, and particularly preferably 10 ppm by mass or less from the viewpoint of improving the light-emitting characteristics. Furthermore, from the viewpoint of driving the light-emitting element at a low voltage, the content is preferably 7 ppm by mass or less, more preferably 5 ppm by mass or less, still more preferably 3 ppm by mass or less, and particularly preferably 1 ppm by mass or less.

The content of the sulfur element in the photosensitive composition is preferably 0.01 ppm by mass or more, more preferably 0.03 ppm by mass or more, still more preferably 0.05 ppm by mass or more, even more preferably 0.07 ppm by mass or more, and particularly preferably 0.1 ppm by mass or more. On the other hand, the content of the sulfur element is preferably 700 ppm by mass or less, more preferably 500 ppm by mass or less, and still more preferably 300 ppm by mass or less. Furthermore, the content is preferably 100 ppm by mass or less, more preferably 70 ppm by mass or less, still more preferably 50 ppm by mass or less, even more preferably 30 ppm by mass or less, and particularly preferably 10 ppm by mass or less from the viewpoint of improving the light-emitting characteristics. Furthermore, from the viewpoint of driving the light-emitting element at a low voltage, the content is preferably 7 ppm by mass or less, more preferably 5 ppm by mass or less, still more preferably 3 ppm by mass or less, and particularly preferably 1 ppm by mass or less.

The content of the phosphorus element in the photosensitive composition is preferably 0.01 ppm by mass or more, more preferably 0.03 ppm by mass or more, still more preferably 0.05 ppm by mass or more, even more preferably 0.07 ppm by mass or more, and particularly preferably 0.1 ppm by mass or more. On the other hand, the content of the phosphorus element is preferably 700 ppm by mass or less, more preferably 500 ppm by mass or less, and still more preferably 300 ppm by mass or less. Furthermore, the content is preferably 100 ppm by mass or less, more preferably 70 ppm by mass or less, still more preferably 50 ppm by mass or less, even more preferably 30 ppm by mass or less, and particularly preferably 10 ppm by mass or less from the viewpoint of improving the light-emitting characteristics. Furthermore, from the viewpoint of driving the light-emitting element at a low voltage, the content is preferably 7 ppm by mass or less, more preferably 5 ppm by mass or less, still more preferably 3 ppm by mass or less, and particularly preferably 1 ppm by mass or less.

The photosensitive composition of the present invention preferably contains one or more selected from the group consisting of a halogen element-containing component, a sulfur element-containing component, and a phosphorus element-containing component, and satisfying one or more of the following conditions (1) to (3).
(1) A content of the halogen elements in the photosensitive composition is 0.01 to 100 ppm by mass
(2) A content of the sulfur elements in the photosensitive composition is 0.01 to 100 ppm by mass
(3) A content of the phosphorus elements in the photosensitive composition is 0.01 to 100 ppm by mass

In addition, the photosensitive composition of the present invention more preferably satisfies the condition (1) and/or the condition (2), and still more preferably satisfies the condition (2). In addition, the photosensitive composition of the present invention preferably satisfies two or more conditions selected from the group consisting of the conditions (1) to (3), more preferably satisfies the conditions (1) and (2), and still more preferably satisfies all the conditions (1) to (3).

The photosensitive composition of the present invention contains one or more selected from the group consisting of a halogen element-containing component, a sulfur element-containing component, and a phosphorus element-containing component, when the photosensitive composition contains a component containing a halogen element, the content of the halogen element in the photosensitive composition is 0.01 to 100 ppm by mass, when the photosensitive composition contains a component containing a sulfur element, the content of the sulfur element in the photosensitive composition is 0.01 to 100 ppm by mass, and when the photosensitive composition contains a component containing a phosphorus element, the content of the phosphorus element in the photosensitive composition is more preferably 0.01 to 100 ppm by mass.

When the photosensitive composition contains one or more selected from the group consisting of a halogen element-containing component, a sulfur element-containing component, and a phosphorus element-containing component, and the content of one or more selected from the group consisting of a halogen element, a sulfur element, and a phosphorus element in the photosensitive composition is within a specific range, the effects of improving the reliability of the light-emitting element in the display device and driving the light-emitting element at a low voltage are remarkable. It is considered that a surface of a first electrode is surface-modified by these elements, for example, in a step of forming the pixel defining layer in the organic EL display by containing a small amount of components containing these elements in the photosensitive composition. Alternatively, it is considered that the surface of the first electrode is surface-modified by these elements as these elements contained in the pixel defining layer transition after the pixel defining layer is formed. Therefore, it is estimated that the effect of driving the light-emitting element at a low voltage in the display device becomes remarkable by adjusting the work function difference of the first electrode. Furthermore, it is considered that, for example, the polarization structure and the charge balance in the pixel defining layer in the organic EL display are controlled by intentionally containing a small amount of components containing these elements. Accordingly, it is estimated that the effect of improving the reliability of the light-emitting element in the display device becomes remarkable by suppressing ion migration and electromigration caused by metal impurities and ion impurities that adversely affect the light-emitting characteristics.

In addition, since the halogen element has more unshared electron pairs, it is presumed that the effect of driving the light-emitting element at a low voltage by adjusting the work function difference of the first electrode becomes remarkable by functioning as a dopant that donates electrons and forming a donor level.

In addition, since the sulfur element has a relatively large number of unshared electron pairs, in addition to similarly functioning as a dopant, electrons can be more efficiently donated by using the 3d orbital which is an empty atomic orbital, and thus it is considered that a donor level is easily formed. In addition, it is considered that an acceptor level can also be formed by functioning as a dopant that accepts electrons by the 3d orbital which is an empty atomic orbital. With these functions, it is presumed that the effect of driving the light-emitting element at a low voltage by adjusting the work function difference of the first electrode becomes remarkable.

In addition, it is considered that since the phosphorus element has an unshared electron pairs, the phosphorus element similarly functions as a dopant, and in addition, it is easy to form a donor level similarly by using the 3d orbital which is an empty atomic orbital. In addition, it is considered that an acceptor level can be similarly formed by accepting an electron by the 3d orbital which is an empty atomic orbital. With these functions, it is presumed that the effect of driving the light-emitting element at a low voltage by adjusting the work function difference of the first electrode becomes remarkable.

The halogen element-containing component, the sulfur element-containing component, and the phosphorus element-containing component contained in the photosensitive composition are preferably a simple substance, an ion, a compound, or a compound ion. That is, the photosensitive composition preferably contains a simple substance of a halogen element, an ion of a halogen element, a compound containing a halogen element, a compound ion containing a halogen element, a simple substance of a sulfur element, an ion of a sulfur element, a compound containing a sulfur element, a compound ion containing a sulfur element, a simple substance of a phosphorus element, an ion of a phosphorus element, a compound containing a phosphorus element, or a compound ion containing a phosphorus element. The content of the halogen element in the photosensitive composition is the total amount of the halogen element which is a simple substance, an ion, a compound, or a compound ion. Similarly, the content of the sulfur element in the photosensitive composition is the total amount of the sulfur element which is a simple substance, an ion, a compound, or a compound ion. Similarly, the content of the phosphorus element in the photosensitive composition is the total amount of the phosphorus element which is a simple substance, an ion, a compound, or a compound ion.

Examples of the simple substance of the halogen element include chlorine, bromine, iodine, and fluorine, chlorine and bromine are preferable, and chlorine is more preferable.

Examples of the ion of the halogen element include a chloride ion, a bromide ion, an iodide ion, and a fluoride ion, and a chloride ion or a bromide ion is preferable, and a chloride ion is more preferable.

Examples of the compound containing a halogen element include a halogenated aliphatic compound, a halogenated alicyclic compound, a halogenated aromatic compound, a hydrogen halide, a halogen dioxide, and a halogen oxyacid, and an aliphatic compound to which a chlorine atom is bonded, an alicyclic compound to which a chlorine atom is bonded, an aromatic compound to which a chlorine atom is bonded, hydrogen chloride, chlorine dioxide, an aliphatic compound to which a bromine atom is bonded, an alicyclic compound to which a bromine atom is bonded, an aromatic compound to which a bromine atom is bonded, hydrogen bromide, or bromine dioxide is preferable, and an aliphatic compound to which a chlorine atom is bonded, an alicyclic compound to which a chlorine atom is bonded, or an aromatic compound to which a chlorine atom is bonded is preferable. These may be either unsubstituted or substituted.

Examples of the compound ion containing a halogen element include a hypohalite oxoacid ion, a halogene oxoacid ion, a halogen oxoacid ion, and a perhalogen oxoacid ion, and a hypochlorite ion, a chlorite ion, a chlorate ion, or a perchlorate ion is preferable. These may be either unsubstituted or substituted.

Examples of the aliphatic compound to which a chlorine atom is bonded, the alicyclic compound to which a chlorine atom is bonded, or the aromatic compound to which a chlorine atom is bonded include dichloromethane, dichloroethane, tetrachloroethane, chloroform, carbon tetrachloride, chlorocyclopropane, epichlorohydrin, chlorobenzene, and benzyl chloride. Examples of the aliphatic compound to which a bromine atom is bonded, the alicyclic compound to which a bromine atom is bonded, or the aromatic compound to which a bromine atom is bonded include dibromomethane, dibromoethane, tetrabromoethane, bromoform, carbon tetrabromide, bromocyclopropane, epibromohydrin, bromobenzene, and benzyl bromide.

The simple substance of the sulfur element is sulfur. Sulfur may be an allotrope such as monoclinic sulfur, oblique sulfur, or rubber-like sulfur.

The ion of the sulfur element is a sulfide ion.

Examples of the compound containing a sulfur element include a thiol compound, a sulfide compound, a disulfide compound, a sulfoxide compound, a sulfone compound, a sultone compound, carbon disulfide, a thiophene compound, a thiocarbonyl compound, a dithiocarbonyl compound, a trithiocarbonyl compound, hydrogen sulfide, sulfur monoxide, sulfur dioxide, sulfur trioxide, sulfinic acid, sulfonic acid, sulfurous acid, sulfuric acid, and thiosulfuric acid. A thiol compound, a sulfide compound, a disulfide compound, a sulfoxide compound, a sulfone compound, a sultone compound, carbon disulfide, or a thiophene compound is preferable, and a thiol compound, a sulfide compound, or a sulfoxide compound is more preferable. These may be either unsubstituted or substituted.

Examples of the compound ion containing a sulfur element include a thiolate ion, a sulfinate ion, a sulfonate ion, a sulfite ion, a sulfate ion, a thiosulfate ion, and a sulfonium ion, and a thiolate ion is preferable. These may be either unsubstituted or substituted.

Examples of the thiol compound include butanethiol, octanethiol, dodecanethiol, octadecanethiol, ethanedithiol, octanedithiol, cyclopropanethiol, thiophenol, toluenethiol, mercaptopropyltrimethoxysilane, mercaptooctyltrimethoxysilane, and mercaptododecyltrimethoxysilane. Examples of the sulfide compound include dimethyl sulfide, dibutyl sulfide, dioctyl sulfide, didodecyl sulfide, dicyclopropyl sulfide, diphenyl sulfide, and dibenzyl sulfide. Examples of the sulfoxide compound include dimethyl sulfoxide, dibutyl sulfoxide, dioctyl sulfoxide, didodecyl sulfoxide, dicyclopropyl sulfoxide, diphenyl sulfoxide, and dibenzyl sulfoxide.

The simple substance of the phosphorus element is phosphorus. Phosphorus may be an allotrope such as yellow phosphorus, red phosphorus, black phosphorus, or violet phosphorus.

The ion of the phosphorus element is a phosphide ion.

Examples of the compound containing the phosphorus element include a phosphine compound, a phosphine oxide, a phosphinic acid monoester, a phosphonic acid diester, a hypophosphorous acid diester, a phosphorous acid triester, a phosphoric acid triester, phosphorus trioxide, and diphosphorus pentoxide, and a phosphine compound or a phosphine oxide compound is preferable. These may be either unsubstituted or substituted.

Examples of the compound ion containing the phosphorus element include a hypophosphite ion, a phosphite ion, a phosphate ion, a polyphosphate ion, and a phosphonium ion. These may be either unsubstituted or substituted.

Examples of the phosphine compound include tributylphosphine, trioctylphosphine, tridodecylphosphine, tricyclohexylphosphine, triphenylphosphine, and tribenzylphosphine. Examples of the phosphine oxide compound include tributylphosphine oxide, trioctylphosphine oxide, tridodecylphosphine oxide, tricyclohexylphosphine oxide, triphenylphosphine oxide, and tribenzylphosphine oxide.

When the photosensitive composition contains a chloride ion, a bromide ion, an iodide ion, a fluoride ion, a hypohalogens oxoacid ion, a halogens oxoacid ion, a halogen oxoacid ion, a perhalogens oxoacid ion, a sulfide ion, a thiolate ion, a sulfinate ion, a sulfonate ion, a sulfite ion, a sulfate ion, a thiosulfate ion, a hypophosphite ion, a phosphite ion, a phosphate ion, or a polyphosphate ion, the photosensitive composition may contain a counter cation. Examples of the counter cation include a metal element ion, an ammonium ion, a primary ammonium ion, a secondary ammonium ion, a tertiary ammonium ion, and a quaternary ammonium ion, and a quaternary ammonium ion is preferable. Examples of the metal element ion include an alkali metal ion, an alkaline earth metal ion, a typical element metal ion, and a transition metal ion. The metal element is preferably Li, Be, Na, Mg, Al, K, Ca, Sc, Ti, V, Cr, Mn, Fe, Co, Ni, Cu, or Zn. Each of the primary ammonium ion, the secondary ammonium ion, the tertiary ammonium ion, and the quaternary ammonium ion has 1 to 4 aliphatic groups, alicyclic groups, or aromatic groups. When the photosensitive composition contains a sulfonium ion or a phosphonium ion, the photosensitive composition may contain a counter anion. Examples of the counter anion include a hydroxide ion, a carboxylate ion, a hyponitrite ion, a nitrite ion, a nitrate ion, and a phenoxy ion.

### <Content of specific nitrogen-containing compound>

From the viewpoint of improving the migration resistance, the photosensitive composition of the present invention preferably further contains one or more selected from the group consisting of a cyclic amide compound represented by general formula (20), an amide compound represented by general formula (21), a cyclic urea compound represented by general formula (22), and a urea compound represented by general formula (23), and a condition (4) described below is satisfied.

(4) Total content of the cyclic amide compound represented by the general formula (20), the amide compound represented by the general formula (21), the cyclic urea compound represented by the general formula (22), and the urea compound represented by the general formula (23) (hereinafter, referred to as "a specific nitrogen-containing compound") in the total solid content of the photosensitive composition is 0.010% to 5.0% by mass.

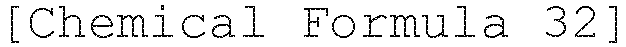

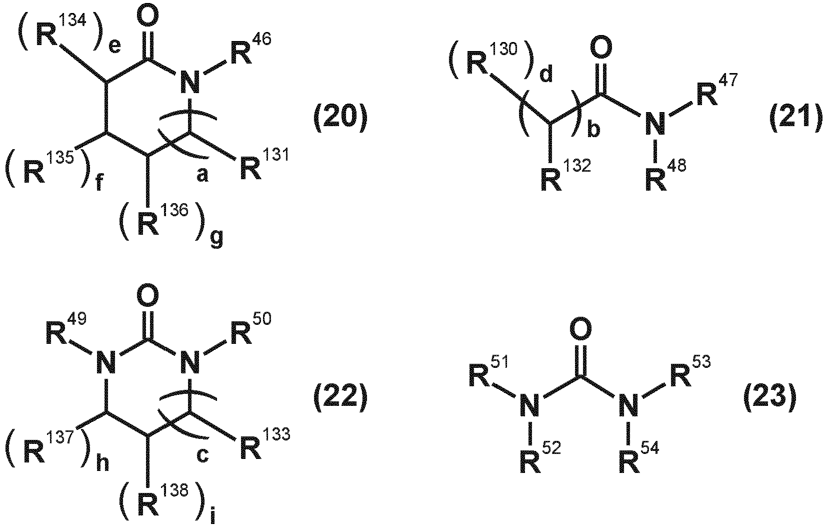

In the general formulae (20) to (23), R⁴⁶ to R⁵⁴ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms. R¹³⁰ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms. R¹³¹ to R¹³⁸ each independently represent an alkyl group having 1 to 6 carbon atoms, a, b, and c each independently represent an integer of 0 to 6. d represents 1 or 2. e, f, g, h, and i each independently represent an integer of 0 to 2. In a case where b is 0, d is 1.

Examples of the specific nitrogen-containing compound include N-methyl-2-pyrrolidone, N-ethyl-2-pyrrolidone, N-butyl-2-pyrrolidone, N-cyclohexyl-2-pyrrolidone, N-vinyl-2-pyrrolidone, N,N'-dimethylformamide, N,N'-diethylformamide, N,N'-dimethylacetamide, N,N'-dimethylpropionamide, N,N'-dimethylisobutyramide, N,N'-dimethyl-3-methoxypropionamide, N,N'-dimethyl-3-butoxypropionamide, 1,3-dimethyl-2-imidazolidinone, 1,3-diethyl-2-imidazolidinone, N,N'-dimethylpropyleneurea, 1,1,3,3-tetramethylurea, and 1,1,3,3-tetraethylurea.

The total content of the specific nitrogen-containing compound in the total solid content of the photosensitive composition is more preferably 0.030% by mass or more, still more preferably 0.050% by mass or more, particularly preferably 0.070% by mass or more, and most preferably 0.10% by mass or more. On the other hand, the total content of the specific nitrogen-containing compound is more preferably 4.0% by mass or less, still more preferably 3.5% by mass or less, and particularly preferably 3.0% by mass or less. Further, from the viewpoint of improving the migration resistance, the content is preferably 2.5% by mass or less, more preferably 2.0% by mass or less, still more preferably 1.5% by mass or less, even more preferably 1.0% by mass or less, particularly preferably 0.70% by mass or less, and most preferably 0.50% by mass or less.

Regarding a semiconductor device, a material used for an interlayer insulation layer in a multilayer metal redistribution layer is required to have high mechanical properties for withstanding the stress associated with multilayering. In addition, due to wiring miniaturization associated with high integration of the semiconductor devices, the reliability related to electrical insulation property is required, and therefore high migration resistance is also required. In addition, there is a restriction that a memory used in recent years, a mold resin used in manufacturing a semiconductor package, and the like have low heat resistance, and a high-temperature process cannot be applied. Therefore, a material used for a surface protective layer or an interlayer insulation layer of a semiconductor device is required to be curable even by heating at a low temperature of 250°C or lower, more desirably 220°C or lower, and to have high mechanical properties.

It is considered that when the photosensitive composition of the present invention contains the specific nitrogen-containing compound, the degree of cross-linking of the resin is improved and the ring-closing reaction is promoted, so that excellent mechanical properties are achieved even in heating at a low temperature. In addition, the effect of improving the migration resistance is remarkable. In addition, since the specific nitrogen-containing compound traps metal impurities, ion impurities, and the like that adversely affect electrical insulation property due to the nitrogen-containing structure having the unshared electron pairs, it is presumed that ion migration and electromigration are suppressed, and the migration resistance is improved.

### <Content of specific metal element>

When the photosensitive composition of the present invention contains one or more selected from the group consisting of specific nitrogen-containing compounds and satisfies the condition (4), from the viewpoint of improving the mechanical properties in heating at a low temperature and improving the migration resistance, the photosensitive composition of the present invention preferably further contains one or more selected from the group consisting of a component containing a sodium element, a component containing a potassium element, a component containing a magnesium element, a component containing a calcium element, a component containing an iron element, a component containing a copper element, and a component containing a chromium element, and a condition (5) described below is satisfied.

(5) Total content of the sodium element, the potassium element, the magnesium element, the calcium element, the iron element, the copper element, and the chromium element (hereinafter, referred to as "specific metal element") in the total solid content of the photosensitive composition is 0.010 ppm to 500 ppm by mass.

The component containing a specific metal element is preferably a halide, an oxide, a nitride, a hydroxide, a sulfide, a carbide, an oxynitride, a carboxylate, a phosphate, a carbonate, a sulfate, a nitrate, or a metasilicate of the specific metal element.

The total content of the specific metal element in the total solid content of the photosensitive composition is preferably 0.030 ppm by mass or more, more preferably 0.050 ppm by mass or more, still more preferably 0.070 ppm by mass or more, and particularly preferably 0.10 ppm by mass or more. On the other hand, the total content of the specific metal elements is preferably 300 ppm by mass or less, more preferably 200 ppm by mass or less, and still more preferably 100 ppm by mass or less. Further, the content is preferably 50 ppm by mass or less, more preferably 30 ppm by mass or less, still more preferably 10 ppm by mass or less, even more preferably 5 ppm by mass or less, particularly preferably 3 ppm by mass or less, and most preferably 1 ppm by mass or less, from the viewpoint of improving the mechanical properties and the migration resistance in heating at a low temperature.

Since the specific metal element described above traps metal impurities, ion impurities, and the like that adversely affect electrical insulation property due to positive charges of the metal element, it is estimated that ion migration and electromigration are suppressed, and the migration resistance is improved. In the photosensitive composition of the present invention, it is presumed that a metal complex is formed by intentionally containing a small amount of a specific metal element in the presence of a specific nitrogen-containing compound. The formed metal complex is considered to function as a catalyst that promotes a cross-linking reaction on an aromatic ring, a ring-closing reaction of a resin, or a cross-linking reaction in a resin having a silanol group, such as polysiloxane, in a resin having an aromatic ring, such as polyimide, polybenzoxazole, or a precursor thereof. As a result, since the cross-linking reaction and the ring-closing reaction efficiently proceed, it is considered that excellent mechanical properties are achieved even in heating at a low temperature. In addition, the formed metal complex efficiently traps metal impurities, ion impurities, and the like that adversely affect electrical insulation property due to positive charges of metal elements and a nitrogen-containing structure, and thus the migration resistance is estimated to be improved.

### <Ink repellent agent and other additives>

It is also preferable that the photosensitive composition of the present invention further contain an ink repellent agent. The ink repellent agent refers to a compound having a water repellent structure and/or an oil repellent structure. When the ink repellent agent is contained, the liquid repellency of the film can be improved, so that a contact angle of a film with respect to pure water and/or the contact angle of the film with respect to an organic solvent can be increased. The ink repellent agent preferably has one or more selected from the group consisting of at least two photoreactive groups, at least two alkenyl groups having 2 to 5 carbon atoms, at least two alkynyl groups having 2 to 5 carbon atoms, and at least two thermally reactive groups.

The photoreactive group is preferably a radical polymerizable group, more preferably a styryl group, a cinnamoyl group, a maleimide group, or a (meth)acryloyl group, and still more preferably a (meth)acryloyl group. On the other hand, the alkenyl group having 2 to 5 carbon atoms or the alkynyl group having 2 to 5 carbon atoms is preferably a radical polymerizable group, a vinyl group, an allyl group, a 2-methyl-2-propenyl group, a crotonyl group, a 2-methyl-2-butenyl group, a 3-methyl-2-butenyl group, a 2,3-dimethyl-2-butenyl group, or an ethynyl group, more preferably a 2-propargyl group, and still more preferably a vinyl group or an allyl group. The thermally reactive group is preferably an alkoxymethyl group, a methylol group, an epoxy group, an oxetanyl group, or a blocked isocyanate group. It is also preferable that the ink repellent agent has a polymer chain, and it is also preferable that the ink repellent agent has one or more selected from the group consisting of a water-repellent structure, an oil-repellent structure, at least two photoreactive groups, at least two alkenyl groups having 2 to 5 carbon atoms, at least two alkynyl groups having 2 to 5 carbon atoms, and at least two thermally reactive groups in the side chain of the repeating unit of the polymer chain. Examples of the ink repellent agent having a polymer chain include an acrylic resin ink repellent agent, a polyoxyalkylene ether ink repellent agent, a polyester ink repellent agent, a polyurethane ink repellent agent, a polyol ink repellent agent, a polyethyleneimine ink repellent agent, and a polyallylamine ink repellent agent.

The photosensitive composition of the present invention preferably further contains one or more selected from the group consisting of a sensitizer, a chain transfer agent, a polymerization terminator, a silane coupling agent, and a surfactant. When the sensitizer is contained, the effect of improving the sensitivity at the time of exposure becomes remarkable. The sensitizer is preferably a compound having a fluorene skeleton, a benzofluorene skeleton, a fluorenone skeleton, or a thioxanthone skeleton. When the chain transfer agent is contained, the effect of improving the sensitivity at the time of exposure becomes remarkable. The chain transfer agent is preferably a compound having at least two mercapto groups. By containing the polymerization terminator, the effect of improving the resolution after development is remarkable. The polymerization terminator is preferably a hindered phenol compound, a hindered amine compound, or a benzimidazole compound. By containing the silane coupling agent, the effect of improving adhesion property between the cured film and the underlying substrate becomes remarkable. As the silane coupling agent, a trifunctional organosilane, a tetrafunctional organosilane, or a silicate compound is preferable. By containing the surfactant, the effect of improving the film thickness uniformity of the coating film becomes remarkable. As the surfactant, a fluororesin-based surfactant, a silicone-based surfactant, a polyoxyalkylene ether-based surfactant, or an acrylic resin-based surfactant is preferable. The content ratio of the surfactant in the photosensitive composition according to the present invention is preferably 0.001% by mass or higher, and more preferably 0.005% by mass or higher, based on the whole photosensitive composition. On the other hand, the content ratio of the surfactant is preferably 1% by mass or less, and is more preferably 0.5% by mass or less.

### <Solvent>

It is also preferable that the photosensitive composition of the present invention further contain a solvent. By containing the solvent, a film of the composition can be formed on the substrate at a desired film thickness, and the effect of improving the film thickness uniformity of the coating film becomes remarkable. As the solvent, a compound having an alcoholic hydroxyl group, a compound having a carbonyl group, a compound having an ester bond, or a compound having at least three ether bonds is preferable from the viewpoint of the solubility of various resins and various additives. The solvent is preferably a compound having a boiling point of 110°C or higher under atmospheric pressure from the viewpoint of improving the film thickness uniformity of the coating film. On the other hand, from the viewpoint of improving flatness by suppressing film shrinkage during thermal curing, a compound having a boiling point of 250°C or lower under atmospheric pressure is preferable. The content ratio of the solvent in the photosensitive composition according to the present invention can be adjusted appropriately depending on the coating method and the like. For example, in the case of forming a coating film by spin coating, it is common to adjust the ratio to 50% to 95% by mass of the whole photosensitive composition.

When the photosensitive composition of the present invention contains the pigment (D1) as the colorant (D), by containing a solvent having a carbonyl group or a solvent having an ester bond as the solvent, the effect of suppressing residues after development becomes remarkable by improving the dispersion stability of the pigment (D1). The carbonyl group is preferably an alkylcarbonyl group, a dialkylcarbonyl group, a formyl group, a carboxy group, an amide group, an imide group, a urea bond, or a urethane bond. The ester bond is preferably a carboxylic acid ester bond, a carbonic acid ester bond or a formic acid ester bond, and more preferably a carboxylic acid ester bond. Among the carboxylic acid ester bonds, an acetate bond, a propionate bond, or a butyrate bond is more preferable, and an acetate bond is still more preferable. In the photosensitive composition according to the present invention, the content ratio of the solvent having a carbonyl group or an ester bond in the solvent is preferably 30% to 100% by mass, more preferably 50% to 100% by mass, and still more preferably 70% to 100% by mass, from the viewpoint of suppressing residues after development and improving resolution after development. In the photosensitive composition according to the present invention, when the compound (F1) contains the specific compound (F1) described above, similarly, the content ratio of propylene glycol monoalkyl ether acetate in the solvent is preferably 30% to 100% by mass, more preferably 50% to 100% by mass, and still more preferably 70% to 100% by mass.

In the photosensitive composition according to the present invention, when the compound (FB1) contains the specific compound (FB1) described above, the content ratio of propylene glycol monoalkyl ether acetate in the solvent is preferably 30% by mass or more, more preferably 40% by mass or more, and still more preferably 50% by mass or more. On the other hand, the content ratio of propylene glycol monoalkyl ether acetate is preferably 90% by mass or less, more preferably 80% by mass or less, and still more preferably 70% by mass or less. In the photosensitive composition according to the present invention, when the compound (FB1) contains the above-mentioned specific compound (FB1), the total content ratio of the diethylene glycol dialkyl ether and/or the solvent having an alcoholic hydroxyl group in the solvent is preferably 10% by mass or more, more preferably 20% by mass or more, and still more preferably 30% by mass or more. On the other hand, the total content ratio of these solvents is preferably 50% by mass or less, and more preferably 40% by mass or less. The solvent having an alcoholic hydroxyl group is preferably a solvent having an alcoholic hydroxyl group and an ether bond and/or an ester bond. The ester bond is preferably a carboxylic acid ester bond, a carbonic acid ester bond or a formic acid ester bond, and more preferably a carboxylic acid ester bond. The solvent having an alcoholic hydroxyl group and an ether bond and/or a carboxylic acid ester bond is preferably one or more selected from the group consisting of propylene glycol monoalkyl ether, alkyl lactate, alkyl hydroxyacetate, and hydroxyalkyl acetate.

### <Method for producing photosensitive composition according to the present invention>

A typical method for producing the photosensitive composition of the present invention will be described. When the colorant (D) contains the black colorant (Da) and the black colorant (Da) contains the black pigment (D1a), the black pigment (D1a) is dispersed in a mixed solution obtained by adding the dispersant (E) as necessary to the solution of the alkali-soluble resin (A) using a disperser to prepare a pigment dispersion liquid. Next, the alkali-soluble resin (A), the radical polymerizable compound (B), the photosensitive agent (C), other additives as necessary, and an optional solvent are added to the pigment dispersion liquid, and the mixture is stirred for 20 minutes to 3 hours to obtain a uniform solution. After the stirring, the obtained solution is filtered, thereby providing the photosensitive composition of the present invention. The disperser is preferably a bead mill from the viewpoint of suppressing residues after development. Examples of the beads include titania beads, zirconia beads, or zircon beads. A bead diameter is preferably 0.01 to 6 mm, more preferably 0.015 to 5 mm, and still more preferably 0.03 to 3 mm.

### <Photosensitive film>

In the present invention, the photosensitive film is in a semi-cured state (stage B) on which a film of the photosensitive composition of the present invention is formed. The semi-cured state refers to a state in which a cross-linked structure is not formed, or a cross-linked structure is formed by a partial reaction, but the film has fluidity, or a state thereof. Examples thereof include a state in which a coating film is applied to a substrate or the like and then dried under reduced pressure to distill off a solvent, and a state in which a coating film is heated at 40°C to 150°C and dried, and this state refers to a state in which the coating film is soluble in an alkaline solution or an organic solvent. The photosensitive film refers to a film having positive-type or negative-type photosensitivity and capable of forming a self-standing film as a single film. It is preferable that the photosensitive film has adhesion property, and it is also preferable that a plurality of members are bonded. The phrase "capable of forming a self-standing film as a single film" means that a film having a width of 1.5 cm or more, a length of 5.0 cm or more, and a thickness of 5.0 µm or more can be formed without a support.

Since the photosensitive film in the present invention has positive-type or negative-type photosensitivity, a positive-type or negative-type pattern can be formed by performing development with an alkaline developer or an organic solvent after patterning exposure. The photosensitive film in the present invention is suitable for pattern formation on a substrate having an irregularity structure, formation of a hollow structure, or a dry film resist. The photosensitive film in the present invention is preferably a laminate disposed on a support. In the present invention, the laminate has a support and the photosensitive film in the present invention. Such a configuration is suitable from the viewpoint of handleability.

The support is preferably a flexible substrate from the viewpoint of improvement in adhesion property to the photosensitive film in the present invention, flexibility, and handleability. The flexible substrate is preferably a polyimide substrate, a polyphenylene sulfide substrate, a silicone substrate, an acrylic resin substrate, an epoxy resin substrate, a polyethylene terephthalate substrate, a polybutylene terephthalate substrate, a polyethylene naphthalate substrate, or a polycarbonate substrate. The support may be a rigid substrate. Examples of the rigid substrate include a glass substrate, a quartz substrate, a crystal substrate, and a sapphire substrate. The surface of the support on the photosensitive film side of the present invention may be subjected to a surface treatment with a silane coupling agent or the like from the viewpoint of improving adhesion property to the film and improving peelability. The thickness of the support is preferably 10 to 200 µm from the viewpoint of handleability.

### <Cured product and optical density, taper angle, and step shape of cured product>

The cured product of the present invention is an object obtained by curing the photosensitive composition of the present invention. Curing means that a cross-linked structure is formed by a reaction, and the fluidity of the film is lost, or a state thereof. The reaction is not particularly limited, but is preferably performed by heating, irradiation with an energy ray, or the like. A state in which a cross-linked structure is formed by heating and the fluidity of the film is lost is referred to as thermal curing. The heating condition is, for example, a condition of heating at 150°C to 500°C for 5 to 300 minutes. Examples of the heating method include a method for heating using an oven, a hot plate, infrared rays, a flash annealing device, or a laser annealing device. Examples of the treatment atmosphere include an air, oxygen, nitrogen, helium, neon, argon, krypton, or xenon atmosphere, a gas atmosphere containing 1 to 10,000 ppm by mass (0.0001% to 1% by mass) of oxygen, and a vacuum atmosphere.

In the cured film obtained by curing the photosensitive composition of the present invention, the optical density at a wavelength of visible light (380 to 780 nm) per film thickness of 1 um is preferably 0.5 to 5.0. From the viewpoint of suppressing external light reflection, preventing light leakage from an adjacent pixel, and improving the reliability of the light-emitting element, the optical density is preferably 0.5 or more, more preferably 0.7 or more, still more preferably 1.0 or more, even more preferably 1.2 or more, and particularly preferably 1.5 or more. On the other hand, the optical density is preferably 5.0 or less, more preferably 4.0 or less, still more preferably 3.0 or less, even more preferably 2.5 or less, and particularly preferably 2.0 or less from the viewpoint of improving the light emission luminance and improving the reliability of the light-emitting element. The optical density per film thickness of 1 um can be adjusted depending on the composition and content ratio of the colorant (D) described above. Here, the optical density refers to an optical density in a cured product obtained by heating the photosensitive composition of the present invention at 250°C for 60 minutes and curing the composition. As thermal curing conditions, the temperature is raised to 250°C at a temperature raising rate of 3.5°C/min in a nitrogen atmosphere having an oxygen concentration of 20 ppm by mass or less, heat treatment is performed at 250°C for 60 minutes, and then the temperature is cooled to 50°C. When the photosensitive composition contained a dye or when the photosensitive composition had positive-type photosensitivity, the thermosetting condition was a condition in which the temperature was raised to 200°C at a temperature raising rate of 3.5°C/min under a nitrogen atmosphere having an oxygen concentration of 20 ppm by mass or less, the heat treatment was performed at 200°C for 60 minutes, and then the temperature was cooled to 50°C. This thermal curing condition is common throughout the present specification unless otherwise specified. The taper angle of the inclined side in the cross section of the cured pattern contained in the cured film obtained by curing the photosensitive composition of the present invention is preferably 20° to 45° from the viewpoint of preventing electrode disconnection and improving the reliability of the light-emitting element in the display device.

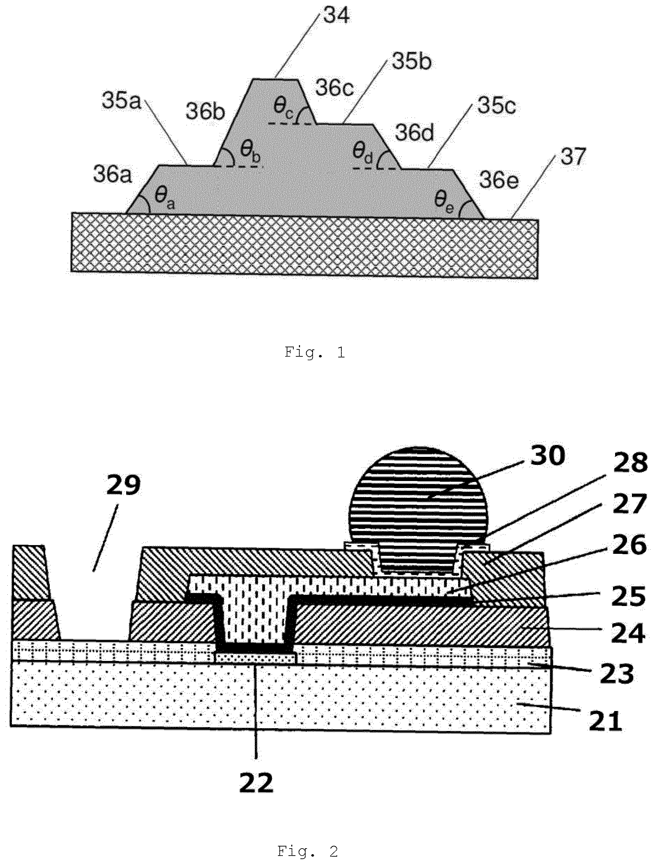

Fig. 1 illustrates an example of a cross section of a cured pattern having a step shape included in a cured film obtained by curing the photosensitive composition of the present invention. A thick film part 34 in the step shape corresponds to a cured part at the time of exposure, and has the maximum film thickness of the cured pattern. Thin film parts 35a, 35b, and 35c in the step shape correspond to halftone exposed portions at the time of exposure, and have film thicknesses smaller than the thickness of the thick film part 34. The respective taper angles θₐ, θ_{b}, θ_{c}, θ_{d}, and θₑ of inclined sides 36a, 36b, 36c, 36d, and 36e in the cross section of the cured pattern with the step shape preferably all have low tapers. The taper angles θₐ, θ_{b}, θ_{c}, θ_{d}, and θₑ herein refer to, as illustrated in Fig. 1, angles inside the cross section of the cured pattern with the step shape, which are made by a horizontal side 37 of the underlying substrate with the cured pattern formed, or the horizontal sides of the thin film parts 35a, 35b, and 35c, and the inclined sides 36a, 36b, 36c, 36d, and 36e in the cross section of the cured pattern with the step shape, which intersect the horizontal sides of the thin film parts 35a, 35b, and 35c. In this regard, the forward tapered shape means that the taper angle is within the range of more than 0° and less than 90°, and the inverse tapered shape means that the taper angle is within the range of more than 90° and less than 180°. Furthermore, the rectangular shape means that the taper angle is 90°, and the low-taper shape means that the taper angle is within the range of more than 0° to 60°. The taper angle of the inclined side in the cross section of the cured pattern having a step shape, which is contained in the cured film obtained by curing the photosensitive composition of the present invention, is the same as the preferable taper angle of the low-taper cured pattern described above.

In the thickness between the plane of the lower surface (the horizontal side 37 side of the underlying substrate) and the plane of the upper surface of the cured pattern having a step shape, which is included in the cured film obtained by curing the photosensitive composition of the present invention, a region having the largest thickness is referred to as a thick film part 34, and regions having a thickness smaller than the thickness of the thick film part 34 are referred to as thin film parts 35a, 35b, and 35c. In a case where the film thickness of the thick film part 34 is denoted by (T_{FT}) um, whereas the film thicknesses of the thin film parts 35a, 35b, and 35c disposed on the thick film part 34 with at least one step shape interposed therebetween are denoted by (T_{HT}) µm, each film thickness difference (ΔT_{FT-HT}) um between (T_{FT}) and (T_{HT}) is preferably 0.5 um or more, more preferably 1.0 um or more, still more preferably 1.5 µm or more, even more preferably 2.0 µm or more, particularly preferably 2.5 um or more, most preferably 3.0 µm or more. All of them are preferably 0.5 µm or more, more preferably 1.0 um or more, still more preferably 1.5 um or more, even more preferably 2.0 um or more, particularly preferably 2.5 µm or more, and most preferably 3.0 um or more. The film thickness difference (ΔT_{FT-HT}) um between (T_{FT}) and the film thickness (T_{HT}) of the thin film part 35a or 35b is more preferably in the above range, and the film thickness difference (ΔT_{FT-HT}) um between (T_{FT}) and the film thickness (T_{HT}) of the thin film part 35a is still more preferably in the above range. When the film thickness difference is 0.5 µm or more, the effect of improving the reliability of the light-emitting element in the display device becomes remarkable. When the film thickness difference is 1.5 µm or more, the contact area with the deposition mask at the time of forming the light-emitting layer can be reduced, so that the effects of suppressing a decrease in the yield of the panel and improving the reliability of the light-emitting element in the display device are remarkable. In addition, since one cured pattern layer having a step shape has a sufficient film thickness difference, the effect of reducing the process time and improving the productivity becomes remarkable. On the other hand, the film thickness difference (ΔT_{FT-HT}) um is preferably 10.0 um or less, more preferably 9.5 um or less, still more preferably 9.0 um or less, even more preferably 8.5 um or less, particularly preferably 8.0 um or less. When the film thickness difference is 10.0 µm or less, the exposure energy at the time of forming a cured pattern having a step shape can be reduced, so that the effect of reducing the process time and improving the productivity becomes remarkable.

The cured product of the present invention is obtained by curing a photosensitive composition, and when the cured product has a cured pattern having a step shape, and the film thickness of the thick film part 34 in the step shape of the cured pattern is denoted by (T_{FT}) µm and the film thickness of the thin film parts 35a, 35b, and 35c is denoted by (T_{HT}) µm, it is preferable that the film thickness (T_{FT}) um of the thick film part 34 and the film thickness (T_{HT}) um of the thin film parts 35a, 35b, or 35c satisfy all of the relationships represented by the formulae (α) to (γ), it is more preferable that (T_{FT}) um of the thick film part 34 and the film thickness (T_{HT}) um of the thin film part 35a or 35b satisfy all of the relationships represented by the formulae (α) to (γ), and it is still more preferable that (T_{FT}) um of the thick film part 34 and the film thickness (T_{HT}) um of the thin film part 35a satisfy all of the relationships represented by formulae (α) to (γ). It is also preferable that (T_{FT}) um of the thick film part 34 and the film thicknesses (T_{HT}) µm of all of the thin film parts 35a, 35b, and 35c satisfy all of the relations represented by the formulae (α) to (γ). $2.0 \leq \left({T}_{FT}\right) \leq 10.0 \left(α\right)$ $0.20 \leq \left({T}_{HT}\right) \leq 7.5 \left(β\right)$ $0.10 \times \left({T}_{FT}\right) \leq \left({T}_{HT}\right) \leq 0.75 \times \left({T}_{FT}\right) \left(γ\right) .$

It is preferable that the film thickness (T_{FT}) um of the thick film part 34 and the film thickness (T_{HT}) um of the thin film parts 35a, 35b, or 35c more satisfy all of the relationships represented by the formulae (δ) to (ζ), it is more preferable that the film thickness (T_{FT}) um of the thick film part 34 and the film thickness (T_{HT}) um of the thin film part 35a or 35b satisfy all of the relationships represented by the formulae (δ) to (ζ), and it is still more preferable that the film thickness (T_{FT}) µm of the thick film part 34 and the film thickness (T_{HT}) µm of the thin film part 35a more satisfy all of the relationships represented by formulae (δ) to (ζ). It is also preferable that (T_{FT}) um and the film thicknesses (T_{HT}) um of all of the thin film parts 35a, 35b, and 35c further satisfy all of the relations represented by the formulae (δ) to (ζ). $2.0 \leq \left({T}_{FT}\right) \leq 10.0 \left(δ\right)$ $0.30 \leq \left({T}_{HT}\right) \leq 7.0 \left(ε\right)$ $0.15 \times \left({T}_{FT}\right) \leq \left({T}_{HT}\right) \leq 0.70 \times \left({T}_{FT}\right) \left(ζ\right) .$

When the film thickness (T_{FT}) um of the thick film part 34 and the film thicknesses (T_{HT}) um of the thin film parts 35a, 35b, and 35c are within the above-described ranges, the effects of suppressing a decrease in panel yield and improving the reliability of the light-emitting element in the display device become remarkable. In addition, the effect of reducing the process time and improving the productivity becomes remarkable.

### <Contact angle on pattern surface having step shape of pixel defining layer>

In a case where the cured film obtained by curing the photosensitive composition of the present invention is a pixel defining layer of an organic EL display, when a contact angle of a thick film part with respect to pure water is denoted by (CAw_{FT}) ° and a contact angle of a thin film part with respect to pure water is denoted by (CAw_{HT}) ° in a cured film including a pattern having the above-described step shape, a contact angle difference (ΔCAw_{FT-HT})° between the (CAw_{FT})° and the (CAw_{HT})° is preferably 20° or more, and more preferably 40° or more, from the viewpoint of suppressing color mixture between inks in a case where an organic EL layer is formed by inkjet coating. On the other hand, from the viewpoint of suppressing film formation defects of the organic EL layer, the contact angle difference (ΔCAw_{FT-HT})° with respect to pure water is preferably 90° or less, and more preferably 70° or less. The contact angle difference (ΔCAw_{FT-HT})° between (CAw_{FT})° and the contact angle (CAw_{HT})° of the thin film part 35a, 35b, or 35c with respect to pure water is preferably in the above range, the contact angle difference (ΔCAw_{FT-HT})° between (CAw_{FT})° and the contact angle (CAw_{HT})° of the thin film part 35a or 35c with respect to pure water is more preferably in the above range, and the contact angle difference (ΔCAw_{FT-HT})° between (CAw_{FT})° and the contact angle (CAw_{HT})° of the thin film part 35a with respect to pure water is still more preferably in the above range. It is also preferable that all contact angle differences (ΔCAw_{FT-HT})° between (CAw_{FT})° and contact angles (CAw_{HT})° of the thin film parts 35a, 35b, and 35c with respect to pure water are within the above range.

In a case where the cured film obtained by curing the photosensitive composition of the present invention is a pixel defining layer of an organic EL display, when a contact angle of a thick film part with respect to propylene glycol monomethyl ether acetate is denoted by (CAp_{FT})° and a contact angle of a thin film part with respect to propylene glycol monomethyl ether acetate is denoted by (CAp_{HT})° in a cured film including a pattern having the above-described step shape, a contact angle difference (ΔCAp_{FT-HT})° between the (CAp_{FT})° and the (CAp_{HT})° is preferably 10° or more, and more preferably 30° or more, from the viewpoint of suppressing color mixture between inks in a case where an organic EL layer is formed by inkjet coating. On the other hand, from the viewpoint of suppressing film formation defects of the organic EL layer, the contact angle difference (ΔCAp_{FT-HT})° with respect to propylene glycol monomethyl ether acetate is preferably 70° or less, and more preferably 50° or less.

### <Element and article including cured product>

In the present invention, an element includes the cured product of the present invention. In addition, in the present invention, the article includes the cured product of the present invention. Examples of the article include an electronic component, an electronic device, a moving body, a building, and a window. Examples of the electronic component include a semiconductor device, an antenna, a display device, a metal-clad laminate, a wiring board, a semiconductor package, an active component including a semiconductor device, and a passive component. Examples of the semiconductor device include a transistor, a diode, an integrated circuit, a processor, and a memory. Examples of the passive component include a resistor, a capacitor, and an inductor. Examples of the electronic device include an industrial device, a medical device, and a building device. Examples of the moving body include a vehicle, a railway, an airplane, and a heavy machine. Examples of the building include a house, a store, an office, a building, and a factory. Examples of the window include an electronic device window, a moving body window, and a building window.

The photosensitive composition of the present invention is preferably used for formation of an electronic component. The photosensitive composition of the present invention is also preferably used for formation of one or more selected from the group consisting of a semiconductor device, an antenna, a display device, and a metal-clad laminate.

Examples of the semiconductor device include a semiconductor device having a fan-out wafer level package structure, a fan-out panel level package structure, or an antenna-in-package structure. Examples of the antenna include a microstrip line antenna, a strip line antenna, a coplanar line antenna, and a grounded coplanar line (Conductor Back Coplanar; CBC) antenna, a substrate integrated waveguide (SIW) antenna, a post wall waveguide (PWW) antenna, a parallel bilinear line (Coplanar Strip; CPS) antenna or a slot line antenna. Examples of the display device include an organic EL display, a quantum dot display, a micro light emitting diode (hereinafter, referred to as "micro LED") display, a mini LED display, and a liquid crystal display. Examples of the metal-clad laminate include a printed circuit board.

The electronic component of the present invention includes the cured product of the present invention. The cured product of the present invention can have both excellent mechanical properties and high migration resistance even when heated at a low temperature. Therefore, the photosensitive composition of the present invention is preferably used for forming an insulation layer of a metal wiring, a protective layer of a metal wiring, or an interlayer insulation layer of a metal wiring in an electronic component.

In the present invention, a semiconductor device, an antenna, a display device, and a metal-clad laminate include the cured product of the present invention. For the same reason as described above, the photosensitive composition of the present invention is also preferably used for forming an interlayer insulation layer of rewiring in a semiconductor device, is also preferably used for forming an insulation layer of metal wiring in an antenna, a protective layer of metal wiring, or an interlayer insulation layer of metal wiring and ground wiring, is also preferably used for forming a pixel defining layer, a planarization layer of TFT, a protective layer of TFT, an interlayer insulation layer of TFT, or a gate insulation layer in an organic EL display, a quantum dot display, or a microLED display, and is also preferably used for forming an insulation layer of metal wiring in a metal-clad laminate, a protective layer of metal wiring, or a solder resist layer of metal wiring.

Application Example in which the cured product of the present invention is used to a semiconductor device having a bump will be described with reference to the drawings. Fig. 2 is a schematic sectional view illustrating an enlarged section of a pad portion of a semiconductor device having a bump. On an Al pad 22 for input and output formed on a Si wafer 21, a passivation layer 23 is formed, and a via hole is formed in the passivation layer 23. On the passivation layer 23, an insulation layer 24 which is a patterned cured product of the present invention is formed, a metal layer 25 made of Cr, Ti or the like is formed so as to be connected to the Al pad 22, and a metal wiring 26 made of Al, Cu, or the like is formed by electrolytic plating or the like. By etching the metal layer 25 around a solder bump 30, insulation is established between the pads. A barrier metal layer 28 and the solder bump 30 are formed for the insulated pad. The insulation layer 27 is a cured product of a patterned photosensitive composition, and is preferably the cured product of the present invention. The photosensitive composition for forming the insulation layer 27 can form a pattern with a thick film in formation of a scribe line 29. When the insulation layer 24 and/or the insulation layer 27 is the cured product of the present invention, since the mechanical properties are excellent in heating at a low temperature, warpage of the wafer is suppressed, and the effect of improving the accuracy of processes such as exposure and conveyance of the wafer becomes remarkable. In addition, since the stress of the sealing resin at the time of mounting the semiconductor can be alleviated, the damage of a low-k layer is suppressed, and the effect of improving the reliability of the semiconductor device becomes remarkable.

### <Hollow structure>

In the present invention, the hollow structure includes the cured product of the present invention. The electronic component of the present invention preferably has the hollow structure of the present invention. The hollow structure in the present invention includes a hollow structure support member and a hollow structure roof member. The hollow structure support member and the hollow structure roof member are preferably the cured product of the present invention. The hollow structure support member and the hollow structure roof member preferably contain the polyimide-based resin from the viewpoint of improving the heat resistance and the reliability. The film thickness of the hollow structure support member is preferably 5 to 20 um. The film thickness of the hollow structure roof member is preferably 10 to 50 µm.

The photosensitive composition of the present invention is preferably used for forming a hollow structure, and more preferably used for forming a hollow structure support member and/or a hollow structure roof member. The photosensitive film of the present invention is more suitable for forming a hollow structure, further suitable for forming a hollow structure support member and/or a hollow structure roof member, and particularly suitable for forming a hollow structure roof member. Examples of the electronic component having a hollow structure include micro electro mechanical systems (MEMS). Examples of the MEMS include a sensor, a noise filter, a surface acoustic wave (SAW) filter, and a bulk acoustic wave (BAW) filter.

### <Display device including cured product of the present invention>

Hereinafter, a display device including the cured product of the present invention will be described. Examples of the display device of the present invention include an organic EL display, a quantum dot display, a micro LED display, an LED display, a liquid crystal display, a plasma display, and a field emission display. The display device of the present invention is preferably an organic EL display, a quantum dot display, or a micro LED display, and more preferably an organic EL display.

The photosensitive composition of the present invention is able to have improved sensitivity at the time of exposure, suppressed narrow mask bias of the opening pattern dimension after development, and excellent halftone characteristics. In addition, the reliability of the light-emitting element in the display device can be improved. Therefore, the cured film obtained by curing the photosensitive composition of the present invention under the curing conditions described above is particularly preferable as a pixel defining layer, a TFT planarization layer, a TFT protective layer, an interlayer insulation layer, or a gate insulation layer of an organic EL display. A black matrix or a black column spacer is also preferable. The cured film can be particularly suitably included in the organic EL display. As a result, the durability of the organic EL display can be improved by the high reliability of the light-emitting element. For the reasons described above, the photosensitive composition of the present invention is particularly suitable in applications for forming a pixel defining layer in an organic EL display. Furthermore, since the film has suppression of a narrow mask bias of an opening pattern dimension after development and excellent halftone characteristics, the film is particularly suitable in applications for collectively forming a step shape of a pixel defining layer in the organic EL display.

More specifically, the photosensitive composition according to the present invention is preferably used for collectively forming the step shape of the pixel defining layer in the organic EL display.

In the photosensitive composition of the present invention, when the colorant (D) contains the black colorant (Da), external light reflection can be suppressed by improving the light-shielding property of the cured film as described above. Therefore, a display device including a cured film obtained by curing the photosensitive composition of the present invention can suppress external light reflection even without having a polarizing film such as a linear polarizing plate, a 1/4 wavelength plate, or a circularly polarizing plate on the light extraction side of a light-emitting element. Therefore, it can be particularly suitably included in a flexible display device having a structure in which a cured film is stacked on a flexible substrate and having no polarizing film. The flexible substrate is preferably a polyimide substrate, a polyethylene terephthalate substrate, a cycloolefin polymer substrate, a polycarbonate substrate, or a cellulose triacetate substrate. The display device having flexibility preferably includes a curved display unit, a display unit bendable outward, or a display unit bendable inward.

A display device according to a first aspect of the present invention includes the cured product of the present invention. The first aspect of the display device of the present invention is a display device including at least a substrate, a first electrode, a second electrode, and a pixel defining layer, and further including an organic EL layer including a light-emitting layer and/or a light extraction layer including a light-emitting layer, in which the pixel defining layer is formed so as to overlap a part of the first electrode, and the organic EL layer including a light-emitting layer and/or the light extraction layer including a light-emitting layer preferably has a stacking structure formed on the first electrode and between the first electrode and the second electrode. In the display device according to the first aspect of the present invention, the pixel defining layer is preferably the cured product of the present invention. The first aspect of the display device of the present invention is preferably an organic EL display.

### <Display device>

Hereinafter, a second aspect of the display device of the present invention will be described.

A display device according to the second aspect of the present invention includes at least a substrate, a first electrode, a second electrode, and a pixel defining layer, and further including an organic EL layer including a light-emitting layer and/or a light extraction layer including a light-emitting layer, the pixel defining layer is formed so as to overlap a part of the first electrode, the organic EL layer including the light-emitting layer and/or the light extraction layer including the light-emitting layer are formed on the first electrode and between the first electrode and the second electrode, the pixel defining layer includes a colorant (D-DL), and optical density of the pixel defining layer at a wavelength of visible light per 1 um of film thickness is 0.5 to 5.0, the pixel defining layer contains a resin having a weakly acidic group (WA) below, a resin having a weakly acidic group (WA) contains one or more selected from the group consisting of a resin (XA3-1), a resin (XA3-2), a resin (XA3-3), and a resin (XA3-4) below, and the display device satisfies conditions (1x) and/or (2x) below:
the weakly acidic group (WA): one or more groups selected from the group consisting of a phenolic hydroxyl group, a hydroxyimide group, a hydroxyamide group, a silanol group, a 1,1-bis(trifluoromethyl) methylol group, and a mercapto group;
the resin (XA3-1): a phenol resin;
the resin (XA3-2): polyhydroxystyrene;
the resin (XA3-3): a phenol group-containing epoxy resin;
the resin (XA3-4): a phenol group-containing acrylic resin; (1x) when a maximum value of a surface roughness of a surface of a thin film part in a step shape of the pixel defining layer is represented by (Ra_{HT/max}) and a maximum value of a surface roughness of a surface of a thick film part in a step shape of the pixel defining layer is represented by (Ra_{FT/max}), a difference |Δ (Ra_{HT/max} - Ra_{FT/max})| between (Ra_{HT/max}) and (Ra_{FT/max}) is 1.0 to 50.0 nm; and
(2x) when (Ra_{DL/max}) is a maximum value of surface roughness on a surface of the pixel defining layer, and (Ra_{SP/max}) is a maximum value of surface roughness on a surface of a spacer layer on the pixel defining layer, a difference |Δ(Ra_{DL/max} - Ra_{SP/max})| between (Ra_{DL/max}) and (Ra_{SP/max}) is 1.0 to 50.0 nm.

With the above configuration, the present invention can improve the reliability of the light-emitting element. This is considered to be because when the pixel defining layer contains a resin having a specific weakly acidic group (WA) and a specific resin having a phenolic hydroxyl group, the roughness of the film surface during pattern formation of the pixel defining layer can be reduced. For example, in order to impart a light-shielding property to the pixel defining layer, when the pixel defining layer contains a colorant (D-DL) and the optical density at the wavelength of visible light is within a specific range, the roughness of the film surface may be significantly deteriorated by a pigment or the like in the pixel defining layer. The remarkable deterioration of roughness on the surface of the pixel defining layer may cause deterioration of reliability due to electric field concentration in a cathode (cathode) formed on the pixel defining layer or occurrence of a defect in a sealing step, or may cause non-lighting of the pixel due to electrode disconnection or electrode short circuit. In the present invention, even when the pixel defining layer contains the colorant (D-DL) and the optical density at the wavelength of visible light is within a specific range, the effect of the present invention is achieved by containing the above-described specific resin.

That is, when the photosensitive composition for forming the pixel defining layer has negative-type photosensitivity, it is considered that the film loss of the exposed portion is suppressed by the mild acidity of the resin having a specific weakly acidic group (WA). In addition, it is presumed that excessive radicals generated at the time of pattern exposure are stabilized by a specific resin having a phenolic hydroxyl group, and excessive photo-curing in an exposed portion is controlled by the phenolic hydroxyl group, so that reflow property during thermal curing is improved. Since the roughness on the surface of the pixel defining layer is reduced by these actions, the effect of the present invention is achieved by satisfying the conditions (1x) and/or (2x).

In addition, when the photosensitive composition for forming the pixel defining layer has positive-type photosensitivity, it is considered that the film loss of the unexposed portion is suppressed by the mild acidity of the resin having a specific weakly acidic group (WA). In addition, it is presumed that an excessive cross-linking reaction during thermal curing is suppressed by n-bond stacking of a specific resin having a phenolic hydroxyl group, and thus reflow property during thermal curing is improved. Since the roughness on the surface of the pixel defining layer is reduced by these actions, the effect of the present invention is achieved by satisfying the conditions (1x) and/or (2x).

### <Substrate>

A first aspect of the display device of the present invention preferably includes a substrate. A second aspect of the display device of the present invention includes a substrate. The substrate is preferably a glass substrate from the viewpoint of improving impact resistance. As the substrate, for example, a substrate is used which has an oxide including one or more selected from indium, tin, zinc, aluminum, and gallium, a metal (for example, molybdenum, silver, copper, aluminum, chromium, or titanium), or a CNT (Carbon Nano Tube) formed as an electrode or a wiring on a glass. The substrate is preferably a flexible substrate such as a polyimide substrate from the viewpoint of improving the bendability.

### <First electrode and second electrode>

The first aspect of the display device of the present invention preferably includes a first electrode and a second electrode. The second aspect of the display device of the present invention includes a first electrode and a second electrode. By combining a transparent electrode and a non-transparent electrode as the first electrode and the second electrode, light emission in the light-emitting layer described later can be extracted to one side. In the display device of the present invention, the transparent electrode and the non-transparent electrode are required to have composite characteristics such as excellent electrical characteristics, efficient injection of holes when used as an anode, and efficient injection of electrons when used as a cathode.

The display device of the present invention preferably has a transparent conductive oxide film layer containing one or more selected from the group consisting of indium, tin, zinc, aluminum, and gallium on the outermost layer on the light-emitting layer side of the first electrode described above, more preferably has a transparent conductive oxide film layer containing at least indium, and still more preferably has an amorphous transparent conductive oxide film layer containing at least indium. The transparent conductive oxide film layer containing at least indium is preferably indium tin oxide (ITO) or indium zinc oxide (IZO), and more preferably ITO, from the viewpoint of driving the light-emitting characteristics at a low voltage by adjusting the work function difference.

The first electrode has a single-layer structure or a multilayer structure. When the first electrode has a single-layer structure, the first electrode is a transparent electrode, and a transparent conductive oxide film layer containing indium is preferable. When the first electrode has a multilayer structure, the first electrode is preferably a transparent electrode or a non-transparent electrode, and preferably has a transparent conductive oxide film layer containing at least indium on the outermost layer on the light-emitting layer side of the first electrode. The second electrode is a single-layered transparent electrode, a multilayered transparent electrode, a single-layered non-transparent electrode, or a multilayered non-transparent electrode. When the first electrode described above is a transparent electrode, the second electrode is a non-transparent electrode. On the other hand, when the first electrode is a non-transparent electrode, the second electrode is a transparent electrode. In the display device of the present invention, it is preferable that the above-described first electrode has a multilayer structure including at least a transparent conductive oxide film layer and a non-transparent conductive metal layer, the first electrode has an amorphous conductive oxide film layer containing at least indium on the outermost layer on the light-emitting layer side of the first electrode, and the non-transparent conductive metal layer has an alloy layer containing at least silver, and has a top emission type configuration.

### <Pixel defining layer>

A first aspect of the display device of the present invention preferably includes a pixel defining layer. The pixel defining layer is preferably formed so as to overlap with a part of the first electrode described above.

A second aspect of the display device of the present invention includes a pixel defining layer, and the pixel defining layer is formed so as to overlap a part of the first electrode.

The pixel defining layer is preferably a cured film obtained by curing the above-described photosensitive composition. By forming the pixel defining layer so as to partially overlap the first electrode, it is possible to insulate the first electrode of an optional pixel from a second electrode to be described later of the pixel, and it is possible to suppress pixel non-lighting due to a short circuit between the first electrode and the second electrode. Furthermore, the first electrode of an optional pixel and the first electrode of a pixel adjacent to the pixel can be insulated, and non-lighting of the pixel due to a short circuit between the first electrodes can be suppressed.

### <Resin, compound, colorant, and inorganic particles in pixel defining layer>

In the display device of the present invention, from the viewpoint of improving the reliability and migration resistance of the light-emitting element in the display device, the above-described pixel defining layer preferably contains a resin (XA1) (hereinafter, referred to as "resin (XA1)") having a structural unit containing one or more selected from the group consisting of an imide structure, an amide structure, an oxazole structure, and a siloxane structure. The resin (XA1) preferably has one or more selected from the group consisting of an imide structure, an amide structure, an oxazole structure, and a siloxane structure in a structural unit in a main chain of the resin. These resins are preferably resins having a structure derived from the above-described resin (A1) and/or a structure derived from the above-described resin (A2). The pixel defining layer preferably has one or more selected from the group consisting of the structural unit represented by any of the general formulae (1), (2), (3), (4), (5), (6), (9), and (10) described above, and more preferably has the structural unit represented by the general formula (1) and/or the structural unit represented by the general formula (5).

In the display device of the present invention, from the viewpoint of improving the reliability of the light-emitting element in the display device, the above-described pixel defining layer preferably contains a resin (XA3) (hereinafter, referred to as "resin (XA3)") having a structural unit containing a phenolic hydroxyl group. These resins are preferably resins having one or more selected from the group consisting of a structure derived from the resin (A3) described above, a structure derived from the resin (A1) described above, and a structure derived from the resin (A2) described above. The pixel defining layer preferably has one or more selected from the group consisting of structural units represented by any of the general formulae (36), (91), and (92) described above, and more preferably has a structural unit represented by the general formula (36). It is preferable that these resins have a phenolic hydroxyl group as an alkali-soluble group on at least one of the main chain of the resin, the side chain of the resin, and the end of the resin, and have an aromatic ring skeleton in the structural unit of the resin, and it is more preferable that these resins have a phenolic hydroxyl group as an alkali-soluble group in the structural unit in the main chain of the resin and have an aromatic ring skeleton. It is also preferable that some of the phenolic hydroxyl groups contained in the resin react with other resins or compounds to form a cross-linked structure.

In the display device of the present invention, from the viewpoint of improving the reliability of the light-emitting element in the display device, the above-described pixel defining layer preferably contains a resin (XA2) (hereinafter, referred to as "resin (XA2)") having a reaction residue of a radical polymerizable group. These resins are preferably resins having a structure derived from the above-described resin (A2) and/or a structure derived from the above-described resin (A3). The pixel defining layer preferably has one or more selected from the group consisting of structural units represented by any of (1), (2), (3), (4), (5), (6), (9), (10), (41), (61), (62), (63), (81), and (82) described above, more preferably has one or more selected from the group consisting of structural units represented by any of the general formulae (1), (2), (3), (4), (5), (6), (9), and (10), and still more preferably has one or more selected from the group consisting of structural units represented by any of the general formulae (1), (2), (3), (4), (5), and (6).

It is more preferable that the pixel defining layer contains the resin (XA1) and/or the resin (XA3), and further contains the resin (XA2). When the pixel defining layer includes these resins, the effect of improving the reliability and migration resistance of the light-emitting element in the display device becomes remarkable.

In the display device of the present invention, from the viewpoints of improving the contrast of the display device by improving the light-shielding property, improving the reliability of the light-emitting element in the display device, and driving the light-emitting element at a low voltage, the pixel defining layer described above preferably further contain one or more selected from the group consisting of (hereinafter, referred to as "compound having a phosphoric acid-based structure") a phosphate ester structure-containing compound, a phosphonic acid structure-containing compound, a phosphonic acid ester structure-containing compound, a phosphite ester structure-containing compound, a phosphinic acid structure-containing compound, a phosphinic acid ester structure-containing compound, a hypophosphite ester structure-containing compound, a phosphoric acid betaine ester structure-containing compound, a phosphonic acid betaine structure-containing compound, a phosphonic acid betaine ester structure-containing compound, a phosphinic acid betaine ester structure-containing compound, a phosphite betaine structure-containing compound, a phosphinic acid betaine ester structure-containing compound, and a hypophosphorous acid betaine ester structure-containing compound.

The compound having a phosphoric acid-based structure more preferably contains one or more selected from the group consisting of a phosphonic acid structure-containing compound, a phosphonic acid ester structure-containing compound, and a phosphite ester structure-containing compound, and further preferably contains a phosphonic acid structure-containing compound and/or a phosphonic acid ester structure-containing compound. The compound having a phosphoric acid-based structure is preferably a compound having a structure derived from the above-described compound (F0) and/or a compound having a structure derived from the compound (FB), and more preferably a compound having a structure derived from the above-described compound (F1) and/or a compound having a structure derived from the compound (FB1).

In the display device according to the first aspect of the present invention, the pixel defining layer described above preferably further contains a colorant (D). In a second aspect of the display device of the present invention, the pixel defining layer contains a colorant (D-DL). The colorant (D-DL) contained in the pixel defining layer is more preferably a black colorant (Da). When the pixel defining layer contains the black colorant (Da), the effects of improving the contrast of the display device by improving the light-shielding property and improving the reliability of the light-emitting element in the display device become remarkable.

In the display device of the present invention, the above-described pixel defining layer preferably further contains the black pigment (D1a). In the pixel defining layer, the black pigment (D1a) more preferably contains the specific organic black pigment (D1a-1) described above, and further preferably contains the benzofuranone-based black pigment (D1a-1a). The above-described pixel defining layer preferably contains one or more selected from the group consisting of a compound having a structure represented by any of general formulae (161) and (162), a geometric isomer thereof, and a salt thereof, and a salt of the geometric isomer thereof; a compound having a structure represented by any of general formulae (164), (165) and (166), and a salt thereof; and a compound having a structure represented by the general formula (168) and a salt thereof. The pixel defining layer described above more preferably contains a compound having a structure represented by any of general formulae (161) and (162).

In the first aspect of the display device of the present invention, the optical density at the wavelength of visible light per 1 um of the film thickness of the pixel defining layer is preferably 0.5 to 5.0. In the second aspect of the display device of the present invention, the optical density at the wavelength of visible light per 1 µm of the film thickness of the pixel defining layer is 0.5 to 5.0.

From the viewpoint of suppressing external light reflection, preventing light leakage from an adjacent pixel, and improving the reliability of the light-emitting element, the optical density is preferably 0.5 or more, more preferably 0.7 or more, still more preferably 1.0 or more, even more preferably 1.2 or more, and particularly preferably 1.5 or more. On the other hand, the optical density is preferably 5.0 or less, more preferably 4.0 or less, still more preferably 3.0 or less, even more preferably 2.5 or less, and particularly preferably 2.0 or less from the viewpoint of improving the light emission luminance and improving the reliability of the light-emitting element. Here, the optical density of the pixel defining layer is as described above regarding the optical density of the cured film obtained by curing the photosensitive composition of the present invention.

In the display device of the present invention, the above-described pixel defining layer preferably further contains inorganic particles from the viewpoint of improving the reliability and migration resistance of the light-emitting element. The inorganic particles in the pixel defining layer are more preferably silica particles, alumina particles, titania particles, vanadium oxide particles, chromium oxide particles, ferric oxide particles, cobalt oxide particles, copper oxide particles, zinc oxide particles, zirconium oxide particles, niobium oxide particles, tin oxide particles, or cerium oxide particles, and silica particles are preferable. The inorganic particles in the pixel defining layer are preferably the inorganic particles (I) described above, and the silica particles in the pixel defining layer are preferably the silica particles (I1) described above.

The average primary particle size of the silica particles in the pixel defining layer is preferably 5.0 nm or more, more preferably 7.0 nm or more, and still more preferably 10 nm or more, from the viewpoint of improving the reliability of the light-emitting element, and improving the migration resistance. On the other hand, the average primary particle size of the silica particles in the pixel defining layer is preferably 200 nm or less, more preferably 100 nm or less, and still more preferably 70 nm or less, from the viewpoint of suppressing external light reflection, and improving the reliability of the light-emitting element. Furthermore, it is preferably 50 nm or less, more preferably 40 nm or less, still more preferably 30 nm or less, even more preferably 25 nm or less, particularly preferably 20 nm or less, and most preferably 15 nm or less.

In addition, the average primary particle size of the silica particles in the pixel defining layer is preferably more than 0.20 um, more preferably 0.30 um or more, and still more preferably 0.50 um or more from the viewpoint of increasing the elastic modulus and decreasing the thermal expansion coefficient. On the other hand, the average primary particle size of the silica particles in the pixel defining layer is preferably 100 µm or less, more preferably 50 um or less, still more preferably 30 um or less, even more preferably 10 um or less, particularly preferably 5.0 µm or less, and most preferably 3.0 um or less from the viewpoint of improving migration resistance. The primary particle size of the silica particles in the pixel defining layer refers to the major axis size of the primary particles of the silica particles in the pixel defining layer.

### <Specific resin in pixel defining layer>

In a second aspect of the display device of the present invention, the pixel defining layer contains a resin having the following weakly acidic group (WA).

Weakly acidic group (WA): one or more groups selected from the group consisting of a phenolic hydroxyl group, a hydroxyimide group, a hydroxyamide group, a silanol group, a 1,1-bis(trifluoromethyl) methylol group, and a mercapto group.

These resins are preferably resins having one or more selected from the group consisting of a structure derived from the resin (A1) described above, a structure derived from the resin (A2) described above, and a structure derived from the resin (A3) described above. Examples and preferable descriptions concerning the resin having a weakly acidic group (WA) in the pixel defining layer are as in the examples and preferable descriptions concerning the resin (XA1), the resin (XA2), and the resin (XA3).

In a second aspect of the display device of the present invention, the resin having a weakly acidic group (WA) in the pixel defining layer includes one or more selected from the group consisting of the following resin (XA3-1), resin (XA3-2), resin (XA3-3), and resin (XA3-4).
Resin (XA3-1): Phenol resin
Resin (XA3-2): Polyhydroxystyrene
Resin (XA3-3): Phenol group-containing epoxy resin
Resin (XA3-4): Phenol group-containing acrylic resin.

These resins are preferably resins having a structure derived from the above-described resin (A3). Examples and preferable descriptions concerning the resin (XA3-1), the resin (XA3-2), the resin (XA3-3), and the resin (XA3-4) in the pixel defining layer are as in the examples and preferable descriptions concerning the resin (XA3).

### <Spacer layer>

In the display device of the present invention, preferably, the pixel defining layer has a cured pattern, and a spacer layer is provided on a part of the pixel defining layer, and a film thickness (T_{SP}) um of the spacer layer is 0.5 to 10.0 um. With such a configuration, a spacer layer having a sufficient height can be formed by photolithography. Since the spacer layer is included, the effect of suppressing the decrease in the yield of the panel and improving the reliability of the light-emitting element becomes remarkable by suppressing the damage of the pixel defining layer.

In the display device of the present invention, the film thickness (T_{SP}) µm of the spacer layer is preferably 0.5 um or more, more preferably 1.0 um or more, still more preferably 1.5 µm or more, even more preferably 2.0 µm or more, particularly preferably 2.5 µm or more, and most preferably 3.0 um or more. On the other hand, the film thickness (T_{SP}) µm of the spacer layer is preferably 10.0 um or less, more preferably 9.0 µm or less, and still more preferably 8.0 um or less.

In the display device of the present invention, when the pixel defining layer includes a cured pattern having a step shape, and in the step shape of the cured pattern of the pixel defining layer, the film thickness of the thick film part is denoted by (T_{FT}) um, and the film thickness of the thin film part is denoted by (T_{HT}) µm, it is preferable that a film thickness difference (ΔT_{FT-HT}) um between (T_{FT}) um and (T_{HT}) µm is 0.5 to 10.0 um, a spacer layer is provided on a part of the pixel defining layer, and the film thickness (T_{SP}) um of the spacer layer is 0.5 to 10.0 um. With such a configuration, a spacer layer having a sufficient height can be formed by photolithography. Therefore, the effect of suppressing the decrease in the yield of the panel and improving the reliability of the light-emitting element becomes remarkable.

Examples and preferable descriptions regarding the resin, the compound, the colorant, and the inorganic particles of the spacer layer are the same as the examples and preferable descriptions regarding the resin, the compound, the colorant, and the inorganic particles of the pixel defining layer described above.

### <Maximum value of surface roughness on surfaces of pixel defining layer and spacer layer>

A second aspect of the display device of the present invention satisfies the following conditions (1x) and/or (2x) .

(1x) When a maximum value of a surface roughness of a surface of a thin film part in a step shape of the pixel defining layer is represented by (Ra_{HT/max}) and a maximum value of a surface roughness of a surface of a thick film part in a step shape of the pixel defining layer is represented by (Ra_{FT/max}), a difference |Δ(Ra_{HT/max} - Ra_{FT/max})| between (Ra_{HT/max}) and (Ra_{FT/max}) is 1.0 to 50.0 nm

(2x) When (Ra_{DL/max}) is a maximum value of surface roughness on a surface of the pixel defining layer, and (Ra_{SP/max}) is a maximum value of surface roughness on a surface of a spacer layer on the pixel defining layer, a difference |Δ(Ra_{DL/max} - Ra_{SP/max})| between (Ra_{DL/max}) and (Ra_{SP/max}) is 1.0 to 50.0 nm.

In the display device of the present invention, by setting the maximum value of the surface roughness on the surface of the pixel defining layer within the above-described range, the reliability of the light-emitting element can be improved, and the effect of suppressing external light reflection becomes remarkable. It is presumed that this is because specular reflection light having a large contribution to glare and reflection in visibility can be reduced by increasing diffusely reflected light on the surface of the pixel defining layer.

In the display device of the present invention, when the pixel defining layer includes a cured pattern having a step shape, it is preferable to satisfy the condition (1x). The |Δ(Ra_{HT/max} - Ra_{FT/max})| is preferably 1.0 nm or more, more preferably 3.0 nm or more, still more preferably 5.0 nm or more, particularly preferably 7.0 nm or more, and most preferably 10.0 nm or more, from the viewpoint of improving the reliability of the light-emitting element and suppressing external light reflection. On the other hand, the |Δ(Ra_{HT/max} - Ra_{FT/max}) is preferably 50.0 nm or less, more preferably 40.0 nm or less, still more preferably 30.0 nm or less, and particularly preferably 20.0 nm or less, from the viewpoint of improving the reliability of the light-emitting element and suppressing external light reflection.

In the display device of the present invention, when the pixel defining layer has a cured pattern and has a spacer layer on a part of the pixel defining layer, it is preferable to satisfy the condition (2x). Examples and preferable descriptions concerning the |Δ(Ra_{DL/max} - Ra_{SP/max})| are as described above examples and preferable descriptions concerning the |Δ(Ra_{HT/max} - Ra_{FT/max})|.

The maximum value of the surface roughness on the surface of the pixel defining layer is preferably 0.1 nm or more, more preferably 0.3 nm or more, still more preferably 0.5 nm or more, even more preferably 0.7 nm or more, and particularly preferably 1.0 nm or more from the viewpoint of improving the reliability of the light-emitting element and suppressing external light reflection. Furthermore, it is preferably 3.0 nm or more, more preferably 5.0 nm or more, still more preferably 7.0 nm or more, and particularly preferably 10.0 nm or more. On the other hand, the maximum value of the surface roughness of the surface of the pixel defining layer is preferably 50.0 nm or less, more preferably 40.0 nm or less, still more preferably 30.0 nm or less, and particularly preferably 20.0 nm or less, from the viewpoint of improving the reliability of the light-emitting element and suppressing external light reflection.

Examples and preferable descriptions regarding the maximum value of the surface roughness of the surface of the thin film part of the pixel defining layer, the maximum value of the surface roughness of the surface of the thick film part of the pixel defining layer, and the maximum value of the surface roughness of the surface of the spacer layer are as examples and preferable descriptions regarding the maximum value of the surface roughness of the surface of the pixel defining layer.

In the display device of the present invention, the maximum value of the surface roughness can be measured by an atomic force microscope (hereinafter, referred to as "AFM"). In general, measurement by AFM is performed on a surface of a pixel defining layer or the like of a display device placed on a horizontal surface from vertically above. In addition, the maximum value of the surface roughness refers to a value measured on a surface measurable by AFM on the surface of the pixel defining layer or the like, that is, a surface substantially parallel to the substrate.

### <Organic EL layer including light-emitting layer and light extraction layer including light-emitting layer>

The display device of the present invention preferably further includes an organic EL layer including a light-emitting layer and/or a light extraction layer including a light-emitting layer. The organic EL layer including a light-emitting layer and/or the light extraction layer including a light-emitting layer preferably have a stacking structure formed on the first electrode and between the first electrode and the second electrode.

The display device according to the second aspect of the present invention further includes an organic EL layer including a light-emitting layer and/or a light extraction layer including a light-emitting layer, in which the organic EL layer including a light-emitting layer and/or the light extraction layer including a light-emitting layer are formed on the first electrode and between the first electrode and the second electrode.

With such a configuration, it is possible to form a region corresponding to a light-emitting pixel portion.

The organic EL layer preferably further includes a hole transport layer and/or an electron transport layer, and the organic EL layer is preferably formed so as to have a stacking structure with the light-emitting layer. Examples of the configuration of the organic EL layer include (1) a hole transport layer/a light-emitting layer, (2) a hole transport layer/a light-emitting layer/an electron transport layer, and (3) a light-emitting layer/an electron transport layer. Various studies have been made on the configuration of the organic EL layer in order to comprehensively enhance injection and transport of holes and electrons, light emission efficiency in the light-emitting layer, and the like. Examples of a preferable configuration include an organic EL element disclosed in Japanese Patent Laid-open Publication No. 8-109373, that is, an organic thin film EL element including a hole transport layer in which at least one of the holes has at least a hole transport band between a pair of transparent electrodes, and the hole transport band is in contact with an anode and a blocking layer in contact with the light-emitting layer, or an organic thin film EL element including a hole injection layer in contact with the anode, a hole transport layer in contact with the hole injection layer, and a blocking layer in contact with the light-emitting layer, in which the hole transport layer contains a histriphenylamine styryl derivative represented by a specific general formula.

Note that the display device of the present invention can manufacture an organic EL display as a display device by having a stacking structure using an organic EL layer including a light-emitting layer. On the other hand, the display device of the present invention can manufacture a quantum dot display or a micro LED display which is a display device by having a stacking structure using a light extraction layer including a light-emitting layer.

The display device of the present invention is also preferably a quantum dot display in which the light extraction layer including the light-emitting layer includes quantum dots. The quantum dot display is a display device including a light extraction layer including a first electrode, a second electrode, a pixel defining layer, and a light-emitting layer on a substrate, in which the pixel defining layer is formed so as to overlap a part of the first electrode, the light extraction layer including the light-emitting layer is formed on the first electrode and between the first electrode and the second electrode, and the light extraction layer including the light-emitting layer includes quantum dots.

The display device of the present invention is also preferably a micro LED display in which the light extraction layer including the light-emitting layer includes an inorganic semiconductor. The micro LED display is a display device including a light extraction layer including a first electrode, a second electrode, a pixel defining layer, and a light-emitting layer on a substrate, in which the pixel defining layer is formed so as to overlap a part of the first electrode, the light extraction layer including the light-emitting layer is formed on the first electrode and between the first electrode and the second electrode, and the light extraction layer including the light-emitting layer includes an inorganic semiconductor.

The display device of the present invention preferably further includes a color filter including quantum dots from the viewpoint of improving the luminance and the purity of the emitted color. In the case of a stacking structure having a color filter including quantum dots, the light-emitting element superimposed on the color filter including quantum dots and positioned below the color filter including quantum dots is preferably an organic EL light-emitting element that emits blue light, an organic EL light-emitting element that emits white light, an LED element that emits blue light, or an LED element that emits white light.

The display device of the present invention preferably includes a plurality of pixel portions. In the display device of the present invention, in the opening of the pixel defining layer, a portion on the first electrode described above and where the organic EL layer including the light-emitting layer and/or the light extraction layer including the light-emitting layer are/is formed is preferably set as a pixel portion. The region corresponding to the pixel portion corresponds to a region where the organic EL layer including the light-emitting layer and/or the light extraction layer including the light-emitting layer are in contact with the first electrode portion described above. In the display device of the present invention, the pixel portion preferably overlaps the openings of a color filter layer and a black matrix layer. The display device of the present invention preferably includes a first electrode, a second electrode, a pixel defining layer, an organic EL layer including a light-emitting layer and/or a light extraction layer including a light-emitting layer, a sealing layer, a color filter layer, and a black matrix layer on the same substrate.

### <Schematic cross-sectional view of production process of organic EL display>

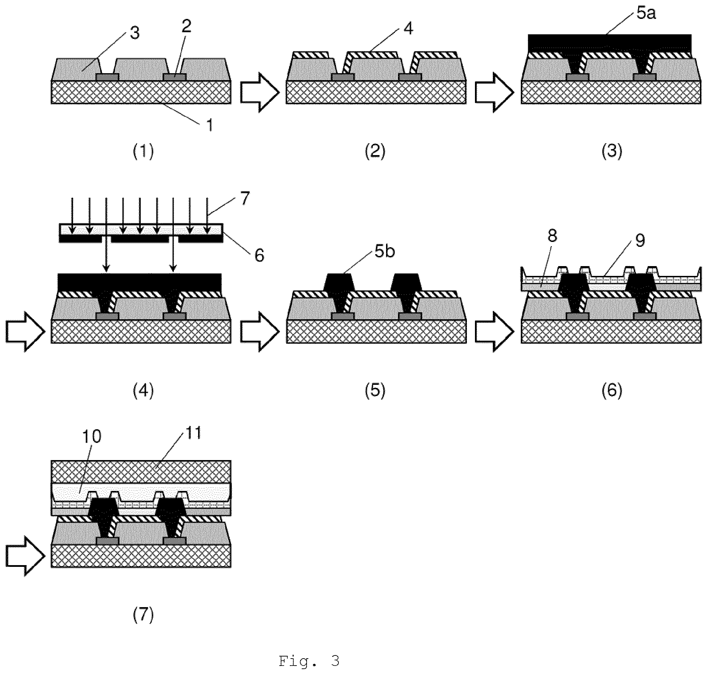

When the colorant (D) contains the black colorant (Da) in the photosensitive composition of the present invention, a process for producing an organic EL display including a cured film obtained by curing the composition as a pixel defining layer having a light-shielding property will be described as an example with a schematic cross-sectional view illustrated in Fig. 3. First, (Step 1) a thin-film-transistor (hereinafter, referred to as referred to as a "TFT") 2 is formed on a glass substrate 1, a photosensitive material for a TFT planarization film is formed, subjected to pattern processing by photolithography, and then thermally cured to a cured film 3 for TFT planarization. Next, (Step 2) a silver-palladium-copper alloy (hereinafter, referred to as referred to as "APC") is deposited by sputtering, and subjected to pattern processing by etching with the use of a photoresist to form an APC layer, and furthermore, as an upper layer on the APC layer, an indium tin oxide (hereinafter, referred to as referred to as an "ITO") is formed by sputtering, and subjected to pattern processing by etching with the use of a photoresist to form the reflective electrode 4 as the first electrode. Thereafter, (Step 3) the photosensitive composition according to the present invention is applied and prebaked to form a prebaked film 5a. Then, (Step 4) irradiation with active actinic rays 7 is performed through a mask 6 that has a desired pattern. Next, (Step 5) after development and pattern processing, bleaching exposure and middle baking are performed as necessary. Furthermore, the cured pattern 5b having a desired pattern is formed as a pixel defining layer having a light-shielding property by thermal curing. Thereafter, (Step 6) an EL light-emitting material is deposited by vapor deposition through the mask to form an organic EL layer 8, and a magnesium-silver alloy (hereinafter, referred to as "MgAg") is deposited by vapor deposition, and subjected to pattern processing by etching with the use of a photoresist to form a transparent electrode 9 as the second electrode. Next, (Step 7) a photosensitive material for a planarization film is deposited, subjected to pattern processing by photolithography, and hen thermally cured to form a cured film 10 for planarization, and thereafter, cover glass 11 is joined, thereby obtaining an organic EL display including the cured film of the photosensitive composition of the present invention as a pixel defining layer having the light-shielding property.

### <Method for producing cured product>

The method for producing a cured product of the present invention preferably includes the following steps (1) to (4).
(1) Step of forming, on a substrate, a coating film of the photosensitive composition of the present invention;
(2) Step of irradiating the coating film of the photosensitive composition with active actinic rays through a photomask;
(3) Step of forming a pattern of the photosensitive composition by development with an alkaline solution; and
(4) Step of heating the pattern to obtain a cured pattern of the photosensitive composition.

In the method for producing a cured product of the present invention, it is preferable that the photomask is a halftone photomask including a light-transmitting portion and a light-shielding portion, and including a partial light-transmitting portion between the light-transmitting portion and the light-shielding portion, the partial light-transmitting portion having a transmittance lower than a value of the light-transmitting portion and a transmittance higher than a value of the light-shielding portion.

As a method for producing a cured product, each method described in paragraphs [0453] to [0481] of International Publication No. 2019/087985 may be applied.

### <Step of forming coating film>

The method for producing a cured product of the present invention includes (1) a step of forming, on a substrate, a coating film of the photosensitive composition of the present invention. As a method for forming a film of the photosensitive composition, for example, a method in which the photosensitive composition is applied onto a substrate or a method in which the photosensitive composition is applied in a pattern on a substrate can be cited. As the substrate, for example, a substrate is used which has an oxide including one or more selected from indium, tin, zinc, aluminum, and gallium, a metal (for example, molybdenum, silver, copper, aluminum, chromium, or titanium), or a CNT (Carbon Nano Tube) formed as an electrode or a wiring on a glass. Examples of the oxide including one or more selected from indium, tin, zinc, aluminum, and gallium include an indium tin oxide (ITO).

### <Method for applying photosensitive composition onto substrate>

Examples of the method for applying the photosensitive composition onto the substrate include spin coating, curtain flow coating, spray coating, and slit coating. Although the coating film thickness varies depending on the coating method, the solid content concentration and viscosity of the photosensitive composition, the film thickness subsequent to the application and the prebake is usually 0.1 to 30 um. The photosensitive composition is preferably applied on a substrate, and then prebaked to form a film. The prebaking can use an oven, a hot plate, infrared rays, a flash annealing device, a laser annealing device, or the like. A prebaking temperature is more preferably 50°C to 150°C. A prebaking time is preferably 30 seconds to 10 minutes. It is also permissible to perform prebake in multiple steps of two or more steps, such as prebake at 80°C for 2 minutes and then prebake at 120°C for 2 minutes.

### <Method for pattern processing of coating film formed on substrate>

Examples of the method for pattern processing of the coating film of the photosensitive composition formed on the substrate include a method of direct pattern processing by photolithography and a method of pattern processing by etching. From the viewpoint of reduction of the number of steps and reduction of the process time, a method in which the coating film is directly pattern-processed by photolithography is preferable.

### <Step of applying active actinic rays via photomask>

The method for producing a cured product includes the (2) step of irradiating the above-described coating film of the photosensitive composition with active actinic rays through a photomask. Examples of the method of irradiation with active actinic rays via the photomask include a method of patterning exposure with the use of an exposure machine such as a stepper, a scanner, a mirror projection mask aligner (MPA), or a parallel light mask aligner (PLA).

The photomask refers to, for example, a photomask that has a pattern including a light-transmitting portion and a light-shielding portion, and it is preferable to use a halftone photomask having, between the light-transmitting portion and the light-shielding portion, a partial light-transmitting portion having a transmittance lower than a value of the light-transmitting portion and having a transmittance higher than a value of the light-shielding portion. The exposure with the use of the halftone photomask makes it possible to form a pattern which has a step shape after development. When a negative-type photosensitive composition is used, in a pattern having a step shape, a portion formed from an exposed portion irradiated with active actinic rays through a light-transmitting portion corresponds to a thick film part, and a portion formed from a halftone portion irradiated with active actinic rays through a partial light-transmitting portion corresponds to a thin film part.

The exposure wavelength of the active actinic rays is preferably 150 nm or more, and more preferably 300 nm or more. On the other hand, the exposure wavelength is preferably 450 nm or less, and more preferably 420 nm or less. The active actinic rays are particularly preferably j-rays (wavelength: 313 nm), i-rays (wavelength: 365 nm), h-rays (wavelength: 405 nm), or g-rays (wavelength: 436 nm) from a mercury lamp, or a mixed ray of i-rays, h-rays, and g-rays. As the active actinic rays, a XeF (wavelength: 351 nm) laser, a XeCl (wavelength: 308 nm) laser, a KrF (wavelength: 248 nm) laser, an ArF (wavelength: 193 nm) laser, or the like may be used. On the other hand, the exposure energy of the active actinic rays is preferably 100 J/m² (10 mJ/cm²) to 30,000 J/m² (3,000 mJ/cm²) or less in terms of i-ray illuminance value. After the exposure, post-exposure bake may be performed. By performing post-exposure baking, it is possible to improve the resolution after development or increase the allowable range of development conditions.

### <Step of forming pattern by development with alkaline solution>

The method for producing a cured product of the present invention includes the (3) step of performing development with the use of an alkaline solution to form a pattern of the photosensitive composition described above. Examples of a method for performing development using an alkaline solution after irradiation with active actinic rays through a photomask include a method for performing development using an automatic developing machine. Examples of the development method include paddle development, spray development, and dip development. In the case of having negative-type photosensitivity, a pattern in which an unexposed portion is removed with a developer can be formed, and in the case of having positive-type photosensitivity, a pattern in which an exposed portion is removed with a developer can be formed.

The developer is preferably an alkaline solution, and is preferably an organic alkaline solution or an aqueous solution of a compound exhibiting alkalinity. Examples of the alkaline solution include diethanolamine, trimethylamine, triethylamine, sodium hydroxide, potassium hydroxide, sodium carbonate, potassium carbonate, tetramethylammonium hydroxide, and tetraethylammonium hydroxide. As the developer, an organic solvent may be used. As the developer, a mixed solution may be used which contains both the organic solvent and a poor solvent with respect to the photosensitive composition. The alkali concentration of the alkaline solution is preferably 0.01 to 5% by mass. The developing time is preferably 30 seconds to 10 minutes. After development, it is preferable that the obtained pattern is washed with a rinse liquid. As the rinse liquid, water is preferable in the case where an alkali aqueous solution is used as the developer. As the rinse solution, an aqueous solution of an alcohol, an aqueous solution of an ester, an aqueous solution of a compound exhibiting acidity, or an organic solvent may be used. After the development, post-development exposure may be performed. By performing post-development exposure, it is possible to improve the resolution after thermal curing, control the pattern shape after thermal curing, and form a pattern having a step shape after thermal curing. Further, after the development, middle baking may be performed. By performing middle baking, it is possible to improve the resolution after thermal curing and to control the pattern shape after thermal curing.

### <Step of obtaining cured pattern by heating pattern>

The method for producing a cured product of the present invention includes the (4) step of heating the pattern of the photosensitive composition described above to obtain a cured pattern of the photosensitive composition described above (hereinafter, referred to as "Step (4)").

In Step (4), the pattern is preferably heated for thermosetting. Examples of the thermal curing method include a method for heating using an oven, a hot plate, infrared rays, a flash annealing device, or a laser annealing device. By thermal curing, the heat resistance of the cured film can be improved, and a pattern in a low-taper shape can be formed. A thermal curing temperature is preferably 150°C to 500°C. A thermal curing time is preferably 5 to 300 minutes. It is permissible to perform thermosetting in multiple steps of two or more steps, such as thermosetting at 150°C for 30 minutes and then thermosetting at 250°C for 30 minute. Examples of the treatment atmosphere include an air, oxygen, nitrogen, helium, neon, argon, krypton, or xenon atmosphere, a gas atmosphere containing 1 to 10,000 ppm by mass (0.0001% to 1% by mass) of oxygen, and a vacuum atmosphere.

### EXAMPLES

The present invention will be described more concretely hereinafter with reference to examples, reference examples, and comparative example. However, the present invention is not limited to scopes thereof. The names corresponding to the abbreviations of the compounds used in the following description or table are collectively shown in Table 1.

### [Table 1]

**[Table 1]**

| Abbreviations | Corresponding names | Abbreviations | Corresponding names |
|---|---|---|---|
| 6FDA | 4,4'-hexafluoropropane-2,2-diyl-bis(1,2-phthalic anhydride) | MEK-ST-L | Silica particle dispersion liquid using methyl ethyl ketone as dispersion solvent (manufactured by Nissan Chemical Corporation) |
| APC | Argentum-Palladium-Copper (silver-palladium-copper alloy) | | |
| BAD | Benzaldehyde | MeTMS | Methyltrimethoxysilane |
| BAHF | 2,2-bis(3-amino-4-hydroxyphenyl)hexafluoropropane | MgAg | Magnesium-Argentum (magnesium-silver alloy) |
| BAPF | 9,9-bis(3-amino-4-hydroxyphenyl)fluorene | MHBA | 4-hydroxybenzoic acid; Monohydroxybenzoic acid |
| BGPF | 9,9-bis(4-glycidoxyphenyl)fluorene | MOI | 2-methacryloxyethyl isocyanate |
| BnMA | benzyl methacrylate | MOP | 4-methoxyphenol |
| BHPP | 1,1-bis[3-hydroxymethyl-4-hydroxyphenyl] propane | NA | 5-norbornene-2,3-dicarboxylic anhydride |
| BIP | 1,1-bis(4-hydroxyphenyl) propane | NC-3000-H | Epoxy resin having a structural unit including a biphenyl skeleton, a benzene skeleton, and one epoxy group (manufactured by Nippon Kayaku Co., Ltd.) |
| BMMB | 4,4'-bis(methoxymethyl) biphenyl | | |
| BPFL | 9,9'-bis(4-hydroxyphenyl) fluorene | NC-3500 | Epoxy resin having a structural unit including a biphenyl skeleton, a benzene skeleton, and two epoxy groups (manufactured by Nippon Kayaku Co., Ltd.) |
| BPIN | 3,3'-bis(4-hydroxyphenyl)-1-isoindolinone | | |
| BPL | Biphenol | NPDL | 1,4-naphthalenediol |
| cyEpoTMS | 2-(3,4-epoxycyclohexyl) ethyltrimethoxysilane | ODB-HBT | Mixture of dicarboxylic acid derivatives obtained by reacting bis(4-carboxyphenyl) ether with 1-hydroxy-1,2,3-benzotriazole |
| DHBA | 3.5-dihydroxybenzoic acid | | |
| EDM | Diethylene glycol ethyl methyl ether | ODPA | Oxydiphthalic dianhydride |
| EL | Ethyl lactate | PGMEA | Propylene glycol monomethyl ether acetate |
| EtOH | Ethanol | PHA | Phthalic anhydride |
| GAD | Glutaraldehyde | PhTMS | Phenyltrimethoxysilane |
| GBL | γ-butyrolactone | RSC | Resorcinol |
| GDMA | Glycerol dimethacrylate | SAD | Salicylaldehyde |
| GMA | Glycidyl methacrylate | SiDA | 1,3-bis(3-aminopropyl) tetramethyldisiloxane |
| HAD | Formaldehyde | STR | Styrene |
| HEMA | 2-hydroxyethyl methacrylate | TCDM | Methacrylic acid tricyclo[5.2.1.0^{2,6}]decan-8-yl; methylol-tricyclodecane methacrylate |
| HPMA | (4-hydroxy) phenyl methacrylate | | |
| HST | 4-hydroxystyrene | THPHA | 1,2,3,6-tetrahydrophthalic anhydride |
| ITO | Indium tin oxide | TMAC | Trimellitic anhydride chloride |
| KBM-503 | 3-methacryloyloxypropyltrimethoxysilane (manufactured by Shin-Etsu Chemical Co., Ltd.) | TMAH | Tetramethylammonium hydroxide |
| MAA | Methacrylic acid | TMOS | Tetramethoxysilane |
| MAP | m-aminophenol | XLN | 2,6-xylenol |
| MBA | 3-methoxy-n-butyl acetate | ZCR-1569H | Acid-modified epoxy resin having a structural unit including a biphenyl skeleton and a benzene skeleton (manufactured by Nippon Kayaku Co., Ltd.; acid equivalent: 570 g/mol, double bond equivalent: 500 g/mol) |
| MCS | m-cresol | | |
| MEK | Methyl ethyl ketone | | |
| MEK-ST-40 | Silica particle dispersion liquid using methyl ethyl ketone as dispersion solvent (manufactured by Nissan Chemical Corporation) | | |
| | | | |

### <Synthesis Example of each resin>

(A) As the alkali-soluble resin, the composition of each resin obtained in Synthesis Examples 1 to 32 is collectively shown in Table 2-1 to Table 2-4. Each resin was synthesized by a known method by appropriately changing a monomer compound to be a monomer and a copolymerization ratio based on a method described in the following document. The copolymerization ratio of the monomers is as shown in Table 2-1 to Table 2-4.

· Polyimides (PI-1) to (PI-2) of Synthesis Examples 1 and 2 are synthesized by the methods described in Synthesis Example 1 of paragraph [0544] of International Publication No. 2017/057281.
· A polyimide precursor (PIP-1) of Synthesis Example 4 is synthesized by the method described in Synthesis Example 15 of paragraph [0548] of International Publication No. 2017/057281.
· Polyimide precursors (PIP-2) to (PIP-3) of Synthesis Examples 5 and 6 are synthesized by the methods described in Synthesis Example 6 of paragraph [0114] of Japanese Patent Laid-open Publication No. 2018-165819.
· Polybenzoxazole (PB-1) of Synthesis Example 7 is synthesized by the method described in Synthesis Example 12 of paragraph [0546] of International Publication No. 2017/057281.
· Polysiloxane (PS-1) of Synthesis Example 11 is synthesized by the method described in Synthesis Example 30 of paragraph [0553] of International Publication No. 2017/057281.
· A polycyclic side chain-containing resin (CR-1) of Synthesis Example 12 is synthesized by the method described in Synthesis Example 45 of paragraph [0563] of International Publication No. 2017/057281.
· Phenol group-containing acrylic resins (PAC-1) to (PAC-2) of Synthesis Examples 31 and 32 are synthesized by the method described in Synthesis Example 46 of paragraph [0564] of International Publication No. 2017/057281.
· A polyimide (PI-3) of Synthesis Example 3 is synthesized by the method described in Synthesis Example 6 of paragraph [0726] of International Publication No. 2017/159876.
· An acid-modified epoxy resin (AE-2) of Synthesis Example 13 is synthesized by the method described in Synthesis Example 25 of paragraph [0744] of International Publication No. 2017/159876.
· An acrylic resin (AC-1) of Synthesis Example 14 is synthesized by the method described in Synthesis Example 20 of paragraph [0739] of International Publication No. 2017/159876.
· Phenolic resins (PR-1), (PR-5) to (PR-7), and (PR-9) to (PR-14) of Synthesis Examples 15, 19 to 21, and 23 to 28 are synthesized by the method described in Synthesis Example 21 of paragraph [0740] of International Publication No. 2017/159876.
· Polyhydroxystyrene (PHS-1) of Synthesis Example 29 is synthesized by the method described in Synthesis Example 23 of paragraph [0742] of International Publication No. 2017/159876.
· Polybenzoxazole precursor (PBP-1) of Synthesis Example 8 is synthesized by the method described in Synthesis Example 9 of paragraph [0161] of International Publication No. 2017/057143.
· polyamideimides (PAI-1) to (PAI-2) of Synthesis Examples 9 and 10 are synthesized by the methods described in Synthesis Example 9 of paragraph [0160] of International Publication No. 2018/159384.
· A phenol resin (PR-2) of Synthesis Example 16 is synthesized by the method described in Synthesis Example 5 in paragraph [0120] of International Publication No. 2012/141165.
· A phenol resin (PR-3) of Synthesis Example 17 is synthesized by the method described in Synthesis Example 2 in paragraph [0119] of International Publication No. 2016/103850.
· Phenolic resins (PR-4) and (PR-8) of Synthesis Examples 18 and 22 are synthesized by the method described in Synthesis Example 12 of paragraph [0188] of International Publication No. 2014/046062.
· The phenol group-containing epoxy resin (PE-1) of Synthesis Example 30 is synthesized by the method described in Production Example 1 of paragraph [0171] of Japanese Patent Laid-open Publication No. 2020-042150.

In Synthesis Examples 3 and 10, a radical polymerizable group was introduced based on the method described in Synthesis Example 6 of paragraph [0726] of International Publication No. 2017/159876.

In Synthesis Examples 14, 21, and 32, a radical polymerizable group was introduced based on the method described in Synthesis Example 20 of paragraph [0739] of International Publication No. 2017/159876.

In Synthesis Example 13, an unsaturated carboxylic acid was reacted with NC-3500 having an epoxy group, and ring-opening addition was performed on all epoxy groups derived from NC-3500.

In Synthesis Examples 14, 21, and 32, GMA having an epoxy group was reacted, and all the epoxy groups of GMA were subjected to ring-opening addition.

In Synthesis Example 30, a carboxy group-containing phenol compound was reacted with a structural unit derived from NC-3000-H having an epoxy group, and ring-opening addition was performed on all epoxy groups derived from NC-3000-H.

In Synthesis Example 31, a carboxy group-containing phenol compound was reacted with a structural unit derived from GMA having an epoxy group, and ring-opening addition was performed on all epoxy groups derived from GMA.

As the acid-modified epoxy resin (AE-1), ZCR-1569H which is a commercially available resin was used.

The hydroxy group-containing diamine (HA) having the following structure used in Synthesis Example 4 was synthesized by a known method based on the synthesis method described in Synthesis Example 1 in paragraphs [0374] to [0376] of International Publication No. 2016/056451. The resin obtained in Synthesis Example 4 using which is a hydroxy group-containing diamine (HA) having the following structure is a polyimide precursor having an amide acid ester structural unit, an amide acid structural unit, and an imide ring-closed structure.

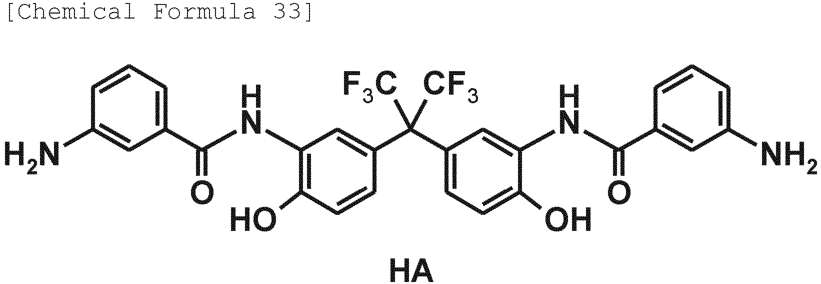

In Synthesis Examples 16 and 17, a phenol compound having the following structure was synthesized as a condensation reaction product of XLN and SAD instead of the condensation reaction product of XLN and 4-hydroxybenzaldehyde based on the synthesis method described in Synthesis Example 3 and Synthesis Example 5 in paragraphs [0109] to [0122] of International Publication No. 2012/141165, and the obtained phenol compound was used for the condensation reaction with an aldehyde compound.

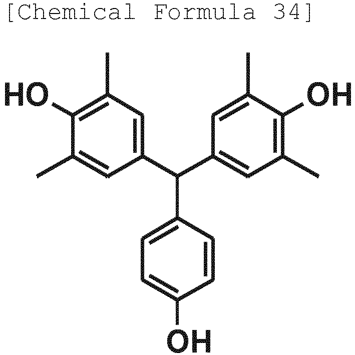

**[Table 2-1-1]**

| | Polymer | Monomer [mol ratio] | | | | |
|---|---|---|---|---|---|---|
| | | Carboxylic acid derivative | Amine derivative | | End - capping agent | Radical polymerizable group-containing compound |
| Synthesis Example 1 | Polyimide (PI-1) | ODPA (100) | BAHF (85) | SiDA (5) | MAP (20) | - |
| Synthesis Example 2 | Polyimide (PI-2) | ODPA (100) | BAPF (85) | SiDA (5) | MAP (20) | - |
| Synthesis Example 3 | Polyimide (PI-3) | ODPA (100) | BAHF(85) | SiDA (5) | MAP (20) | MOI (50) |
| Synthesis Example 4 | Polyimide Precursor (PIP-1) | 6FDA (100) | HA (55) BAHF (10) | SiDA (5) | MAP (60) | - |
| Synthesis Example 5 | Polyimide Precursor (PIP-2) | ODPA (100) | BAHF (90) | - | EtOH (20) | HEMA (200) |
| Synthesis Eample 6 | Polyimide Precursor(PIP-3) | ODPA (100) | BAHF (90) | - | EtOH(20) | GDMA (200) |
| Synthesis Example 7 | Polybenzoxazole (PB-1) | ODB-HBT (80) | BAHF (95) | SiDA (5) | NA (40) | - |
| Synthesis Eample 8 | Polybenzoxazole Precursor(PBP-1) | ODB-HBT (80) | BAHF(100) | - | NA (40) | - |
| Synthesis Eample 9 | Polyamideimide (PAI-1) | TMAC (80) | BAHF (100) | - | NA (40) | - |
| Synthesis Example 10 | Polyamideimide (PAI-2) | TMAC (80) | BAHF (100) | - | NA (40) | MOI (50) |

**[Table 2-1-2]**

| | Structural unit having fluorine atom to all of structural units [mol%] | Weight average molecular weight | Acid equivalent Phenol equivalent Carboxylic acid equivalent [g/mol] | Double bond equivalent [g/mol] |
|---|---|---|---|---|
| Synthesis Example 1 | 40.5 | 27,000 | Acid equivalent: 330 | - |
| | | | Phenol equivalent: 330 | |
| Synthesis Example 2 | 0.0 | 25,000 | Acid equivalent: 340 | - |
| | | | Phenol equivalent: 340 | |
| Synthesis Example 3 | 40.5 | 30,000 | Acid. equivalent: 500 | 1,400 |
| | | | Phenol equivalent: 500 | |
| Synthesis Example 4 | 71.7 | 20,000 | Acid equivalent: 380 | - |
| | | | Phenol equivalent: 470 | |
| | | | Carboxylic acid equivalent: 1,800 | |
| Synthesis Example 5 | 47.4 | 20,000 | Acid equivalent: 510 | 460 |
| | | | Phenol equivalent: 510 | |
| Synthesis Example 6 | 47.4 | 20,000 | Acid. equivalent: 620 | 280 |
| | | | Phenol equivalent: 620 | |
| Synthesis Example 7 | 43.2 | 27,000 | Acid equivalent: 460 | - |
| | | | Phenol equivalent: 670 | |
| | | | Carboxylic acid equivalent: 1,420 | |
| Synthesis Example 8 | 45.5 | 22,000 | Acid equivalent: 260 | - |
| | | | Phenol equivalent: 310 | |
| | | | Carboxylic acid equivalent: 1,530 | |
| Synthesis Example 9 | 45.5 | 25,000 | Acid equivalent: 280 | - |
| | | | Phenol equivalent: 280 | |
| Synthesis Example 10 | 45.5 | 28,000 | Acid equivalent: 420 | 1,320 |
| | | | Phenol equivalent: 420 | |

**[Table 2-2-1]**

| | | | | | |
|---|---|---|---|---|---|
| | Polymer | Monomer [mol%] | | | |
| | | Trifunctional Organosilane | | | Tetrafunctional organosilane |
| Synthesis Example 11 | Polysiloxane (PS-1) | MeTMS (30) | PhTMS (50) | cyEpoTMS (10) | TMOS (10) |
| | Polymer | Monomer [mol ratio] | | | |
| | | Polyfunctional epoxy compound. | Polyfunctional carboxylic dianhydride | Carboxylic anhydride | Unsaturated carboxylic acid |
| Synthesis Example 12 | Polycyclic side chain-containing resin (CR-1) | BGPF (100) | ODPA (90) | PHA (20) | MAA (200) |
| | Polymer | Monomer [mol ratio] | | | |
| | | Polyfunctional epoxy compound | | Carboxylic anhydride | Unsaturated carboxylic acid |
| Synthesis Example 13 | Acid-modified epoxy resin (AE-2) | NC-3500 (Epoxy equivalent: 210 g/mol) (Epoxy group standard: 0.2 mol) (Epoxy group standard mol ratio: 100) | | THPHA (0.16 mol) (mol ratio: 80) | MAA (0.20 mol) (mol ratio: 100) |
| | Polymer | Monomer [mol ratio] | | | |
| | | Acidic copolymerization component | Aromatic copolymerization component | Alicyclic copolymerization component | Unsaturated compound having epoxy group |
| Synthesis Example 14 | Acrylic resin (AC-1) | MAA (50) | BnMA (45) | TCDM (5) | GMA (20) |

**[Table 2-2-2]**

| | | | | | |
|---|---|---|---|---|---|
| | Structural Unit having aromatic group to polysiloxane [mol%] | Weight average molecular weight | Acid equivalent (= silanol equivalent) [g/mol] | Carboxylic acid equivalent [g/mol] | Double bond equivalent [g/mol] |
| Synthesis Example 11 | 50.0 | 4, 500 | 360 | - | **-** |
| | Polyfunctional carboxylic acid derivative structural unit having aromatic group and carboxylic acid anhydride structural unit [mol%] | Weight average molecular weight | Phenol equivalent [g/mol] | Acid equivalent (= carboxylic acid equivalent) [g/mol] | Double bond equivalent [g/mol] |
| Synthesis Example 12 | 10 0.0 | 4, 700 | - | 470 | 470 |
| | Polyfunctional carboxylic acid derivative structural unit having aromatic group and carboxylic acid anhydride structural unit [mol%] | Weight average molecular weight | Phenol equivalent [g/mol] | Acid equivalent (= carboxylic acid equivalent; [g/mol] | Double bond equivalent [g/mol] |
| Synthesis Example 13 | 0.0 | 4, 500 | - | 520 | 420 |
| | Structural unit having aromatic group to all of structural units [mol%] | Weight average molecular weight | Phenol equivalent [g/mol] | Acid equivalent (= carboxylic acid equivalent) [g/mol] | Double bond equivalent [g/mol] |
| Synthesis Example 14 | 45.0 | 15,000 | - | 540 | 810 |

### [Table 2-3]

**[Table 2-3]**

| | Polymer | Monomer [mol ratio] | | | | | | Weight average molecular weight | Acid equivalent (= phenol equivalent) [g/mol] | Double bond equivalent [g/mol] |
|---|---|---|---|---|---|---|---|---|---|---|
| | | Phenol compound | | Aldehyde compound Bisalkoxymethyl compound | | | Compound having unsaturated double bond group | | | |
| Synthesis Example 15 | Phenol resin (PR-1) | MCS (100) | - | SAD (75) | BAD (25) | - | - | 3,000 | 120 | - |
| Synthesis Example 16 | Phenol resin (PR-2) | XLN (200) | - | SAD (100) | BAD (25) | HAD (75) | - | 4,000 | 130 | - |
| Synthesis Example 17 | Phenol resin (PR-3) | XLN (200) | - | SAD (100) | GAD (50) | HAD (100) | - | 7,000 | 140 | - |
| Synthesis Example 18 | Phenol resin (PR-4) | MCS (100) | - | BMMB (75) | - | HAD (25) | - | 5,000 | 280 | - |
| Synthesis Example 19 | Phenol resin (PR-5) | RSC (100) | - | BAD (75) | - | HAD (25) | - | 4,000 | 90 | - |
| Synthesis Example 20 | Phenol resin (PR-6) | MCS (100) | - | - | - | HAD (100) | - | 3,000 | 120 | - |
| Synthesis Example 21 | Phenol resin (PR-7) | MCS (100) | - | SAD (75) | BAD (25) | - | GMA (20) | 3,500 | 150 | 1,190 |
| Synthesis Example 22 | Phenol resin (PR-8) | MCS (100) | - | BHPP (75) | - | HAD (25) | - | 5,000 | 130 | - |
| Synthesis Example 23 | Phenol resin (PR-9) | MCS (100) | - | - | BAD (75) | HAD (25) | - | 3,500 | 180 | - |
| Synthesis Example 24 | Phenol resin (PR-10) | MCS (70) | BIP (30) | - | BAD (75) | HAD (25) | - | 5,000 | 170 | - |
| Synthesis Example 25 | Phenol resin (PR-11) | MCS (30) | NPDL (70) | - | BAD (75) | HAD (25) | - | 4,500 | 130 | - |
| Synthesis Example 26 | Phenol resin (PR-12) | MCS (70) | BPFL (30) | - | BAD (75) | HAD (25) | - | 6,000 | 190 | - |
| Synthesis Example 27 | Phenol resin (PR-13) | MCS (70) | BPIN (30) | - | BAD (75) | HAD (25) | - | 6,000 | 200 | - |
| Synthesis Example 28 | Phenol resin (PR-14) | MCS (70) | BPL (30) | - | BAD (75) | HAD (25) | - | 5,000 | 160 | - |

### [Table 2-4]

**[Table 2-4]**

| | | | | | | | | | | |
|---|---|---|---|---|---|---|---|---|---|---|
| | Polymer | Monomer [mol ratio] | | | | | | Weight average molecular weight | Acid equivalent (= phenol equivalent) [g/mol] | Double bond equivalent [g/mol] |
| | | Hydroxystyrene copolymerization component | | | Styrene copolymerization component | | | | | |
| Synthesis Example 29 | Polyhydroxystyrene (PHS-1) | HST (80) | | | STR (20) | | | 9,500 | 150 | - |
| | Polymer | Monomer [mol rate] | | | | | | Weight average molecular weight | Acid equivalent (= phenol equivalent) [g/mol] | Double bond equivalent [g/mol] |
| | | Polyfunctional epoxy compound | | Carboxy group-containing phenol compound | | | | | | |
| Synthesis Example 30 | Phenol group-modiied epoxy resin (PE-1) | NC-3000-H (Epoxy equivalent 290 g/mol) (Epoxy group standard: 0.2 mol) (Epoxy group standard mol ratio: 100) | | DHBA (0.10 mol) (mol ratio: 50) | | MHBA (0.10 mol) (mol ratio: 50) | | 5,500 | 290 | - |
| | Polymer | Monomer [mol ratio] | | | | | | Weight average molecular weight | Acid equivalent (= phenol equivalent) [g/mol] | Double bond equivalent [g/mol] |
| | | Copolymerization component having epoxy group | Copolymerization component having phenolic hydroxyl group | Aromatic copolymerization component | Alicyclic copolymerization component | Carboxy group-containing phenol compound | Compound having unsaturated double bond group | | | |
| Synthesis Example 31 | Phenol group-modified acrylic resin (PAC-1) | GMA (30) | - | STR (50) | TCDM (20) | DHBA (30) | - | 13,000 | 310 | - |
| Synthesis Example 32 | Phenol group-modified acrylic resin (PAC-2) | - | HPMA (75) | BnMA (25) | - | - | GMA (15) | 8,000 | 330 | 1,330 |

The structural units and structures of the resins obtained in the respective Synthesis Examples and the resins used in the respective Examples, Reference Examples, and Comparative Examples are collectively shown in Table 3.

### [Table 3]

**[Table 3]**

| Alkali-soluble resin (A) | Structural unit and structure of alkali-soluble resin (A) |
|---|---|
| Polyimide (PI-1) | Structural unit represented by general formula (1); |
| Polyimide (PI-2) | Structural unit represented by general formula (1); |
| Polyimide (PI-3) | Structural unit represented by general formula (1); Radical polymerizable group: methacryloyl group (2-methacryloyloxyethyl isocyanate residue) |
| Polyimide Precursor (PIP-1) | Structural unit represented by general formula (3); |
| | Content ratio of amide acid ester structural unit is 65 mol%, content ratio of amide acid structural unit is 25 mol%, and content ratio of imide ring-closed structural unit is 10 mol% |
| Polyimide Precursor (PIP-2) | Structural unit represented by general formula (3); |
| | Radical polymerizable group: methacryloyl group (2-hydroxyethyl methacrylate residue) |
| Polyimide Precursor (PIP-3) | Structural unit represented by general formula (3); |
| | Radical polymerizable group: methacryloyl group (glycerol dimethacrylate residue) |
| Polybenzoxazole (PB-1) | Structural unit represented by general formula (2); |
| Polybenzoxazole precursor (PBP-1) | Structural unit represented by general formula (4); |
| Polyamideimide (PAI-1) | Structural unit represented by general formula (5); |
| | Residues having fluorine atoms; nadiimide group at end of resin |
| Polyamideimide (PAI-2) | Structural unit represented by general formula (5); |
| | Radical polymerizable group: methacryloyl group (2-methacryloyloxyethyl isocyanate residue) |
| Polysiloxane (PS-1) | Trifunctional organosilane unit represented by the general formula (9); |
| | Tetrafunctional organosilane unit represented by the general formula (10) |
| Polycyclic side chain-containing resin (CR-1) | Structural unit represented by general formula (41) including structure represented by general formula (44); |
| | Main chain having cardo-based resin structure; radical polymerizable group: methacryloyl group (methacrylic acid residue) |
| Acid-modified epoxy resin (AE-1) (=ZCR-1569H) | Structural unit represented by general formula (61) including structure represented by general formula (66); |
| | Main chain having epoxy methacrylate resin structure; |
| | Radical polymerizable group: methacryloyl group (methacrylic acid residue) |
| Acid-modified epoxy resin (AE-2) | Structural unit represented by general formula (61) including structure represented by general formula (66); |
| | Main chain having epoxy methacrylate resin structure; |
| | Radical polymerizable group: methacryloyl group (methacrylic acid residue) |
| Acrylic resin (AC-1) | Structural unit represented by general formula (81) and structural unit represented by general formula (82) |
| | Radical polymerizable group: methacryloyl group (glycidyl methacrylate residue) |
| Phenol resin (PR-1) | Structural unit represented by general formula (31); structural unit (3x) and structural unit (3y) |
| Phenol resin (PR-2) | Structural unit represented by general formula (32); structural unit (3x) and structural unit (3y) |
| Phenol resin (PR-3) | Structural unit represented by general formula (33); structural unit (3x) |
| Phenol resin (PR-4) | Structural unit represented by general formula (34); structural unit (3y) |
| Phenol resin (PR-5) | Structural unit represented by general formula (35); structural unit (3x) and structural unit (3v) |
| Phenol resin (PR-6) | Structural unit represented by general formula (36) |
| Phenol resin (PR-7) | Structural unit represented by general formula (31); structural unit (3x) and structural unit (3y); |
| | Radical polymerizable group: methacryloyl group (glycidyl methacrylate residue) |
| Phenol resin (PR-8) | Structural unit represented by general formula (34); structural unit (3x) and structural unit (3y) |
| Phenol resin (PR-9) | Structural unit represented by general formula (38); structural unit (3y) |
| Phenol resin (PR-10) | Structural unit represented by general formula (40); structural unit (3x) and structural unit (3y); |
| Phenol resin (PR-11) | Structural unit represented by general formula (35); structural unit (3x) and structural unit (3y); |
| | Condensed polycyclic structure: naphthalene structure |
| Phenol resin (PR-12) | Structural unit represented by general formula (40); structural unit (3x) and structural unit (3y); |
| | Condensed polycyclic structure: fluorene structure |
| Phenol resin (PR-13) | Structural unit represented by general formula (40); structural unit (3x) and structural unit (3y); |
| | Condensed polycyclic structure: isoindolinone structure |
| Phenol resin (PR-14) | Structural unit represented by general formula (40); structural unit (3x) and structural unit (3y); |
| Polyhydroxystyrene (PHS-1) | Structural unit represented by general formula (91); structural unit (3z) |
| Phenol group-modified epoxy resin (PE-1) | Structural unit (3x) and structural unit (3y); main chain having epoxy methacrylate resin structure |
| Phenol group-modified acrylic resin (PAC-1) | Structural unit (3x) and structural unit (3z) |
| Phenol group-modified acrylic resin (PAC-2) | Structural unit (3z) |
| | Radical polymerizable group: methacryloyl group (glycidyl methacrylate residue) |

A list and description of the colorant (D) and the dispersant (E) used in each of Examples, Reference Examples, and Comparative Examples are collectively shown in Table 4.

### [Table 4]

**[Table 4]**

| Colorant (D) Dispersant (E) | Description of colorant (D) and description of dispersant (E) |
|---|---|
| Bk-S0100CF | Mixture of compound represented by general formula (161) and compound represented by general formula (162); |
| | "IRGAPHOR" (registered trademark) BLACK S0100CF |
| | (manufactured by BASF; benzofuranone-based black pigment having a primary particle size of 40 to 80 nm) |
| Bk-S0084 | Compound represented by general formula (164); |
| | "PALIOGEN" (registered trademark) BLACK S0084 |
| | (manufactured by BASF); perylene-based black pigment having a primary particle size of 50 to 100 nm) |
| Bk-FK4280 | Mixture of compound represented by general formula (165) and compound represented by general formula (166); |
| | "LUMOGEN" (registered trademark) BLACK FK4280 |
| | (manufactured by BASF); perylene-based black pigment having a primary particle size of 50 to 100 nm) |
| Bk-A1103 | Compound represented by general formula (168); |
| | "CHROMOFINE" (registered trademark) BLACK A1103 |
| | (manufactured by Dainichiseika Color & Chemicals Mfg. Co., Ltd.); Azo-based black pigment having a primary particle size of 50 to 100 nm) |
| P.R.179 | C.I. Pigment Red 179 (perylene-based red pigment) |
| P.Y.192 | C.I. Pigment Yellow 192 (imidazolone-based yellow pigment) |
| P.B.60 | C.I. Pigment Blue 60 (indanthrone blue pigment) |
| Bk-CBF1 | Mixture of compound represented by general formula (161) and compound represented by general formula (162); |
| | Surface-covered benzofuranone-based black pigment |
| | Silica covering layer (DC-1): silica (100 parts by mass in terms of SiO₂ with respect to 100 parts by mass of the black pigment); |
| | Metal oxide covering layer (DC-2): alumina (2.0 parts by mass in terms of Al₂O₃ with respect to 100 parts by mass of the black pigment); |
| | Average coverage of covering layer with respect to black pigment: 97.5% |
| Bk-CBF2 | Mixture of compound represented by general formula (165) and compound represented by general formula (166); |
| | Surface-covered perylene-based black pigment |
| | Silica covering layer (DC-1): silica + silica (two layers of silica covering layers (DC-1); |
| | 3.0 + 7.0 parts by mass in terms of SiO₂ with respect to 100 parts by mass of the black pigment); |
| | Average coverage of covering layer with respect to black pigment: 84.5% |
| ADP | Tertiary amino group, structure represented by general formula (26), structure represented by general formula (29), and Pigment dispersant having basic group (E1) having polyoxyalkylene structure |
| | (amine value: 20 mgKOH/g (solid concentration: 100% by mass)) |

### <Colorants>

· Bk-CBF1 is a benzofuranone-based black pigment having a covering layer described in paragraphs [0503] to [0505] and Covering Example 1 of International Publication No. 2019/087985.
· Bk-CBF2 is a perylene-based black pigment having a covering layer obtained by the synthesis method described in paragraphs [0186] to [0188] and paragraph [0191] and Example 18 of International Publication No. 2018/038083.

### <Preparation Examples of pigment dispersion liquids>

As the pigment dispersion liquid, the compositions of the dispersions obtained in Preparation Examples 1 to 7 are collectively shown in Table 5-1. In Preparation Examples 1 to 7, each pigment dispersion liquid was prepared by a known method based on the method described in paragraph [0506] of International Publication No. 2019/087985. The polyalkylene amine-based polyoxyalkylene ether-based dispersant (ADP) used in Preparation Examples 1 to 7 was synthesized by a known method based on the method described in Synthesis Example 2 in paragraphs [0138] to [0141] of Japanese Patent Laid-open Publication No. 2020-070352.

**[Table 5-1]**

| | Dispersion liquid | Composition (% by mass) | | | | Solvent | Average primary particle size in pigment dispersion liquid [nm] | Average primary particle size in cured film [nm] |
|---|---|---|---|---|---|---|---|---|
| | | (D) Colorant | | | (E) Dispersant | | | |
| Preparation Example 1 | Pigment dispersion liquid (Bk-1) | Bk-S0100CF (100) | - | - | ADP (35) | PGMEA | 80 | 60 |
| Preparation Example 2 | Pigment dispersion liquid (Bk-2) | Bk-S0084 (100) | - | - | ADP (35) | PGMEA | 100 | 80 |
| Preparation Example 3 | Pigment dispersion liquid (Bk-3) | Bk-FK4280 (100) | - | - | ADP (35) | PGMEA | 100 | 80 |
| Preparation Example 4 | Pigment dispersion liquid (Bk-4) | Bk-A1103 (100) | - | - | ADP (35) | PGMEA | 100 | 80 |
| Preparation Example 5 | Pigment dispersion liquid (Bk-5) | P.R.179 (30) | P.Y.192 (30) | P.B.60 (40) | ADP (35) | PGMEA | 100 | 80 |
| Preparation Example 6 | Pigment dispersion liquid (Bk-6) | Bk-CBF1 (100) | - | - | ADP (35) | PGMEA | 60 | 60 |
| Preparation Example 7 | Pigment dispersion liquid (Bk-7) | Bk-CBF2 (100) | - | - | ADP (35) | PGMEA | 80 | 80 |

### Synthesis Example 33 Synthesis of silica particle (SP-1) dispersion liquid

In a three-necked flask, 104.5 g of MEK as a solvent, 142.5 g of MEK-ST-40 as a silica particle dispersion liquid containing a sodium element, and 0.01 g of MOP as a polymerization terminator were weighed and added, mixed, and stirred for 10 minutes, and then the liquid temperature was raised to 50°C. Then, a solution of 3.0 g of KBM-503 dissolved in 50.0 g of MEK as a surface modifier was added dropwise over 10 minutes. After completion of the dropwise addition, the mixture was stirred at 50°C for 2 hours to dehydrate and condense the surface modifier. After the reaction, the reaction solution was cooled to room temperature to obtain a silica particle (SP-1) dispersion liquid. The obtained silica particles (SP-1) have a surface-modifying group containing a methacryloyl group as a radical polymerizable group.

As the silica particles, the compositions of the silica particle dispersion liquid obtained in Synthesis Example 33 and the commercially available silica particle dispersion liquid are collectively shown in Table 5-2. As the silica particle (SP-2) dispersion liquid, MEK-ST-40 which is a commercially available silica particle dispersion liquid was used. As the silica particle (SP-3) dispersion liquid, MEK-ST-L which is a commercially available silica particle dispersion liquid was used.

**[Table 5-2]**

| Silica particles | Silica particle dispersion liquid | Physical property values of silica particles | | | | |
|---|---|---|---|---|---|---|
| | | Distribution range of primary particle size [nm] | Average primary particle size [nm] | Aspect ratio range | Average aspect ratio | Sodium element content |
| SP-1 | Synthesis Example 33 | 10 to 16 | 12 | 1.0 to 1.1 | 1.1 | 100 ppm |
| SP-2 | MEK-ST-40 | 10 to 15 | 12 | 1.0 to 1.1 | 1.1 | 100 ppm |
| SP-3 | MEK-ST-L | 20 to 60 | 40 | 1.0 to 1.2 | 1.2 | 100 ppm |

### <Evaluation methods in Examples, Reference Examples, and Comparative Examples>

Evaluation methods in Examples, Reference Examples, and Comparative Examples are described below.

### (1) Weight-average molecular weight of resin

With the use of a GPC analyzer (HLC-8220; manufactured by Tosoh Corporation), and with the use of tetrahydrofuran or N-methyl-2-pyrrolidone as a fluidized bed, the weight average molecular weight in terms of polystyrene was measured and then obtained by a method at around normal temperature, based on "JIS K7252-3 (2008)".

### (2) Phenol equivalent, hydroxyimide equivalent, hydroxyamide equivalent, silanol equivalent, 1,1-bis(trifluoromethyl) methylol equivalent, mercapto equivalent, and carboxylic acid equivalent; weakly acidic group equivalent

With the use of an automatic potentiometric titrator (AT-510; manufactured by KYOTO ELECTRONICS MANUFACTURING CO., LTD.), and with the use of a 0.1 mol/L sodium hydroxide/ethanol solution as a titration reagent, xylene/N,N-dimethylformamide = 1/1 (mass ratio) as a titration solvent, the phenol value (unit: mgKOH/g) or carboxylic acid value (unit: mgKOH/g) was measured, and then obtained by a potentiometric titration method, based on "JIS K2501 (2003)". The phenol equivalent (unit: g/mol) or the carboxylic acid equivalent (unit: g/mol) was calculated from the measured phenol value or carboxylic acid value.

Incidentally, the silanol equivalent (unit: g/mol) was calculated from the value of the silanol value similarly measured by a potentiometric titration method in a reaction in which silanol groups were acetylated using acetic anhydride as an acetylating reagent, imidazole and N,N'-dimethylaminopyridine as a catalyst, and N,N-dimethylformamide as a solvent.

Similarly, regarding the hydroxyimide equivalent, the hydroxyamide equivalent, the 1,1-bis(trifluoromethyl) methylol equivalent, and the mercapto equivalent, a sample in which each acidic group (a hydroxyimide group, a hydroxyamide group, a 1,1-bis(trifluoromethyl) methylol group, and a mercapto group) was acetylated was prepared, and the equivalent (unit: g/mol) of each acidic group was calculated from the acid value of each acidic group similarly measured by the potentiometric titration method.

The weakly acidic group equivalent was calculated from the weakly acidic group value obtained by the sum of the phenol value, the hydroxyimide value, the hydroxyamide value, the silanol value, the 1,1-bis(trifluoromethyl) methylol value, and the mercapto value.

When a plurality of resins having a phenolic hydroxyl group, a silanol group, or a carboxy group are contained in the composition, components in the composition that could be separated by a method such as centrifugation, liquid separation extraction, or column chromatography were removed, and then each resin was separated by GPC fractionation. Thereafter, the carboxylic acid equivalent (unit: g/mol) was calculated based on the method for measuring the carboxylic acid equivalent described above. Similarly, the silanol equivalent (unit: g/mol) was calculated based on the method for measuring the silanol equivalent described above.

When the resin has a plurality of acidic groups among a phenolic hydroxyl group, a silanol group, and a carboxy group, first, the phenolic hydroxyl group and the silanol group were protected by a silyl ether group using tert-butyldimethylsilyl chloride as a silylating reagent, imidazole as a catalyst, and N,N-dimethylformamide as a solvent. Next, thereafter, the carboxylic acid equivalent (unit: g/mol) was calculated based on the method for measuring the carboxylic acid equivalent described above.

Separately, the phenolic hydroxyl group and the silanol group were protected by a silyl ether group in the same manner, and then the carboxy group was protected by a tert-butyl ester group using tert-butyl bromide as a tert-butylating reagent and N,N-dimethylformamide as a solvent. Thereafter, the phenolic hydroxyl group and the silanol group were deprotected using tetrabutylammonium fluoride as a desilylation reagent and N,N-dimethylformamide as a solvent. Subsequently, the phenolic hydroxyl group was protected by a methoxymethyl ether group using chloromethyl methyl ether as a methoxymethylation reagent, sodium hydride as a catalyst, and N,N-dimethylformamide as a titration solvent as a solvent. Thereafter, the silanol equivalent (unit: g/mol) was calculated based on the method for measuring the silanol equivalent described above.

Separately, the carboxy group was protected by a tert-butyl ester group in the same manner, and the phenolic hydroxyl group was further protected by a methoxymethyl group. Thereafter, the silanol group was protected by a silyl ether group using tert-butyldimethylsilyl chloride as a silylating reagent, imidazole as a catalyst, and N,N-dimethylformamide as a solvent. Subsequently, the phenolic hydroxyl group was deprotected using 1 mol/L hydrochloric acid as a demethoxymethylation reagent and methanol as a solvent. Thereafter, the phenol equivalent (unit: g/mol) was calculated based on the method for measuring the phenol equivalent described above.

### (3) Double bond equivalent

With the use of an automatic potentiometric titrator (AT-510; manufactured by KYOTO ELECTRONICS MANUFACTURING CO., LTD.), and with the use of an iodine monochloride solution (mixed solution of iodine trichloride = 7.9 g, iodine = 8.9 g, acetic acid = 1,000 mL) as an iodine source, a 100 g/L potassium iodide aqueous solution as an aqueous solution for trapping unreacted iodine, and a 0.1 mol/L sodium thiosulfate aqueous solution as a titration reagent, the iodine value of the resin was measured by the Wiis method, based on the method described in the "Section 6: Iodine Value" of JIS K0070: 1992 "Method for Testing Acid Value, Saponification Value, Ester Value, Iodine Value, Hydroxyl Value, and Unsaponifiable Matter of Chemical Product". From the value of the measured iodine value (whose unit is gI/100 g), a double bond equivalent (whose unit is g/mol) was calculated.

### (4) Average primary particle size of pigment in pigment dispersion liquid

D50 (median diameter) was measured using a dynamic light scattering particle size distribution measuring apparatus (SZ-100; manufactured by HORIBA, Ltd.) with a laser wavelength of 532 nm, PGMEA as a diluent solvent, a dilution ratio of 250 times (weight ratio), a solvent viscosity of 1.25, a solvent refractive index of 1.40, a measurement temperature of 25°C, a measurement mode of scattered light, and operating conditions of polydispersion and broad. The number of measurements was two, and the average value was taken as the average primary particle size of the pigment in the pigment dispersion liquid.

### (5) Average primary particle size of pigment in cured film

A cured film of a composition was prepared by the method described in Example 1 below. The cross section of the cured film was imaged and analyzed using a transmission electron microscope, and the primary particle size of the pigment was measured. The average value obtained by measuring 30 primary particles of the pigment was determined as the average primary particle size of the pigment in the cured film.

### (6) Pretreatment for substrate

A glass in which APC (silver/palladium/copper = 98.07/0.87/1.06 (mass ratio)) had been formed into a film of 10 nm by sputtering on a glass sheet and, furthermore, as an upper layer on the APC layer, ITO was formed into a film of 100 nm by sputtering (manufactured by GEOMATEC Co., Ltd., hereinafter "ITO/Ag substrate") was subjected to a UV-Os washing process for 100 seconds by using a table-top Photo Surface Processor (PL16-110, manufactured by SEN LIGHTS Corporation) before the glass substrate was used. A TEMPAX glass substrate (manufactured by AGC Techno Glass Co., Ltd.) was used without being pretreated. Other substrates may be a hot plate (HP-1SA; manufactured by AS ONE Corporation) at 130°C for 2 minutes to perform a dehydration baking treatment.

### (7) Film thickness measurement

With the use of a surface roughness and contour measuring instrument (SURFCOM 1400D; manufactured by TOKYO SEIMITSU CO., LTD.), at the measurement magnification of 10,000 times, the measurement length of 1.0 mm, the measurement speed of 0.30 mm/s, the film thickness was measured.

### (8) Sensitivity

A developed film of a composition was prepared by the method described in Example 1 below. FPD/LSI inspection microscope (OPTIPHOT-300; manufactured by Nikon Corporation) was used to observe a resolution pattern of the developed film prepared. As an index of the sensitivity, an exposure energy (value of i-line illuminance meter) at which a space pattern corresponding to an opening can be formed with a dimension width of 18 um in a line-and-space pattern of 20 µm was defined as sensitivity. It has been determined as follows that the A+, A, B+, B, C+, and C with the sensitivity of 90 mJ/cm² or less are regarded as pass, the A+, A, B+, and B with the sensitivity of 60 mJ/cm² or less are regarded as favorable, and the A+ and A with the sensitivity of 40 mJ/cm² or less are regarded as excellent.
A+: Sensitivity is 30 mJ/cm² or less
A: Sensitivity is more than 30 mJ/cm² and 40 mJ/cm² or less
B: Sensitivity is more than 40 mJ/cm² and 50 mJ/cm² or less
B: Sensitivity is more than 50 mJ/cm² and 60 mJ/cm² or less
C+: Sensitivity is more than 60 mJ/cm² and 75 mJ/cm² or less
C: Sensitivity is more than 75 mJ/cm² and 90 mJ/cm² or less
D: Sensitivity is more than 90 mJ/cm² and 150 mJ/cm² or less
E: Sensitivity is more than 150 mJ/cm².

### (9) Mask bias

A developed film of a composition was prepared by the method described in Example 1 below. With the use of an FPD/LSI inspection microscope (OPTIPHOT-300; manufactured by NIKON CORPORATION), the resolution pattern of the developed film prepared was observed, and the opening dimension (CD_{DEV}) um of a pattern corresponding to the opening was measured in a line-and-space pattern with a mask dimension of 20 µm. In addition, as for the exposure energy, the opening dimension (CD_{DEV}) µm is less than 20 um, and the minimum exposure energy was set such that the development residual film rate ((T_{DEV})/(T_{PB}) × 100) was 70% or more when the film thickness after pre-baking is (T_{PB}) um and the film thickness after development is (T_{DEV}) um. As an index of the mask bias, an opening dimensional difference ((CD_{DEV})-20) um from 20 µm as a mask dimension was calculated. It has been determined as follows that A+, A, B+, B, C+, and C with an opening dimensional difference of 3.0 um or less are regarded as pass, A+, A, B+, and B with an opening dimensional difference of 2.0 µm or less are regarded as favorable, and A+ and A with an opening dimensional difference of 1.0 um or less are regarded as excellent.
A+: Opening dimensional difference is 0.5 um or less
A: Opening dimensional difference is more than 0.5 µm and 1.0 um or less
B+: Opening dimensional difference is more than 1.0 um and 1.5 um or less
B: Opening dimensional difference is more than 1.5 um and 2.0 um or less
C+: Opening dimensional difference is more than 2.0 um and 2.5 µm or less
C: Opening dimensional difference is more than 2.5 µm and 3.0 µm or less
D: Opening dimensional difference is more than 3.0 um and 4.0 µm or less
E: Opening dimensional difference is more than 4.0 um.

### (10) Halftone characteristics

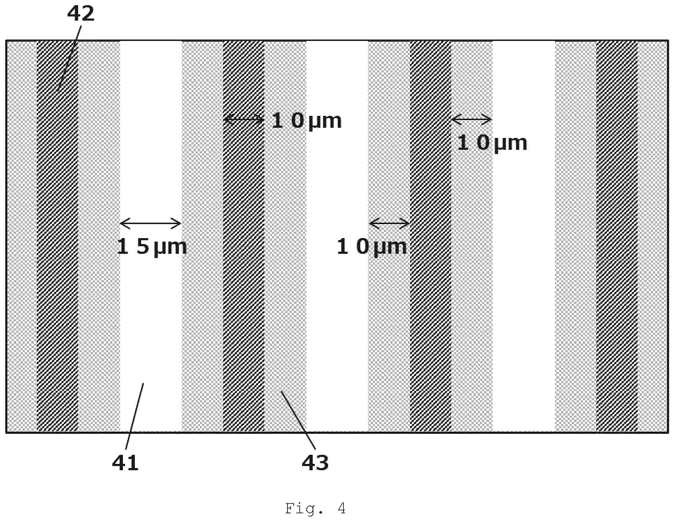

In accordance with the method described in Example 1, a prebaked film of the composition was formed to have a film thickness of 5 µm on an ITO/Ag substrate, subjected to exposure for patterning with the i-ray (wavelength: 365 nm), h-ray (wavelength: 405 nm), and g-ray (wavelength 436 nm) of an ultra-high pressure mercury lamp by changing the exposure energy through a halftone photomask for evaluating halftone characteristics with the use of a double-sided alignment single-sided exposure apparatus (Mask Aligner PEM-6M; manufactured by Union Optical Co., Ltd.), and developed with the use of a small-size developing device (AD-1200; TAKIZAWA SANGYO K.K.) for photolithography, thereby preparing a developed film of the composition. Photomasks including a light-transmitting portion, a light-shielding portion, and a partial light-transmitting portion between the light-transmitting portion and the light-shielding portion were used as the halftone photomask. The photomasks have sites where the transmittances (%T_{HT}) of the partial light-transmitting portions are respectively 20%, 25%, 30%, 35%, 40%, or 50% of the transmittance (%T_{FT}) of the light-transmitting portion. The light-transmitting portion is adjacent to the partial light-transmitting portion, and the partial light-transmitting portion is adjacent to the light-shielding portion. Fig. 4 illustrates, as an example of the halftone photomask, an example of the arrangement and dimensions of the light-transmitting portion 41, light-shielding portion 42, and partial light-transmitting portion 43.

For the resolution pattern having the step shape of the developed film prepared, the film thickness (T_{FT}) um after development of the thick film part formed from the light-transmitting portion was measured. The film thickness (T_{HT}) um of the thin film part formed from the partial light-transmitting portion, which is a halftone exposed portion, after development at a portion having a different transmittance was measured, and the minimum film thickness (T_{HT/min}) µm of the thin film part remaining after development was determined. As an index of the halftone characteristics, the maximum step film thickness ((T_{FT})-(T_{HT/min})) µm was calculated. It has been determined as follows that A+, A, B+, B, C+, and C where the maximum step film thickness is 0.4 um or more are regarded as pass, A+, A, B+, and B where the maximum step film thickness is 1.0 µm or more are regarded as favorable, and A+ and A where the maximum step film thickness is 2.0 µm or more are regarded as excellent.
A+: Maximum step film thickness is 2.5 µm or more
A: Maximum step film thickness is 2.0 µm or more and less than 2.5 µm
B: Maximum step film thickness is 1.5 µm or more and less than 2.0 µm
B: Maximum step film thickness is 1.0 µm or more and less than 1.5 µm
C+: Maximum step film thickness is 0.7 um or more and less than 1.0 µm
C: Maximum step film thickness is 0.4 um or more and less than 0.7 µm
D: Maximum step film thickness is 0.1 um or more and less than 0.4 um
E: Maximum step film thickness is less than 0.1 um or not measurable without any residual film after the development.

### (11) Light-shielding property (optical density value (hereinafter, "OD value")

A cured film of the composition was prepared on a TEMPAX glass substrate by the method described in Example 1 below. Using a transmission densitometer (X-Rite 361T(V), manufactured by X-Rite company), the created cured film was subjected to measurement of incident light intensity (I₀) and of transmitted light intensity (I) at three points in the plane. As an index of the light-shielding property, the OD value per film thickness of 1 um was calculated by the following formula, and the average value of the OD values at three points in the plane was calculated. $OD value = {log}_{10} \left({I}_{0}/I\right) .$

### (12) light-emitting characteristics of light-emitting element (current density-voltage characteristics and reliability)

### <Method for manufacturing organic EL display>

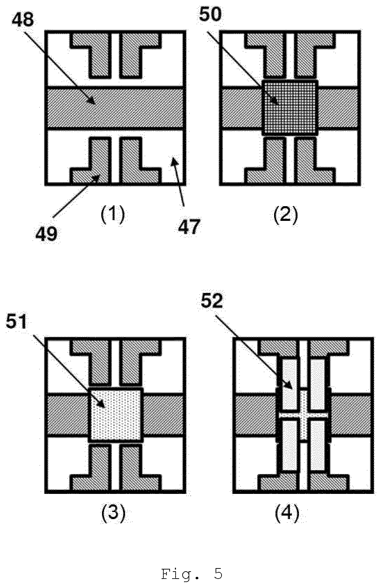

Fig. 5 illustrates a schematic view of the substrate used. First, on a non-alkali glass substrate 47 of 38 × 46 mm, APC (silver/palladium/copper = 98.07/0.87/1.06 (mass ratio)) of 100 nm was formed as a non-transparent conductive metal layer by sputtering, and patterned by etching to form an APC layer. Further, a film of amorphous ITO was formed as a transparent conductive oxide film layer in a thickness of 10 nm on the APC layer by sputtering, and etched to form a reflective electrode as the first electrode 48. In addition, an auxiliary electrode 49 was formed at the same time to take out a second electrode (Fig. 5 (Step 1)). The obtained substrate was subjected to ultrasonic cleaning for 10 minutes with "Semico Clean" (registered trademark) 56 (manufactured by Furuuchi Chemical Corporation), and washed with ultrapure water. Next, the composition was applied and prebaked on the substrate by the method described in Example 1, subjected to patterning exposure through a photomask with a predetermined pattern, and development and rinsing, and then thermally cured by heating. In accordance with the method mentioned above, openings of 70 um in width and 260 µm in length were arranged at a pitch of 155 µm in the width direction and a pitch of 465 µm in the length direction, and a pixel defining layer 50 in a shape for exposing the first electrode through the respective openings was formed only on a substrate effective area in a limited fashion (Fig. 5 (Step 2)). It is to be noted that the openings will finally serve for light-emitting pixels of an organic EL display. Furthermore, the substrate effective area was 16 mm × 16 mm square, and the pixel defining layer 50 was formed to have a thickness of about 1.0 µm.

Next, an organic EL display was manufactured with the use of the substrate with the first electrode 48, auxiliary electrode 49, and pixel defining layer 50 formed. After the substrate was subjected to a nitrogen plasma treatment as a pretreatment, an organic EL layer 51 including a light-emitting layer was formed by vacuum deposition (Fig. 5 (Step 3)). Incidentally, the degree of vacuum at the time of vapor deposition was 1 × 10⁻³ Pa or less, and the substrate was rotated relative to a vapor deposition source during the vapor deposition. First, a compound (HT-1) of 10 nm and a compound (HT-2) of 50 nm were deposited respectively as a hole injection layer and a hole transport layer. Next, for the light-emitting layer, a compound (GH-1) as a host material and a compound (GD-1) as a dopant material were deposited to have a thickness of 40 nm, in such a way that the dope concentration reached 10%. After that, as electron transporting materials, a compound (ET-1) and a compound (LiQ) were stacked, with a volume ratio of 1:1, to a thickness of 40 nm. As the compound (Compound (HT-1), Compound (HT-2), Compound (GH-1), Compound (GD-1), Compound (ET-1), and Compound (LiQ)) used in the organic EL layer, the same compounds as those described in paragraphs [0599] to [0600] of International Publication No. 2017/057281 were used.

Next, after the vapor deposition of the compound (LiQ) of 2 nm, 10 nm MgAg (magnesium/silver = 10/1 (volume ratio)) was deposited as a second electrode 52 to form a transparent electrode (Fig. 5 (Step 4)). Thereafter, under a low-humidity nitrogen atmosphere, sealing was performed by bonding a cap-shaped glass plate with the use of an epoxy resin-based adhesive, and four top-emission organic EL displays each in a square shape of 5 mm on a side were prepared on one substrate. Incidentally, the film thickness mentioned herein refers to a crystal oscillation type film thickness monitor-displayed value.

### <Evaluation of current density-voltage characteristics>

The voltage value of the organic EL display produced by the method described above was sequentially changed from the low voltage side, and light was emitted by direct current drive until the current density reached 30 mA/cm². The voltage value and the current density when the voltage value was sequentially changed from the low voltage side were plotted, and the driving voltage at which the current density was 10 mA/cm² was obtained as an index of the current density-voltage characteristic. It has been determined as follows that A+, A, B+, B, C+, and C where the driving voltage is 4.5 V or less are regarded as pass, A+, A, B+, and B where the driving voltage is 4.0 V or less are regarded as good, and A+ and A where the driving voltage is 3.5 V or less are regarded as excellent.
A+: Driving voltage is 3.2 V or less
A: Driving voltage is more than 3.2 V and 3.5 V or less
B+: Driving voltage is more than 3.5 V and 3.7 V or less
B: Driving voltage is more than 3.7 V and 4.0 V or less
C+: Driving voltage is more than 4.0 V and 4.2 V or less
C: Driving voltage is more than 4.2 V and 4.5 V or less
D: Driving voltage is more than 4.5 V and 5.5 V or less
E: Driving voltage is more than 5.5 V or unmeasurable.

### <Evaluation of reliability>

The organic EL displays prepared by the method described above was driven with a direct current at 10 mA/cm² to emit light, and it was confirmed whether there were defective light emissions such as non-light-emitting regions and uneven luminance. In addition, as a durability test, the display was held at 80°C for 500 hours. After the durability test, the organic EL display was caused to emit light at 10 mA/cm² by direct current drive, and whether or not there was a change in the light-emitting characteristics was observed. When the light-emitting region area before the durability test was 100%, the light-emitting area after the durability test was measured. It has been determined as follows that A+, A, B+, B, C+, and C where the area of the light-emitting region is 80% or more are regarded as pass, A+, A, B+, and B where the area of the light-emitting region is 90% or more are regarded as good, and A+ and A where the area of the light-emitting region is 97% or more are regarded as excellent.
A+: Area of light-emitting region is 100%
A: Area of light-emitting region is 97% or more and less than 100%
B+: Area of light-emitting region is 94% or more and less than 97%
B: Area of light-emitting region is 90% or more and less than 94%
C+: Area of light-emitting region is 85% or more and less than 90%
C: Area of light-emitting region is 80% or more and less than 85%
D: Area of light-emitting region is 60% or more and less than 80%
E: Area of light-emitting region is less than 60%.

### (13) Mechanical properties (elongation at break)

A cured film of a composition having a film thickness of about 5 µm was prepared on a SiO₂/Si wafer having a diameter of 6 inches by the method described in Example 1 below. The cured film was peeled off from the SiO₂/Si wafer using dilute hydrofluoric acid. The peeled cured film was cut into a strip shape having a width of 1.5 cm × a length of 9.0 cm. Using Tensilon RTM-100 (manufactured by ORIENTEC CORPORATION), a tensile test was conducted at a tensile rate of 50 mm/min at a room temperature of 23.0°C and a humidity of 45.0% RH, and the elongation at break was measured. 10 strips were measured per sample. As an index of the mechanical properties, an average value of the top five points was calculated from the obtained results. It has been determined as follows that A+, A, B+, B, C+, and C where the elongation at break is 5.0% or more are regarded as pass, A+, A, B+, and B where the elongation at break is 10% or more are regarded as good, and A+ and A where the elongation at break is 20% or more are regarded as excellent.
A+: Elongation at break is 30% or more
A: Elongation at break is 20% or more and less than 30%
B+: Elongation at break is 15% or more and less than 20%
B: Elongation at break is 10% or more and less than 15%
C+: Elongation at break is 7.5% or more and less than 10%
C: Elongation at break is 5.0% or more and less than 7.5%
D: Elongation at break is 1.0% or more and less than 5.0%
E: Elongation at break is less than 1.0% or unmeasurable.

### (14) Migration resistance (insulation reliability)

A cured film of the composition with a film thickness of about 1.5 um was produced on a migration evaluation substrate (WALTS-TEG ME0102JY; manufactured by WALTS Co., Ltd.) using the method described in Example 1 below. Next, in the line-and-space pattern of the copper wiring of the comb teeth, a conductive wire was soldered to a portion of a measurement terminal having a line of 15 um and a space of 10 um to produce an evaluation element. The prepared evaluation element was evaluated for insulation reliability under high temperature and high humidity using an insulation deterioration characteristic evaluation system (ETAC SIR13; manufactured by Kusumoto Chemicals, Ltd.). The evaluation element was placed in a high temperature and high humidity bath in which the test conditions were set to a temperature of 85°C and a humidity of 85% RH, a voltage of 5.0 V was applied, and the temporal change of the resistance value was measured at intervals of 5 minutes. When the resistance value reached 1.0 × 10⁶ Ω or less, insulation failure was determined, and the test time at that time was measured as an index of migration resistance. It has been determined as follows that A+, A, B+, B, C+, and C where the test time is 200 hours or more are regarded as pass, A+, A, B+, and B where the test time is 400 hours or more are regarded as good, and A+ and A where the test time is 800 hours or more are regarded as excellent.
A+: Test time is 1,000 hours or more
A: Test time is 800 hours or more and less than 1,000 hours
B+: Test time is 600 hours or more and less than 800 hours
B: Test time is 400 hours or more and less than 600 hours
C+: Test time is 300 hours or more and less than 400 hours
C: Test time is 200 hours or more and less than 300 hours
D: Test time is 50 hours or more and less than 200 hours
E: Test time is less than 50 hours or unmeasurable.

### <Compounds used in Examples, Reference Examples, and Comparative Examples>

A list of the compound (F1), compound (FB1), compound (FC1), and compound (FT) used in each of Examples, Reference Examples, and Comparative Examples and physical property values thereof are collectively shown in Table 5-3 to Table 5-4. The composition ratio (fb-1) of the compound (FB1) is also shown in Table 5-4.

### [Table 5-3]

**[Table 5-3]**

| | Compound (F1) | Physical property value of compound (F1) | | | | | | |
|---|---|---|---|---|---|---|---|---|
| | | Compound names | Compound classification | Acidic group containing phosphorus atom | Structure (I-f1) and structure (II-f1) of compound (F1) | Aliphatic group | Oxyalkylene | Structure (III-f1) of compound (F1) |
| | | | | | | Number of carbon atoms and number | group Number of carbon atoms and number | |
| 1 | f-1 | n-octylphosphonic acid | Aliphatic containing phosphonic acid | Phosphonate group | n-octyl group | Number of carbon atoms: 8 | - | - |
| | | | | | | Number: 1 | | |
| 2 | f-2 | Phosphoric acid [auryl-bis(oxyethylene)] ester | Phosphoric acid monoester compound | Phosphate group | Lauryl group oxyethylene group | Number of carbon atoms: 12 | Number of carbon atoms: 2 | - |
| | | | | | | Number: 1 | Number: 2 | |

| | Compound (FT) | Physical property value of compound (FT) | | | | | | |
|---|---|---|---|---|---|---|---|---|
| | | Compound names | Compound classification | Acidic group containing phosphorus atom | Aliphatic group | Aliphatic group | Oxyalkylene group | Photoreactive group |
| | | | | | | Number of carbon atoms and number | | |
| | | | | | Oxyalkylene group | | Number of carbon atoms and number | Alkenyl group |
| | | | | | | | | Alkynyl group |
| 3 | ft-1 | Tris(methacryloxyethylene) phosphate ester | Phosphoric acid triester compound | Absent | Oxyethylene group | - | Number of carbon atoms: 2 | Methacryloyl group |
| | | | | | | | Number: 3 | |

### [Table 5-4]

**[Table 5-4]**

| | Compound (FB1) | Physical property value of compound (FB1); compound (FC1) | | | | | | | |
|---|---|---|---|---|---|---|---|---|---|
| | | Compound names | Compound classification | Anionic stucure containingphosphorus atom | Structure (I-fb1) of Compound (FB1) | Structure (II-fb1) of Compound (FB1) | Fatty acid ester structure/aliphatic ether structure | Structure (IV-fb1) and Structure (V-fb1) of Compound (FB1) | Fatty acid polyfunctional alcohol ester stuctire |
| | Compound (FC1) | | | | | | | | |
| | | | | Stucture (I-fc1) of Compound (FC1) | | Structure (II-fc1) of Compound (FC1) | Number of carbon atoms and number | | |
| | | Lecithin (derived from soybean) | Phosphodiester betaine-type phospholipid | Phosphate anion | Quaternary ammonium cation derived tom choline | Oleic acid ester | Number of carbon atoms: 18, 16 | Glycerin structure | - |
| | | | | | | Palmitic acid ester | | | |
| | | | | | | | Number: 1, 1 | | |
| | | | Phosphodiester betaine-type phospholipid | Phosphate anion | Ammonium cation derived tom ethanolamine | Oleic acid ester | Number of carbon atoms: 18, 16 | Glycerin structure | - |
| | | Mixture of the following compounds | | | | Palmitic acid ester | | | |
| | | | | | | | Number: 1, 1 | | |
| 4 | fb-1 | Phosphatidylcholine | Phosphodiester non-betaine phospholipid | Phosphate group | - | Oleic acid ester | Number of carbon atoms: 18, 16 | Glycerin stuctire | Inositol stricture |
| | | Phosphatidylethanolamine | | | | | | | |
| | | Phosphatidylinositol | | | | Palmitic acid ester | | | |
| | | Phosphatidic acid | | | | | Number: 1, 1 | | |
| | | | Phosphodiester non-betaine phospholipid | Phosphate group | - | Oleic acid ester | Number of carbon atoms: 18, 16 | Glycerin structure | - |
| | | | | | | Palmitic acid ester | | | |
| | | | | | | | Number: 1, 1 | | |

| | Compound (FB1) | Composition ratio of lecithin (t-1) [% by mass] | | | | | | | |
|---|---|---|---|---|---|---|---|---|---|
| | Compound (FC1) | Compound names | Phosphafdylcholine | Phosphatidylethanolamine | | Phosphatidylinositol | | Phosphatidic acid | |
| | fb-1 | Lecithin (derived tom soybean) | 36 | 35 | | 19 | | 10 | |

Names corresponding to abbreviations in Examples, Reference Examples, and Comparative Examples are collectively shown in Table 6. Compounds containing a chlorine element, a bromine element, a sulfur element, or a phosphorus element (hereinafter, referred to as "a compound containing a specific element") used in Examples, Reference Examples, and Comparative Examples; specific nitrogen-containing compound; compounds containing specific metal elements and compounds corresponding thereto are also collectively shown in Table 6.

### [Table 6]

**[Table 6]**

| Abbreviations | Corresponding names | Abbreviations | Compound containing specific element |
|---|---|---|---|
| (d-1) | Bk-S0100CF | (Cl-1) | Cyclopropylmethyl chloride |
| (d-2) | Bk-S0084 | (Cl-2) | Benzyl chloride |
| (d-3) | Bk-FK4280 | (Cl-3) | Tetrabutylammonium chloride |
| (d-4) | Bk-A1103 | (Br-1) | Benzyl bromide |
| (d-5) | Mixture of P.R.179/P.Y.192/P.B.60 | (Br-2) | Potassium bromide |
| (d-6) | Bk-CBF1 | (S-1) | p-toluenethiol |
| (d-7) | Bk-CBF2 | (S-2) | 3-mercaptopropyltrimethoxysilane |
| (e-1) | ADP | (S-3) | Dibenzyl sulfide |
| | | (S-4) | Dimethyl sulfoxide |
| | | (S-1) | Triphenylphosphine |

| Abbreviations | Specific nitrogen-containing compound | Abbreviations | Compound containing specific metal element |
|---|---|---|---|
| (Nc-1) | N-methyl-2-pyrrolidone | (Mt-1) | Sodium dodecanoate |
| (Nc-2) | N,N'-dimethylisobutyramide | (Mt-2) | Potassium dodecanoate |
| (Nc-3) | N,N'-dimethyl-3-methoxypropionamide | (Mt-3) | Magnesium dodecanoate |
| (Nc-4) | N,N'-dimethyl-3-butoxypropionamide | (Mt-4) | Calcium dodecanoate |
| (Nc-5) | 1,3-dimethyl-2-imidazolidinone | (Mt-5) | Tris(dodecanoic acid) iron (III) |
| (Nc-6) | 1,1,3,3-tetramethylurea | (Mt-6) | Bis(dodecanoic acid) copper (II) |
| | | (Mt-7) | Tris(dodecanoic acid) chromium (III) |

The structures of (b-1) to (b-9), (bx-1) to (bx-9), (c-1) to (c-6), (f-1), (f-2), (ft-1), (g-1) to (g-10), (h-1), (j-1), (k-1), and (NQD-1) are shown below as compounds used in Examples, Reference Examples, and Comparative Examples.

Incidentally, (b-1), (b-3), (b-4), and (b-5) correspond to the compound (B-1) described above. (b-2), (b-6), (b-7), and (b-8) correspond to the compound (B-2). (b-9) corresponds to the compound (B-3).

(h-1) is a dissolution accelerator and has a hydrophobic structure (a phenyl group having 6 carbon atoms to which two ethylene groups having 2 carbon atoms and having a phenyl group having 6 carbon atoms are bonded), a hydrophilic structure (12 oxyethylene groups having 2 carbon atoms), and a hydrophilic group (hydroxy group bonded to oxyethylene group).

(j-1) is a fluorenone compound of a sensitizer.

(k-1) is an organosilane compound of a silane coupling agent which is an adhesion promoter, and has an epoxy group.

Incidentally, (bx-1) and (bx-2) correspond to the compound (B-4), and (bx-3) and (bx-4) correspond to the compound (B-5). (bx-5) corresponds to the compound (B-6), and the minimum number of atoms in the structure (I-b6) is 4. (bx-6), (bx-7), (bx-8), and (bx-9) correspond to the compound (B-7), and the minimum number of atoms in the structure (I-b7) is 13 for (bx-6), 23 for (bx-7), 31 for (bx-8), and 17 for (bx-9).

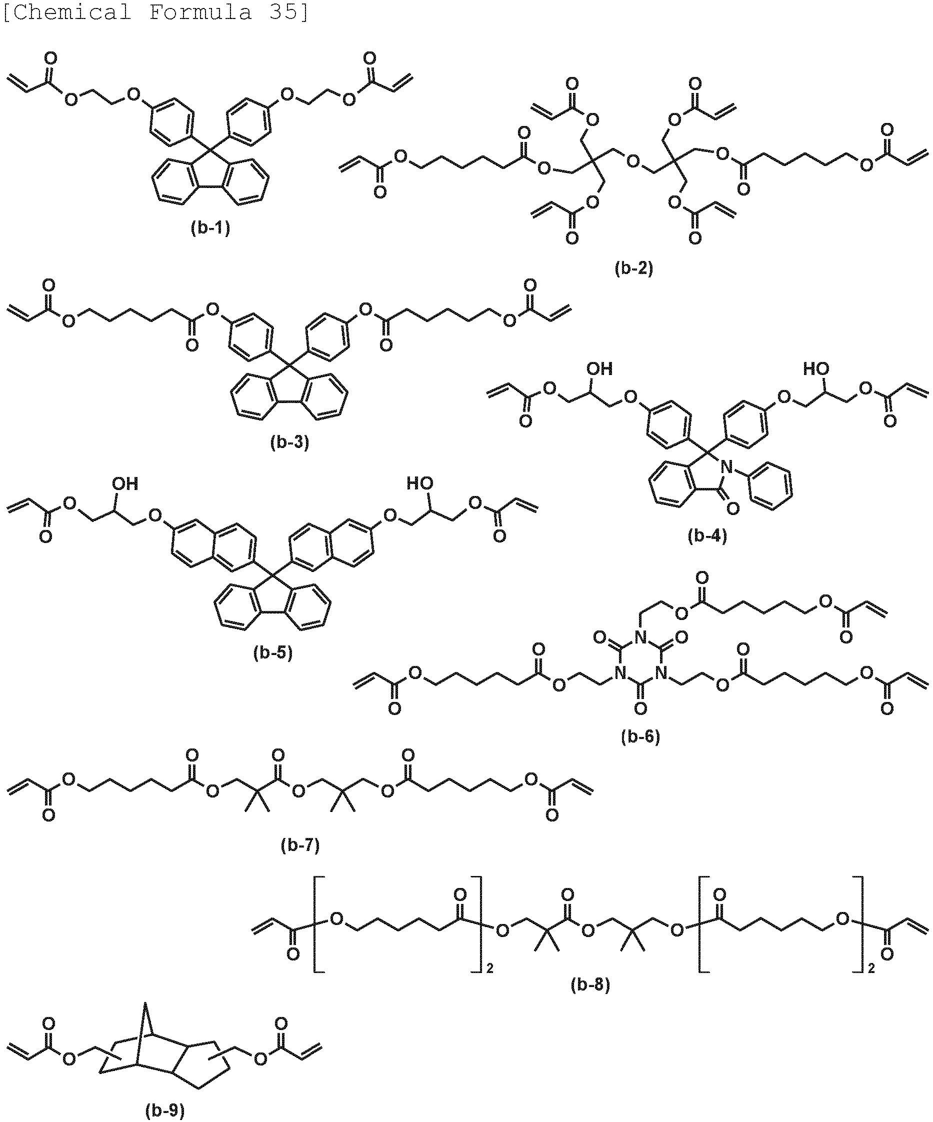

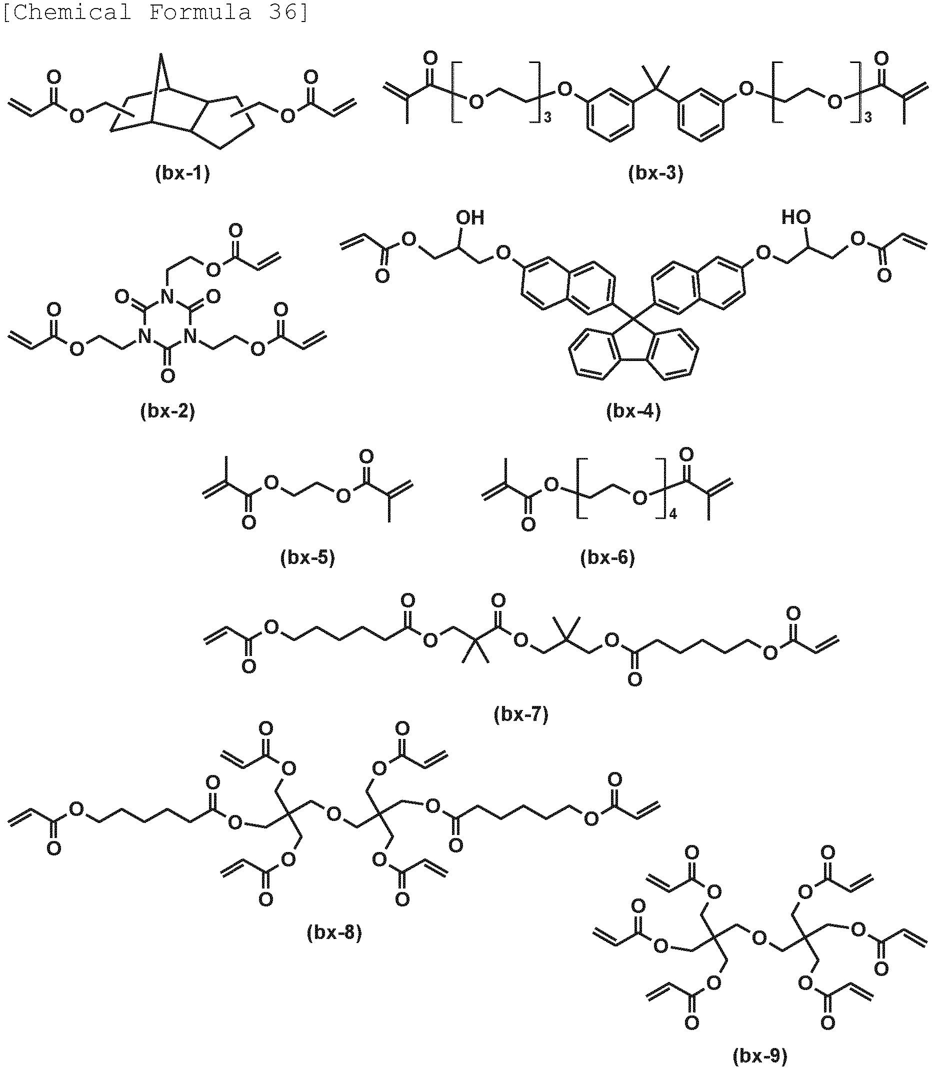

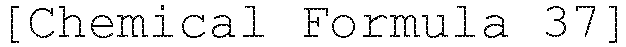

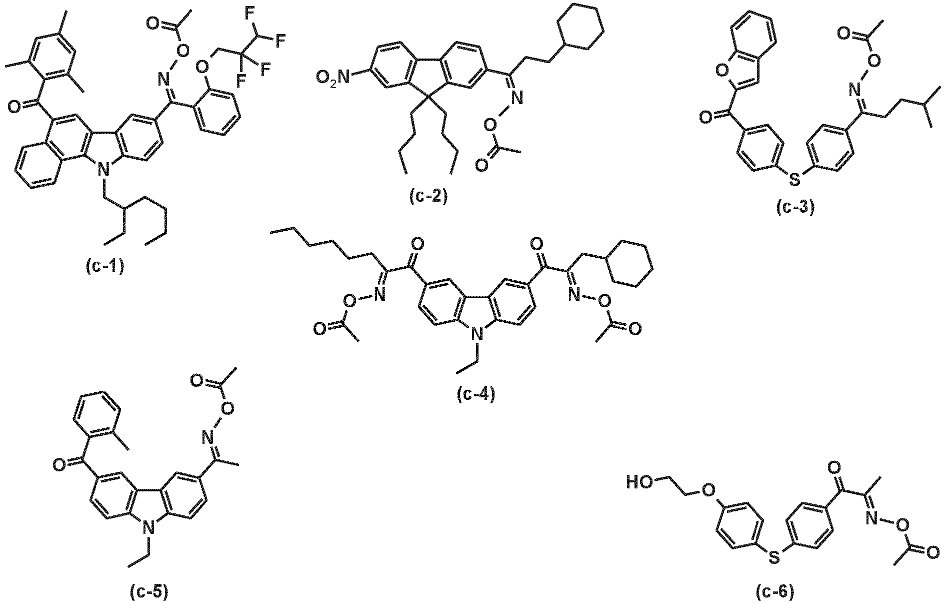

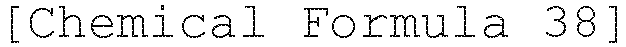

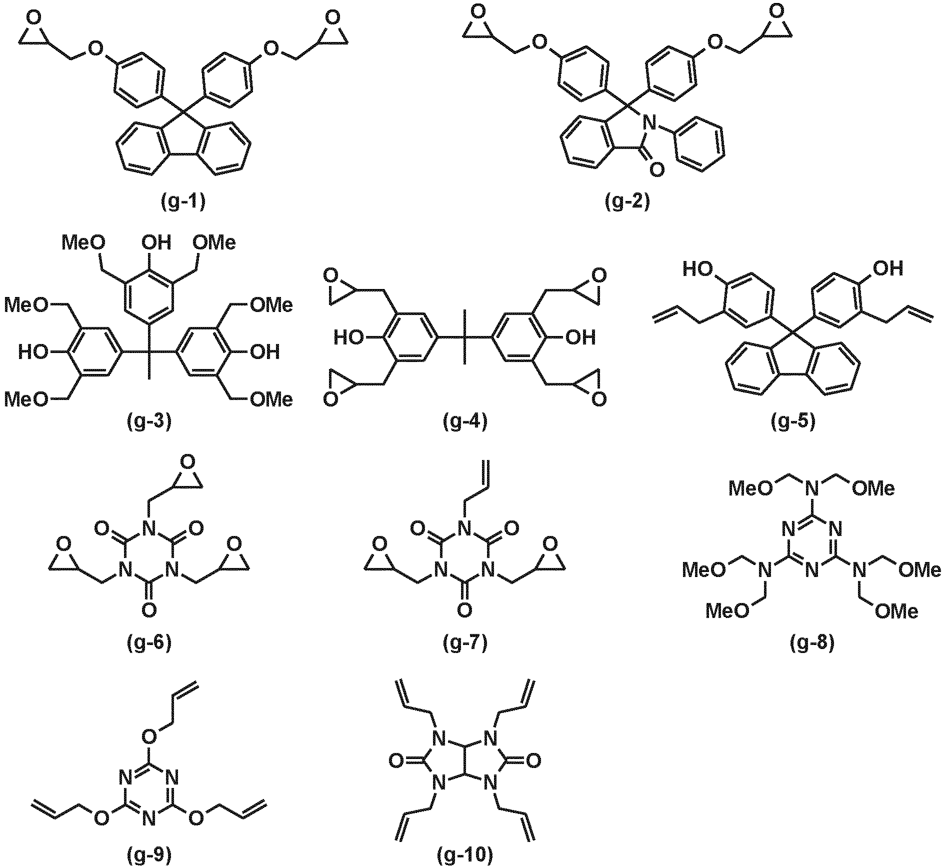

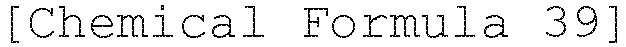

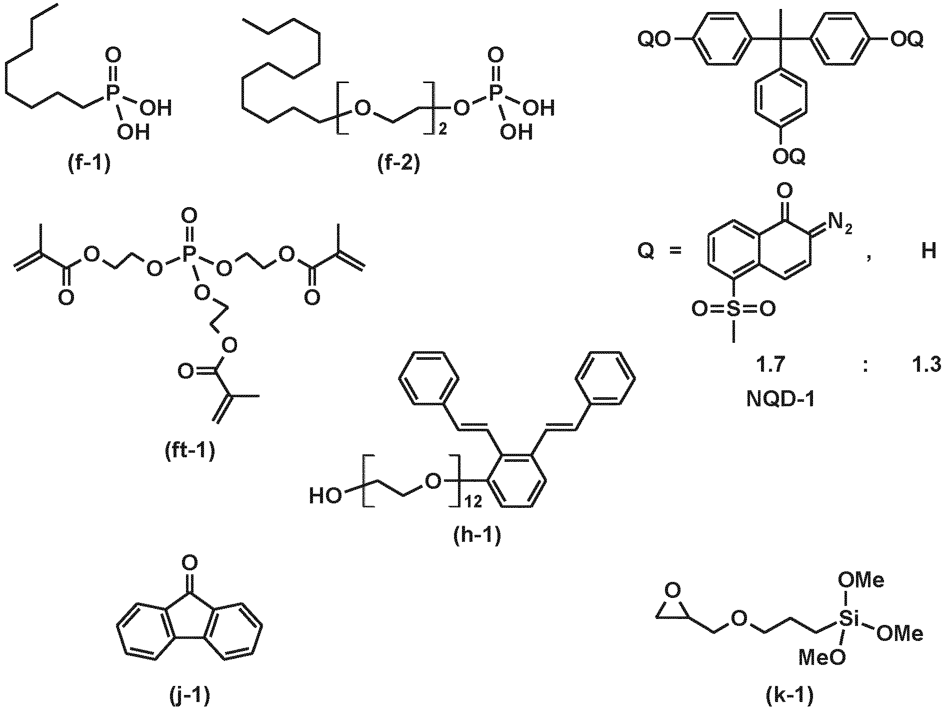

### <Example 1>

A composition 1 was prepared with the composition described in Table 7-1. First, a preparation liquid containing no colorant (D) was prepared, and then the pigment dispersion liquid and the preparation liquid were mixed to prepare a composition. Using PGMEA/EDM/MBA = 70/20/10 (mass ratio) as a solvent, the composition was prepared so that the solid content concentration was 15% by mass. The solution of the obtained composition was filtered through a 0.45 µmϕ filter and used.

### <Preparation of cured film of composition>

The prepared composition 1 was applied onto an ITO/Ag substrate by spin coating at an optional rotation speed with the use of a spin coater (MS-A100; manufactured by Mikasa Co., Ltd.), and then prebaked at 120°C for 120 seconds with the use of a buzzer hot plate (HPD-3000BZN; manufactured by AS ONE Corporation) to prepare a prebaked film of about 1.8 µm in film thickness. The prebaked film prepared was subjected to spray development with a 2.38% by mass TMAH aqueous solution or cyclopentanone with the use of a small-size development device (AD-1200; manufactured by TAKIZAWA SANGYO K.K.) for photolithography, and the time at which the prebaked film (unexposed portion) was completely dissolved (Breaking Point; hereinafter, a "BP") was measured.

In the same manner as mentioned above, a prebaked film was prepared, and the prepared prebaked film was subjected to exposure for patterning with i-ray (wavelength: 365 nm), h-ray (wavelength: 405 nm), and g-ray (wavelength 436 nm) of an ultra-high pressure mercury lamp through a gray scale mask (MDRM MODEL 4000-5-FS; Opto-Line International, Inc.) for sensitivity measurement with the use of a double-sided alignment single-sided exposure apparatus (Mask Aligner PEM-6M; manufactured by Union Optical Co., Ltd.). The exposure energy was defined as an exposure energy (value of i-line illuminance meter) at which a space pattern corresponding to an opening can be formed with a dimension width of 18 µm in a line-and-space pattern of 20 µm. After the exposure, the film was subjected to development with a 2.38% by mass TMAH aqueous solution with the use of a small-size development device (AD-1200; manufactured by TAKIZAWA SANGYO K.K.) for photolithography, and rinsed with water for 30 seconds to produce a developed film of Composition 1. The development time was BP + 20 seconds. When a pattern cannot be formed after development with a 2.38% by mass TMAH aqueous solution, an exposed film is prepared in the same manner as in the above method, and after the exposure, a pattern is formed by using a small-size development device for photolithography (AD-1200; (manufactured by Takizawa Sangyo Co., Ltd.), and rinsed with water for 30 seconds to prepare a developed film of the composition 1. The development time was BP + 20 seconds. After the development, with the use of a high-temperature inert gas oven (INH-9CD-S; manufactured by Koyo Thermo Systems Co., Ltd.), thermal curing was performed at 250°C to produce a cured film of the composition 1 with about 1.2 um in film thickness. As thermal curing conditions, the temperature was raised to 250°C at a temperature raising rate of 3.5°C/min in a nitrogen atmosphere having an oxygen concentration of 20 ppm by mass or less, heat treatment was performed at 250°C for 60 minutes, and then the temperature was cooled to 50°C.

The cured film was analyzed by a method such as nuclear magnetic resonance spectroscopy, infrared spectroscopy, or time-of-flight secondary ion mass spectrometry, and the structural unit of the resin and the structure of the compound contained in the cured film were analyzed. It was confirmed that the cured film obtained by curing the composition 1 by the above-described method contained the following resin and compound. That is, the cured film obtained by curing composition 1 contains a compound having a structure derived from each constituent component contained in the composition 1.

Structure derived from resin (A1): A resin having a structural unit represented by general formula (1).

Structure derived from resin (A2): A resin having a structural unit represented by the general formula (61).

Structure derived from resin (A3): A resin having a structural unit represented by general formula (36).

Structure derived from compound (B1): A compound having a fluorene structure.

Structure derived from compound (Cl-1): A compound having a benzocarbazole structure.

Black pigment (D1a): A benzofuranone-based black pigment (D1a-1a), and a pigment having a structure represented by general formula (161).

Structure derived from compound (F1): A compound having a phosphonate ester structure.

### <Examples 2 to 172 and Comparative Examples 1 to 16>

In substantially the same manner as in Example 1, compositions 2 to 188 were prepared to each have composition indicated in Tables 7-1 to 18. In Tables 7-1 to 18, the numerical values in parentheses represent parts by mass of the solid content of each component. The compositions 133 to 188 were prepared using PGMEA/EL/GBL = 50/40/10 (mass ratio) as a solvent such that the solid content concentration of the composition was 20% by mass. The additional amount of the compound containing a specific metal element was adjusted so that the content of the specific metal element in the total solid content of the composition was the composition shown in Table 17. The additional amount of the specific nitrogen-containing compound was adjusted so that the content in the total solid content of the composition was the composition described in Table 17.

Using the obtained compositions, films of the compositions were formed on substrates, and evaluated for photosensitive property, the properties of the cured films, and light-emitting characteristics in the same manner as in Example 1. These evaluation results and the weakly acidic group equivalent and double bond equivalent of each composition are collectively shown in Table 7-1 to Table 18. For ease of comparison, Table 7-2 shows the compositions and evaluation results of Example 1 and Example 2, Tables 8 and 9 show the compositions and evaluation results of Example 1 and Example 41, Tables 10, 11, 12-1, and 13 show the compositions and evaluation results of Example 1, and Table 14 shows the compositions and evaluation results of Example 1 and Example 41. In addition, in Tables 16 and 17, the composition and evaluation results of Example 125 are described.

In Tables 7-1 to 7-3, various characteristics were evaluated using compositions in which one or more selected from the group consisting of the resin (A1), the resin (A2), and the resin (A3) were changed as the alkali-soluble resin (A) .

In Table 8, various characteristics were evaluated by changing the content ratio of the alkali-soluble resin (A) and the compound (B) and the weakly acidic group equivalent and the double bond equivalent in the composition in which the combination ratio in the compound (B) was changed.

In Table 9, with compositions in which one or more selected from the group consisting of the compound (B), the photosensitive agent (C), and the compound (C1-1) were changed, various characteristics were evaluated by changing the weakly acidic group equivalent and the double bond equivalent.

In Table 10, various characteristics were evaluated using compositions in which one or more selected from the group consisting of compound (F), compound (H)s, and cross-linking agent (G) were changed.

In Table 11, various characteristics were evaluated with compositions in which the type of the black pigment (D1a) was changed. In Example 99 in Table 12-1, various characteristics were evaluated using a composition not containing the colorant (D) and the dispersant (E). In addition, Example 100 and Example 101 in Table 12-1 had positive-type photosensitivity, and various characteristics were evaluated using compositions in which the presence or absence of the colorant (D) and the dispersant (E) was changed.

In Table 12-1, regarding Example 1, Examples 65 and 67 in Table 9, and Example 80 in Table 10 (composition with different compound (C1-1), photosensitive agent (C), or compound (F)), and Examples 97 to 101 in Table 12-1 (compositions with different types or presence or absence of black pigments (D1a), or compositions with positive-type photosensitivity), the content of a chlorine element, a bromine element, a sulfur element, or a phosphorus element is described, and the evaluation results of the reliability and current density-voltage characteristics of light-emitting characteristics are summarized.

In Table 12-2, various characteristics were evaluated with compositions in which additives containing the chlorine element, the bromine element, the sulfur element, or the phosphorus element were changed. Table 12-2 shows the contents of the chlorine element, the bromine element, the sulfur element, or the phosphorus element in Example 102 to 121, and summarizes the evaluation results of the reliability and the current density- voltage characteristic light-emitting characteristic with respect to the light-emitting characteristic.

In Table 13, various characteristics were evaluated with the composition in which the inorganic particles (I) were changed.

In Table 14, in Comparative Examples 1 to 8, various characteristics were evaluated using a composition in which the weakly acidic group equivalent and/or the double bond equivalent was not in a specific range.

In Table 15, compositions in which the resin (A1), the resin (A2), or the resin (A3) was changed as the alkali-soluble resin (A) were evaluated for sensitivity, mechanical properties, and migration resistance.

In Table 16, the sensitivity, mechanical properties, and migration resistance were evaluated with the composition in which the compound (B4) to the compound (B7), the cross-linking agent (G), or the inorganic particle (I) was changed.

In Table 17, the sensitivity, mechanical properties, and migration resistance were evaluated with compositions in which the content of a specific nitrogen-containing compound or the content of a specific metal element was changed.

In Table 18, in Comparative Example 9 to 16, the sensitivity, mechanical properties, and migration resistance were evaluated using a composition in which the weakly acidic group equivalent and/or the double bond equivalent was not in a specific range.

When a composition having positive-type photosensitivity was used, the development time was set to 60 seconds, 90 seconds, or 120 seconds, and using a gray scale mask for sensitivity measurement (MDRM MODEL 4000-5-FS; manufactured by Opto-Line International), the optimum exposure energy (i-line illuminance meter value) at which a space pattern corresponding to an opening could be formed with a dimension width of 18 µm in a 20 µm line-and-space pattern was determined. When a composition having positive-type photosensitivity was used, as thermal curing conditions, the temperature was raised to 200°C at a temperature raising rate of 3.5°C/min in a nitrogen atmosphere having an oxygen concentration of 20 ppm by mass or less, heat treatment was performed at 200°C for 60 minutes, and then the temperature was cooled to 50°C.

### <Contents of chlorine element, bromine element, sulfur element, and phosphorus element in composition>

The contents of the chlorine element, bromine element, sulfur element, and phosphorus element in the composition were measured by combustion ion chromatography under the following measurement conditions. The composition was burned and decomposed in a combustion tube of an analyzer, the generated gas was absorbed into an absorbent, and a part of the absorbent was analyzed by ion chromatography. When the element content is not described, it indicates that the element is not detected.

### <Combustion/absorption conditions>

System: AQF-2100H and GA-210 (manufactured by Mitsubishi Chemical Corporation)
Temperature of electric furnace: 900°C at the inlet and 1,000°C at the outlet
Gas: Ar/O₂ 200 mL/min, O₂ 400 mL/min
Absorbent: H₂O₂ 0.1%
Volume of absorbent: 5 mL
<Ion chromatography/anion analysis conditions>
System: ICS1600 (manufactured by DIONEX)
Mobile phase: 2.7 mmol/L Na₂CO₃, 0.3 mmol/L NaHCOs
Flow rate: 1.50 mL/min
Detector: electrical conductivity detector
Injection amount: 100 µL.

### <Content of specific nitrogen-containing compound in composition>

The content of the specific nitrogen-containing compound in the composition was measured by gas chromatography mass spectrometry using a calibration curve by a standard substance and liquid chromatography mass spectrometry. The content of the composition in the total solid content was calculated from the obtained measured value and the following formula. (Content in total solid content of composition) = (content in composition) × 100/(solid content concentration of composition [% by mass]).

### <Content of specific metal element in composition>

The content of a specific metal element in the composition was measured by inductively coupled plasma mass spectrometry using a calibration curve by a standard substance and inductively coupled plasma-atomic emission spectroscopy. The content of the composition in the total solid content was calculated from the obtained measured value and the following formula. (Content in total solid content of composition) = (content in composition) × 100/(solid content concentration of composition [% by mass]).

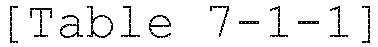

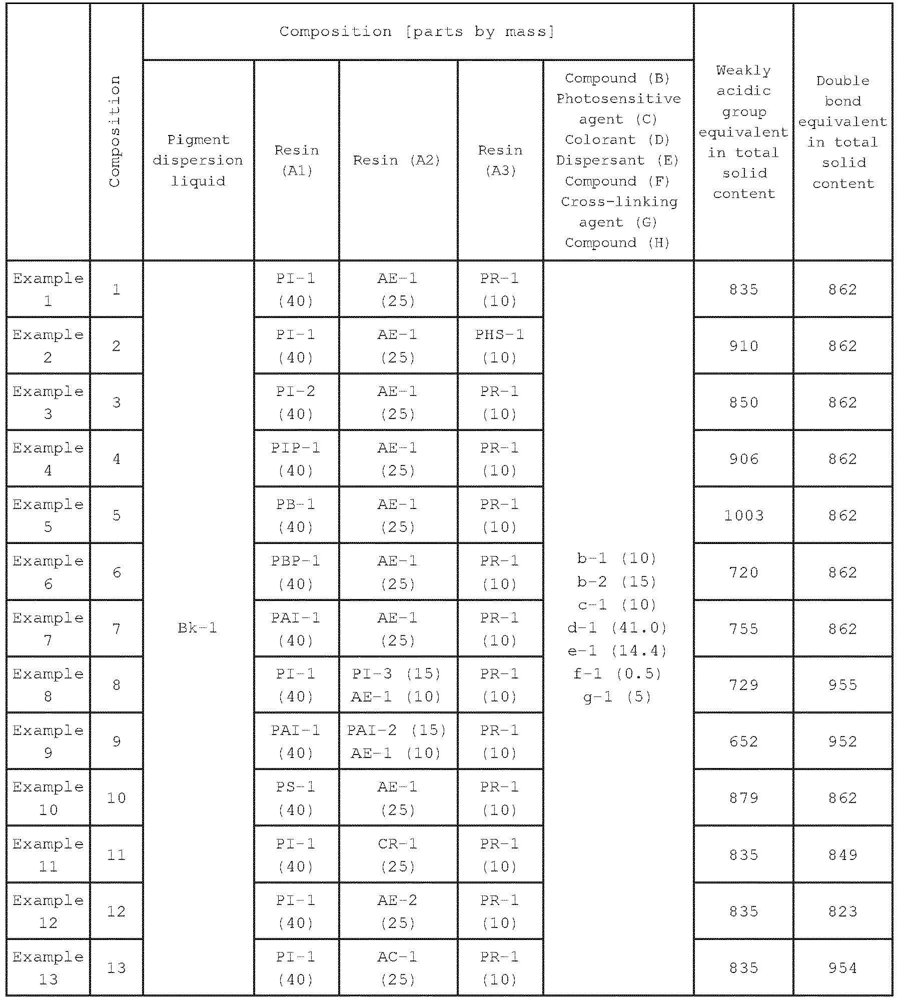

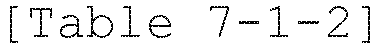

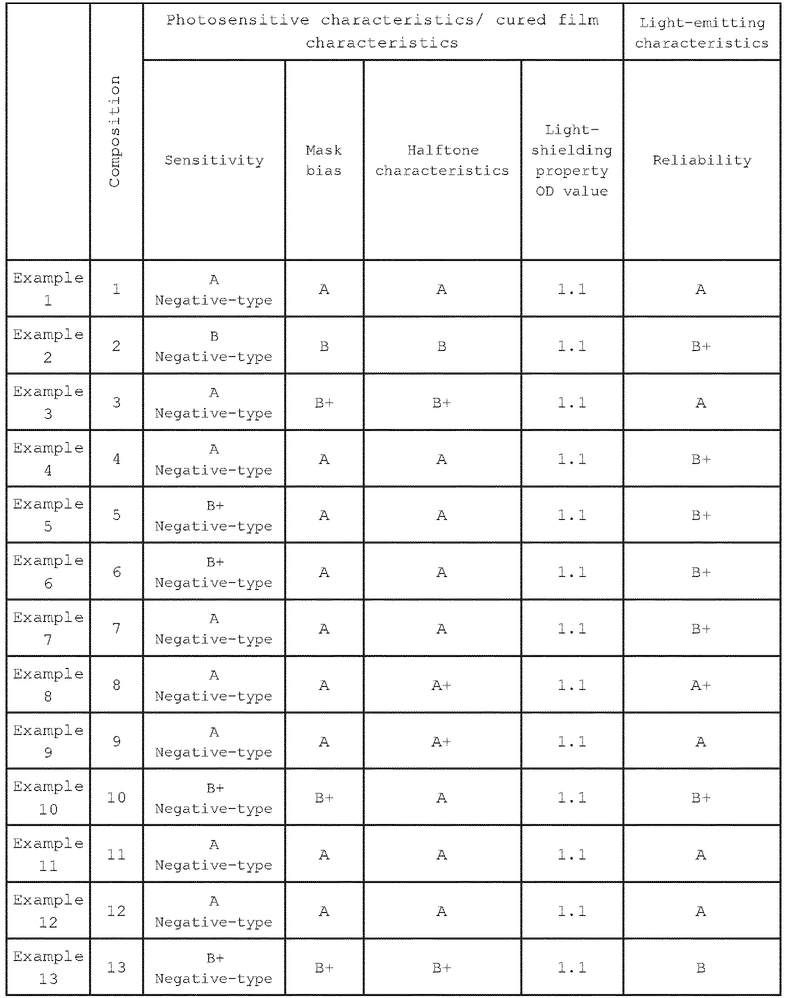

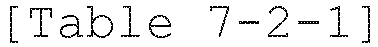

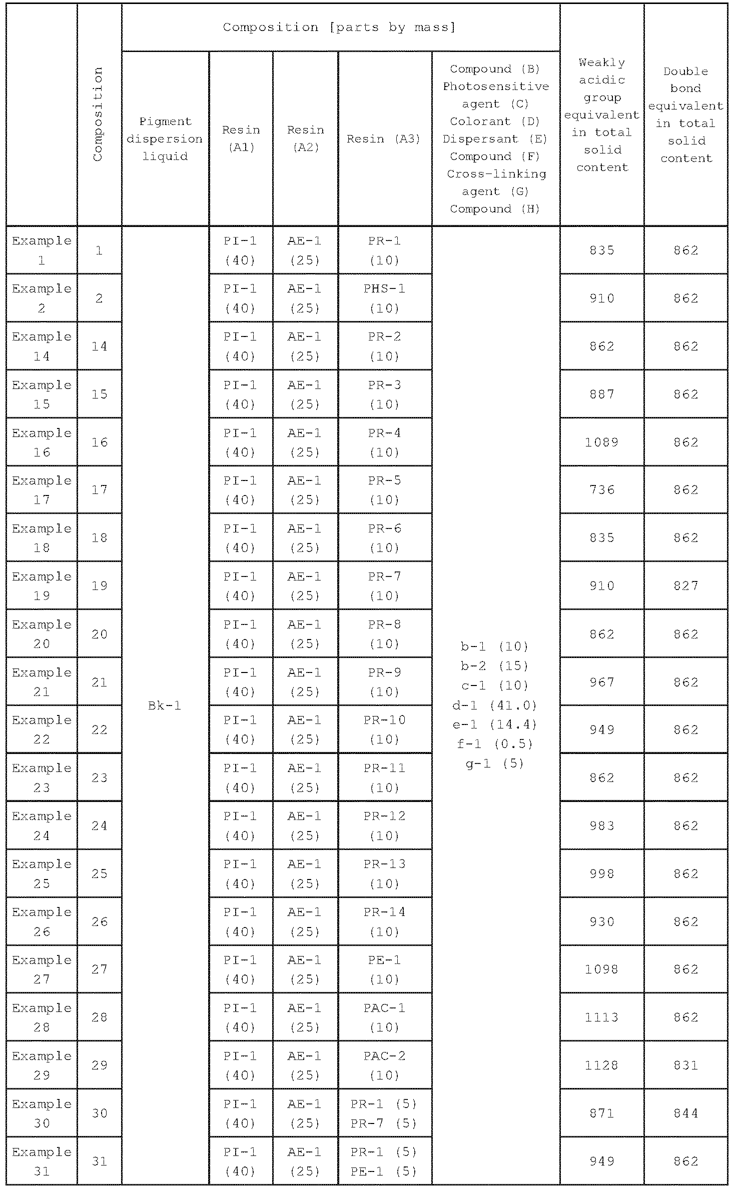

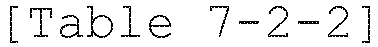

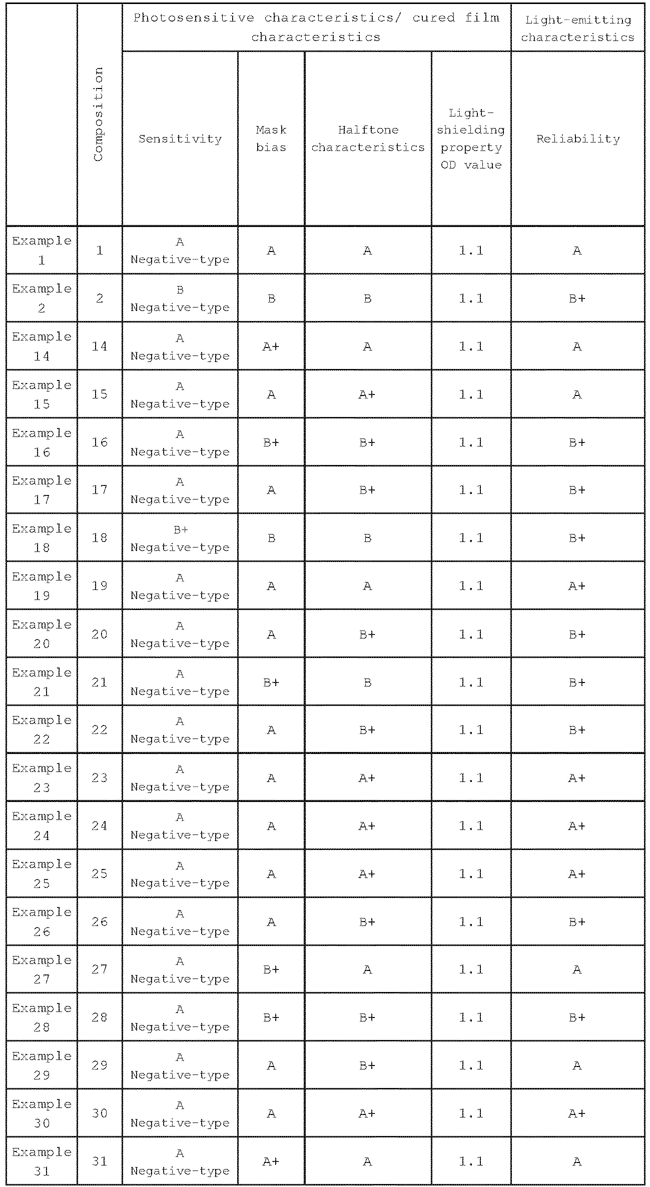

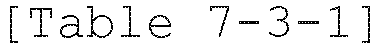

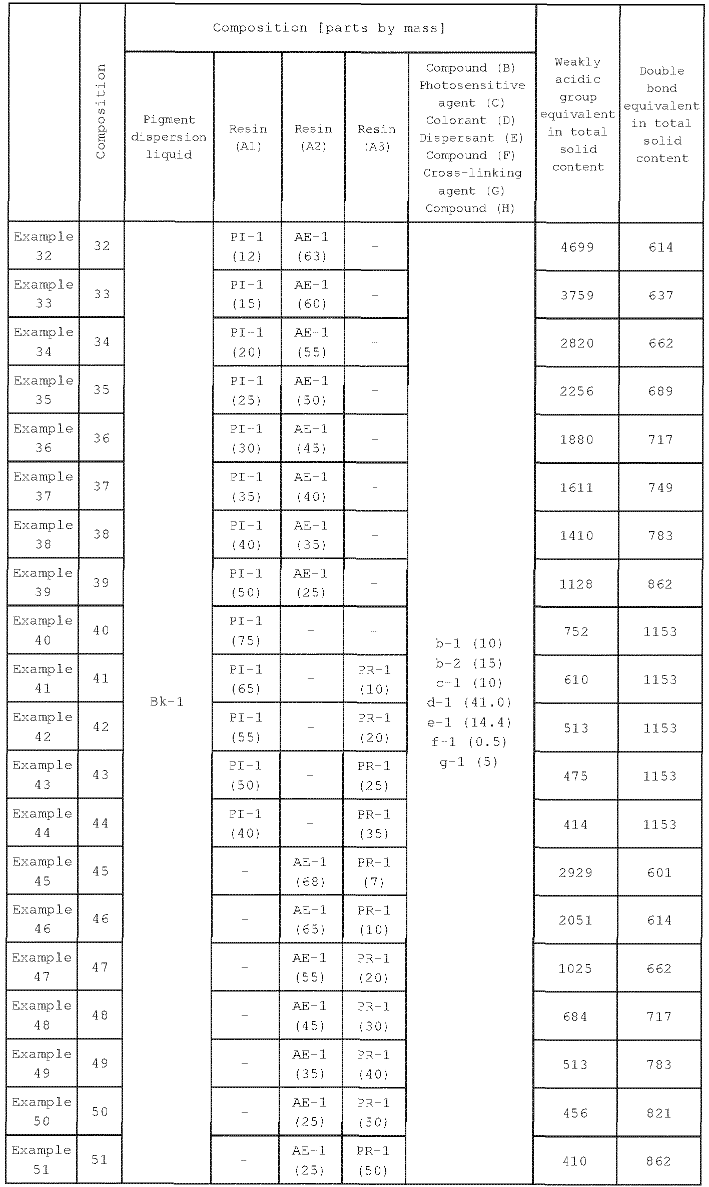

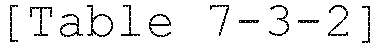

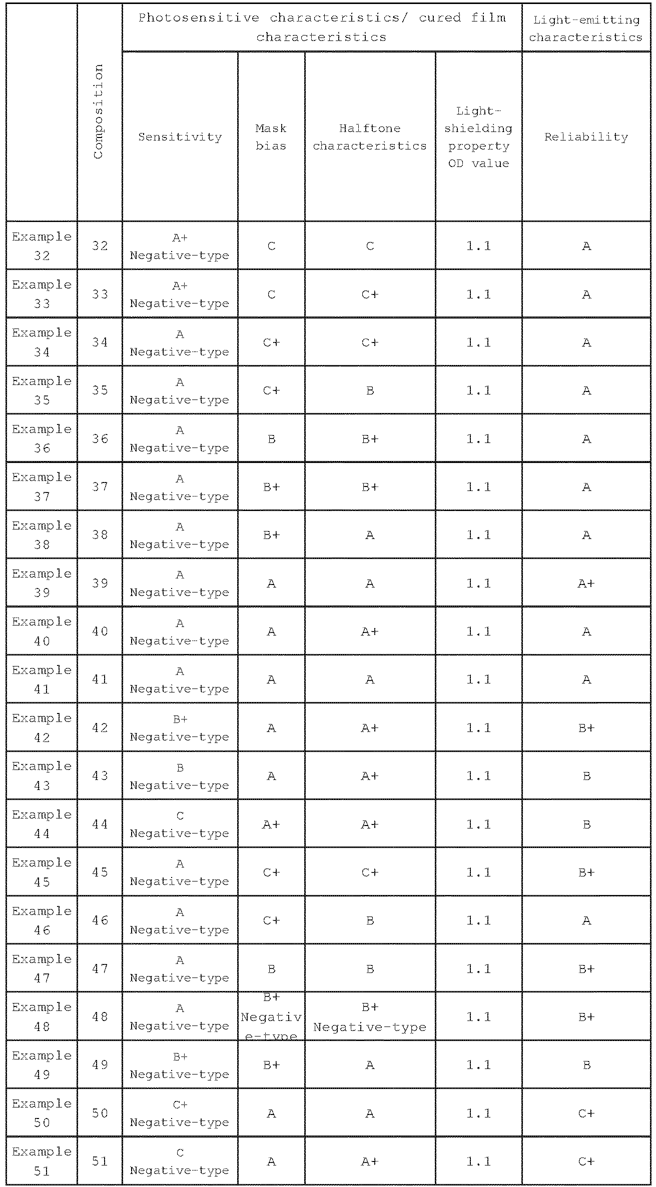

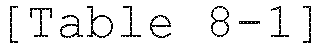

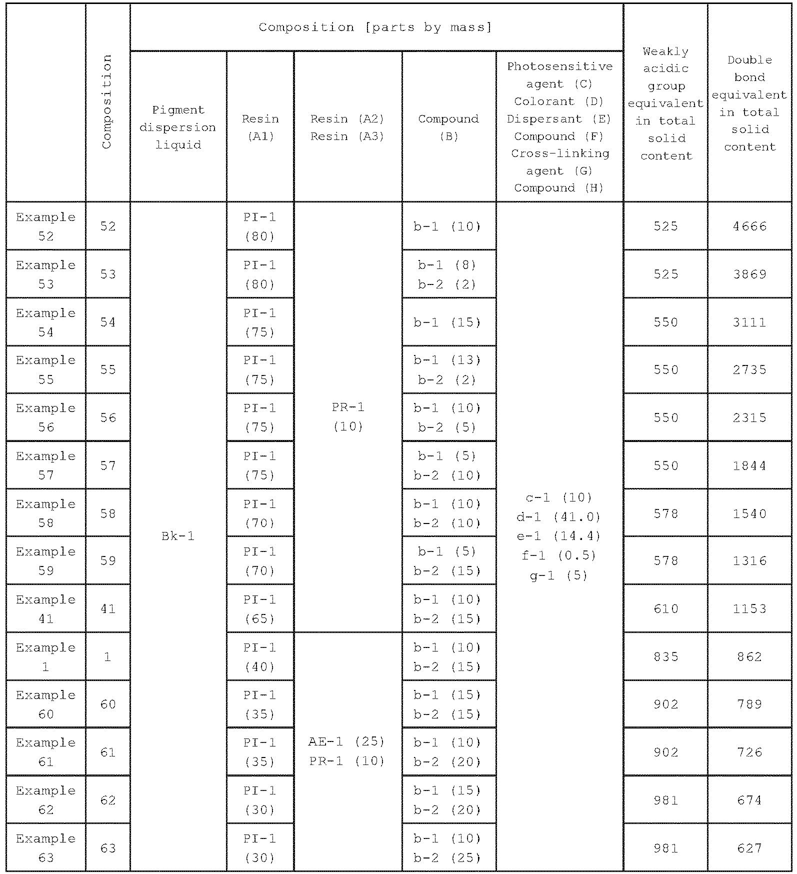

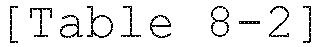

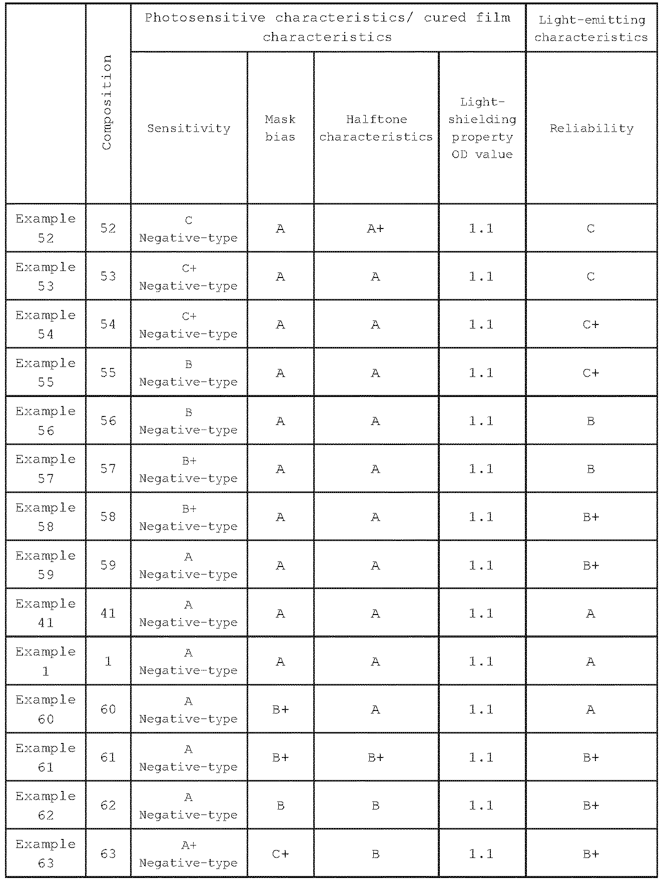

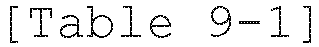

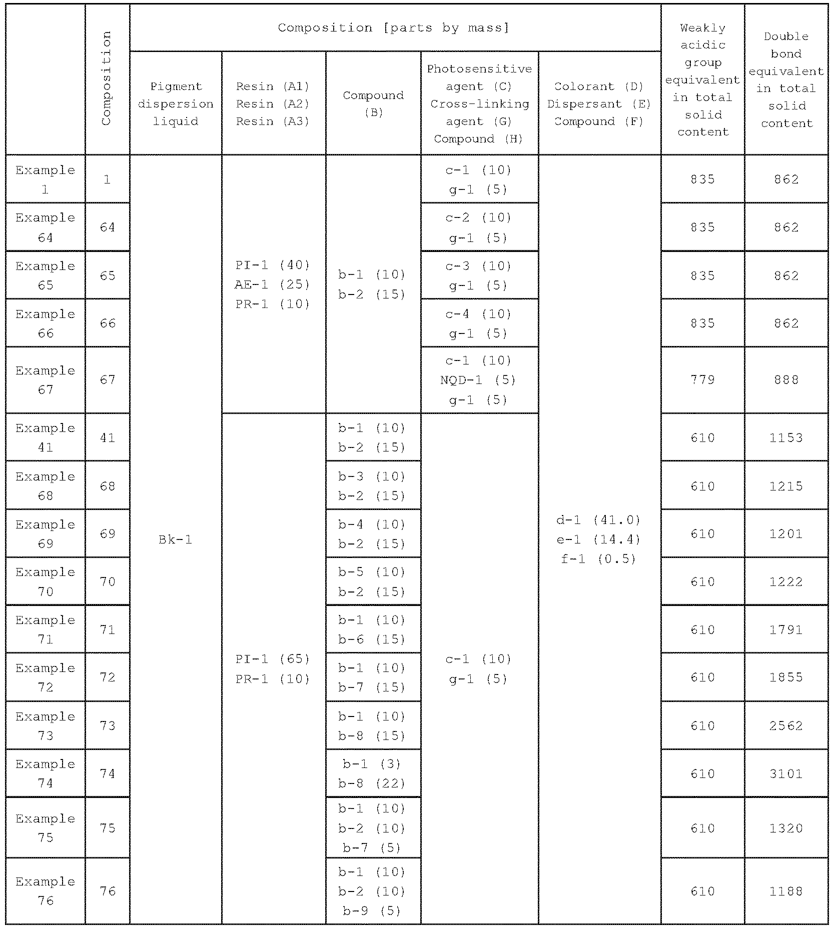

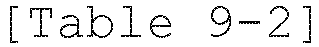

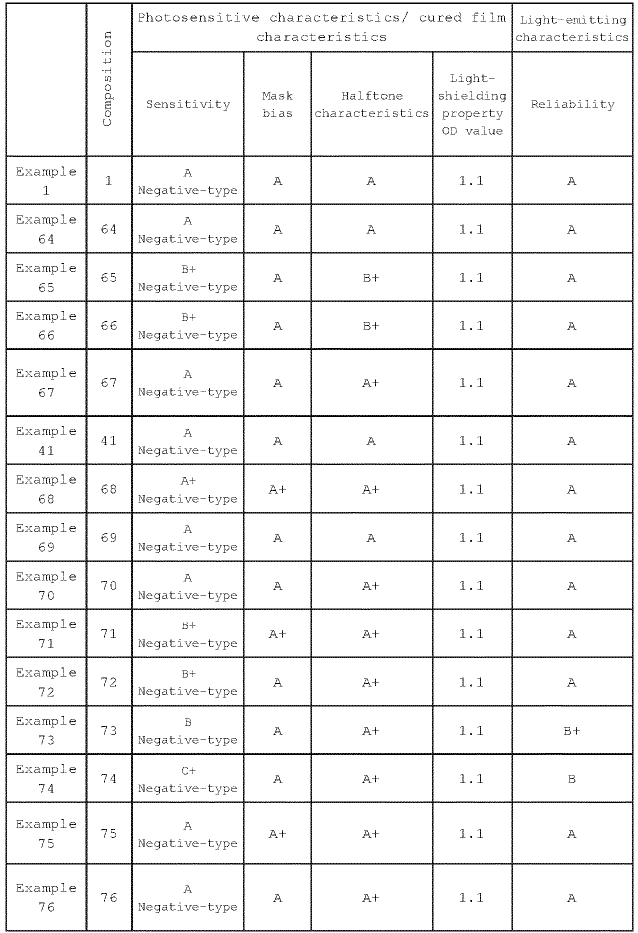

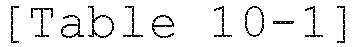

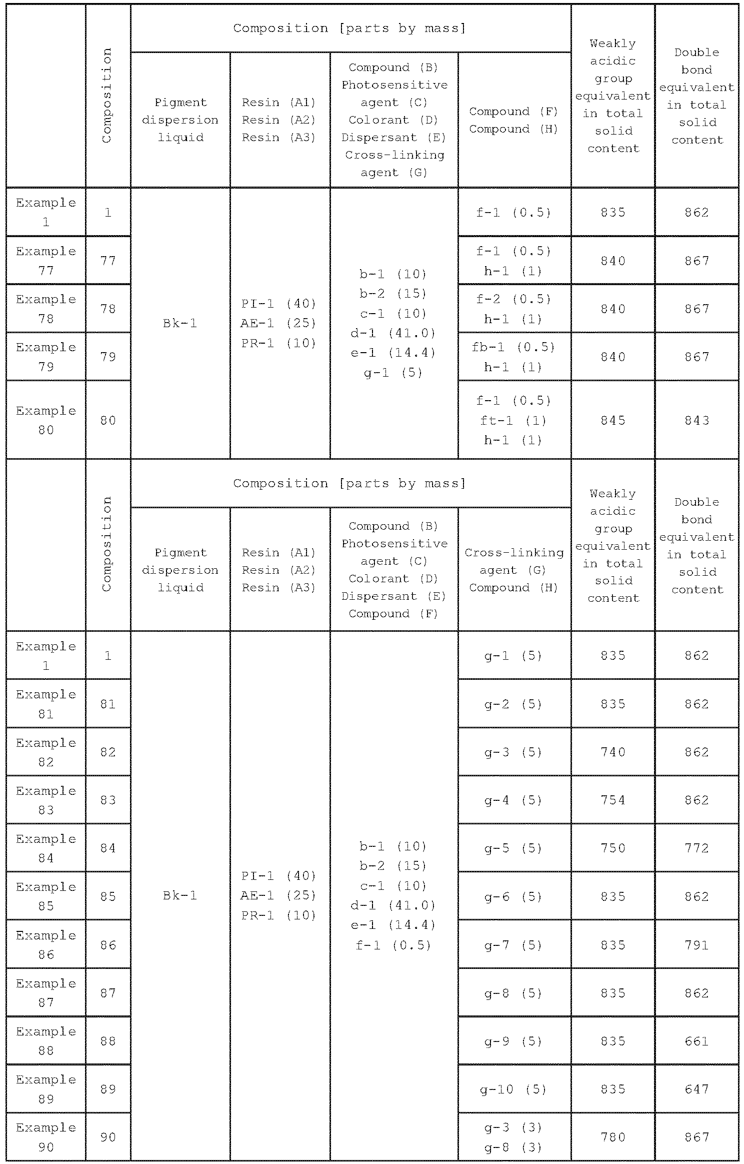

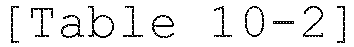

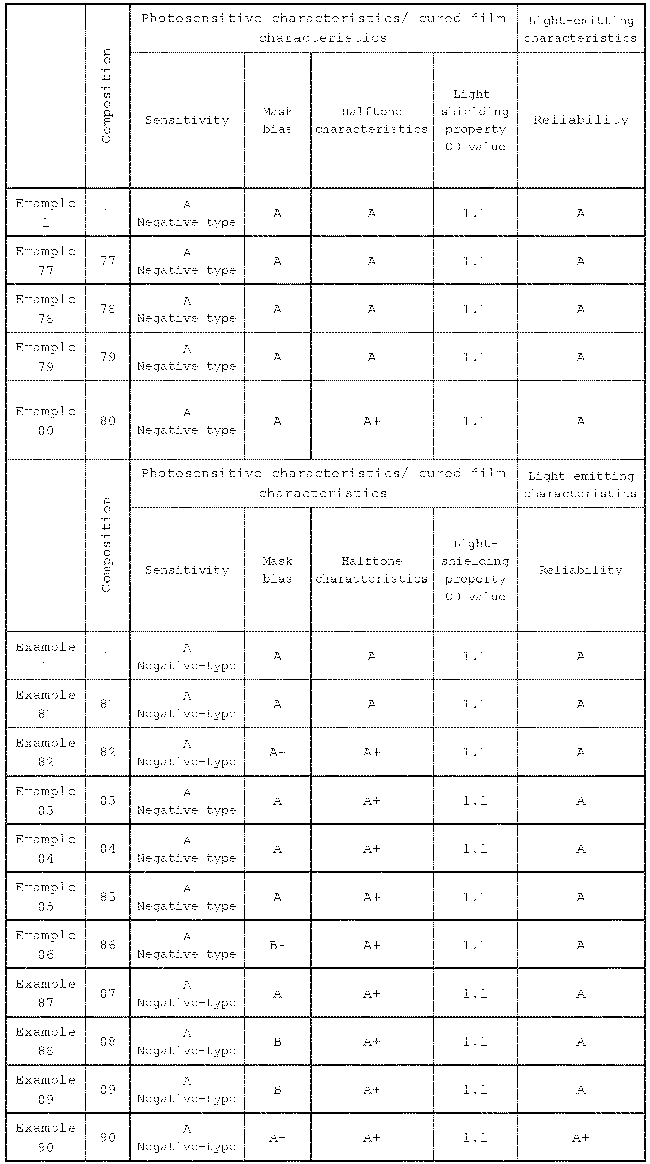

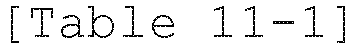

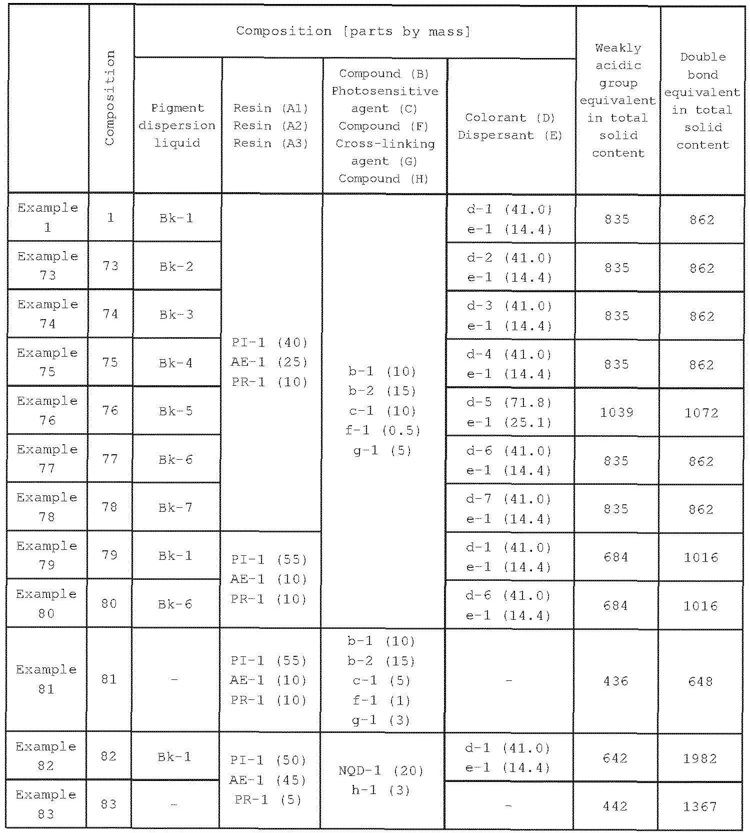

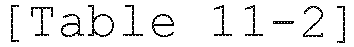

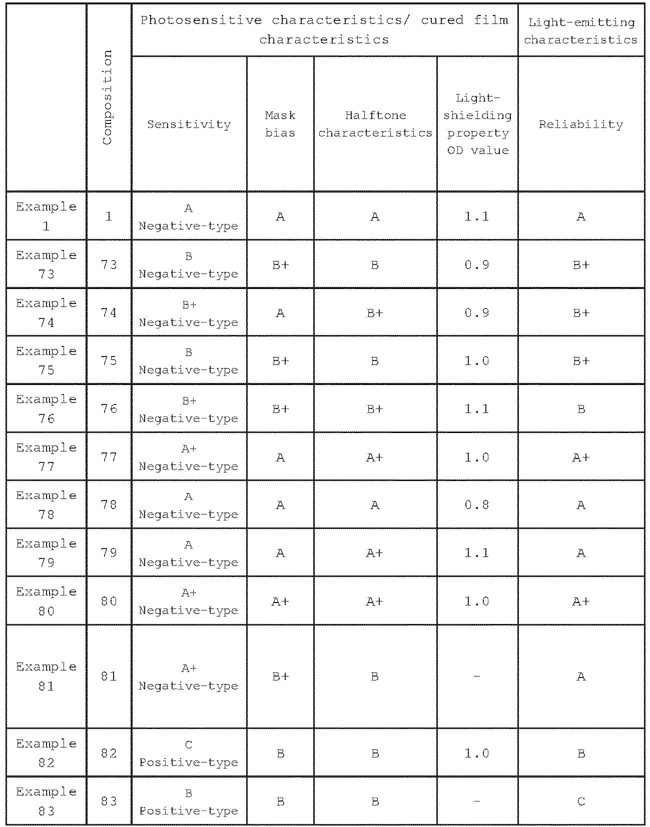

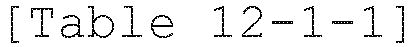

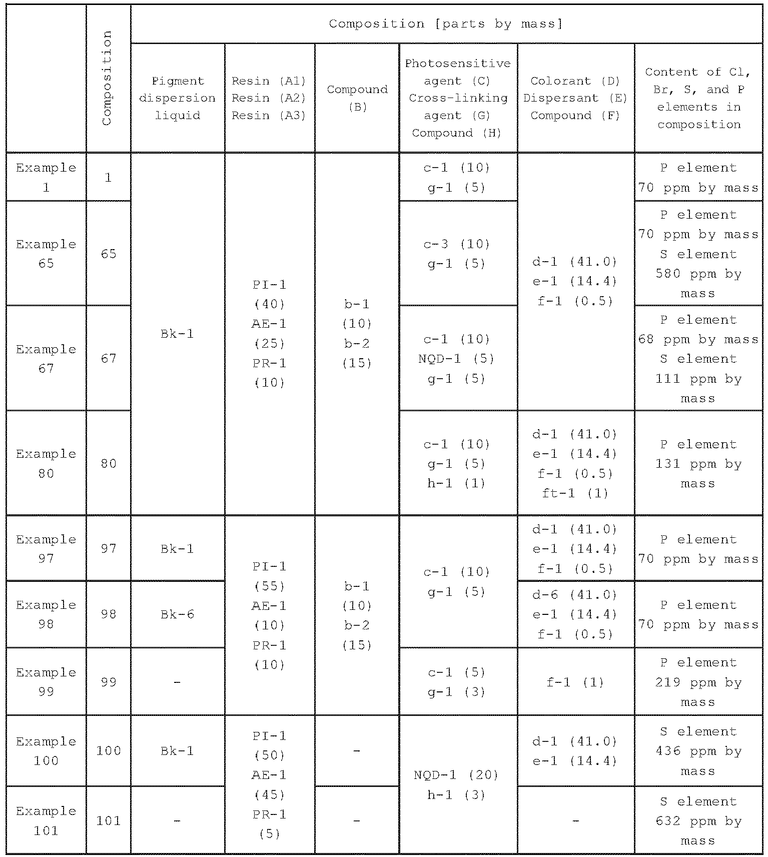

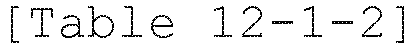

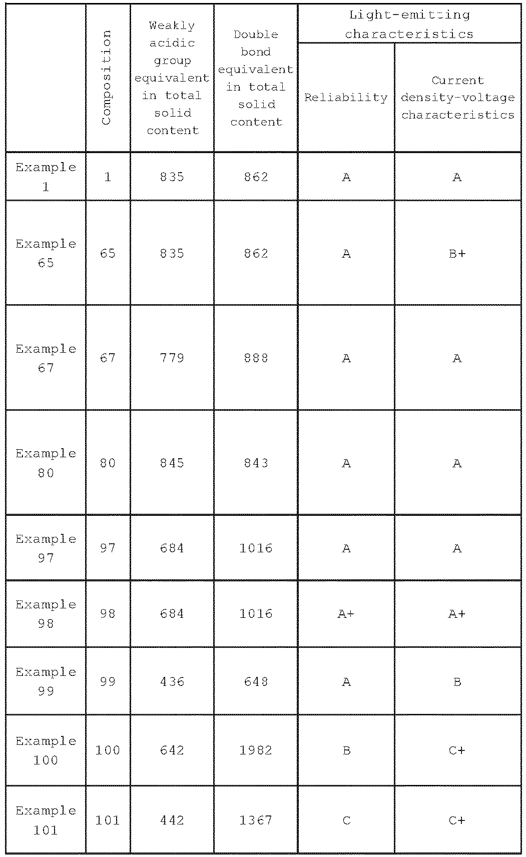

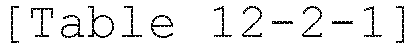

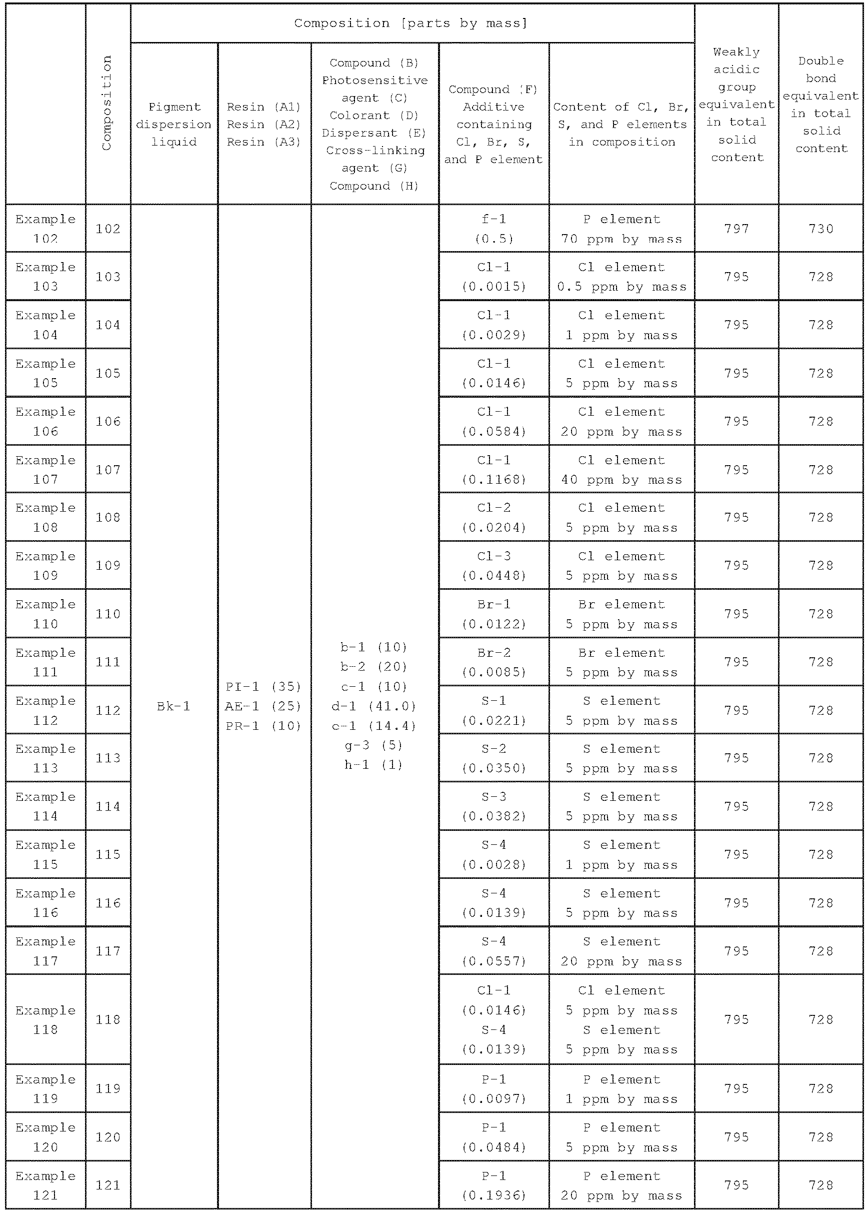

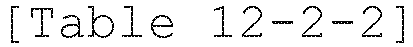

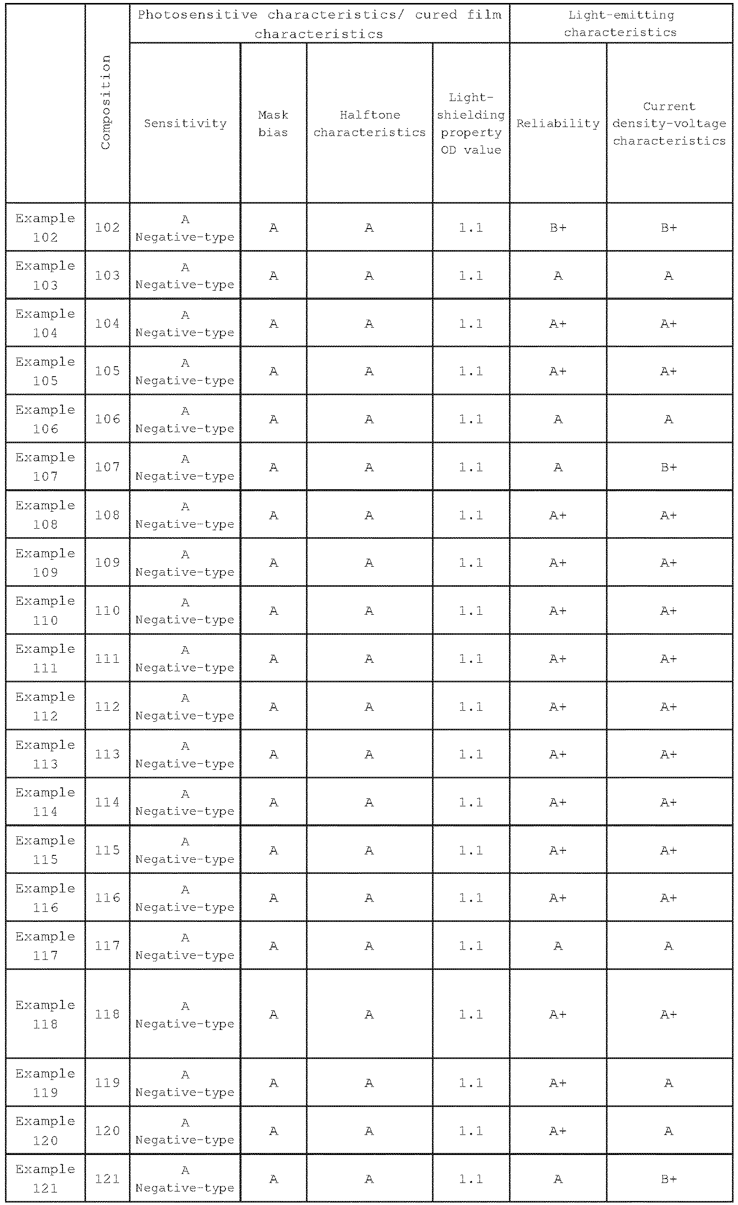

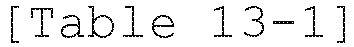

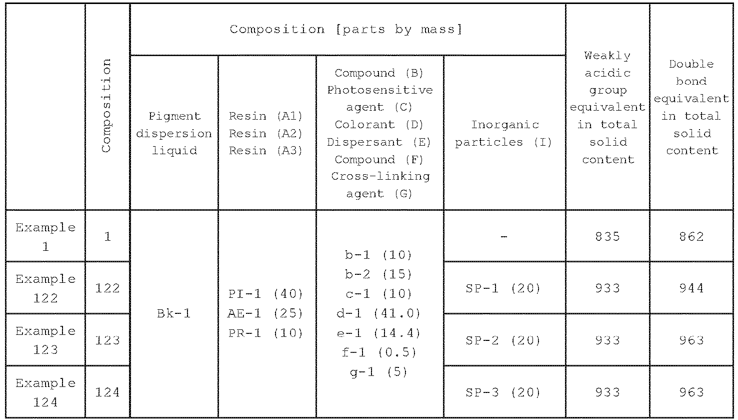

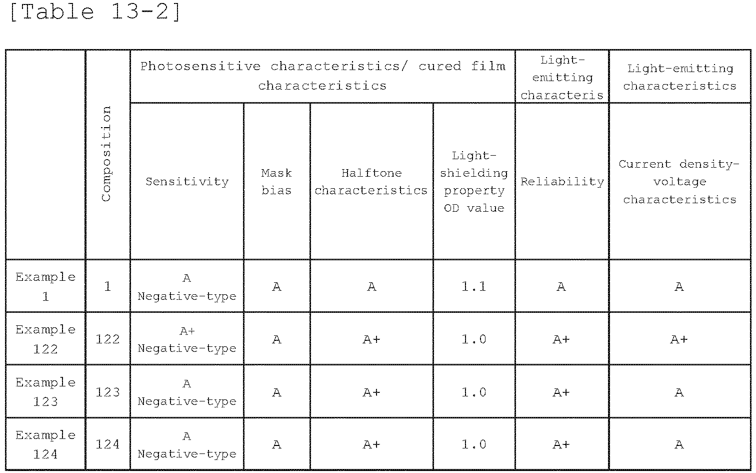

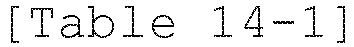

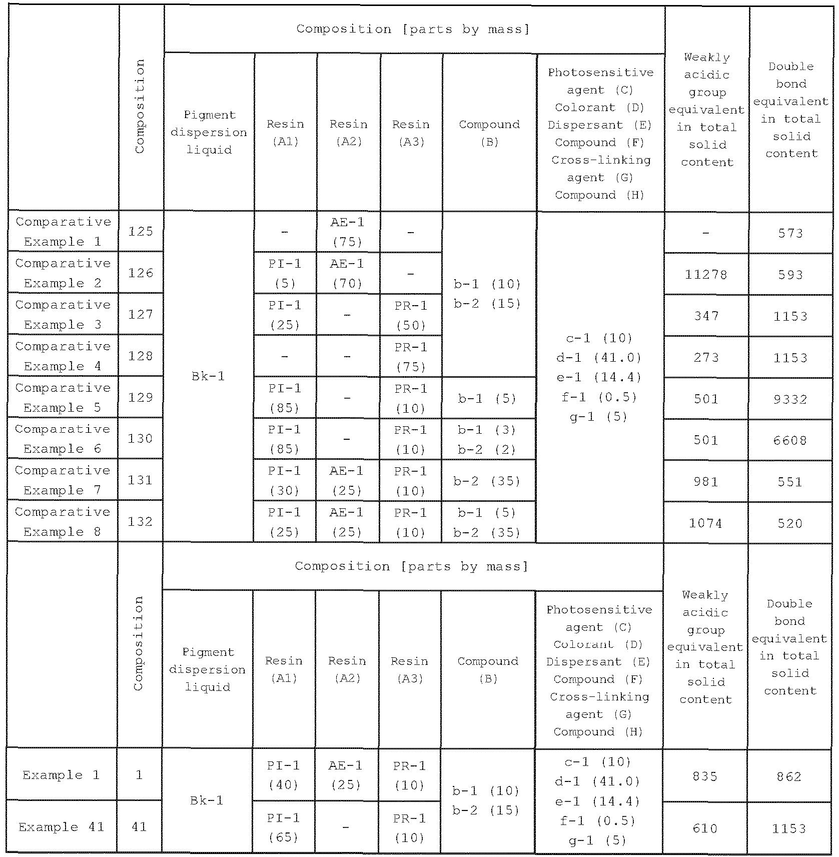

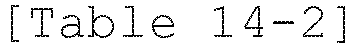

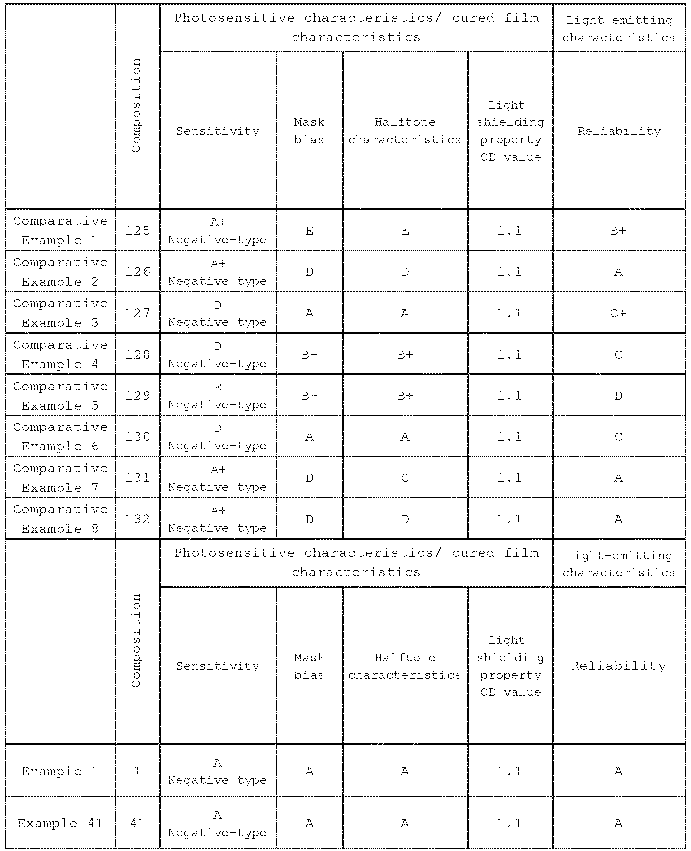

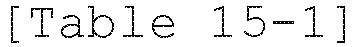

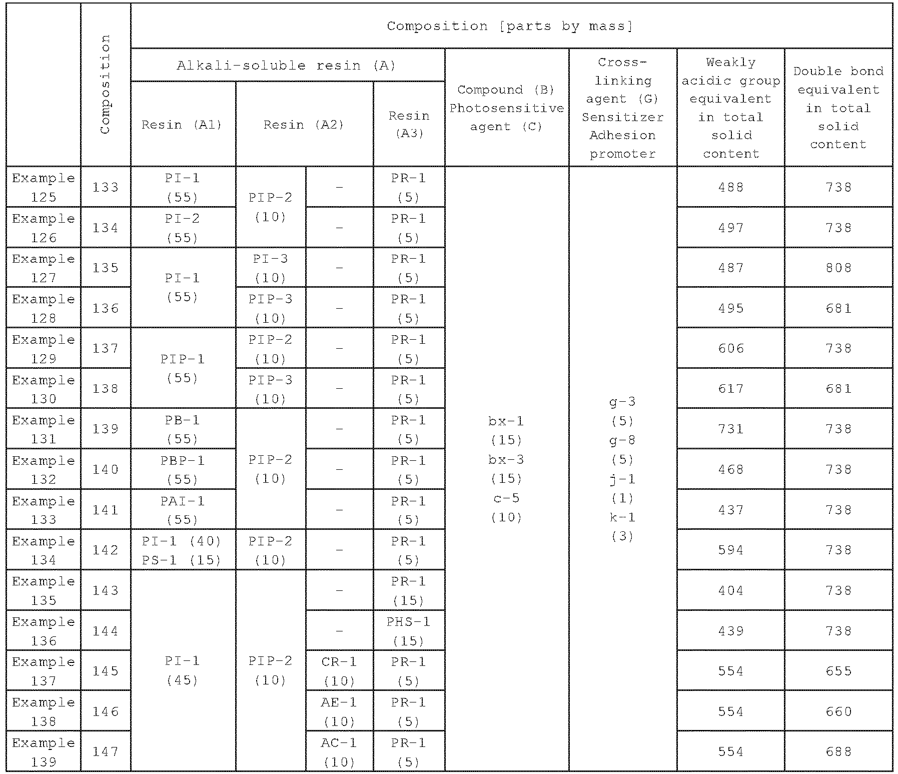

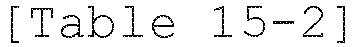

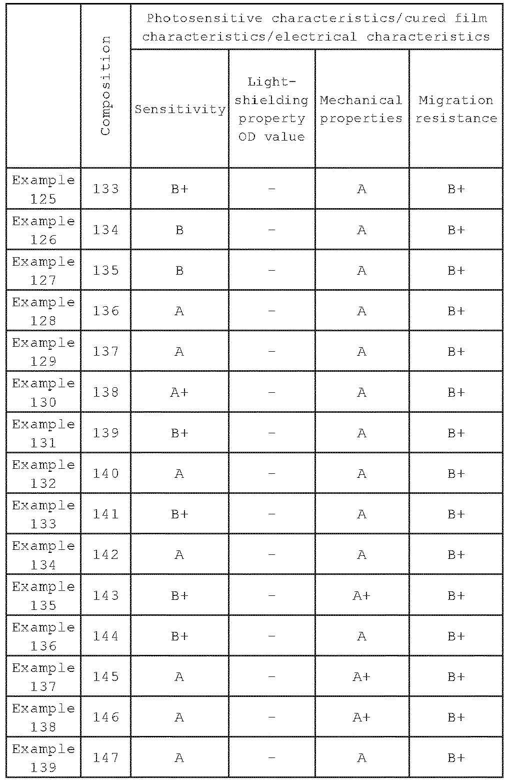

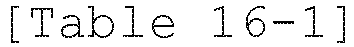

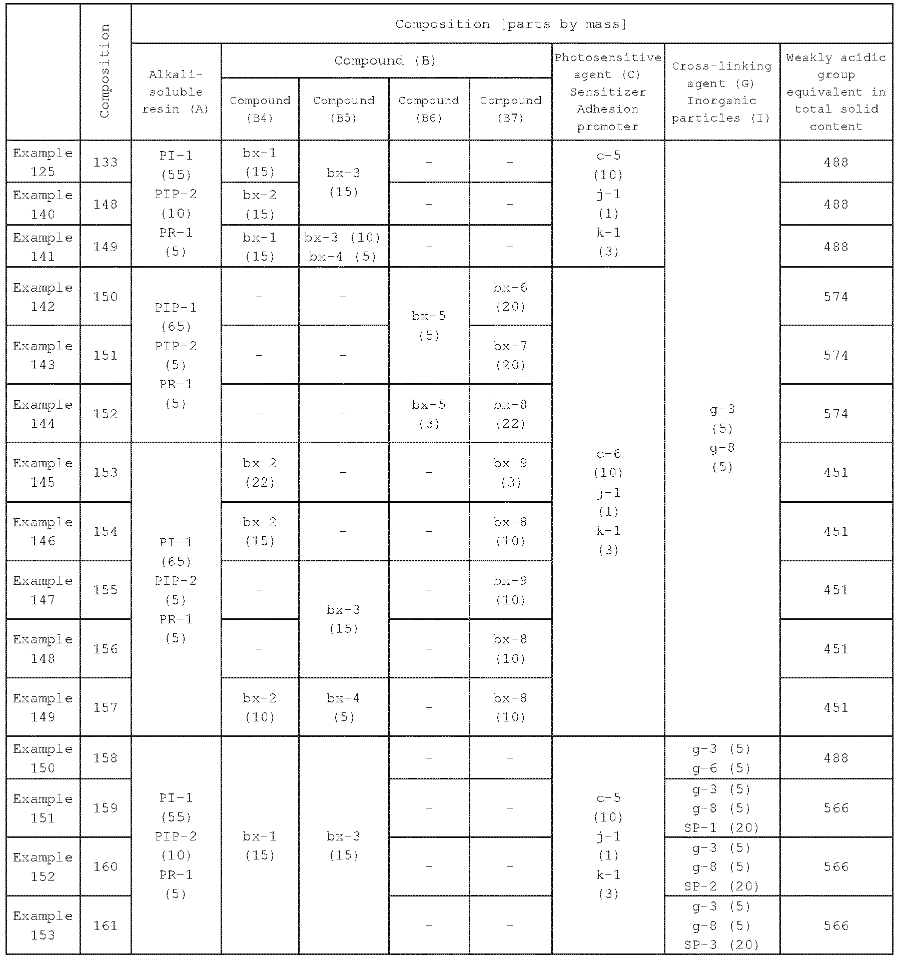

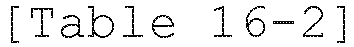

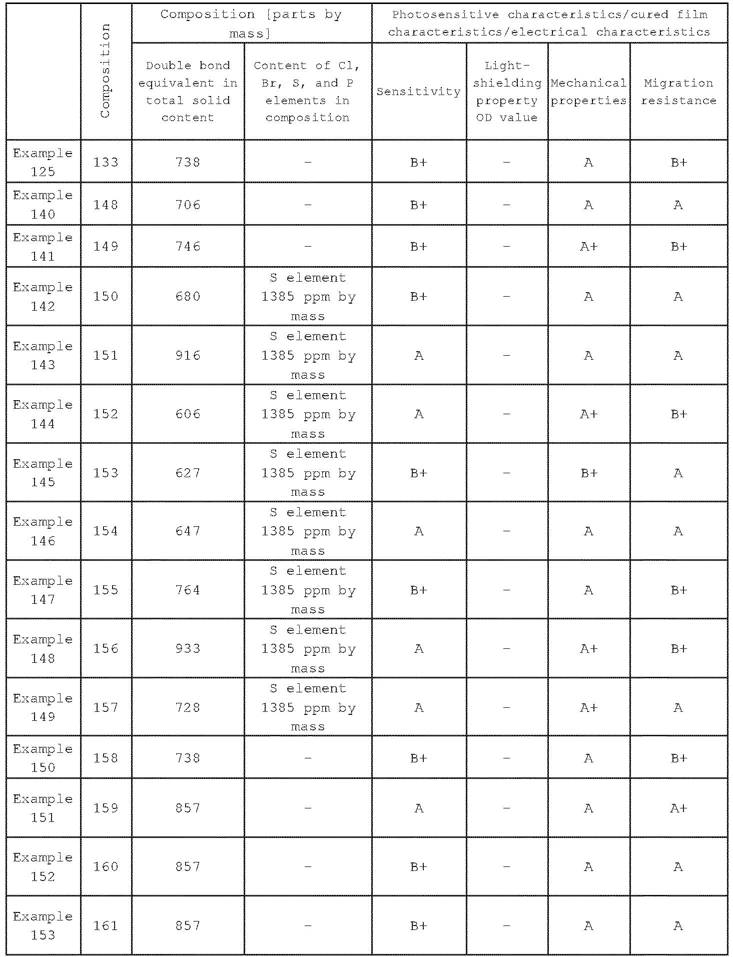

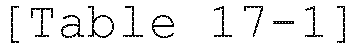

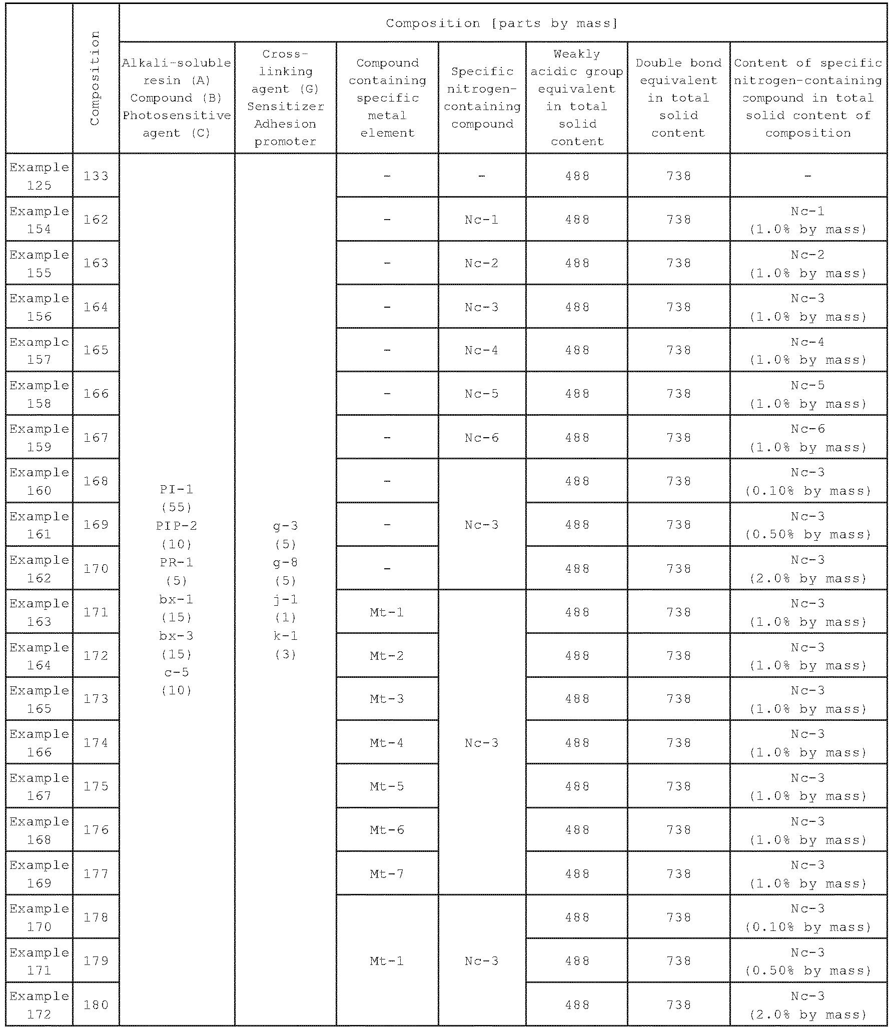

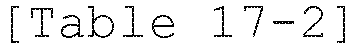

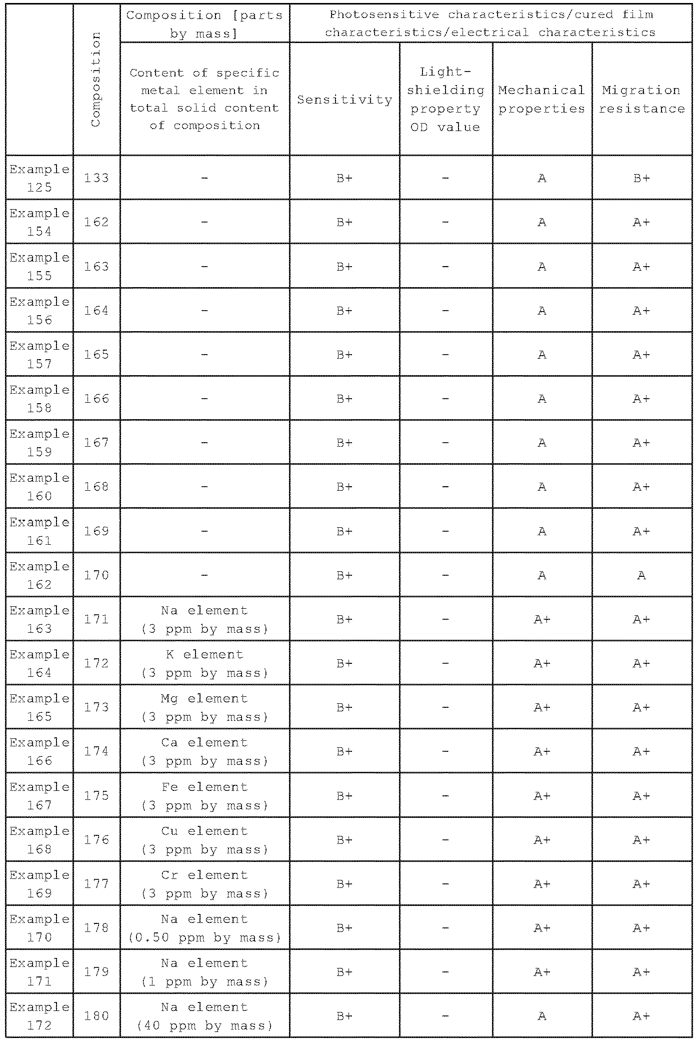

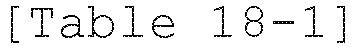

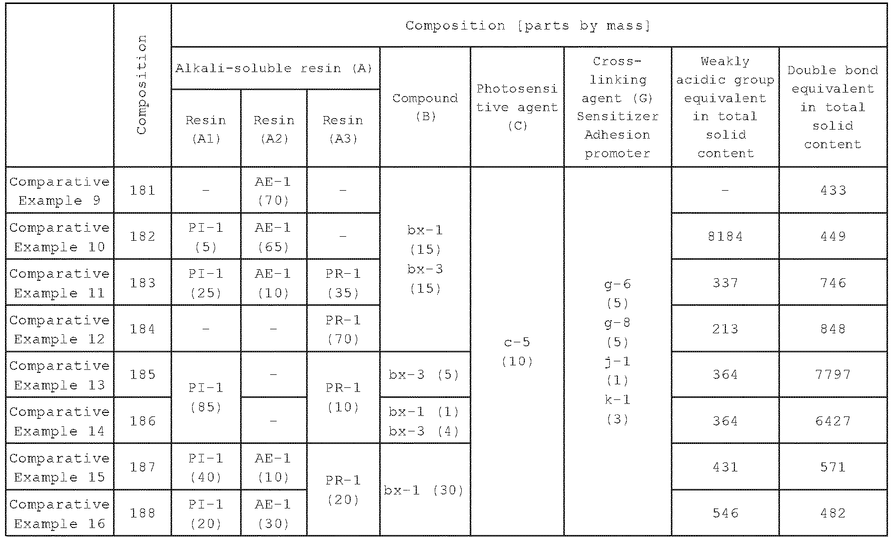

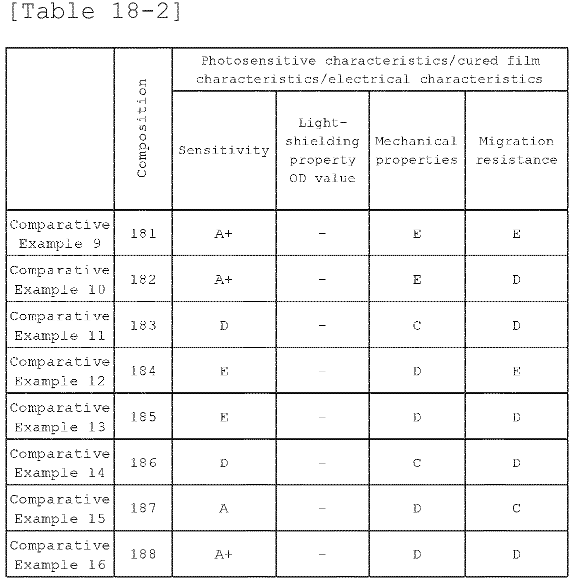

### DESCRIPTION OF REFERENCE SIGNS

1: Glass substrate
2: TFT
3: Cured film for TFT planarization
4: Reflective electrode
5a: Prebaked film
5b: Cured pattern
6: Mask
7: Active actinic rays
8, 51: Organic EL layer
9: Transparent electrode
10: Cured film for planarization
11: Cover glass
21: Si wafer
22: Al pad
23: Passivation layer
24: Insulation layer
25: Metal layer
26: Metal wiring
27: Insulation layer
28: Barrier metal layer
29: Scribe line
30: Solder bump
34: Thick film part
35a, 35b, 35c: Thin film part
36a, 36b, 36c, 36d, 36e: Inclined side in cross section of cured pattern
37: Horizontal side of underlying substrate
41: Light-transmitting portion
42: Light-shielding portion
43: Partial light-transmitting portion
47: Non-alkali glass substrate
48: First electrode
49: Auxiliary electrode
50: Pixel defining layer
52: Second electrode

## Claims

1. A photosensitive composition satisfying a condition (α) or a condition (β) below, wherein
a double bond equivalent in total solid content is 600 to 6,000 g/mol:
the condition (α): containing a compound of (I) described below and/or a compound of (II) described below:
(I) a compound having a weakly acidic group (WA) below and a radical polymerizable group;
(II) a compound having a weakly acidic group (WA) below and a compound having a radical polymerizable group; or
the condition (β): containing an alkali-soluble resin (A), a radical polymerizable compound (B), and a photosensitive agent (C):
the weakly acidic group (WA): one or more groups selected from the group consisting of a phenolic hydroxyl group, a hydroxyimide group, a hydroxyamide group, a silanol group, a 1,1-bis(trifluoromethyl) methylol group, and a mercapto group.

2. The photosensitive composition according to claim 1, wherein a weakly acidic group equivalent in total solid content is 400 to 6,000 g/mol.

3. The photosensitive composition according to claim 1, further comprising one or more selected from the group consisting of a cyclic amide compound represented by general formula (20), an amide compound represented by general formula (21), a cyclic urea compound represented by general formula (22), and a urea compound represented by general formula (23), and a condition (4) described below is satisfied:
(4) a total content of the cyclic amide compound represented by the general formula (20), the amide compound represented by the general formula (21), the cyclic urea compound represented by the general formula (22), and the urea compound represented by the general formula (23) in the total solid content of the photosensitive composition is 0.010% to 5.0% by mass, 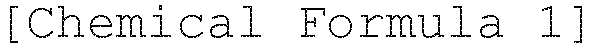 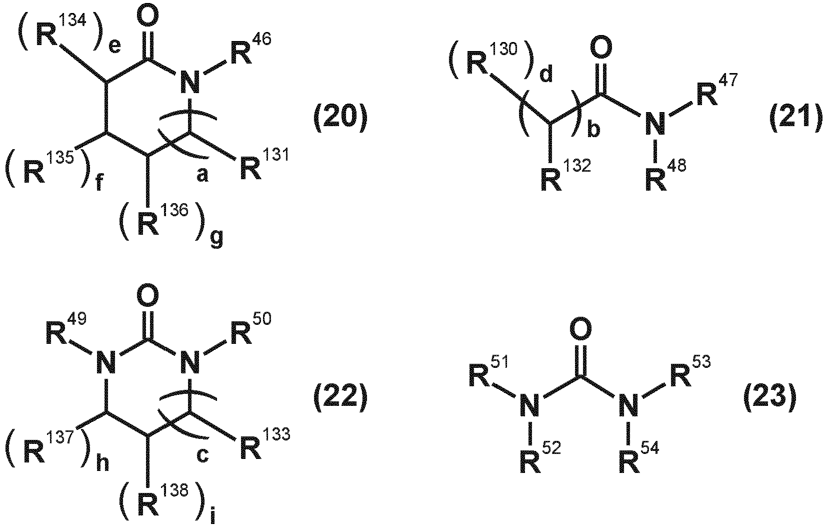
wherein in the general formulae (20) to (23), R⁴⁶ to R⁵⁴ each independently represent a hydrogen atom, an alkyl group having 1 to 6 carbon atoms, a cycloalkyl group having 4 to 10 carbon atoms, an aryl group having 6 to 15 carbon atoms, an alkenyl group having 2 to 6 carbon atoms, or a hydroxyalkyl group having 1 to 6 carbon atoms, R¹³⁰ represents a hydrogen atom, an alkyl group having 1 to 6 carbon atoms, an alkoxy group having 1 to 6 carbon atoms, a hydroxyalkyl group having 1 to 6 carbon atoms, a hydroxyalkoxy group having 1 to 6 carbon atoms, a hydroxy group, an amino group, a monoalkylamino group having 1 to 6 carbon atoms, or a dialkylamino group having 2 to 12 carbon atoms, R¹³¹ to R¹³⁸ each independently represent an alkyl group having 1 to 6 carbon atoms, a, b, and c each independently represent an integer of 0 to 6, d represents 1 or 2, e, f, g, h, and i each independently represent an integer of 0 to 2, and in a case where b is 0, d is 1.

4. The photosensitive composition according to claim 3, further comprising one or more selected from the group consisting of a component containing a sodium element, a component containing a potassium element, a component containing a magnesium element, a component containing a calcium element, a component containing an iron element, a component containing a copper element, and a component containing a chromium element, and a condition (5) described below is satisfied:
(5) a total content of the sodium element, the potassium element, the magnesium element, the calcium element, the iron element, the copper element, and the chromium element in the total solid content of the photosensitive composition is 0.010 to 500 ppm by mass.

5. The photosensitive composition according to any one of claims 1 to 4, comprising an alkali-soluble resin (A),
wherein
the alkali-soluble resin (A) has the weakly acidic group (WA),
a phenol equivalent in a total solid content is 400 to 6,000 g/mol, and
the alkali-soluble resin (A) has a phenolic hydroxyl group.

6. The photosensitive composition according to claim 5, wherein the alkali-soluble resin (A) contains one or more selected from the group consisting of a resin (A3-1), a resin (A3-2), a resin (A3-3), and a resin (A3-4) described below:
the resin (A3-1): a phenol resin;
the resin (A3-2): polyhydroxystyrene;
the resin (A3-3): a phenol group-containing epoxy resin; and
the resin (A3-4): a phenol group-containing acrylic resin.

7. The photosensitive composition according to claim 6, wherein
the resin (A3-1), the resin (A3-2), the resin (A3-3), and the resin (A3-4) have one or more selected from the group consisting of a structural unit (3x), a structural unit (3y), and a structural unit (3z) below,
an aromatic group in the structural unit (3y) is an aromatic group different from an aromatic ring to which a phenolic hydroxyl group is bonded, and
a second aromatic group in the structural unit (3z) is an aromatic group excluding an aromatic ring to which a phenolic hydroxyl group is bonded:
the structural unit (3x): a structural unit containing at least two phenolic hydroxyl groups;
the structural unit (3y): a structural unit containing a phenolic hydroxyl group and an aromatic group; and
the structural unit (3z): a structural unit containing a phenolic hydroxyl group and a structural unit containing a second aromatic group.

8. The photosensitive composition according to any one of claims 2 to 4, comprising an alkali-soluble resin (A); a radical polymerizable compound (B); and a photosensitive agent (C),
wherein
the alkali-soluble resin (A) contains a resin having a radical polymerizable group and a resin not having a radical polymerizable group, and
the photosensitive agent (C) contains a photopolymerization initiator (C1).

9. The photosensitive composition according to any one of claims 1 to 4, wherein
the weakly acidic group equivalent in total solid content is 400 to 1,500 g/mol, and
the double bond equivalent is 750 to 6,000 g/mol.

10. The photosensitive composition according to any one of claims 1 to 4, further comprising inorganic particles (I),
wherein the inorganic particles (I) contain silica particles (I1).

11. The photosensitive composition according to any one of claims 1 to 4, further comprising one or more selected from the group consisting of a halogen element-containing component, a sulfur element-containing component, and a phosphorus element-containing component, and satisfying one or more of conditions (1) to (3) below:
(1) a content of the halogen elements in the photosensitive composition is 0.01 to 100 ppm by mass;
(2) a content of the sulfur elements in the photosensitive composition is 0.01 to 100 ppm by mass; and
(3) a content of the phosphorus elements in the photosensitive composition is 0.01 to 100 ppm by mass.

12. The photosensitive composition according to any one of claims 1 to 4, comprising an alkali-soluble resin (A),
wherein the alkali-soluble resin (A) contains one or more selected from the group consisting of a resin (A1), a resin (A2), and a resin (A3) below:
the resin (A1): a resin having the weakly acidic group (WA), further having a structural unit containing one or more selected from the group consisting of an imide structure, an amide structure, an oxazole structure, and a siloxane structure, and having no radical polymerizable group;
the resin (A2): a resin having a radical polymerizable group; and
the resin (A3): a resin having a phenolic hydroxyl group.

13. The photosensitive composition according to claim 12, wherein the alkali-soluble resin (A) contains the resin (A1) and/or the resin (A3), and further contains the resin (A2) :
the resin (A2): a resin having a radical polymerizable group.

14. The photosensitive composition according to any one of claims 1 to 4, further comprising an organic black pigment (D1a-1) and/or a coloring pigment mixture of two or more colors (D1a-3),
wherein
the organic black pigment (D1a-1) contains one or more selected from the group consisting of a benzofuranone-based black pigment (D1a-1a), a perylene-based black pigment (D1a-1b), and an azo-based black pigment (D1a-1c), and
the coloring pigment mixture of two or more colors (D1a-3) contains two or more pigments selected from the group consisting of red, orange, yellow, green, blue, and violet pigments.

15. The photosensitive composition according to any one of claims 1 to 4, further comprising a radical polymerizable compound (B), and satisfying at least one of conditions (γ), (δ), and (ε) below:
the condition (γ): a radical polymerizable compound (B) contains a fourth polymerizable compound (B4) and a fifth polymerizable compound (B5) below;
the condition (δ): a radical polymerizable compound (B) contains a sixth polymerizable compound (B6) and a seventh polymerizable compound (B7) below; and
the condition (ε): a radical polymerizable compound (B) contains the fourth polymerizable compound (B4) or the fifth polymerizable compound (B5) below, and further contains the sixth polymerizable compound (B6) or the seventh polymerizable compound (B7) below:
the fourth polymerizable compound (B4): a compound having a structure (I-b4) below and further having at least two radical polymerizable groups:
the structure (I-b4): a structure including an alicyclic structure and/or a structure including a heteroalicyclic structure,
the fifth polymerizable compound (B5): a compound having a structure (I-b5) and a structure (II-b5) below and further having at least two radical polymerizable groups:
the structure (I-b5): a structure including an aromatic structure; and
the structure (II-b5): a structure including an aliphatic structure,
the sixth polymerizable compound (B6): a compound having at least two (meth)acryloyl groups and further having a structure (I-b6) below:
the structure (I-b6): a structure having at least two (meth)acryloyl groups linked with a minimum number of atoms of 4 to 10 and an aliphatic structure, and
the seventh polymerizable compound (B7): a compound having at least two (meth)acryloyl groups and further having a structure (I-b7) below:
the structure (I-b7): a structure having at least two (meth)acryloyl groups linked with a minimum number of atoms of 11 to 45 and an aliphatic structure.

16. A cured product obtained by curing the photosensitive composition according to any one of claims 1 to 4.

17. A display device comprising the cured product according to claim 16.

18. An electronic component comprising the cured product according to claim 16.

19. A method for producing a cured product, the method comprising:
(1) forming a coating film of the photosensitive composition according to any one of claims 1 to 4 on a substrate;
(2) irradiating a coating film of the photosensitive composition with active actinic rays through a photomask;
(3) developing using an alkaline solution to form a pattern of the photosensitive composition; and
(4) heating the pattern to obtain a cured pattern of the photosensitive composition,
wherein the photomask is a halftone photomask including a light-transmitting portion, a light-shielding portion, and a partial light-transmitting portion between the light-transmitting portion and the light-shielding portion, the partial light-transmitting portion having a transmittance lower than a value of the light-transmitting portion and a transmittance higher than a value of the light-shielding portion.

20. A display device comprising at least a substrate, a first electrode, a second electrode, and a pixel defining layer, and
further comprising an organic EL layer including a light-emitting layer and/or a light extraction layer including a light-emitting layer,
wherein
the pixel defining layer is formed so as to overlap a part of the first electrode,
the organic EL layer including the light-emitting layer and/or the light extraction layer including the light-emitting layer are formed on the first electrode and between the first electrode and the second electrode,
the pixel defining layer includes a colorant (D-DL), and optical density of the pixel defining layer at a wavelength of visible light per 1 um of film thickness is 0.5 to 5.0,
the pixel defining layer contains a resin having a weakly acidic group (WA) below,
a resin having a weakly acidic group (WA) contains one or more selected from the group consisting of a resin (XA3-1), a resin (XA3-2), a resin (XA3-3), and a resin (XA3-4) below, and
the display device satisfies conditions (1x) and/or (2x) below:
the weakly acidic group (WA) is one or more groups selected from the group consisting of a phenolic hydroxyl group, a hydroxyimide group, a hydroxyamide group, a silanol group, a 1,1-bis(trifluoromethyl) methylol group, and a mercapto group;
the resin (XA3-1): a phenol resin;
the resin (XA3-2): polyhydroxystyrene;
the resin (XA3-3): a phenol group-containing epoxy resin;
the resin (XA3-4): a phenol group-containing acrylic resin;
(1x) when a maximum value of a surface roughness of a surface of a thin film part in a step shape of the pixel defining layer is represented by (Ra_{HT/max}) and a maximum value of a surface roughness of a surface of a thick film part in a step shape of the pixel defining layer is represented by (Ra_{FT/max}), a difference |Δ (Ra_{HT/max} - Ra_{FT/max})| between (Ra_{HT/max}) and (Ra_{FT/max}) is 1.0 to 50.0 nm; and
(2x) when (Ra_{DL/max}) is a maximum value of surface roughness on a surface of the pixel defining layer, and (Ra_{SP/max}) is a maximum value of surface roughness on a surface of a spacer layer on the pixel defining layer, a difference |Δ(Ra_{DL/max} - Ra_{SP/max})| between (Ra_{DL/max}) and (Ra_{SP/max}) is 1.0 to 50.0 nm.
